(19) Europäisches Patentamt
European Patent Office
Office européen des brevets

(11) EP 4 159 827 A1

(12) EUROPEAN PATENT APPLICATION
published in accordance with Art. 153(4) EPC

(43) Date of publication:
**05.04.2023 Bulletin 2023/14**

(21) Application number: **21814080.4**

(22) Date of filing: **28.05.2021**

(51) International Patent Classification (IPC):
***C09K 11/06*** (2006.01) ***C23C 14/12*** (2006.01)
***C23C 14/24*** (2006.01) ***H05B 33/10*** (2006.01)
***H01L 51/50*** (2006.01)

(52) Cooperative Patent Classification (CPC):
**C09K 11/06; C23C 14/12; C23C 14/24; H05B 33/10;** H10K 50/11; H10K 2101/90

(86) International application number:
**PCT/JP2021/020449**

(87) International publication number:
**WO 2021/241738 (02.12.2021 Gazette 2021/48)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **29.05.2020 JP 2020094989**

(71) Applicant: **Idemitsu Kosan Co.,Ltd.**
**Tokyo 100-8321 (JP)**

(72) Inventors:
- **NAKAMURA, Masato**
**Tokyo 100-8321 (JP)**
- **NAKANO, Yuki**
**Tokyo 100-8321 (JP)**
- **ITOI, Hiroaki**
**Tokyo 100-8321 (JP)**

(74) Representative: **Gille Hrabal Partnerschaftsgesellschaft mbB Patentanwälte**
**Brucknerstraße 20**
**40593 Düsseldorf (DE)**

(54) **MIXTURE, ORGANIC ELECTROLUMINESCENCE ELEMENT, ORGANIC ELECTROLUMINESCENCE ELEMENT MANUFACTURING METHOD, AND ELECTRONIC APPARATUS**

(57) A mixture contains a first compound represented by a formula (10) and a second compound represented by a formula (20), and the first compound and the second compound have structures different from each other. In the formula (10) and the formula (20), $L_{12}$ is a substituted or unsubstituted arylene group having 6 to 50 ring carbon atoms or the like; $Ar_{12}$ is a substituted or unsubstituted aryl group having 6 to 50 ring carbon atoms; $L_{11}$, $L_{21}$, and $L_{22}$ are each independently a single bond, a substituted or unsubstituted arylene group having 6 to 50 ring carbon atoms, or the like; $Ar_{11}$, $Ar_{21}$, and $Ar_{22}$ are each independently a substituted or unsubstituted aryl group having 6 to 50 ring carbon atoms; and $R_{11}$ to $R_{18}$ and $R_{21}$ to $R_{28}$ are each independently a hydrogen atom or a substituent.

EP 4 159 827 A1

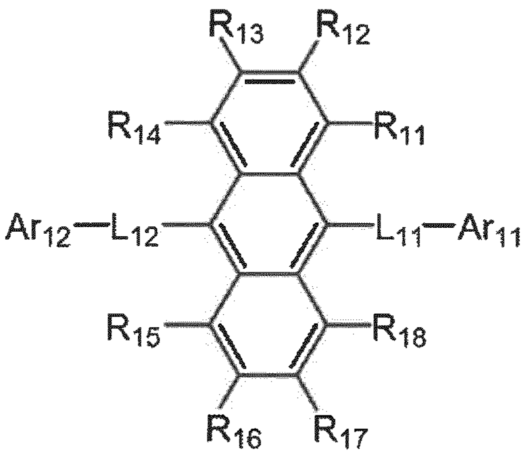

(10)

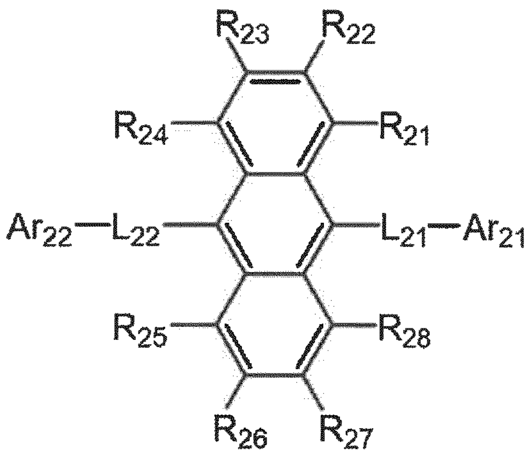

(20)

## Description

### TECHNICAL FIELD

The present invention relates to a mixture, an organic electroluminescence device, a method for manufacturing an organic electroluminescence device, and an electronic device.

### BACKGROUND ART

When a voltage is applied to an organic electroluminescence device (hereinafter, occasionally referred to as an organic EL device), holes are injected from an anode and electrons are injected from a cathode into an emitting layer. The injected holes and electrons are recombined in the emitting layer to form excitons. Specifically, according to the electron spin statistics theory, singlet excitons and triplet excitons are generated at a ratio of 25%:75%.

The organic EL device has been applied to a full-color display for mobile phones, televisions and the like. Various studies have been made for compounds to be used for the organic EL device in order to enhance the performance of the organic EL device. The performance of the organic EL device is evaluable in terms of, for instance, luminance, emission wavelength, chromaticity, emission efficiency, drive voltage, and lifetime.

Studies have also been made for methods for forming an organic layer included in the organic EL device. For instance, Patent Literature 1 discloses a vapor deposition method including forming a layer in an organic emitting device by depositing a depositable homogeneous solid mixture containing at least one luminous organic host material and at least one luminous organic dopant material.

### PATENT LITERATURE(S)

Patent Literature 1: JP 2002-25770 A

### SUMMARY OF THE INVENTION

### PROBLEMS TO BE SOLVED BY THE INVENTION

For the formation of an organic layer in the organic EL device, dry film-forming methods such as a vapor-deposition method and a sputtering method are used. When an organic layer is formed through dry film-forming, a bulky adhering film may be formed not only on a support such as a substrate that is a film-formation target but also in a film-forming device. Thus, depending on a kind of an organic compound forming an organic layer, the bulky adhering film is sometimes formed inside the film-forming device. The adhering film formed inside the film-forming device narrows or blocks a path through which a vaporized organic material passes toward the support (e.g., substrate), resulting in a difficulty for the organic compound to selectively adhere on a desired region. For this reason, when the bulky adhering film is formed inside the film-forming device, the adhering film needs to be removed, which lowers a production efficiency of the organic EL device.

An object of the invention is to provide a mixture capable of inhibiting formation of a bulky adhering film when forming an organic layer of an organic EL device.

A further object of the invention is to provide an organic electroluminescence device that can maintain its performance and is manufactured with high efficiency.

A still further object of the invention is to provide an electronic device including the organic electroluminescence device.

A still further object of the invention is to provide a method for manufacturing an organic electroluminescence device by using the mixture.

### MEANS FOR SOLVING THE PROBLEMS

According to an aspect of the invention, there is provided a mixture containing a first compound and a second compound, in which the first compound is represented by a formula (10) below, the second compound is represented by a formula (20) below, and the first compound and the second compound have structures different from each other.

[Formula 1]

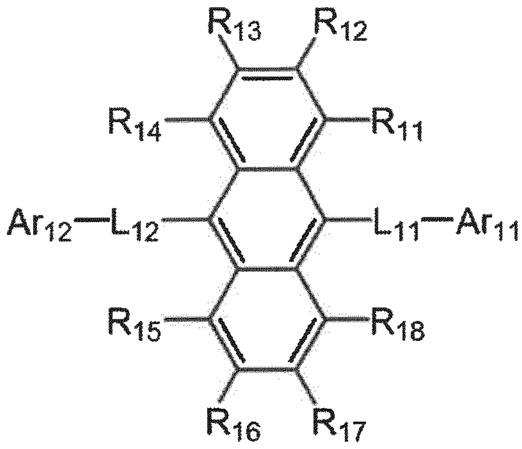

(10)

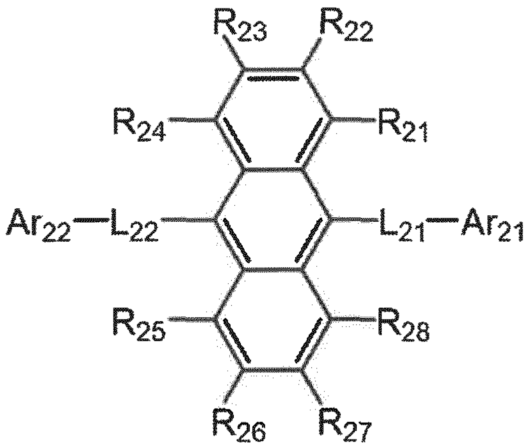

(20)

In the formula (10) and the formula (20),

$L_{12}$ is a substituted or unsubstituted arylene group having 6 to 50 ring carbon atoms, or a substituted or unsubstituted divalent heterocyclic group having 5 to 50 ring atoms;

$Ar_{12}$ is a substituted or unsubstituted aryl group having 6 to 50 ring carbon atoms;

$L_{11}$, $L_{21}$, and $L_{22}$ are each independently a single bond, a substituted or unsubstituted arylene group having 6 to 50 ring carbon atoms, or a substituted or unsubstituted divalent heterocyclic group having 5 to 50 ring atoms;

$Ar_{11}$, $Ar_{21}$, and $Ar_{22}$ are each independently a substituted or unsubstituted aryl group having 6 to 50 ring carbon atoms; and

$R_{11}$ to $R_{18}$ and $R_{21}$ to $R_{28}$ are each independently a hydrogen atom, a substituted or unsubstituted alkyl group having 1 to 50 carbon atoms, a substituted or unsubstituted haloalkyl group having 1 to 50 carbon atoms, a substituted or unsubstituted alkenyl group having 2 to 50 carbon atoms, a substituted or unsubstituted alkynyl group having 2 to 50 carbon atoms, a substituted or unsubstituted cycloalkyl group having 3 to 50 ring carbon atoms, a group represented by $-Si(R_{901})(R_{902})(R_{903})$, a group represented by -O-(R904), a group represented by $-S-(R_{905})$, a group represented by $-N(R_{906})(R_{907})$, a substituted or unsubstituted aralkyl group having 7 to 50 carbon atoms, a group represented by $-C(=O)R_{801}$, a group represented by $-COOR_{802}$, a halogen atom, a cyano group, a nitro group, a substituted or unsubstituted aryl group having 6 to 50 ring carbon atoms, or a substituted or unsubstituted heterocyclic group having 5 to 50 ring atoms.

According to another aspect of the invention, there is provided a mixture containing a first compound and a second compound, in which the first compound is represented by a formula (20) below, the second compound is represented by a formula (30) below, and the first compound and the second compound have structures different from each other.

[Formula 2]

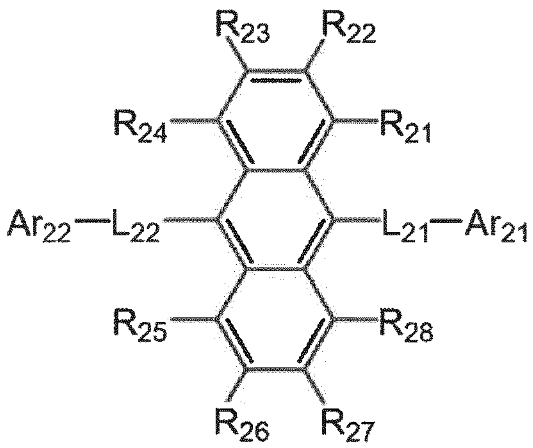

(20)

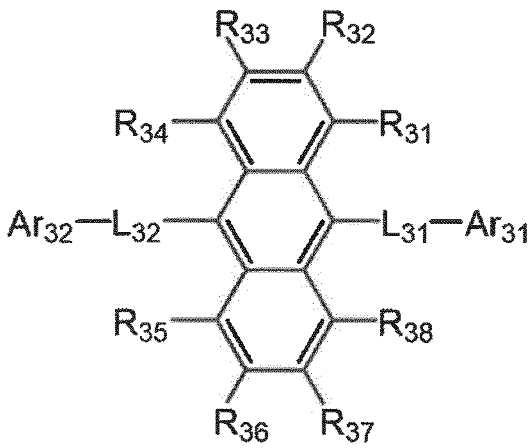

(30)

In the formula (20) and the formula (30):

$L_{21}$, $L_{22}$, $L_{31}$, and $L_{32}$ are each independently a single bond, a substituted or unsubstituted arylene group having 6 to 50 ring carbon atoms, or a substituted or unsubstituted divalent heterocyclic group having 5 to 50 ring atoms;
$Ar_{21}$, $Ar_{22}$, $Ar_{31}$, and $Ar_{32}$ are each independently a substituted or unsubstituted aryl group having 6 to 50 ring carbon atoms;
$R_{21}$ to $R_{28}$ and $R_{31}$ to $R_{38}$ are each independently a hydrogen atom, a substituted or unsubstituted alkyl group having 1 to 50 carbon atoms, a substituted or unsubstituted haloalkyl group having 1 to 50 carbon atoms, a substituted or unsubstituted alkenyl group having 2 to 50 carbon atoms, a substituted or unsubstituted alkynyl group having 2 to 50 carbon atoms, a substituted or unsubstituted cycloalkyl group having 3 to 50 ring carbon atoms, a group represented by $-Si(R_{901})(R_{902})(R_{903})$, a group represented by $-O-(R_{904})$, a group represented by $-S-(R_{905})$, a group represented by $-N(R_{906})(R_{907})$, a substituted or unsubstituted aralkyl group having 7 to 50 carbon atoms, a group represented by $-C(=O)R_{801}$, a group represented by $-COOR_{802}$, a halogen atom, a cyano group, a nitro group, a substituted or unsubstituted aryl group having 6 to 50 ring carbon atoms, or a substituted or unsubstituted heterocyclic group having 5 to 50 ring atoms; and
$R_{22}$, $R_{23}$, $R_{26}$, $R_{27}$, $R_{32}$, $R_{33}$, $R_{36}$, and $R_{37}$ are not substituted or unsubstituted alkyl groups having 1 to 50 carbon atoms.

According to a still another aspect of the invention, there is provided a mixture containing a first compound and a second compound, in which the first compound is represented by a formula (20) below, the second compound is represented by a formula (40) below, the first compound and the second compound have structures different from each other, the total mass $M_T$ of the first compound and the second compound and the mass $M_1$ of the first compound satisfy a relationship of a numerical formula (Numerical Formula 2) below.

$$50 < (M_1/M_T) \times 100 < 100 \qquad \text{(Numerical Formula 2)}$$

[Formula 3]

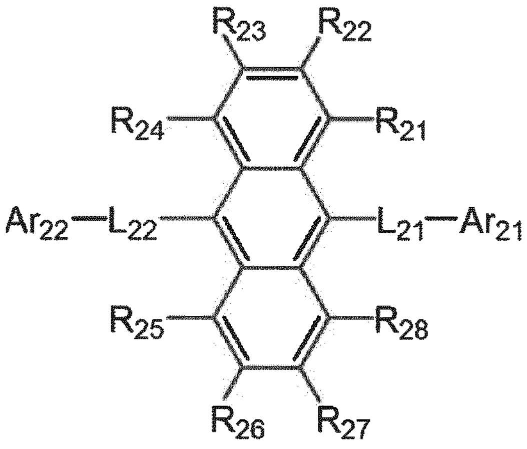

(20)

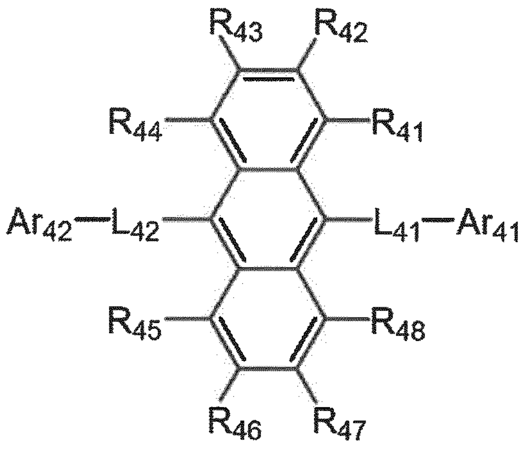

(40)

In the formula (20) and the formula (40):

$L_{21}$, $L_{22}$, $L_{41}$, and $L_{42}$ are each independently a single bond, a substituted or unsubstituted arylene group having 6 to 50 ring carbon atoms, or a substituted or unsubstituted divalent heterocyclic group having 5 to 50 ring atoms;

$Ar_{21}$, $Ar_{22}$, $Ar_{41}$, and $Ar_{42}$ are each independently a substituted or unsubstituted aryl group having 6 to 50 ring carbon atoms; and

$R_{21}$ to $R_{28}$ and $R_{41}$ to $R_{48}$ are each independently a hydrogen atom, a substituted or unsubstituted alkyl group having 1 to 50 carbon atoms, a substituted or unsubstituted haloalkyl group having 1 to 50 carbon atoms, a substituted or unsubstituted alkenyl group having 2 to 50 carbon atoms, a substituted or unsubstituted alkynyl group having 2 to 50 carbon atoms, a substituted or unsubstituted cycloalkyl group having 3 to 50 ring carbon atoms, a group represented by $-Si(R_{901})(R_{902})(R_{903})$, a group represented by -O-(R904), a group represented by $-S-(R_{905})$, a group represented by $-N(R_{906})(R_{907})$, a substituted or unsubstituted aralkyl group having 7 to 50 carbon atoms, a group represented by $-C(=O)R_{801}$, a group represented by $-COOR_{802}$, a halogen atom, a cyano group, a nitro group, a substituted or unsubstituted aryl group having 6 to 50 ring carbon atoms, or a substituted or unsubstituted heterocyclic group having 5 to 50 ring atoms.

In the first compound and the second compound,

$R_{901}$, $R_{902}$, $R_{903}$, $R_{904}$, $R_{905}$, $R_{906}$, $R_{907}$, $R_{301}$, and $R_{302}$ are each independently a hydrogen atom, a substituted or unsubstituted alkyl group having 1 to 50 carbon atoms, a substituted or unsubstituted cycloalkyl group having 3 to 50 ring carbon atoms, a substituted or unsubstituted aryl group having 6 to 50 ring carbon atoms, or a substituted or unsubstituted heterocyclic group having 5 to 50 ring atoms;

when a plurality of $R_{901}$ are present, the plurality of $R_{901}$ are mutually the same or different;

when a plurality of $R_{902}$ are present, the plurality of $R_{902}$ are mutually the same or different;

when a plurality of $R_{903}$ are present, the plurality of $R_{903}$ are mutually the same or different;

when a plurality of $R_{904}$ are present, the plurality of $R_{904}$ are mutually the same or different;

when a plurality of $R_{905}$ are present, the plurality of $R_{905}$ are mutually the same or different;

when a plurality of $R_{906}$ are present, the plurality of $R_{906}$ are mutually the same or different;

when a plurality of $R_{907}$ are present, the plurality of $R_{907}$ are mutually the same or different;

when a plurality of $R_{801}$ are present, the plurality of $R_{801}$ are mutually the same or different; and

when a plurality of $R_{302}$ are present, the plurality of $R_{802}$ are mutually the same or different.

According to a further aspect of the invention, there is provided an organic electroluminescence device including: an anode; a cathode; and an organic layer disposed between the anode and the cathode and containing the mixture according to the above aspect of the invention in one and the same layer.

According to a still further aspect of the invention, there is provided an organic electroluminescence device including: an anode; a cathode; and an organic layer disposed between the anode and the cathode and formed by vapor-depositing the mixture according to the above aspect of the invention from one and the same vapor-deposition source.

According to a still further aspect of the invention, there is provided an electronic device including the organic electroluminescence device according to the above aspect of the invention.

According to a still further aspect of the invention, there is provided a method for manufacturing an organic electroluminescence device, including: preparing the mixture according to the above aspect of the invention by mixing the first compound and the second compound; introducing the mixture into one and the same vapor-deposition source; and heating the vapor-deposition source to form the mixture into a film on a substrate.

According to the above aspect of the exemplary embodiment, a mixture capable of inhibiting formation of a bulky adhering film, when forming an organic layer of an organic EL device, can be provided.

According to the above aspect of the invention, an organic EL device that can maintain its performance and is manufactured with high efficiency can be provided.

According to the above aspect of the invention, an electronic device including the organic EL device according to the above aspect of the invention can be provided.

According to the above aspect of the invention, a method for manufacturing an organic EL device by using the mixture according to the above aspect of the invention can be provided.

## BRIEF DESCRIPTION OF DRAWING(S)

Fig. 1 schematically shows an exemplary arrangement of an organic electroluminescence device according to an exemplary embodiment of the invention.
Fig. 2A is a cross-sectional SEM image (magnification of 100 times) of an organic layer formed using a mixture according to Example 1.
Fig. 2B is a cross-sectional SEM image (magnification of 500 times) of the organic layer formed using the mixture according to Example 1.
Fig. 3A is a cross-sectional SEM image (magnification of 100 times) of an organic layer formed using a mixture according to Example 2.
Fig. 3B is a cross-sectional SEM image (magnification of 500 times) of the organic layer formed using the mixture according to Example 2.
Fig. 4A is a cross-sectional SEM image (magnification of 100 times) of an organic layer formed using a mixture according to Example 3.
Fig. 4B is a cross-sectional SEM image (magnification of 500 times) of the organic layer formed using the mixture according to Example 3.
Fig. 5A is a cross-sectional SEM image (magnification of 100 times) of an organic layer formed using a mixture according to Example 4.
Fig. 5B is a cross-sectional SEM image (magnification of 500 times) of the organic layer formed using the mixture according to Example 4.
Fig. 6A is a cross-sectional SEM image (magnification of 100 times) of an organic layer formed using a mixture according to Example 5.
Fig. 6B is a cross-sectional SEM image (magnification of 500 times) of the organic layer formed using the mixture according to Example 5.
Fig. 7A is a cross-sectional SEM image (magnification of 100 times) of an organic layer formed using a sample according to Comparative Example 1.
Fig. 7B is a cross-sectional SEM image (magnification of 500 times) of the organic layer formed using the sample according to Comparative Example 1.
Fig. 8A is a cross-sectional SEM image (magnification of 100 times) of an organic layer formed using a sample according to Comparative Example 2.
Fig. 8B is a cross-sectional SEM image (magnification of 500 times) of the organic layer formed using the sample according to Comparative Example 2.

## DESCRIPTION OF EMBODIMENTS

### Definitions

Herein, a hydrogen atom includes isotope having different numbers of neutrons, specifically, protium, deuterium and tritium.

In chemical formulae herein, it is assumed that a hydrogen atom (i.e. protium, deuterium and tritium) is bonded to each of bondable positions that are not annexed with signs "R" or the like or "D" representing a deuterium.

Herein, the ring carbon atoms refer to the number of carbon atoms among atoms forming a ring of a compound (e.g., a monocyclic compound, fused-ring compound, cross-linking compound, carbon ring compound, and heterocyclic

compound) in which the atoms are bonded to each other to form the ring. When the ring is substituted by a substituent(s), carbon atom(s) contained in the substituent(s) is not counted in the ring carbon atoms. Unless otherwise specified, the same applies to the "ring carbon atoms" described later. For instance, a benzene ring has 6 ring carbon atoms, a naphthalene ring has 10 ring carbon atoms, a pyridine ring has 5 ring carbon atoms, and a furan ring has 4 ring carbon atoms. Further, for instance, 9,9-diphenylfluorenyl group has 13 ring carbon atoms and 9,9'-spirobifluorenyl group has 25 ring carbon atoms.

When a benzene ring is substituted by a substituent in a form of, for instance, an alkyl group, the number of carbon atoms of the alkyl group is not counted in the number of the ring carbon atoms of the benzene ring. Accordingly, the benzene ring substituted by an alkyl group has 6 ring carbon atoms. When a naphthalene ring is substituted by a substituent in a form of, for instance, an alkyl group, the number of carbon atoms of the alkyl group is not counted in the number of the ring carbon atoms of the naphthalene ring. Accordingly, the naphthalene ring substituted by an alkyl group has 10 ring carbon atoms.

Herein, the ring atoms refer to the number of atoms forming a ring of a compound (e.g., a monocyclic compound, fused-ring compound, cross-linking compound, carbon ring compound, and heterocyclic compound) in which the atoms are bonded to each other to form the ring (e.g., monocyclic ring, fused ring, and ring assembly). Atom(s) not forming the ring (e.g., hydrogen atom(s) for saturating the valence of the atom which forms the ring) and atom(s) in a substituent by which the ring is substituted are not counted as the ring atoms. Unless otherwise specified, the same applies to the "ring atoms" described later. For instance, a pyridine ring has 6 ring atoms, a quinazoline ring has 10 ring atoms, and a furan ring has 5 ring atoms. For instance, the number of hydrogen atom(s) bonded to a pyridine ring or the number of atoms forming a substituent are not counted as the pyridine ring atoms. Accordingly, a pyridine ring bonded to a hydrogen atom(s) or a substituent(s) has 6 ring atoms. For instance, the hydrogen atom(s) bonded to carbon atom(s) of a quinazoline ring or the atoms forming a substituent are not counted as the quinazoline ring atoms. Accordingly, a quinazoline ring bonded to hydrogen atom(s) or a substituent(s) has 10 ring atoms.

Herein, "XX to YY carbon atoms" in the description of "substituted or unsubstituted ZZ group having XX to YY carbon atoms" represent carbon atoms of an unsubstituted ZZ group and do not include carbon atoms of a substituent(s) of the substituted ZZ group. Herein, "YY" is larger than "XX," "XX" representing an integer of 1 or more and "YY" representing an integer of 2 or more.

Herein, "XX to YY atoms" in the description of "substituted or unsubstituted ZZ group having XX to YY atoms" represent atoms of an unsubstituted ZZ group and do not include atoms of a substituent(s) of the substituted ZZ group. Herein, "YY" is larger than "XX," "XX" representing an integer of 1 or more and "YY" representing an integer of 2 or more.

Herein, an unsubstituted ZZ group refers to an "unsubstituted ZZ group" in a "substituted or unsubstituted ZZ group," and a substituted ZZ group refers to a "substituted ZZ group" in a "substituted or unsubstituted ZZ group."

Herein, the term "unsubstituted" used in a "substituted or unsubstituted ZZ group" means that a hydrogen atom(s) in the ZZ group is not substituted with a substituent(s). The hydrogen atom(s) in the "unsubstituted ZZ group" is protium, deuterium, or tritium.

Herein, the term "substituted" used in a "substituted or unsubstituted ZZ group" means that at least one hydrogen atom in the ZZ group is substituted with a substituent. Similarly, the term "substituted" used in a "BB group substituted by AA group" means that at least one hydrogen atom in the BB group is substituted with the AA group.

Substituents Mentioned Herein

Substituents mentioned herein will be described below.

An "unsubstituted aryl group" mentioned herein has, unless otherwise specified herein, 6 to 50, preferably 6 to 30, more preferably 6 to 18 ring carbon atoms.

An "unsubstituted heterocyclic group" mentioned herein has, unless otherwise specified herein, 5 to 50, preferably 5 to 30, more preferably 5 to 18 ring atoms.

An "unsubstituted alkyl group" mentioned herein has, unless otherwise specified herein, 1 to 50, preferably 1 to 20, more preferably 1 to 6 carbon atoms.

An "unsubstituted alkenyl group" mentioned herein has, unless otherwise specified herein, 2 to 50, preferably 2 to 20, more preferably 2 to 6 carbon atoms.

An "unsubstituted alkynyl group" mentioned herein has, unless otherwise specified herein, 2 to 50, preferably 2 to 20, more preferably 2 to 6 carbon atoms.

An "unsubstituted cycloalkyl group" mentioned herein has, unless otherwise specified herein, 3 to 50, preferably 3 to 20, more preferably 3 to 6 ring carbon atoms.

An "unsubstituted arylene group" mentioned herein has, unless otherwise specified herein, 6 to 50, preferably 6 to 30, more preferably 6 to 18 ring carbon atoms.

An "unsubstituted divalent heterocyclic group" mentioned herein has, unless otherwise specified herein, 5 to 50, preferably 5 to 30, more preferably 5 to 18 ring atoms.

An "unsubstituted alkylene group" mentioned herein has, unless otherwise specified herein, 1 to 50, preferably 1 to 20, more preferably 1 to 6 carbon atoms.

Substituted or Unsubstituted Aryl Group

Specific examples (specific example group G1) of the "substituted or unsubstituted aryl group" mentioned herein include unsubstituted aryl groups (specific example group G1A) below and substituted aryl groups (specific example group G1B) below. (Herein, an unsubstituted aryl group refers to an "unsubstituted aryl group" in a "substituted or unsubstituted aryl group", and a substituted aryl group refers to a "substituted aryl group" in a "substituted or unsubstituted aryl group.") A simply termed "aryl group" herein includes both of an "unsubstituted aryl group" and a "substituted aryl group."

The "substituted aryl group" refers to a group derived by substituting at least one hydrogen atom in an "unsubstituted aryl group" with a substituent. Examples of the "substituted aryl group" include a group derived by substituting at least one hydrogen atom in the "unsubstituted aryl group" in the specific example group G1A below with a substituent, and examples of the substituted aryl group in the specific example group G1B below. It should be noted that the examples of the "unsubstituted aryl group" and the "substituted aryl group" mentioned herein are merely exemplary, and the "substituted aryl group" mentioned herein includes a group derived by further substituting a hydrogen atom bonded to a carbon atom of a skeleton of a "substituted aryl group" in the specific example group G1B below, and a group derived by further substituting a hydrogen atom of a substituent of the "substituted aryl group" in the specific example group G1B below.

Unsubstituted Aryl Group (Specific Example Group G1A):
phenyl group, p-biphenyl group, m-biphenyl group, o-biphenyl group, p-terphenyl-4-yl group, p-terphenyl-3-yl group, p-terphenyl-2-yl group, m-terphenyl-4-yl group, m-terphenyl-3-yl group, m-terphenyl-2-yl group, o-terphenyl-4-yl group, o-terphenyl-3-yl group, o-terphenyl-2-yl group, 1-naphthyl group, 2-naphthyl group, anthryl group, benzanthryl group, a phenanthryl group, benzophenanthryl group, phenalenyl group, pyrenyl group, chrysenyl group, benzochrysenyl group, triphenylenyl group, benzotriphenylenyl group, tetracenyl group, pentacenyl group, fluorenyl group, 9,9'-spirobifluorenyl group, benzofluorenyl group, dibenzofluorenyl group, fluoranthenyl group, benzofluoranthenyl group, perylenyl group, and a monovalent aryl group derived by removing one hydrogen atom from cyclic structures represented by formulae (TEMP-1) to (TEMP-15) below.

[Formula 4]

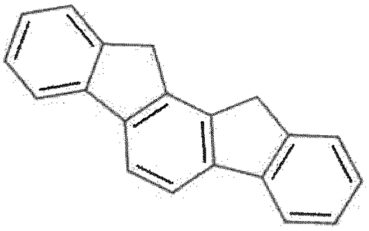

(TEMP-1)

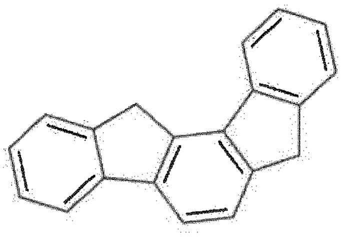

(TEMP-2)

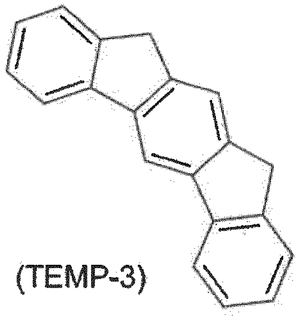

(TEMP-3)

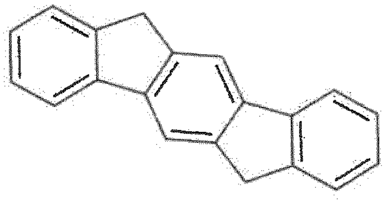

(TEMP-4)

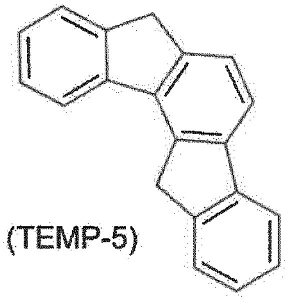

(TEMP-5)

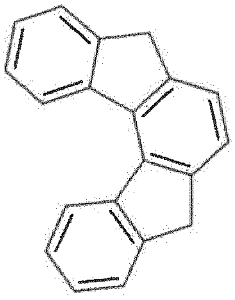

(TEMP-6)

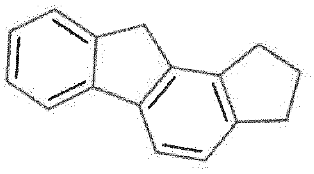

(TEMP-7)

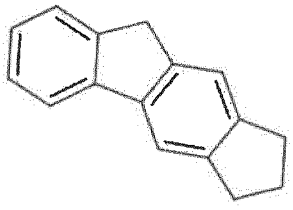

(TEMP-8)

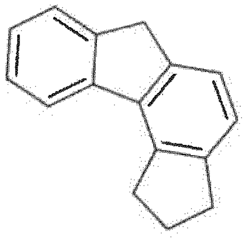

(TEMP-9)

[Formula 5]

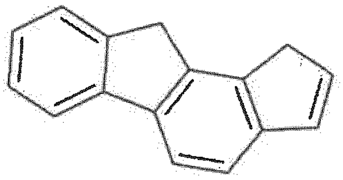

(TEMP-10)

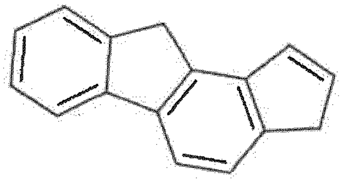

(TEMP-11)

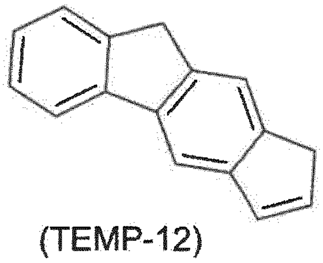

(TEMP-12)

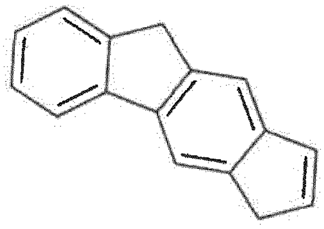

(TEMP-13)

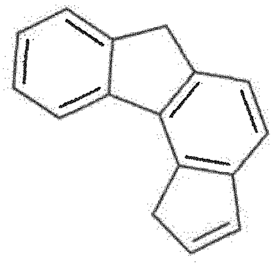

(TEMP-14)

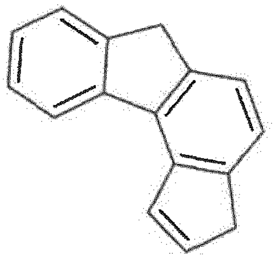

(TEMP-15)

Substituted Aryl Group (Specific Example Group G1B):

o-tolyl group, m-tolyl group, p-tolyl group, para-xylyl group, meta-xylyl group, ortho-xylyl group, para-isopropylphenyl group, meta-isopropylphenyl group, ortho-isopropylphenyl group, para-t-butylphenyl group, meta-t-butylphenyl group, ortho-t-butylphenyl group, 3,4,5-trimethylphenyl group, 9,9-dimethylfluorenyl group, 9,9-diphenylfluorenyl group, 9,9-bis(4-methylphenyl)fluorenyl group, 9,9-bis(4-isopropylphenyl)fluorenyl group, 9,9-bis(4-t-butylphenyl)fluorenyl group, cyanophenyl group, triphenylsilylphenyl group, trimethylsilylphenyl group, phenylnaphthyl group, naphthylphenyl group, and a group derived by substituting at least one hydrogen atom of a monovalent group derived from the cyclic structures represented by the formulae (TEMP-1) to (TEMP-15) with a substituent.

Substituted or Unsubstituted Heterocyclic Group

The "heterocyclic group" mentioned herein refers to a cyclic group having at least one hetero atom in the ring atoms. Specific examples of the hetero atom include a nitrogen atom, oxygen atom, sulfur atom, silicon atom, phosphorus atom, and boron atom.

The "heterocyclic group" mentioned herein is a monocyclic group or a fused-ring group.

The "heterocyclic group" mentioned herein is an aromatic heterocyclic group or a non-aromatic heterocyclic group.

Specific examples (specific example group G2) of the "substituted or unsubstituted heterocyclic group" mentioned herein include unsubstituted heterocyclic groups (specific example group G2A) and substituted heterocyclic groups (specific example group G2B). (Herein, an unsubstituted heterocyclic group refers to an "unsubstituted heterocyclic group" in a "substituted or unsubstituted heterocyclic group," and a substituted heterocyclic group refers to a "substituted heterocyclic group" in a "substituted or unsubstituted heterocyclic group.")A simply termed "heterocyclic group" herein includes both of "unsubstituted heterocyclic group" and "substituted heterocyclic group."

The "substituted heterocyclic group" refers to a group derived by substituting at least one hydrogen atom in an "unsubstituted heterocyclic group" with a substituent. Specific examples of the "substituted heterocyclic group" include a group derived by substituting at least one hydrogen atom in the "unsubstituted heterocyclic group" in the specific example group G2A below with a substituent, and examples of the substituted heterocyclic group in the specific example group G2B below. It should be noted that the examples of the "unsubstituted heterocyclic group" and the "substituted heterocyclic group" mentioned herein are merely exemplary, and the "substituted heterocyclic group" mentioned herein includes a group derived by further substituting a hydrogen atom bonded to a ring atom of a skeleton of a "substituted heterocyclic group" in the specific example group G2B below, and a group derived by further substituting a hydrogen atom of a substituent of the "substituted heterocyclic group" in the specific example group G2B below.

The specific example group G2A includes, for instance, unsubstituted heterocyclic groups including a nitrogen

atom (specific example group G2A1) below, unsubstituted heterocyclic groups including an oxygen atom (specific example group G2A2) below, unsubstituted heterocyclic groups including a sulfur atom (specific example group G2A3) below, and monovalent heterocyclic groups (specific example group G2A4) derived by removing a hydrogen atom from cyclic structures represented by formulae (TEMP-16) to (TEMP-33) below.

The specific example group G2B includes, for instance, substituted heterocyclic groups including a nitrogen atom (specific example group G2B1) below, substituted heterocyclic groups including an oxygen atom (specific example group G2B2) below, substituted heterocyclic groups including a sulfur atom (specific example group G2B3) below, and groups derived by substituting at least one hydrogen atom of the monovalent heterocyclic groups (specific example group G2B4) derived from the cyclic structures represented by formulae (TEMP-16) to (TEMP-33) below.

Unsubstituted Heterocyclic Groups Including Nitrogen Atom (Specific Example Group G2A1):
pyrrolyl group, imidazolyl group, pyrazolyl group, triazolyl group, tetrazolyl group, oxazolyl group, isoxazolyl group, oxadiazolyl group, thiazolyl group, isothiazolyl group, thiadiazolyl group, pyridyl group, pyridazynyl group, pyrimidinyl group, pyrazinyl group, triazinyl group, indolyl group, isoindolyl group, indolizinyl group, quinolizinyl group, quinolyl group, isoquinolyl group, cinnolyl group, phthalazinyl group, quinazolinyl group, quinoxalinyl group, benzimidazolyl group, indazolyl group, phenanthrolinyl group, phenanthridinyl group, acridinyl group, phenazinyl group, carbazolyl group, benzocarbazolyl group, morpholino group, phenoxazinyl group, phenothiazinyl group, azacarbazolyl group, and diazacarbazolyl group.

Unsubstituted Heterocyclic Groups Including Oxygen Atom (Specific Example Group G2A2):
furyl group, oxazolyl group, isoxazolyl group, oxadiazolyl group, xanthenyl group, benzofuranyl group, isobenzofuranyl group, a dibenzofuranyl group, naphthobenzofuranyl group, benzoxazolyl group, benzisoxazolyl group, phenoxazinyl group, morpholino group, dinaphthofuranyl group, azadibenzofuranyl group, diazadibenzofuranyl group, azanaphthobenzofuranyl group, and diazanaphthobenzofuranyl group.

Unsubstituted Heterocyclic Groups Including Sulfur Atom (Specific Example Group G2A3):
thienyl group, thiazolyl group, isothiazolyl group, thiadiazolyl group, benzothiophenyl group (benzothienyl group), isobenzothiophenyl group (isobenzothienyl group), dibenzothiophenyl group (dibenzothienyl group), naphthobenzothiophenyl group (nahthobenzothienyl group), benzothiazolyl group, benzisothiazolyl group, phenothiazinyl group, dinaphthothiophenyl group (dinaphthothienyl group), azadibenzothiophenyl group (azadibenzothienyl group), diazadibenzothiophenyl group (diazadibenzothienyl group), azanaphthobenzothiophenyl group (azanaphthobenzothienyl group), and diazanaphthobenzothiophenyl group (diazanaphthobenzothienyl group).

Monovalent Heterocyclic Groups Derived by Removing One Hydrogen Atom from Cyclic Structures Represented by Formulae (TEMP-16) to (TEMP-33) (Specific Example Group G2A4):

[Formula 6]

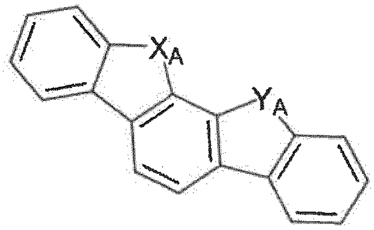

(TEMP-16)

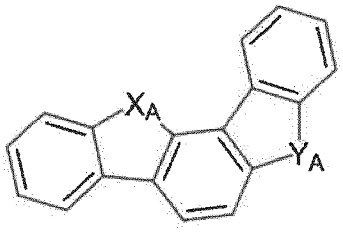

(TEMP-17)

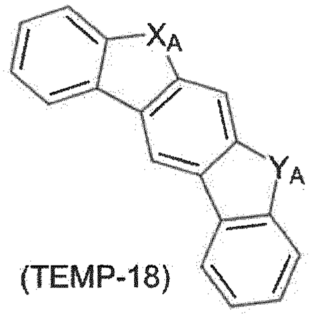

(TEMP-18)

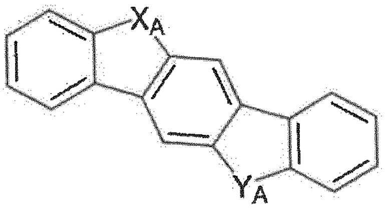

(TEMP-19)

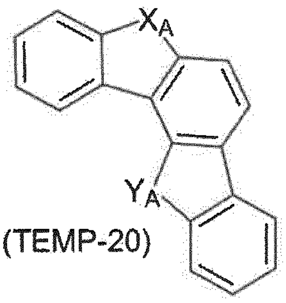

(TEMP-20)

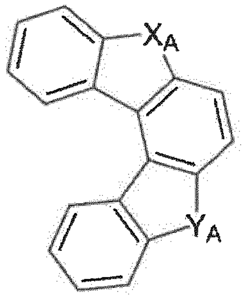

(TEMP-21)

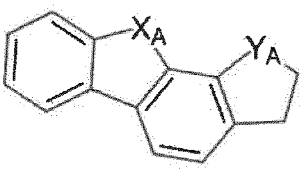

(TEMP-22)

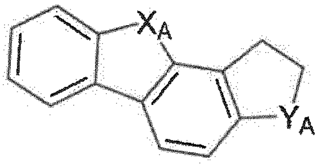

(TEMP-23)

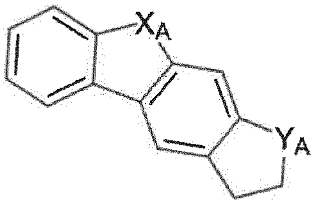

(TEMP-24)

[Formula 7]

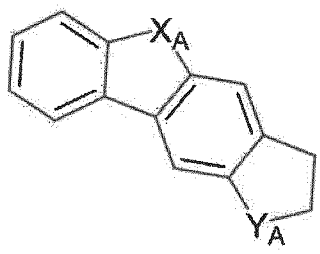

(TEMP-25)

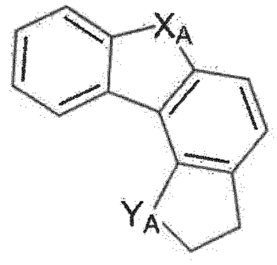

(TEMP-26)

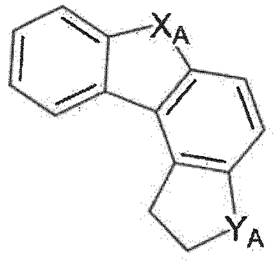

(TEMP-27)

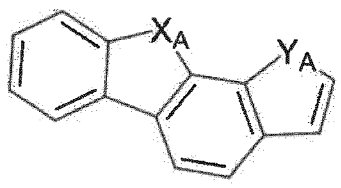

(TEMP-28)

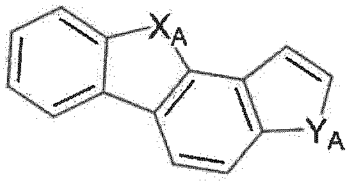

(TEMP-29)

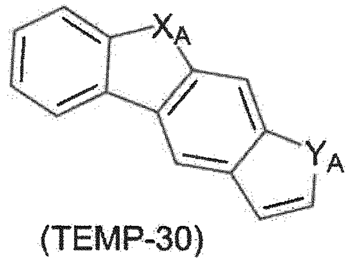

(TEMP-30)

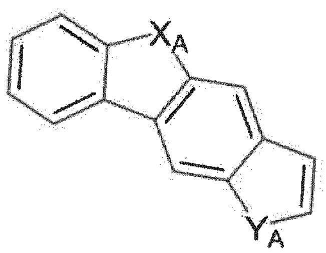

(TEMP-31)

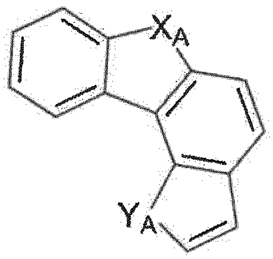

(TEMP-32)

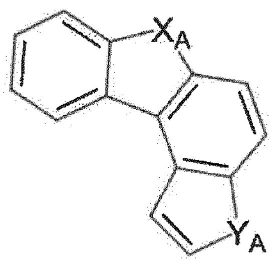

(TEMP-33)

In the formulae (TEMP-16) to (TEMP-33), $X_A$ and $Y_A$ are each independently an oxygen atom, a sulfur atom, NH, or $CH_2$, with a proviso that at least one of $X_A$ or $Y_A$ is an oxygen atom, a sulfur atom, or NH.

When at least one of $X_A$ or $Y_A$ in the formulae (TEMP-16) to (TEMP-33) is NH or $CH_2$, the monovalent heterocyclic groups derived from the cyclic structures represented by the formulae (TEMP-16) to (TEMP-33) include a monovalent group derived by removing one hydrogen atom from NH or $CH_2$.

Substituted Heterocyclic Groups Including Nitrogen Atom (Specific Example Group G2B1):
(9-phenyl)carbazolyl group, (9-biphenylyl)carbazolyl group, (9-phenyl)phenylcarbazolyl group, (9-naphthyl)carbazolyl group, diphenylcarbazole-9-yl group, phenylcarbazole-9-yl group, methylbenzimidazolyl group, ethylbenzimidazolyl group, phenyltriazinyl group, biphenylyltriazinyl group, diphenyltriazinyl group, phenylquinazolinyl group, and biphenylylquinazolinyl group.
Substituted Heterocyclic Groups Including Oxygen Atom (Specific Example Group G2B2):
phenyldibenzofuranyl group, methyldibenzofuranyl group, t-butyldibenzofuranyl group, and monovalent residue of spiro[9H-xanthene-9,9'-[9H]fluorene].
Substituted Heterocyclic Groups Including Sulfur Atom (Specific Example Group G2B3):
phenyldibenzothiophenyl group, methyldibenzothiophenyl group, t-butyldibenzothiophenyl group, and monovalent residue of spiro[9H-thioxanthene-9,9'-[9H]fluorene].

Groups Obtained by Substituting at Least One Hydrogen Atom of Monovalent Heterocyclic Group Derived from Cyclic Structures Represented by Formulae (TEMP-16) to (TEMP-33) with Substituent (Specific Example Group G2B4):

The "at least one hydrogen atom of a monovalent heterocyclic group" means at least one hydrogen atom selected from a hydrogen atom bonded to a ring carbon atom of the monovalent heterocyclic group, a hydrogen atom

bonded to a nitrogen atom of at least one of $X_A$ or $Y_A$ in a form of NH, and a hydrogen atom of one of $X_A$ and $Y_A$ in a form of a methylene group ($CH_2$).

Substituted or Unsubstituted Alkyl Group

Specific examples (specific example group G3) of the "substituted or unsubstituted alkyl group" mentioned herein include unsubstituted alkyl groups (specific example group G3A) and substituted alkyl groups (specific example group G3B) below.(Herein, an unsubstituted alkyl group refers to an "unsubstituted alkyl group" in a "substituted or unsubstituted alkyl group," and a substituted alkyl group refers to a "substituted alkyl group" in a "substituted or unsubstituted alkyl group.")A simply termed "alkyl group" herein includes both of "unsubstituted alkyl group" and "substituted alkyl group."

The "substituted alkyl group" refers to a group derived by substituting at least one hydrogen atom in an "unsubstituted alkyl group" with a substituent. Specific examples of the "substituted alkyl group" include a group derived by substituting at least one hydrogen atom of an "unsubstituted alkyl group" (specific example group G3A) below with a substituent, and examples of the substituted alkyl group (specific example group G3B) below. Herein, the alkyl group for the "unsubstituted alkyl group" refers to a chain alkyl group. Accordingly, the "unsubstituted alkyl group" include linear "unsubstituted alkyl group" and branched "unsubstituted alkyl group. "It should be noted that the examples of the "unsubstituted alkyl group" and the "substituted alkyl group" mentioned herein are merely exemplary, and the "substituted alkyl group" mentioned herein includes a group derived by further substituting a hydrogen atom of a skeleton of the "substituted alkyl group" in the specific example group G3B, and a group derived by further substituting a hydrogen atom of a substituent of the "substituted alkyl group" in the specific example group G3B.

Unsubstituted Alkyl Group (Specific Example Group G3A):
methyl group, ethyl group, n-propyl group, isopropyl group, n-butyl group, isobutyl group, s-butyl group, and t-butyl group.
Substituted Alkyl Group (Specific Example Group G3B):
heptafluoropropyl group (including isomer thereof), pentafluoroethyl group, 2,2,2-trifluoroethyl group, and trifluoromethyl group.

Substituted or Unsubstituted Alkenyl Group

Specific examples (specific example group G4) of the "substituted or unsubstituted alkenyl group" mentioned herein include unsubstituted alkenyl groups (specific example group G4A) and substituted alkenyl groups (specific example group G4B). (Herein, an unsubstituted alkenyl group refers to an "unsubstituted alkenyl group" in a "substituted or unsubstituted alkenyl group," and a substituted alkenyl group refers to a "substituted alkenyl group" in a "substituted or unsubstituted alkenyl group.")A simply termed "alkenyl group" herein includes both of "unsubstituted alkenyl group" and "substituted alkenyl group."

The "substituted alkenyl group" refers to a group derived by substituting at least one hydrogen atom in an "unsubstituted alkenyl group" with a substituent. Specific examples of the "substituted alkenyl group" include an "unsubstituted alkenyl group" (specific example group G4A) substituted by a substituent, and examples of the substituted alkenyl group (specific example group G4B) below. It should be noted that the examples of the "unsubstituted alkenyl group" and the "substituted alkenyl group" mentioned herein are merely exemplary, and the "substituted alkenyl group" mentioned herein includes a group derived by further substituting a hydrogen atom of a skeleton of the "substituted alkenyl group" in the specific example group G4B with a substituent, and a group derived by further substituting a hydrogen atom of a substituent of the "substituted alkenyl group" in the specific example group G4B with a substituent.

Unsubstituted Alkenyl Group (Specific Example Group G4A):
vinyl group, allyl group, 1-butenyl group, 2-butenyl group, and 3-butenyl group.
Substituted Alkenyl Group (Specific Example Group G4B):
1,3-butanedienyl group, 1-methylvinyl group, 1-methylallyl group, 1,1-dimethylallyl group, 2-methylallyl group, and 1,2-dimethylallyl group.

Substituted or Unsubstituted Alkynyl Group

Specific examples (specific example group G5) of the "substituted or unsubstituted alkynyl group" mentioned herein include unsubstituted alkynyl groups (specific example group G5A) below. (Herein, an unsubstituted alkynyl group refers to an "unsubstituted alkynyl group" in a "substituted or unsubstituted alkynyl group.")A simply termed "alkynyl group" herein includes both of "unsubstituted alkynyl group" and "substituted alkynyl group."

The "substituted alkynyl group" refers to a group derived by substituting at least one hydrogen atom in an "unsubstituted alkynyl group" with a substituent. Specific examples of the "substituted alkynyl group" include a group derived by substituting at least one hydrogen atom of the "unsubstituted alkynyl group" (specific example group G5A) below with a substituent.
Unsubstituted Alkynyl Group (Specific Example Group G5A):
ethynyl group.

Substituted or Unsubstituted Cycloalkyl Group

Specific examples (specific example group G6) of the "substituted or unsubstituted cycloalkyl group" mentioned herein include unsubstituted cycloalkyl groups (specific example group G6A) and substituted cycloalkyl groups (specific example group G6B). (Herein, an unsubstituted cycloalkyl group refers to an "unsubstituted cycloalkyl group" in a "substituted or unsubstituted cycloalkyl group," and a substituted cycloalkyl group refers to a "substituted cycloalkyl group" in a "substituted or unsubstituted cycloalkyl group.")A simply termed "cycloalkyl group" herein includes both of "unsubstituted cycloalkyl group" and "substituted cycloalkyl group."
The "substituted cycloalkyl group" refers to a group derived by substituting at least one hydrogen atom of an "unsubstituted cycloalkyl group" with a substituent. Specific examples of the "substituted cycloalkyl group" include a group derived by substituting at least one hydrogen atom of the "unsubstituted cycloalkyl group" (specific example group G6A) below with a substituent, and examples of the substituted cycloalkyl group (specific example group G6B) below. It should be noted that the examples of the "unsubstituted cycloalkyl group" and the "substituted cycloalkyl group" mentioned herein are merely exemplary, and the "substituted cycloalkyl group" mentioned herein includes a group derived by substituting at least one hydrogen atom bonded to a carbon atom of a skeleton of the "substituted cycloalkyl group" in the specific example group G6B with a substituent, and a group derived by further substituting a hydrogen atom of a substituent of the "substituted cycloalkyl group" in the specific example group G6B with a substituent.

Unsubstituted Cycloalkyl Group (Specific Example Group G6A):
cyclopropyl group, cyclobutyl group, cyclopentyl group, cyclohexyl group, 1-adamantyl group, 2-adamantyl group, 1-norbornyl group, and 2-norbornyl group.
Substituted Cycloalkyl Group (Specific Example Group G6B):
4-methylcyclohexyl group.

Group Represented by -Si($R_{901}$)($R_{902}$)($R_{903}$)

Specific examples (specific example group G7) of the group represented herein by -Si($R_{901}$)($R_{902}$)($R_{903}$) include: -Si(G1)(G1)(G1); -Si(G1)(G2)(G2); - Si(G1)(G1)(G2); -Si(G2)(G2)(G2); -Si(G3)(G3)(G3); and -Si(G6)(G6)(G6), where:
G1 represents a "substituted or unsubstituted aryl group" in the specific example group G1;

G2 represents a "substituted or unsubstituted heterocyclic group" in the specific example group G2;
G3 represents a "substituted or unsubstituted alkyl group" in the specific example group G3;
G6 represents a "substituted or unsubstituted cycloalkyl group" in the specific example group G6;
a plurality of G1 in -Si(G1)(G1)(G1) are mutually the same or different;
a plurality of G2 in -Si(G1)(G2)(G2) are mutually the same or different;
a plurality of G1 in -Si(G1)(G1)(G2) are mutually the same or different;
a plurality of G2 in -Si(G2)(G2)(G2) are mutually the same or different;
a plurality of G3 in -Si(G3)(G3)(G3) are mutually the same or different; and
a plurality of G6 in -Si(G6)(G6)(G6) are mutually the same or different.

Group Represented by -O-($R_{904}$)

Specific examples (specific example group G8) of a group represented by -O-($R_{904}$) herein include: -O(G1); -O(G2); -O(G3); and -O(G6),
where:

G1 represents a "substituted or unsubstituted aryl group" in the specific example group G1;
G2 represents a "substituted or unsubstituted heterocyclic group" in the specific example group G2;
G3 represents a "substituted or unsubstituted alkyl group" in the specific example group G3; and
G6 represents a "substituted or unsubstituted cycloalkyl group" in the specific example group G6.

Group Represented by -S-($R_{905}$)

Specific examples (specific example group G9) of a group represented herein by -S-($R_{905}$) include: -S(G1); -S(G2); -S(G3); and -S(G6), where:

G1 represents a "substituted or unsubstituted aryl group" in the specific example group G1;
G2 represents a "substituted or unsubstituted heterocyclic group" in the specific example group G2;
G3 represents a "substituted or unsubstituted alkyl group" in the specific example group G3; and
G6 represents a "substituted or unsubstituted cycloalkyl group" in the specific example group G6.

Group Represented by -N($R_{906}$)($R_{907}$)

Specific examples (specific example group G10) of a group represented herein by -N($R_{906}$)($R_{907}$) include: -N(G1)(G1); -N(G2)(G2); -N(G1)(G2); - N(G3)(G3); and -N(G6)(G6), where:

G1 represents a "substituted or unsubstituted aryl group" in the specific example group G1;
G2 represents a "substituted or unsubstituted heterocyclic group" in the specific example group G2;
G3 represents a "substituted or unsubstituted alkyl group" in the specific example group G3;
G6 represents a "substituted or unsubstituted cycloalkyl group" in the specific example group G6;
a plurality of G1 in -N(G1)(G1) are mutually the same or different;
a plurality of G2 in -N(G2)(G2) are mutually the same or different;
a plurality of G3 in -N(G3)(G3) are mutually the same or different; and
a plurality of G6 in -N(G6)(G6) are mutually the same or different.

Halogen Atom

Specific examples (specific example group G11) of "halogen atom" mentioned herein include a fluorine atom, chlorine atom, bromine atom, and iodine atom.

Substituted or Unsubstituted Fluoroalkyl Group

The "substituted or unsubstituted fluoroalkyl group" mentioned herein refers to a group derived by substituting at least one hydrogen atom bonded to at least one of carbon atoms forming an alkyl group in the "substituted or unsubstituted alkyl group" with a fluorine atom, and also includes a group (perfluoro group) derived by substituting all of hydrogen atoms bonded to carbon atoms forming the alkyl group in the "substituted or unsubstituted alkyl group" with fluorine atoms. An "unsubstituted fluoroalkyl group" has, unless otherwise specified herein, 1 to 50, preferably 1 to 30, more preferably 1 to 18 carbon atoms. The "substituted fluoroalkyl group" refers to a group derived by substituting at least one hydrogen atom in a "fluoroalkyl group" with a substituent. It should be noted that the examples of the "substituted fluoroalkyl group" mentioned herein include a group derived by further substituting at least one hydrogen atom bonded to a carbon atom of an alkyl chain of a "substituted fluoroalkyl group" with a substituent, and a group derived by further substituting at least one hydrogen atom of a substituent of the "substituted fluoroalkyl group" with a substituent. Specific examples of the "substituted fluoroalkyl group" include a group derived by substituting at least one hydrogen atom of the "alkyl group" (specific example group G3) with a fluorine atom.

Substituted or Unsubstituted Haloalkyl Group

The "substituted or unsubstituted haloalkyl group" mentioned herein refers to a group derived by substituting at least one hydrogen atom bonded to carbon atoms forming the alkyl group in the "substituted or unsubstituted alkyl group" with a halogen atom, and also includes a group derived by substituting all hydrogen atoms bonded to carbon atoms forming the alkyl group in the "substituted or unsubstituted alkyl group" with halogen atoms. An "unsubstituted haloalkyl group" has, unless otherwise specified herein, 1 to 50, preferably 1 to 30, more preferably 1 to 18 carbon atoms. The "substituted haloalkyl group" refers to a group derived by substituting at least one hydrogen atom in a "haloalkyl group" with a substituent. It should be noted that the examples of the "substituted haloalkyl group" mentioned herein include a group derived by further substituting at least one hydrogen atom bonded to a carbon atom of an alkyl chain of a "substituted haloalkyl group" with a substituent, and a group derived by further substituting at least one hydrogen atom of a substituent of the "substituted haloalkyl group" with a substituent. Specific examples of the "unsubstituted haloalkyl group" include a group derived by substituting at least one hydrogen atom of the "alkyl group" (specific example group G3) with a halogen atom. The haloalkyl group is sometimes referred to as a halogenated alkyl group.

Substituted or Unsubstituted Alkoxy Group

Specific examples of a "substituted or unsubstituted alkoxy group" mentioned herein include a group represented by -O(G3), G3 being the "substituted or unsubstituted alkyl group" in the specific example group G3. An "unsubstituted alkoxy group" has, unless otherwise specified herein, 1 to 50, preferably 1 to 30, more preferably 1 to 18 carbon atoms.

Substituted or Unsubstituted Alkylthio Group

Specific examples of a "substituted or unsubstituted alkylthio group" mentioned herein include a group represented by -S(G3), G3 being the "substituted or unsubstituted alkyl group" in the specific example group G3. An "unsubstituted alkylthio group" has, unless otherwise specified herein, 1 to 50, preferably 1 to 30, more preferably 1 to 18 carbon atoms.

Substituted or Unsubstituted Aryloxy Group

Specific examples of a "substituted or unsubstituted aryloxy group" mentioned herein include a group represented by -O(G1), G1 being the "substituted or unsubstituted aryl group" in the specific example group G1. An "unsubstituted aryloxy group" has, unless otherwise specified herein, 6 to 50, preferably 6 to 30, more preferably 6 to 18 ring carbon atoms.

Substituted or Unsubstituted Arylthio Group

Specific examples of a "substituted or unsubstituted arylthio group" mentioned herein include a group represented by -S(G1), G1 being the "substituted or unsubstituted aryl group" in the specific example group G1. An "unsubstituted arylthio group" has, unless otherwise specified herein, 6 to 50, preferably 6 to 30, more preferably 6 to 18 ring carbon atoms.

Substituted or Unsubstituted Trialkylsilyl Group

Specific examples of a "trialkylsilyl group" mentioned herein include a group represented by -Si(G3)(G3)(G3), G3 being the "substituted or unsubstituted alkyl group" in the specific example group G3. The plurality of G3 in -Si(G3)(G3)(G3) are mutually the same or different. Each of the alkyl groups in the "trialkylsilyl group" has, unless otherwise specified herein, 1 to 50, preferably 1 to 20, more preferably 1 to 6 carbon atoms.

Substituted or Unsubstituted Aralkyl Group

Specific examples of a "substituted or unsubstituted aralkyl group" mentioned herein include a group represented by (G3)-(G1), G3 being the "substituted or unsubstituted alkyl group" in the specific example group G3, G1 being the "substituted or unsubstituted aryl group" in the specific example group G1. Accordingly, the "aralkyl group" is a group derived by substituting a hydrogen atom of the "alkyl group" with a substituent in a form of the "aryl group," which is an example of the "substituted alkyl group. "An "unsubstituted aralkyl group," which is an "unsubstituted alkyl group" substituted by an "unsubstituted aryl group," has, unless otherwise specified herein, 7 to 50 carbon atoms, preferably 7 to 30 carbon atoms, more preferably 7 to 18 carbon atoms.

Specific examples of the "substituted or unsubstituted aralkyl group" include a benzyl group, 1-phenylethyl group, 2-phenylethyl group, 1-phenylisopropyl group, 2-phenylisopropyl group, phenyl-t-butyl group, α-naphthylmethyl group, 1-α-naphthylethyl group, 2-α-naphthylethyl group, 1-α-naphthylisopropyl group, 2-α-naphthylisopropyl group, β-naphthylmethyl group, 1-β-naphthylethyl group, 2-β-naphthylethyl group, 1-β-naphthylisopropyl group, and 2-β-naphthylisopropyl group.

Preferable examples of the substituted or unsubstituted aryl group mentioned herein include, unless otherwise specified herein, a phenyl group, p-biphenyl group, m-biphenyl group, o-biphenyl group, p-terphenyl-4-yl group, p-terphenyl-3-yl group, p-terphenyl-2-yl group, m-terphenyl-4-yl group, m-terphenyl-3-yl group, m-terphenyl-2-yl group, o-terphenyl-4-yl group, o-terphenyl-3-yl group, o-terphenyl-2-yl group, 1-naphthyl group, 2-naphthyl group, anthryl group, phenanthryl group, pyrenyl group, chrysenyl group, triphenylenyl group, fluorenyl group, 9,9'-spirobifluorenyl group, 9,9-dimethylfluorenyl group, and 9,9-diphenylfluorenyl group.

Preferable examples of the substituted or unsubstituted heterocyclic group mentioned herein include, unless

otherwise specified herein, a pyridyl group, pyrimidinyl group, triazinyl group, quinolyl group, isoquinolyl group, quinazolinyl group, benzimidazolyl group, phenanthrolinyl group, carbazolyl group (1-carbazolyl group, 2-carbazolyl group, 3-carbazolyl group, 4-carbazolyl group, or 9-carbazolyl group), benzocarbazolyl group, azacarbazolyl group, diazacarbazolyl group, dibenzofuranyl group, naphthobenzofuranyl group, azadibenzofuranyl group, diazadibenzofuranyl group, dibenzothiophenyl group, naphthobenzothiophenyl group, azadibenzothiophenyl group, diazadibenzothiophenyl group, (9-phenyl)carbazolyl group ((9-phenyl)carbazole-1-yl group, (9-phenyl)carbazole-2-yl group, (9-phenyl)carbazole-3-yl group, or (9-phenyl)carbazole-4-yl group), (9-biphenylyl)carbazolyl group, (9-phenyl)phenylcarbazolyl group, diphenylcarbazole-9-yl group, phenylcarbazole-9-yl group, phenyltriazinyl group, biphenylyltriazinyl group, diphenyltriazinyl group, phenyldibenzofuranyl group, and phenyldibenzothiophenyl group.

The carbazolyl group mentioned herein is, unless otherwise specified herein, specifically a group represented by one of formulae below.

[Formula 8]

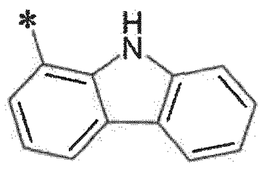

(TEMP-Cz1)

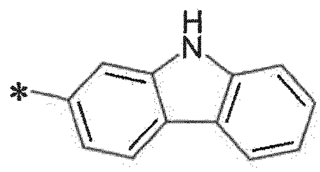

(TEMP-Cz2)

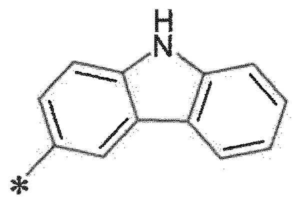

(TEMP-Cz3)

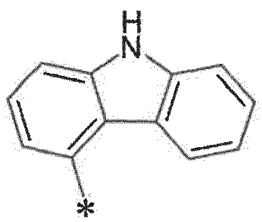

(TEMP-Cz4)

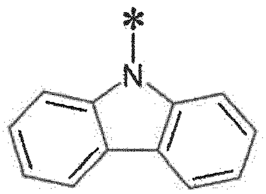

(TEMP-Cz5)

[0080]

The (9-phenyl)carbazolyl group mentioned herein is, unless otherwise specified herein, specifically a group represented by one of formulae below.

[Formula 9]

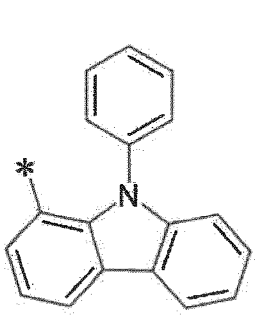

(TEMP-Cz6)

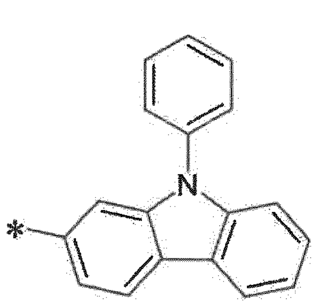

(TEMP-Cz7)

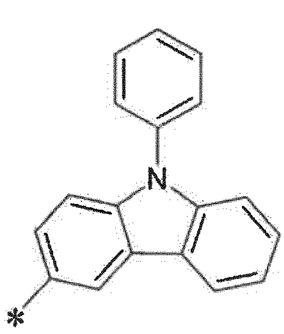

(TEMP-Cz8)

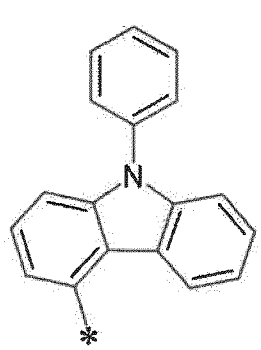

(TEMP-Cz9)

In the formulae (TEMP-Cz1) to (TEMP-Cz9), * represents a bonding position.

The dibenzofuranyl group and dibenzothiophenyl group mentioned herein are, unless otherwise specified herein, each specifically represented by one of formulae below.

[Formula 10]

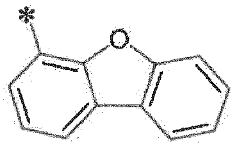
(TEMP-34)

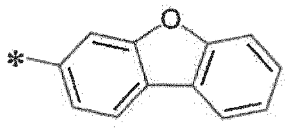
(TEMP-35)

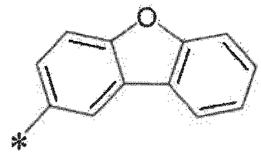
(TEMP-36)

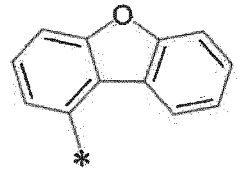
(TEMP-37)

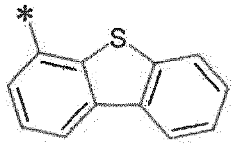
(TEMP-38)

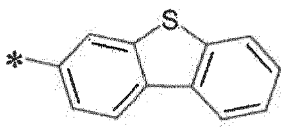
(TEMP-39)

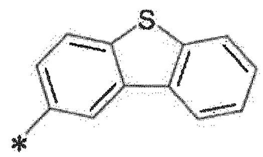
(TEMP-40)

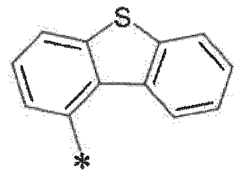
(TEMP-41)

In the formulae (TEMP-34) to (TEMP-41), * represents a bonding position.

Preferable examples of the substituted or unsubstituted alkyl group mentioned herein include, unless otherwise specified herein, a methyl group, ethyl group, propyl group, isopropyl group, n-butyl group, isobutyl group, and t-butyl group.

Substituted or Unsubstituted Arylene Group

The "substituted or unsubstituted arylene group" mentioned herein is, unless otherwise specified herein, a divalent group derived by removing one hydrogen atom on an aryl ring of the "substituted or unsubstituted aryl group. "Specific examples of the "substituted or unsubstituted arylene group" (specific example group G12) include a divalent group derived by removing one hydrogen atom on an aryl ring of the "substituted or unsubstituted aryl group" in the specific example group G1.

Substituted or Unsubstituted Divalent Heterocyclic Group

The "substituted or unsubstituted divalent heterocyclic group" mentioned herein is, unless otherwise specified herein, a divalent group derived by removing one hydrogen atom on a heterocycle of the "substituted or unsubstituted heterocyclic group. "Specific examples of the "substituted or unsubstituted divalent heterocyclic group" (specific example group G13) include a divalent group derived by removing one hydrogen atom on a heterocyclic ring of the "substituted or unsubstituted heterocyclic group" in the specific example group G2.

Substituted or Unsubstituted Alkylene Group

The "substituted or unsubstituted alkylene group" mentioned herein is, unless otherwise specified herein, a divalent group derived by removing one hydrogen atom on an alkyl chain of the "substituted or unsubstituted alkyl group. "Specific examples of the "substituted or unsubstituted alkylene group" (specific example group G14) include a divalent group derived by removing one hydrogen atom on an alkyl chain of the "substituted or unsubstituted alkyl group" in the specific example group G3.

The substituted or unsubstituted arylene group mentioned herein is, unless otherwise specified herein, preferably any one of groups represented by formulae (TEMP-42) to (TEMP-68) below.

[Formula 11]

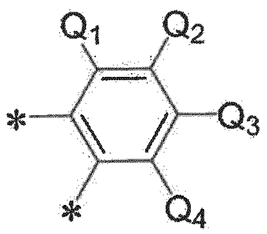

(TEMP-42)

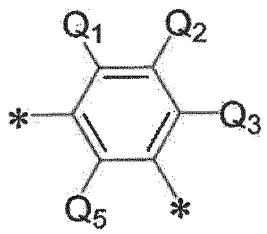

(TEMP-43)

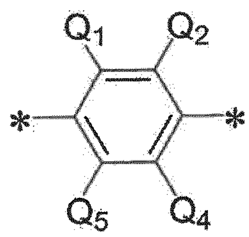

(TEMP-44)

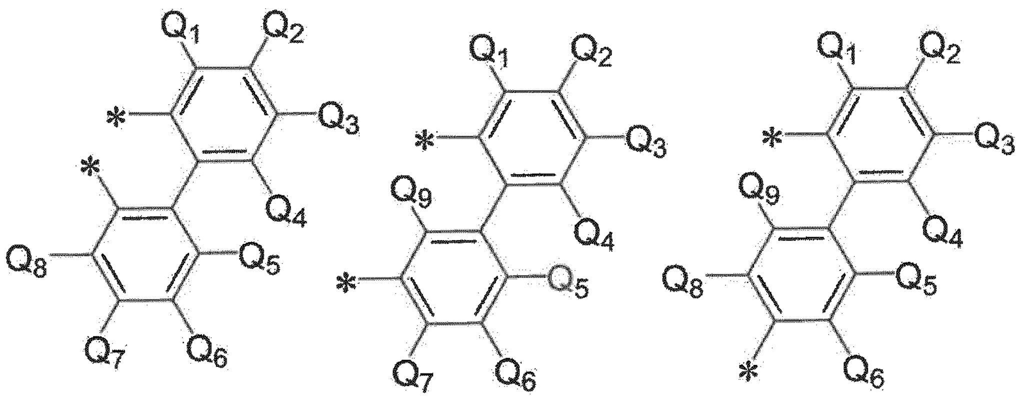

(TEMP-45) (TEMP-46) (TEMP-47)

[Formula 12]

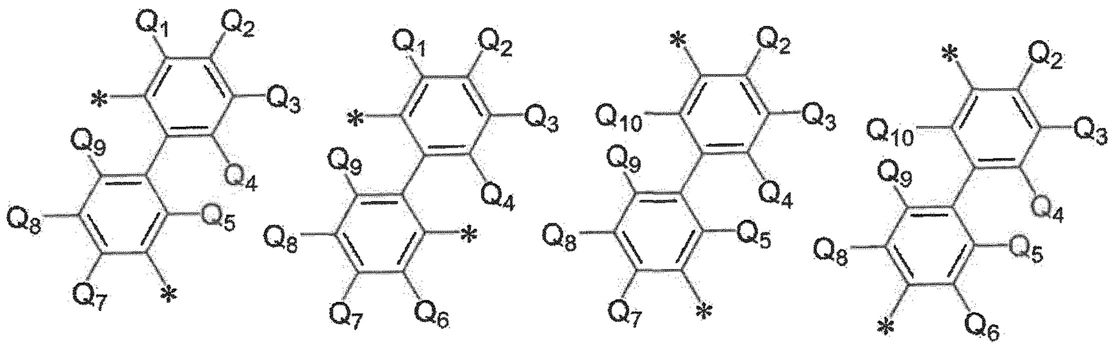

(TEMP-48) (TEMP-49) (TEMP-50) (TEMP-51)

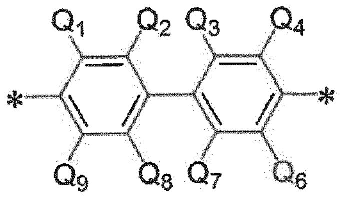

(TEMP-52)

In the formulae (TEMP-42) to (TEMP-52), $Q_1$ to $Q_{10}$ are each independently a hydrogen atom or a substituent.

In the formulae (TEMP-42) to (TEMP-52), * represents a bonding position.

[Formula 13]

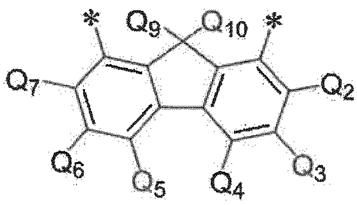

(TEMP-53)

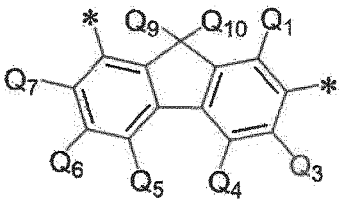

(TEMP-54)

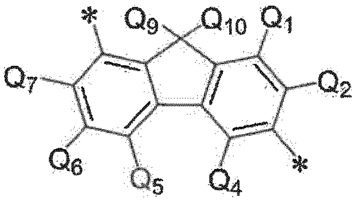

(TEMP-55)

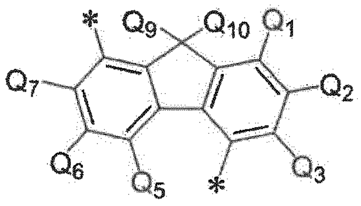

(TEMP-56)

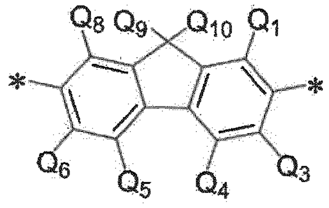

(TEMP-57)

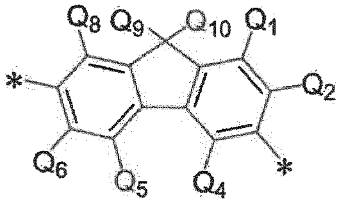

(TEMP-58)

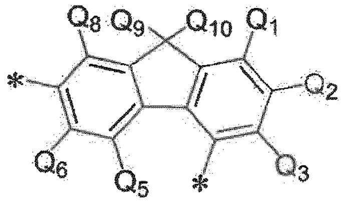

(TEMP-59)

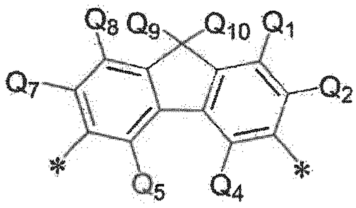

(TEMP-60)

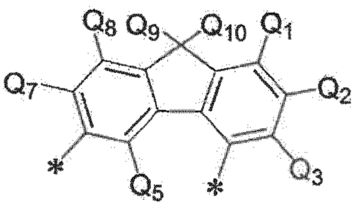

(TEMP-61)

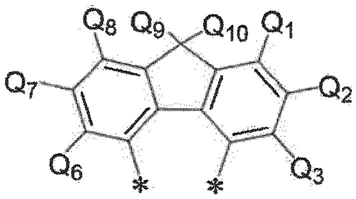

(TEMP-62)

In the formulae (TEMP-53) to (TEMP-62), $Q_1$ to $Q_{10}$ are each independently a hydrogen atom or a substituent.

In the formulae, $Q_9$ and $Q_{10}$ may be mutually bonded through a single bond to form a ring.

In the formulae (TEMP-53) to (TEMP-62), * represents a bonding position.

[Formula 14]

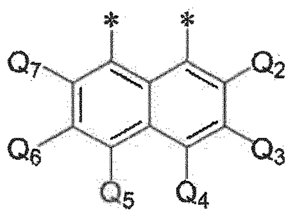

(TEMP-63)

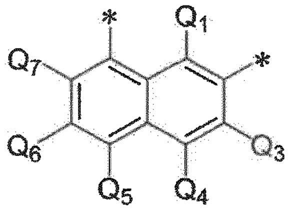

(TEMP-64)

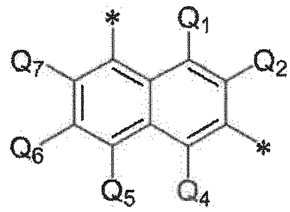

(TEMP-65)

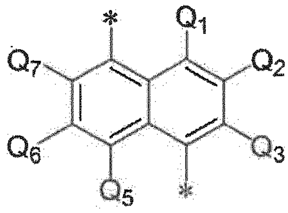

(TEMP-66)

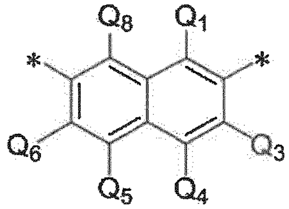

(TEMP-67)

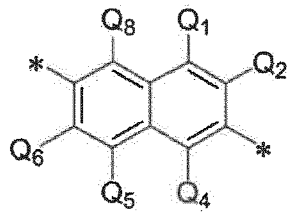

(TEMP-68)

In the formulae (TEMP-63) to (TEMP-68), $Q_1$ to $Q_8$ are each independently a hydrogen atom or a substituent.

In the formulae (TEMP-63) to (TEMP-68), * represents a bonding position.

The substituted or unsubstituted divalent heterocyclic group mentioned herein is, unless otherwise specified herein, preferably a group represented by any one of formulae (TEMP-69) to (TEMP-102) below.

[Formula 15]

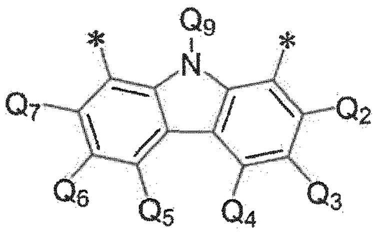

(TEMP-69)

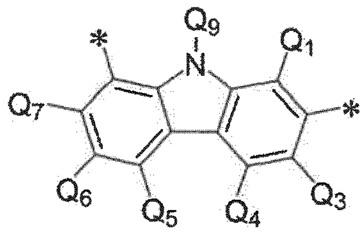

(TEMP-70)

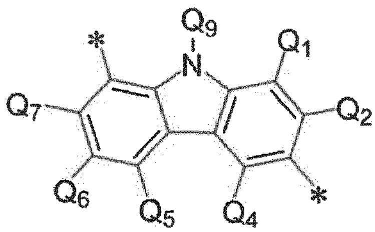

(TEMP-71)

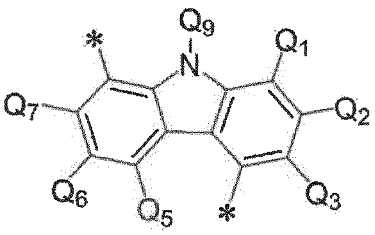

(TEMP-72)

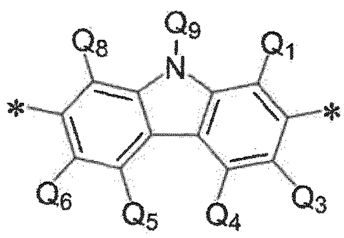

(TEMP-73)

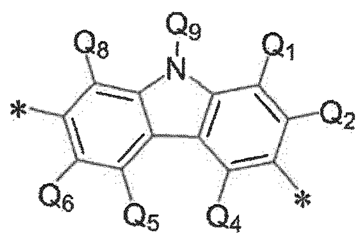

(TEMP-74)

[Formula 16]

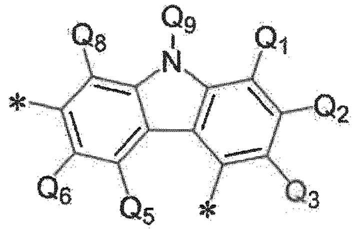

(TEMP-75)

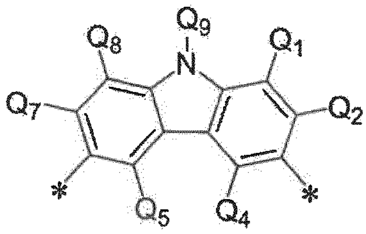

(TEMP-76)

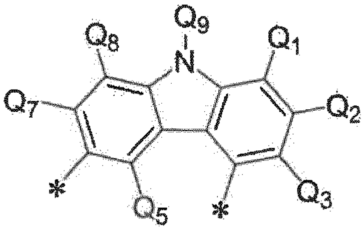

(TEMP-77)

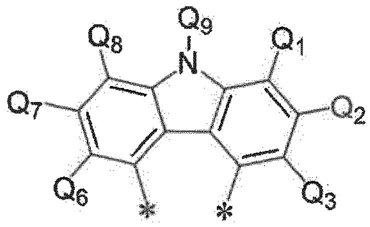

(TEMP-78)

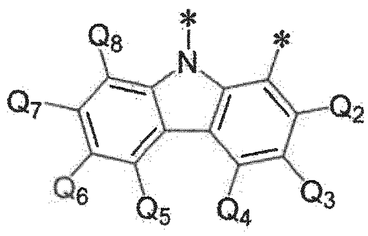

(TEMP-79)

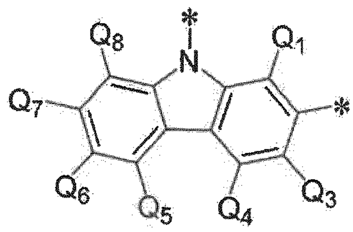

(TEMP-80)

[Formula 17]

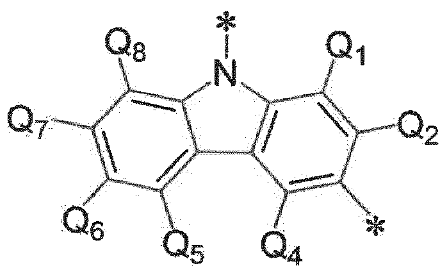

(TEMP-81)

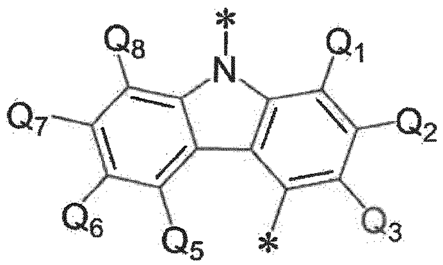

(TEMP-82)

In the formulae (TEMP-69) to (TEMP-82), $Q_1$ to $Q_9$ are each independently a hydrogen atom or a substituent.

[Formula 18]

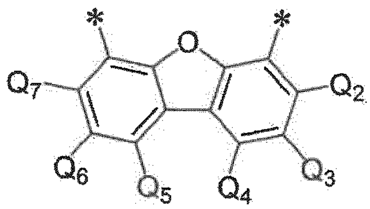

(TEMP-83)

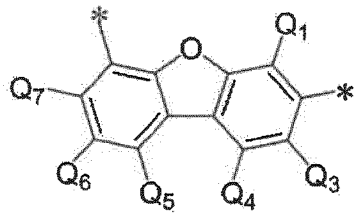

(TEMP-84)

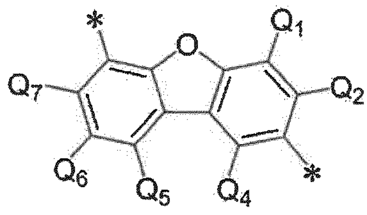

(TEMP-85)

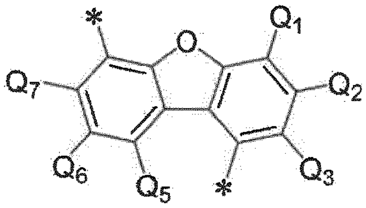

(TEMP-86)

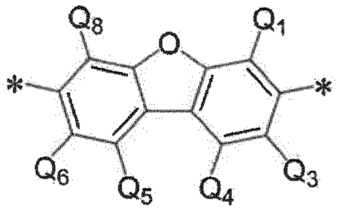

(TEMP-87)

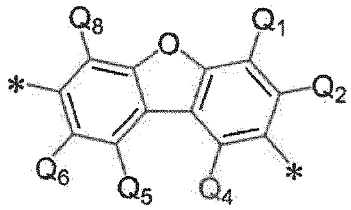

(TEMP-88)

[Formula 19]

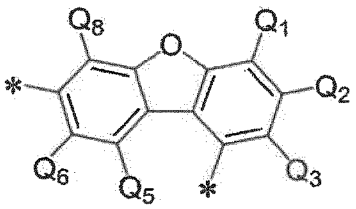

(TEMP-89)

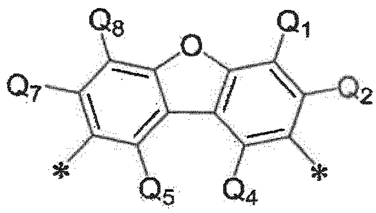

(TEMP-90)

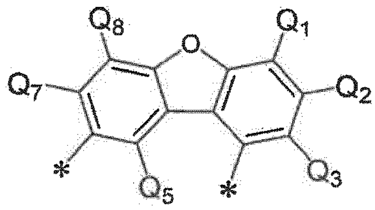

(TEMP-91)

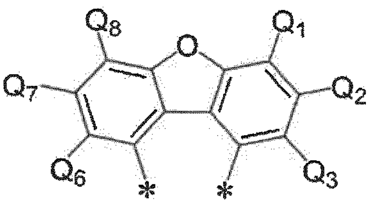

(TEMP-92)

[Formula 20]

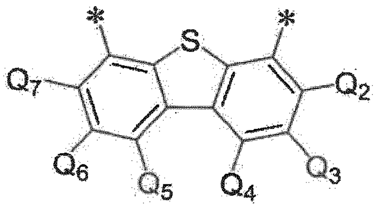

(TEMP-93)

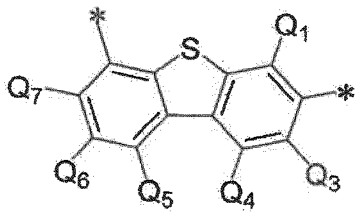

(TEMP-94)

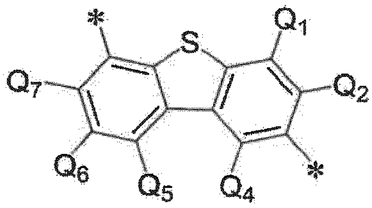

(TEMP-95)

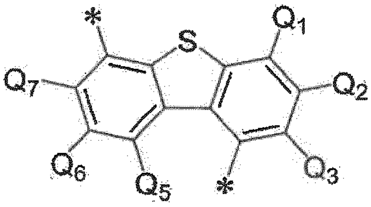

(TEMP-96)

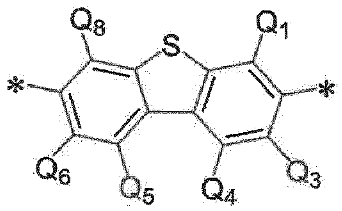

(TEMP-97)

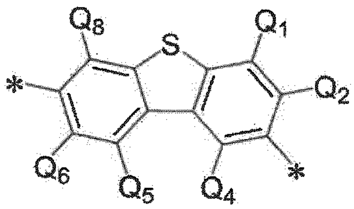

(TEMP-98)

[Formula 21]

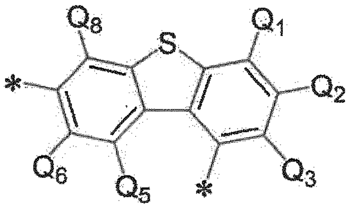

(TEMP-99)

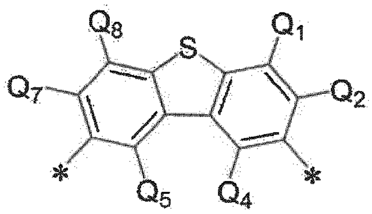

(TEMP-100)

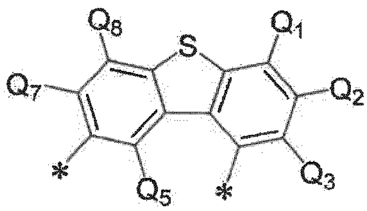

(TEMP-101)

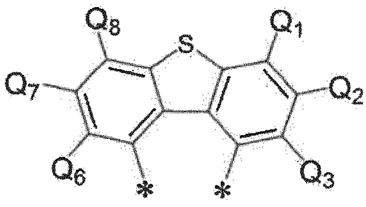

(TEMP-102)

In the formulae (TEMP-83) to (TEMP-102), $Q_1$ to $Q_8$ are each independently a hydrogen atom or a substituent.
The substituent mentioned herein has been described above.

Instance of "Bonded to Form Ring"

Instances where "at least one combination of adjacent two or more (of...) are mutually bonded to form a substituted or unsubstituted monocyclic ring, mutually bonded to form a substituted or unsubstituted fused ring, or not mutually bonded" mentioned herein refer to instances where "at least one combination of adjacent two or more (of...) are mutually bonded to form a substituted or unsubstituted monocyclic ring, "at least one combination of adjacent two or more (of...) are mutually bonded to form a substituted or unsubstituted fused ring," and "at least one combination of adjacent two or more (of...) are not mutually bonded."
Instances where "at least one combination of adjacent two or more (of...) are mutually bonded to form a substituted or unsubstituted monocyclic ring" and "at least one combination of adjacent two or more (of...) are mutually bonded to form a substituted or unsubstituted fused ring" mentioned herein (these instances will be sometimes collectively referred to as an instance of "bonded to form a ring" hereinafter) will be described below. An anthracene compound having a basic skeleton in a form of an anthracene ring and represented by a formula (TEMP-103) below will be used as an example for the description.

[Formula 22]

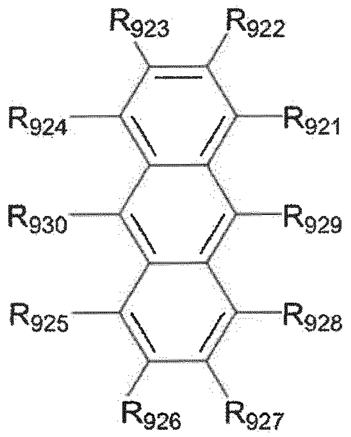

(TEMP-103)

For instance, when "at least one combination of adjacent two or more of $R_{921}$ to $R_{930}$ are mutually bonded to form a ring," the combination of adjacent ones of $R_{921}$ to $R_{930}$ (i.e. the combination at issue) is a combination of $R_{921}$ and $R_{922}$, a combination of $R_{922}$ and $R_{923}$, a combination of $R_{923}$ and $R_{924}$, a combination of $R_{924}$ and $R_{930}$, a combination of $R_{930}$ and $R_{925}$, a combination of $R_{925}$ and $R_{926}$, a combination of $R_{926}$ and $R_{927}$, a combination of $R_{927}$ and $R_{928}$, a combination of $R_{928}$ and $R_{929}$, or a combination of $R_{929}$ and $R_{921}$.

The term "at least one combination" means that two or more of the above combinations of adjacent two or more of R921 to R930 may simultaneously form rings. For instance, when $R_{921}$ and $R_{922}$ are mutually bonded to form a ring $Q_A$ and $R_{925}$ and $R_{926}$ are simultaneously mutually bonded to form a ring $Q_B$, the anthracene compound represented by the formula (TEMP-103) is represented by a formula (TEMP-104) below.

[Formula 23]

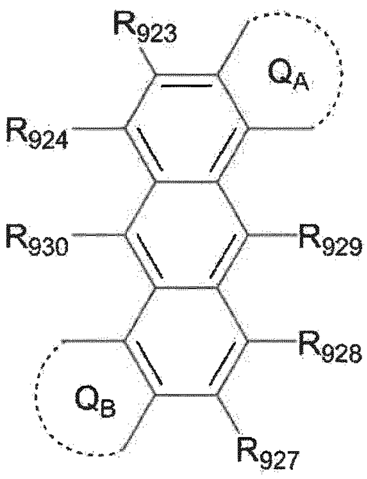

(TEMP-104)

The instance where the "combination of adjacent two or more" form a ring means not only an instance where the "two" adjacent components are bonded but also an instance where adjacent "three or more" are bonded. For instance, $R_{921}$ and $R_{922}$ are mutually bonded to form a ring $Q_A$ and $R_{922}$ and $R_{923}$ are mutually bonded to form a ring Qc, and mutually adjacent three components ($R_{921}$, $R_{922}$ and $R_{923}$) are mutually bonded to form a ring fused to the anthracene basic skeleton. In this case, the anthracene compound represented by the formula (TEMP-103) is represented by a formula (TEMP-105) below. In the formula (TEMP-105) below, the ring $Q_A$ and the ring Qc share $R_{922}$.

[Formula 24]

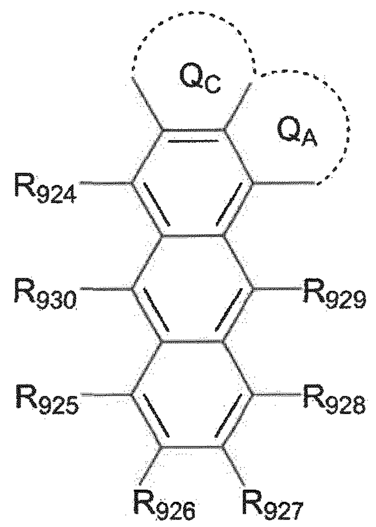

(TEMP-105)

The formed "monocyclic ring" or "fused ring" may be, in terms of the formed ring in itself, a saturated ring or an unsaturated ring. When the "combination of adjacent two" form a "monocyclic ring" or a "fused ring," the "monocyclic ring" or "fused ring" may be a saturated ring or an unsaturated ring. For instance, the ring $Q_A$ and the ring $Q_B$ formed in the formula (TEMP-104) are each independently a "monocyclic ring" or a "fused ring." Further, the ring $Q_A$ and the ring Qc formed in the formula (TEMP-105) are each a "fused ring." The ring $Q_A$ and the ring Qc in the formula (TEMP-105) are fused to form a fused ring. When the ring $Q_A$ in the formula (TMEP-104) is a benzene ring, the ring $Q_A$ is a monocyclic ring. When the ring $Q_A$ in the formula (TMEP-104) is a naphthalene ring, the ring $Q_A$ is a fused ring.

The "unsaturated ring" represents an aromatic hydrocarbon ring or an aromatic heterocycle. The "saturated ring" represents an aliphatic hydrocarbon ring or a non-aromatic heterocycle.

Specific examples of the aromatic hydrocarbon ring include a ring formed by terminating a bond of a group in the specific example of the specific example group G1 with a hydrogen atom.

Specific examples of the aromatic heterocycle include a ring formed by terminating a bond of an aromatic heterocyclic group in the specific example of the specific example group G2 with a hydrogen atom.

Specific examples of the aliphatic hydrocarbon ring include a ring formed by terminating a bond of a group in the specific example of the specific example group G6 with a hydrogen atom.

The phrase "to form a ring" herein means that a ring is formed only by a plurality of atoms of a basic skeleton, or by a combination of a plurality of atoms of the basic skeleton and one or more optional atoms. For instance, the ring $Q_A$ formed by mutually bonding $R_{921}$ and $R_{922}$ shown in the formula (TEMP-104) is a ring formed by a carbon atom of the anthracene skeleton bonded to $R_{921}$, a carbon atom of the anthracene skeleton bonded to $R_{922}$, and one or more optional atoms. Specifically, when the ring $Q_A$ is a monocyclic unsaturated ring formed by $R_{921}$ and $R_{922}$, the ring formed by a carbon atom of the anthracene skeleton bonded to $R_{921}$, a carbon atom of the anthracene skeleton bonded to $R_{922}$, and four carbon atoms is a benzene ring.

The "optional atom" is, unless otherwise specified herein, preferably at least one atom selected from the group consisting of a carbon atom, nitrogen atom, oxygen atom, and sulfur atom. A bond of the optional atom (e.g. a carbon atom and a nitrogen atom) not forming a ring may be terminated by a hydrogen atom or the like or may be substituted by an "optional substituent" described later. When the ring includes an optional element other than carbon atom, the resultant ring is a heterocycle.

The number of "one or more optional atoms" forming the monocyclic ring or fused ring is, unless otherwise specified herein, preferably in a range from 2 to 15, more preferably in a range from 3 to 12, further preferably in a range from 3 to 5.

Unless otherwise specified herein, the ring, which may be a "monocyclic ring" or "fused ring," is preferably a "monocyclic ring."

Unless otherwise specified herein, the ring, which may be a "saturated ring" or "unsaturated ring," is preferably an "unsaturated ring."

Unless otherwise specified herein, the "monocyclic ring" is preferably a benzene ring.

Unless otherwise specified herein, the "unsaturated ring" is preferably a benzene ring.

When "at least one combination of adjacent two or more" (of...) are "mutually bonded to form a substituted or unsubstituted monocyclic ring" or "mutually bonded to form a substituted or unsubstituted fused ring," unless otherwise specified herein, at least one combination of adjacent two or more of components are preferably mutually bonded to form a substituted or unsubstituted "unsaturated ring" formed of a plurality of atoms of the basic skeleton, and 1 to 15

atoms of at least one element selected from the group consisting of carbon, nitrogen, oxygen and sulfur.

When the "monocyclic ring" or the "fused ring" has a substituent, the substituent is the substituent described in later-described "optional substituent." When the "monocyclic ring" or the "fused ring" has a substituent, specific examples of the substituent are the substituents described in the above under the subtitle "Substituent Mentioned Herein."

When the "saturated ring" or the "unsaturated ring" has a substituent, the substituent is the substituent described in later-described "optional substituent." When the "monocyclic ring" or the "fused ring" has a substituent, specific examples of the substituent are the substituents described in the above under the subtitle "Substituent Mentioned Herein."

The above is the description for the instances where "at least one combination of adjacent two or more (of...) are mutually bonded to form a substituted or unsubstituted monocyclic ring" and "at least one combination of adjacent two or more (of...) are mutually bonded to form a substituted or unsubstituted fused ring" mentioned herein (sometimes referred to as an instance of "bonded to form a ring").

Substituent for Substituted or Unsubstituted Group

In an exemplary embodiment herein, a substituent for the substituted or unsubstituted group (sometimes referred to as an "optional substituent" hereinafter) is, for instance, a group selected from the group consisting of an unsubstituted alkyl group having 1 to 50 carbon atoms, an unsubstituted alkenyl group having 2 to 50 carbon atoms, an unsubstituted alkynyl group having 2 to 50 carbon atoms, an unsubstituted cycloalkyl group having 3 to 50 ring carbon atoms, $-Si(R_{901})(R_{902})(R_{903})$, $-O-(R_{904})$, $-S-(R_{905})$, $-N(R_{906})(R_{907})$, a halogen atom, a cyano group, a nitro group, an unsubstituted aryl group having 6 to 50 ring carbon atoms, and an unsubstituted heterocyclic group having 5 to 50 ring atoms;

$R_{901}$ to $R_{907}$ are each independently a hydrogen atom, a substituted or unsubstituted alkyl group having 1 to 50 carbon atoms, a substituted or unsubstituted cycloalkyl group having 3 to 50 ring carbon atoms, a substituted or unsubstituted aryl group having 6 to 50 ring carbon atoms, or a substituted or unsubstituted heterocyclic group having 5 to 50 ring atoms;
when two or more $R_{901}$ are present, the two or more $R_{901}$ are mutually the same or different;
when two or more $R_{902}$ are present, the two or more $R_{902}$ are mutually the same or different;
when two or more $R_{903}$ are present, the two or more $R_{903}$ are mutually the same or different;
when two or more $R_{904}$ are present, the two or more $R_{904}$ are mutually the same or different;
when two or more $R_{905}$ are present, the two or more $R_{905}$ are mutually the same or different;
when two or more $R_{906}$ are present, the two or more $R_{906}$ are mutually the same or different; and
when two or more $R_{907}$ are present, the two or more $R_{907}$ are mutually the same or different.

In an exemplary embodiment, a substituent for the substituted or unsubstituted group is selected from the group consisting of an alkyl group having 1 to 50 carbon atoms, an aryl group having 6 to 50 ring carbon atoms, and a heterocyclic group having 5 to 50 ring atoms.

In an exemplary embodiment, a substituent for the substituted or unsubstituted group is selected from the group consisting of an alkyl group having 1 to 18 carbon atoms, an aryl group having 6 to 18 ring carbon atoms, and a heterocyclic group having 5 to 18 ring atoms.

Specific examples of the above optional substituent are the same as the specific examples of the substituent described in the above under the subtitle "Substituent Mentioned Herein."

Unless otherwise specified herein, adjacent ones of the optional substituents may form a "saturated ring" or an "unsaturated ring," preferably a substituted or unsubstituted saturated five-membered ring, a substituted or unsubstituted saturated six-membered ring, a substituted or unsubstituted unsaturated five-membered ring, or a substituted or unsubstituted unsaturated six-membered ring, more preferably a benzene ring.

Unless otherwise specified herein, the optional substituent may further include a substituent. Examples of the substituent for the optional substituent are the same as the examples of the optional substituent.

Herein, numerical ranges represented by "AA to BB" represent a range whose lower limit is the value (AA) recited before "to" and whose upper limit is the value (BB) recited after "to."

First Exemplary Embodiment

A mixture according to the present exemplary embodiment is a mixture of two or more compounds. The mixture according to the present exemplary embodiment contains at least a first compound and a second compound. The two or more compounds contained in the mixture according to the present exemplary embodiment are compounds having structures different from each other. Herein, when the two or more compounds contained in the mixture according to the present exemplary embodiment are different from each other only in the type of hydrogen (protium, deuterium, and tritium), structures of the two or more compounds are not different from each other.

The two or more compounds contained in the mixture according to the present exemplary embodiment are two or more compounds selected from the group consisting of a compound represented by a formula (10) below, a compound represented by a formula (20) below, a compound represented by a formula (30) below, and a compound represented by a formula (40) below.

For instance, the mixture according to the present exemplary embodiment is preferably a mixture according to the following first, second, or third aspect.

Mixture According to First Aspect

A mixture according to the first aspect contains the compound represented by the formula (10) as the first compound and contains the compound represented by the formula (20) as the second compound. The first compound and the second compound have structures different from each other.

[Formula 25]

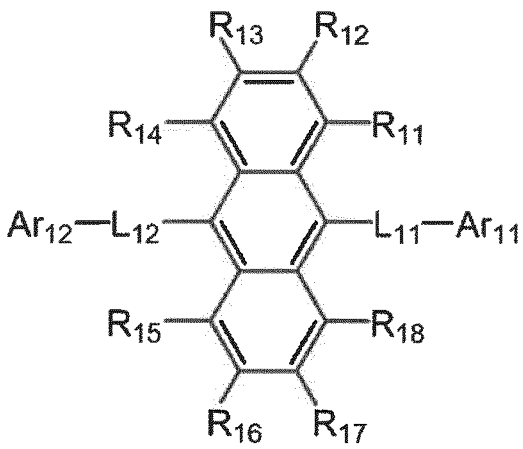

(10)

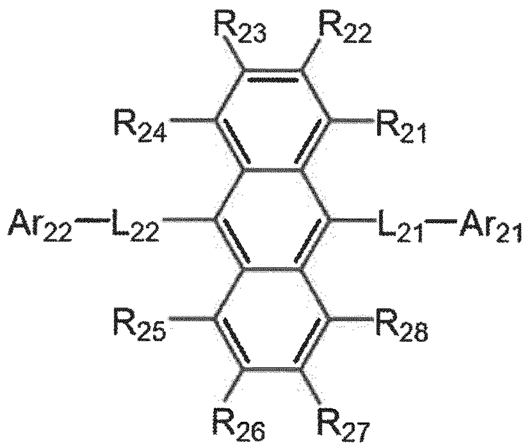

(20)

In the formula (10) and the formula (20):

$L_{12}$ is a substituted or unsubstituted arylene group having 6 to 50 ring carbon atoms, or a substituted or unsubstituted divalent heterocyclic group having 5 to 50 ring atoms;

$Ar_{12}$ is a substituted or unsubstituted aryl group having 6 to 50 ring carbon atoms;

$L_{11}$, $L_{21}$, and $L_{22}$ are each independently a single bond, a substituted or unsubstituted arylene group having 6 to 50 ring carbon atoms, or a substituted or unsubstituted divalent heterocyclic group having 5 to 50 ring atoms;

$Ar_{11}$, $Ar_{21}$, and $Ar_{22}$ are each independently a substituted or unsubstituted aryl group having 6 to 50 ring carbon atoms; and

$R_{11}$ to $R_{18}$ and $R_{21}$ to $R_{28}$ are each independently a hydrogen atom, a substituted or unsubstituted alkyl group having 1 to 50 carbon atoms, a substituted or unsubstituted haloalkyl group having 1 to 50 carbon atoms, a substituted or unsubstituted alkenyl group having 2 to 50 carbon atoms, a substituted or unsubstituted alkynyl group having 2 to 50 carbon atoms, a substituted or unsubstituted cycloalkyl group having 3 to 50 ring carbon atoms, a group represented by $-Si(R_{901})(R_{902})(R_{903})$, a group represented by -O-(R904), a group represented by $-S-(R_{905})$, a group represented by $-N(R_{906})(R_{907})$, a substituted or unsubstituted aralkyl group having 7 to 50 carbon atoms, a group represented by $-C(=O)R_{801}$, a group represented by $-COOR_{802}$, a halogen atom, a cyano group, a nitro group, a substituted or unsubstituted aryl group having 6 to 50 ring carbon atoms, or a substituted or unsubstituted heterocyclic group having 5 to 50 ring atoms.

In the present exemplary embodiment, in the first compound and the second compound, $R_{901}$, $R_{902}$, $R_{903}$, $R_{904}$, $R_{905}$, $R_{906}$, $R_{907}$, $R_{801}$, and $R_{302}$ are each independently a hydrogen atom, a substituted or unsubstituted alkyl group having 1 to 50 carbon atoms, a substituted or unsubstituted cycloalkyl group having 3 to 50 ring carbon atoms, a substituted or unsubstituted aryl group having 6 to 50 ring carbon atoms, or a substituted or unsubstituted heterocyclic group having 5 to 50 ring atoms;

when a plurality of $R_{901}$ are present, the plurality of $R_{901}$ are mutually the same or different;
when a plurality of $R_{902}$ are present, the plurality of $R_{902}$ are mutually the same or different;
when a plurality of $R_{903}$ are present, the plurality of $R_{903}$ are mutually the same or different;
when a plurality of $R_{904}$ are present, the plurality of $R_{904}$ are mutually the same or different;
when a plurality of $R_{905}$ are present, the plurality of $R_{905}$ are mutually the same or different;
when a plurality of $R_{906}$ are present, the plurality of $R_{906}$ are mutually the same or different;
when a plurality of $R_{907}$ are present, the plurality of $R_{907}$ are mutually the same or different;
when a plurality of $R_{801}$ are present, the plurality of $R_{801}$ are mutually the same or different; and
when a plurality of $R_{802}$ are present, the plurality of $R_{802}$ are mutually the same or different.

In the mixture according to the first aspect, $L_{12}$ is preferably a substituted or unsubstituted arylene group having 6 to 50 ring carbon atoms.

In the mixture according to the first aspect, the first compound is preferably represented by a formula (11) below.

[Formula 26]

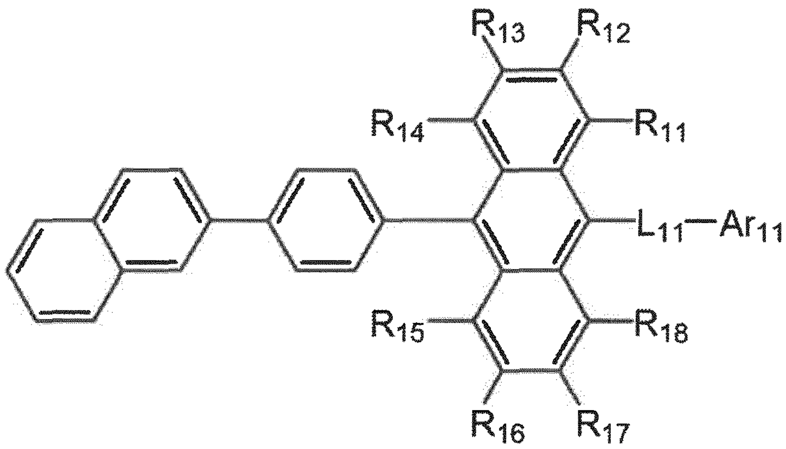

(11)

In the formula (11), $R_{11}$ to $R_{18}$, $L_{11}$, and $Ar_{11}$ represent the same as $R_{11}$ to $R_{18}$, $L_{11}$, and $Ar_{11}$, respectively, in the formula (10).

In the mixture according to the first aspect, $L_{11}$ is preferably a single bond or a substituted or unsubstituted arylene group having 6 to 50 ring carbon atoms.

In the mixture according to the first aspect, $Ar_{11}$ is preferably a substituted or unsubstituted aryl group having 6 to 18 ring carbon atoms.

In the mixture according to the first aspect, $R_{11}$ to $R_{18}$ are preferably each independently a hydrogen atom, a substituted or unsubstituted alkyl group having 1 to 50 carbon atoms, a substituted or unsubstituted cycloalkyl group having 3 to 50 ring carbon atoms, or a group represented by $-Si(R_{901})(R_{902})(R_{903})$.

In the mixture according to the first aspect, $R_{11}$ to $R_{18}$ are preferably each a hydrogen atom.

In the mixture according to the first aspect, $R_{21}$ to $R_{28}$ are preferably each independently a hydrogen atom, a substituted or unsubstituted haloalkyl group having 1 to 50 carbon atoms, a substituted or unsubstituted alkenyl group having 2 to 50 carbon atoms, a substituted or unsubstituted alkynyl group having 2 to 50 carbon atoms, a substituted or unsubstituted cycloalkyl group having 3 to 50 ring carbon atoms, a group represented by $-Si(R_{901})(R_{902})(R_{903})$, a group represented by $-O-(R_{904})$, a group represented by $-S-(R_{905})$, a group represented by $-N(R_{906})(R_{907})$, a substituted or unsubstituted aralkyl group having 7 to 50 carbon atoms, a group represented by $-C(=O)R_{801}$, a group represented by $-COOR_{802}$, a halogen atom, a cyano group, a nitro group, a substituted or unsubstituted aryl group having 6 to 50 ring carbon atoms, or a substituted or unsubstituted heterocyclic group having 5 to 50 ring atoms.

In the mixture according to the first aspect, $R_{21}$ to $R_{28}$ are preferably each a hydrogen atom.

In the mixture according to the first aspect, $L_{21}$ and $L_{22}$ are preferably each independently a single bond or a substituted or unsubstituted arylene group having 6 to 50 ring carbon atoms, and $Ar_{21}$ and $Ar_{22}$ are preferably each independently a substituted or unsubstituted aryl group having 6 to 18 ring carbon atoms.

In the mixture according to the first aspect, $L_{21}$ is preferably a substituted or unsubstituted phenylene group, and $Ar_{21}$ is preferably a substituted or unsubstituted naphthyl group.

In the mixture according to the first aspect, the second compound is preferably represented by a formula (21)

below.

[Formula 27]

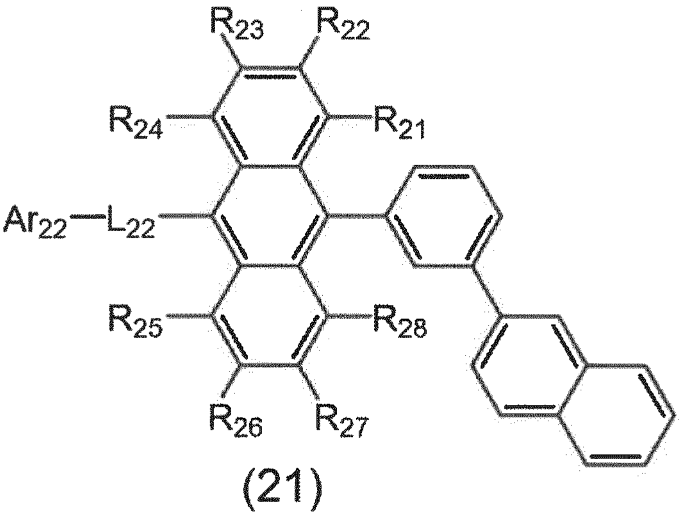

(21)

In the formula (21), $R_{21}$ to $R_{28}$, $L_{22}$, and $Ar_{22}$ represent the same as $R_{21}$ to $R_{28}$, $L_{22}$, and $Ar_{22}$, respectively, in the formula (20).

In the mixture according to the first aspect, the total mass $M_T$ of the first compound and the second compound and the mass $M_1$ of the first compound preferably satisfy the relationship of a numerical formula (Numerical Formula 1) below.

$$50 \leq (M_1/M_T) \times 100 < 100 \qquad \text{(Numerical Formula 1)}$$

Mixture According to Second Aspect

A mixture according to the second aspect contains the compound represented by the formula (20) as the first compound and contains the compound represented by the formula (30) as the second compound. The first compound and the second compound have structures different from each other.

[Formula 28]

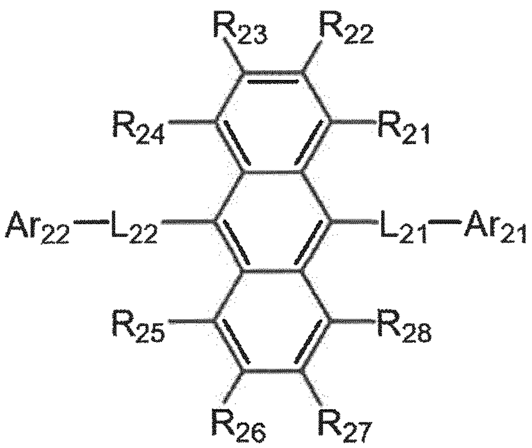

(20)

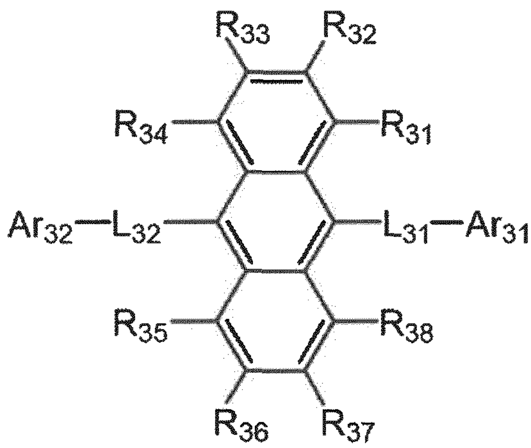

(30)

In the formula (20) and the formula (30):

$L_{21}$, $L_{22}$, $L_{31}$, and $L_{32}$ are each independently a single bond, a substituted or unsubstituted arylene group having 6 to 50 ring carbon atoms, or a substituted or unsubstituted divalent heterocyclic group having 5 to 50 ring atoms;
$Ar_{21}$, $Ar_{22}$, $Ar_{31}$, and $Ar_{32}$ are each independently a substituted or unsubstituted aryl group having 6 to 50 ring carbon atoms;
$R_{21}$ to $R_{28}$ and $R_{31}$ to $R_{38}$ are each independently a hydrogen atom, a substituted or unsubstituted alkyl group having 1 to 50 carbon atoms, a substituted or unsubstituted haloalkyl group having 1 to 50 carbon atoms, a substituted or unsubstituted alkenyl group having 2 to 50 carbon atoms, a substituted or unsubstituted alkynyl group having 2 to 50 carbon atoms, a substituted or unsubstituted cycloalkyl group having 3 to 50 ring carbon atoms, a group represented by $-Si(R_{901})(R_{902})(R_{903})$, a group represented by $-O-(R_{904})$, a group represented by -S-(R905), a group represented by -N(R906)(R907), a substituted or unsubstituted aralkyl group having 7 to 50 carbon atoms, a group represented by $-C(=O)R_{801}$, a group represented by $-COOR_{802}$, a halogen atom, a cyano group, a nitro group, a substituted or unsubstituted aryl group having 6 to 50 ring carbon atoms, or a substituted or unsubstituted heterocyclic group having 5 to 50 ring atoms; and
$R_{22}$, $R_{23}$, $R_{26}$, $R_{27}$, $R_{32}$, $R_{33}$, $R_{36}$, and $R_{37}$ are not substituted or unsubstituted alkyl groups having 1 to 50 carbon atoms.

In the mixture according to the second aspect, $R_{31}$ to $R_{38}$ are preferably each a hydrogen atom.
In the mixture according to the second aspect, $L_{31}$ and $L_{32}$ are preferably each independently a single bond or a substituted or unsubstituted arylene group having 6 to 50 ring carbon atoms.
In the mixture according to the second aspect, $L_{31}$ is preferably a substituted or unsubstituted phenylene group, and $Ar_{31}$ is preferably a substituted or unsubstituted naphthyl group.
In the mixture according to the second aspect, the second compound is preferably represented by a formula (31) below.

[Formula 29]

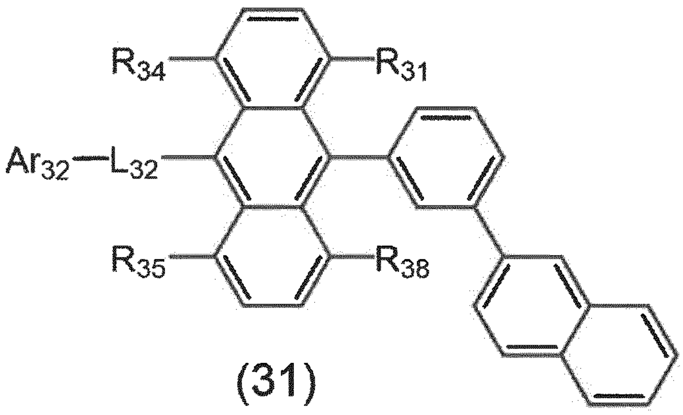

(31)

In the formula (31), $R_{31}$, $R_{34}$, $R_{35}$, $R_{38}$, $L_{32}$, and $Ar_{32}$ represent the same as $R_{31}$, $R_{34}$, $R_{35}$, $R_{38}$, $L_{32}$, and $Ar_{32}$, respectively, in the formula (30).
In the mixture according to the second aspect, the total mass $M_T$ of the first compound and the second compound and the mass $M_1$ of the first compound preferably satisfy the relationship of the numerical formula (Numerical Formula 1).

$$50 \leq (M_1/M_T) \times 100 < 100 \quad \text{(Numerical Formula 1)}$$

The mixture according to the second aspect containing the first compound represented by the formula (20) and the second compound represented by the formula (30) is stable to electrical excitation. Thus, an organic EL device manufactured using the mixture according to the second aspect is less likely to deteriorate during driving.

Mixture According to Third Aspect

A mixture according to the third aspect contains the compound represented by the formula (20) as the first compound and contains the compound represented by the formula (40) as the second compound. The first compound and the second compound have structures different from each other.
In the mixture according to the third aspect, the total mass $M_T$ of the first compound and the second compound

and the mass $M_1$ of the first compound satisfy the relationship of a numerical formula (Numerical Formula 2) below.

$$50 < (M_1/M_T) \times 100 < 100 \qquad \text{(Numerical Formula 2)}$$

[Formula 30]

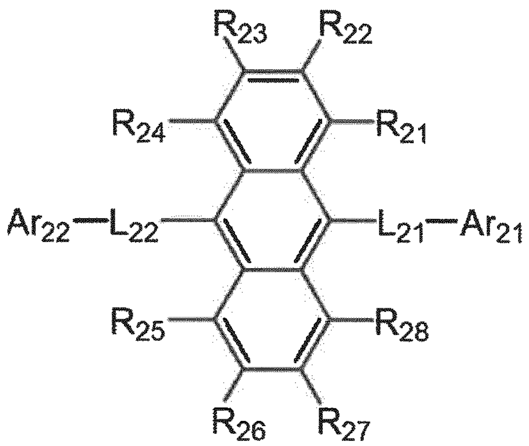

(20)

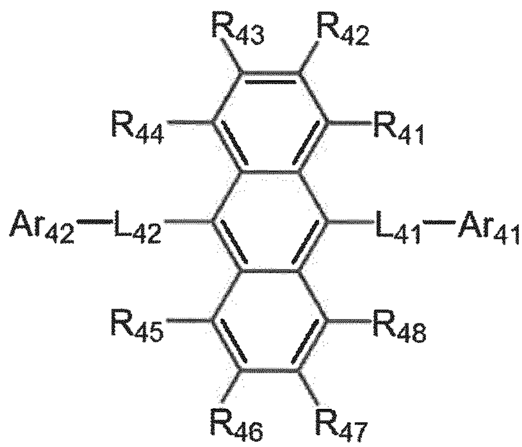

(40)

In the formula (20) and the formula (40):

$L_{21}$, $L_{22}$, $L_{41}$, and $L_{42}$ are each independently a single bond, a substituted or unsubstituted arylene group having 6 to 50 ring carbon atoms, or a substituted or unsubstituted divalent heterocyclic group having 5 to 50 ring atoms;
$Ar_{21}$, $Ar_{22}$, $Ar_{41}$, and $Ar_{42}$ are each independently a substituted or unsubstituted aryl group having 6 to 50 ring carbon atoms; and
$R_{21}$ to $R_{28}$ and $R_{41}$ to $R_{48}$ are each independently a hydrogen atom, a substituted or unsubstituted alkyl group having 1 to 50 carbon atoms, a substituted or unsubstituted haloalkyl group having 1 to 50 carbon atoms, a substituted or unsubstituted alkenyl group having 2 to 50 carbon atoms, a substituted or unsubstituted alkynyl group having 2 to 50 carbon atoms, a substituted or unsubstituted cycloalkyl group having 3 to 50 ring carbon atoms, a group represented by $-Si(R_{901})(R_{902})(R_{903})$, a group represented by $-O-(R_{904})$, a group represented by $-S-(R_{905})$, a group represented by $-N(R_{906})(R_{907})$, a substituted or unsubstituted aralkyl group having 7 to 50 carbon atoms, a group represented by $-C(=O)R_{801}$, a group represented by $-COOR_{802}$, a halogen atom, a cyano group, a nitro group, a substituted or unsubstituted aryl group having 6 to 50 ring carbon atoms, or a substituted or unsubstituted heterocyclic group having 5 to 50 ring atoms.

In the mixture according to the third aspect, $R_{41}$ to $R_{48}$ are preferably each a hydrogen atom.

In the mixture according to the third aspect, $L_{41}$ and $L_{42}$ are preferably each independently a single bond or a substituted or unsubstituted arylene group having 6 to 50 ring carbon atoms, and $Ar_{41}$ and $Ar_{42}$ are preferably each

independently a substituted or unsubstituted aryl group having 6 to 18 ring carbon atoms.

In the mixture according to the third aspect, $L_{41}$ is preferably a substituted or unsubstituted phenylene group, and $Ar_{41}$ is preferably a substituted or unsubstituted naphthyl group.

In the mixture according to the third aspect, the second compound is preferably represented by a formula (41) below.

[Formula 31]

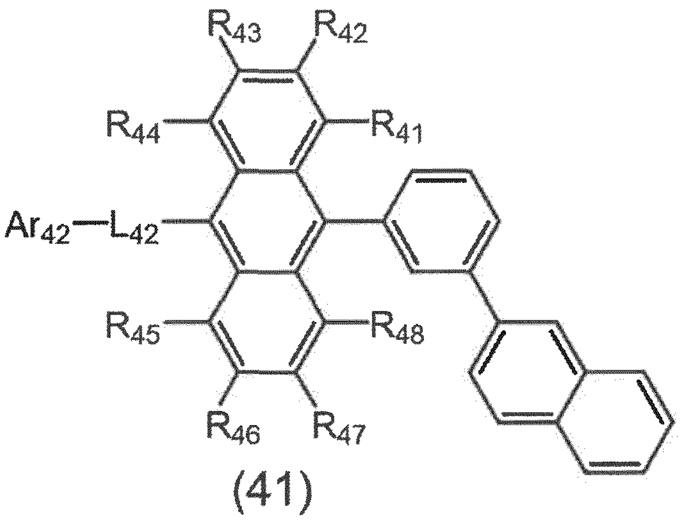

(41)

In the formula (41), $R_{41}$ to $R_{48}$, $L_{42}$, and $Ar_{42}$ represent the same as $R_{41}$ to $R_{48}$, $L_{42}$, and $Ar_{42}$, respectively, in the formula (40).

In the mixture according to at least one of the second aspect or the third aspect, $L_{22}$ is preferably a substituted or unsubstituted arylene group having 6 to 50 ring carbon atoms, and $Ar_{22}$ is preferably a substituted or unsubstituted aryl group having 6 to 18 ring carbon atoms.

In the mixture according to at least one of the second aspect or the third aspect, the first compound is preferably represented by a formula (22) below.

[Formula 32]

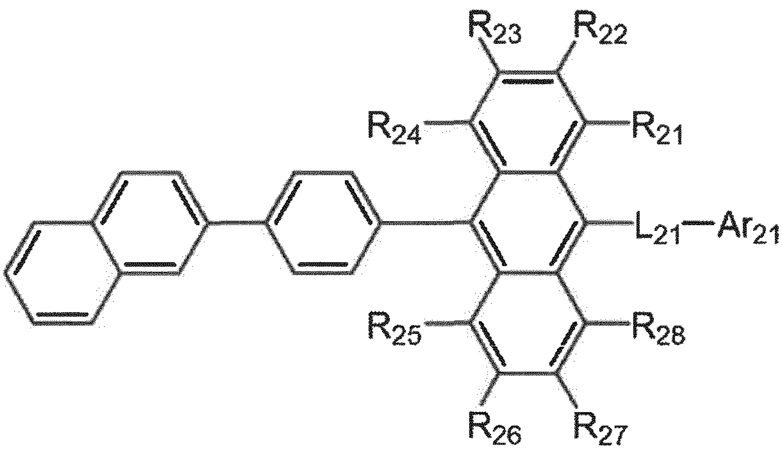

(22)

In the formula (22), $R_{21}$ to $R_{28}$, $L_{21}$, and $Ar_{21}$ represent the same as $R_{21}$ to $R_{28}$, $L_{21}$, and $Ar_{21}$, respectively, in the formula (20).

In the mixture according to at least one of the second aspect or the third aspect, $L_{21}$ is preferably a single bond or a substituted or unsubstituted arylene group having 6 to 50 ring carbon atoms.

In the mixture according to at least one of the second aspect or the third aspect, $Ar_{21}$ is preferably a substituted

or unsubstituted aryl group having 6 to 18 ring carbon atoms.

In the mixture according to at least one of the second aspect or the third aspect, $R_{21}$ to $R_{28}$ are also preferably each independently a hydrogen atom, a substituted or unsubstituted alkyl group having 1 to 50 carbon atoms, a substituted or unsubstituted cycloalkyl group having 3 to 50 ring carbon atoms, or a group represented by $-Si(R_{901})(R_{902})(R_{903})$.

In the mixture according to at least one of the second aspect or the third aspect, $R_{21}$ to $R_{28}$ are also preferably each independently a hydrogen atom, a substituted or unsubstituted haloalkyl group having 1 to 50 carbon atoms, a substituted or unsubstituted alkenyl group having 2 to 50 carbon atoms, a substituted or unsubstituted alkynyl group having 2 to 50 carbon atoms, a substituted or unsubstituted cycloalkyl group having 3 to 50 ring carbon atoms, a group represented by $-Si(R_{901})(R_{902})(R_{903})$, a group represented by $-O-(R_{904})$, a group represented by $-S-(R_{905})$, a group represented by $-N(R_{906})(R_{907})$, a substituted or unsubstituted aralkyl group having 7 to 50 carbon atoms, a group represented by $-C(=O)R_{801}$, a group represented by $-COOR_{802}$, a halogen atom, a cyano group, a nitro group, a substituted or unsubstituted aryl group having 6 to 50 ring carbon atoms, or a substituted or unsubstituted heterocyclic group having 5 to 50 ring atoms.

In the mixture according to at least one of the second aspect or the third aspect, $R_{21}$ to $R_{28}$ are preferably each a hydrogen atom.

In the mixture according to the present exemplary embodiment, the total mass $M_T$ of the first compound and the second compound and the mass $M_1$ of the first compound preferably satisfy the relationship of a numerical formula (Numerical Formula 3) below, more preferably satisfy the relationship of a numerical formula (Numerical Formula 4) below, further preferably satisfy the relationship of a numerical formula (Numerical Formula 4A) below, still further preferably satisfy the relationship of a numerical formula (Numerical Formula 5) below.

$$60 \leq (M_1/M_T) \times 100 < 100 \quad \text{(Numerical Formula 3)}$$

$$70 \leq (M_1/M_T) \times 100 < 100 \quad \text{(Numerical Formula 4)}$$

$$70 \leq (M_1/M_T) \times 100 < 98 \quad \text{(Numerical Formula 4A)}$$

$$70 \leq (M_1/M_T) \times 100 \leq 90 \quad \text{(Numerical Formula 5)}$$

In the first compound and the second compound of the mixture according to the present exemplary embodiment, the groups described as "substituted or unsubstituted" are preferably each an "unsubstituted" group.

The form of the mixture according to the present exemplary embodiment is not particularly limited. Examples of the form of the mixture according to the present exemplary embodiment include solids, powders, solutions, films, and layers. The mixture according to the present exemplary embodiment is also preferably a powdery mixture in which the first compound in powder form and the second compound in powder form are mixed. The mixture according to the present exemplary embodiment is also preferably a solid, and is also preferably a solid mixture obtained by melt-mixing the first compound and the second compound and then solidifying the resultant by cooling. When the mixture according to the present exemplary embodiment is a solid, the mixture according to the present exemplary embodiment may be a pelletized mixture formed using the first compound in powder form and the second compound in powder form.

The mixture according to the present exemplary embodiment is preferably neither a film nor a layer.

It has been found that the mixture according to the present exemplary embodiment inhibits a blockage phenomenon.

When the first compound according to the present exemplary embodiment is used to form a film through dry film-forming such as a vacuum deposition method, a decrease or a change in a vapor-deposition speed tends to easily occur over time. This is considered to be because the first compound of the present exemplary embodiment tends to adhere on an adhesion shield plate, a crucible end or the like to grow into crystal during the film formation through the vacuum deposition method, and the resultant bulky film of the first compound formed by the crystal growth blocks a vaporized beam from a vapor-deposition source.

Thus, the inventors have conducted intensive studies and found that the blockage phenomenon is inhibited by mixing the first compound with the second compound under predetermined conditions. Probably, by mixing the first compound with the second compound, the crystal growth likely to occur during film formation using the first compound alone was inhibited, so that the occurrence of a bulky deposit was inhibited. If the second compound is a compound having a crystal form different from that of the first compound, probably, the crystal growth of each compound will be inhibited by mixing the first compound with a small amount of the second compound, so that the occurrence of a bulky

deposit can be inhibited.

According to the mixture of the present exemplary embodiment, the formation of a bulky adhering film can be inhibited when forming an organic layer of an organic EL device through dry film-forming.

Method for Producing First Compound and Second Compound

The first compound and the second compound according to the present exemplary embodiment can each be produced by a known method, or by following the method and using known alternative reactions and materials according to the target compound.

Specific Examples of First Compound and Second Compound

Specific examples of the first compound and the second compound according to the present exemplary embodiment include the following compounds. Specific examples of the mixture according to the present exemplary embodiment each contain, for instance, a first compound and a second compound selected from the group consisting of the following compounds so as to meet the conditions of the mixtures according to the first, second, and third aspects described above. However, the invention is not limited to these specific examples.

[Formula 33]

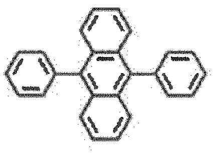
H-1

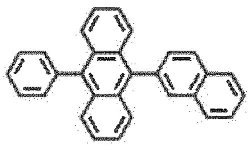
H-2

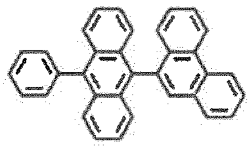
H-3

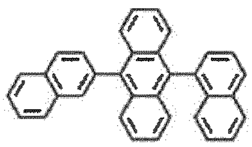
H-4

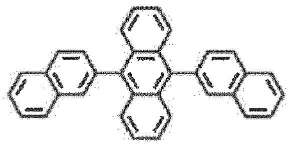
H-5

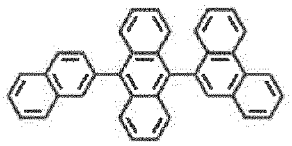
H-6

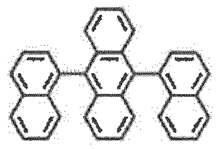
H-7

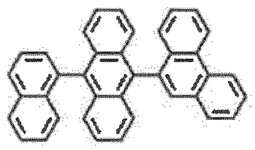
H-8

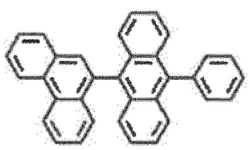
H-9

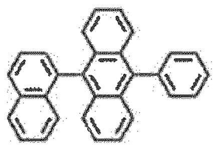
H-10

[Formula 34]

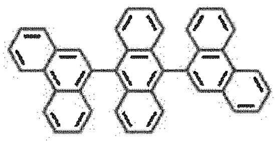

H-11

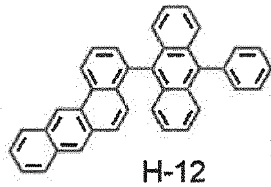

H-12

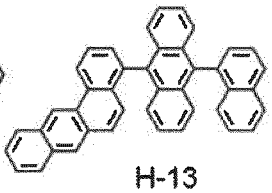

H-13

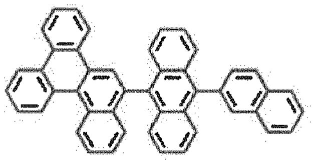

H-14

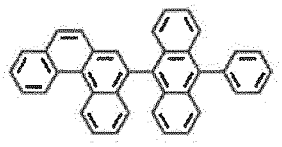

H-15

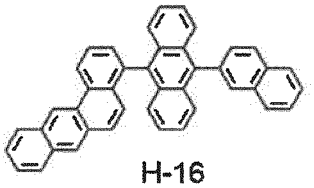

H-16

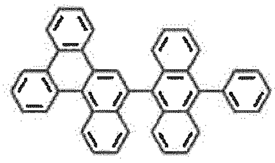

H-17

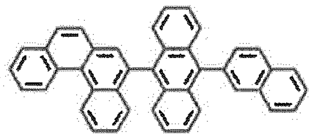

H-18

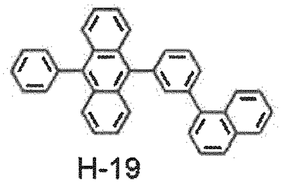

H-19

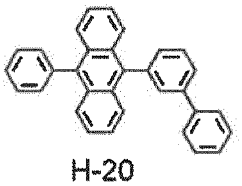

H-20

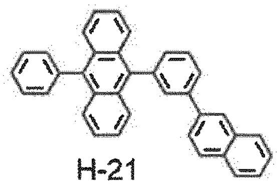

H-21

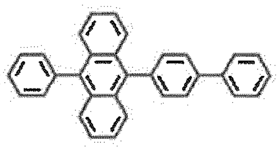

H-22

[Formula 35]

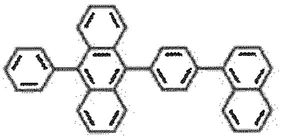

H-23

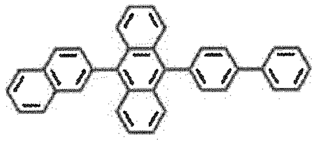

H-24

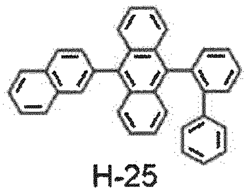

H-25

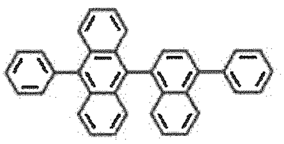

H-26

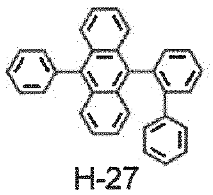

H-27

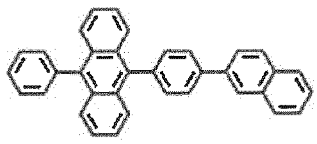

H-28

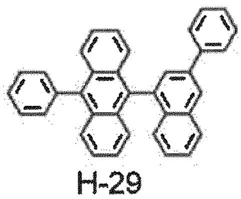

H-29

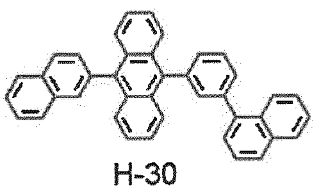

H-30

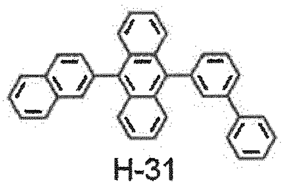

H-31

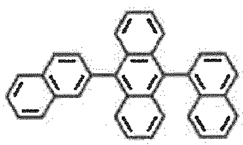

H-32

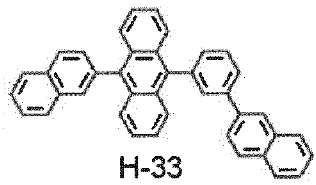

H-33

[Formula 36]

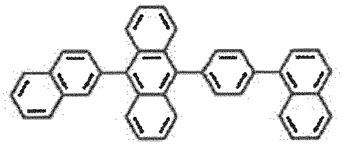
H-34

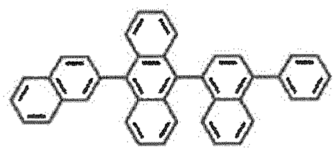
H-35

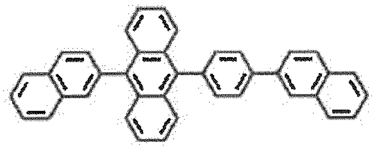
H-36

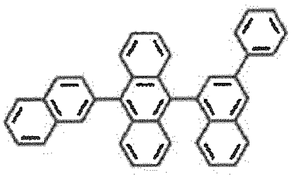
H-37

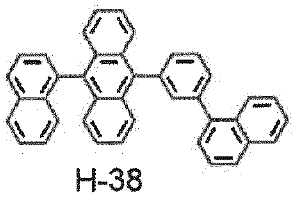
H-38

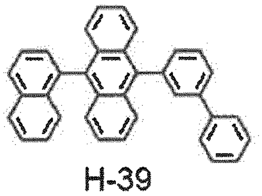
H-39

[Formula 37]

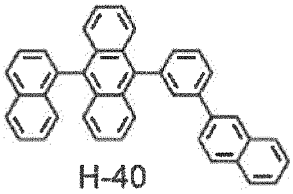
H-40

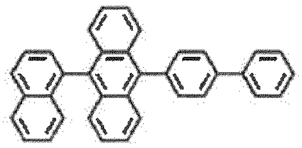
H-41

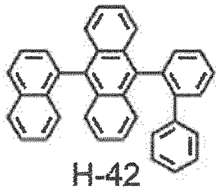
H-42

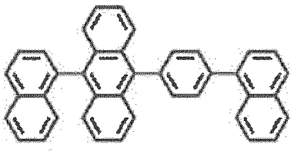
H-43

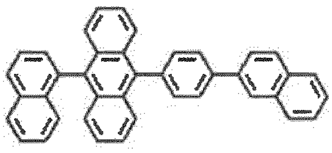
H-44

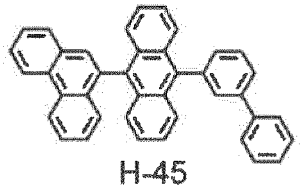
H-45

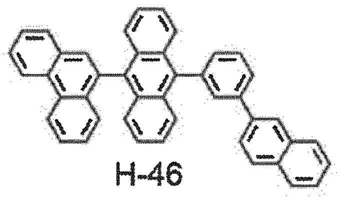
H-46

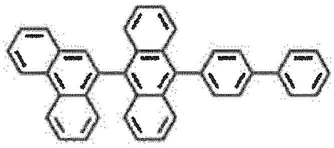
H-47

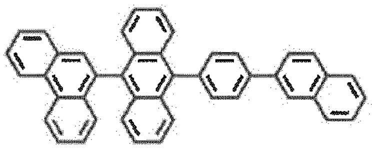
H-48

[Formula 38]

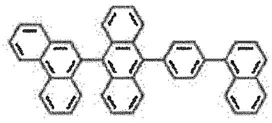

H-49

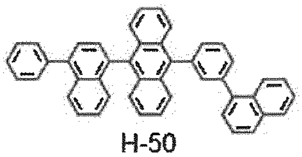

H-50

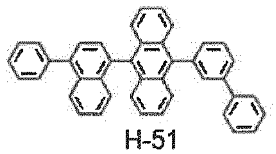

H-51

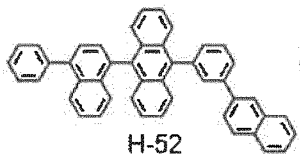

H-52

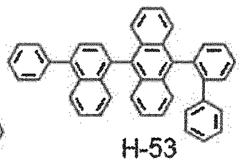

H-53

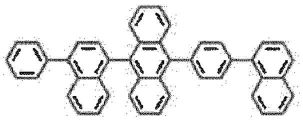

H-54

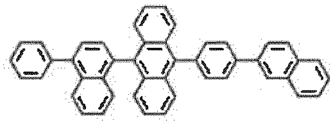

H-55

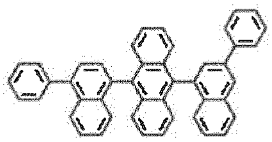

H-56

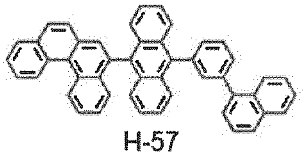

H-57

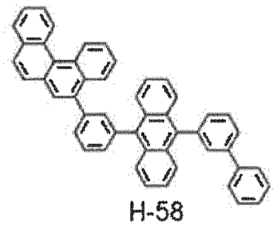

H-58

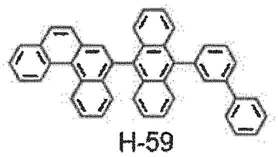

H-59

[Formula 39]

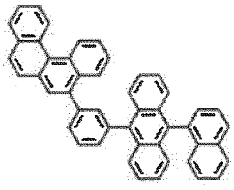

H-60

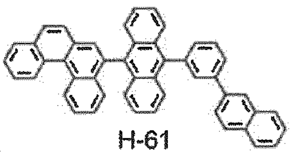

H-61

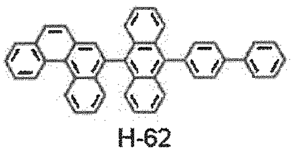

H-62

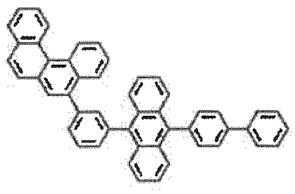

H-63

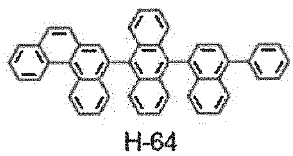

H-64

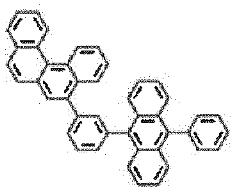

H-65

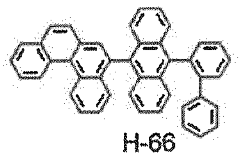

H-66

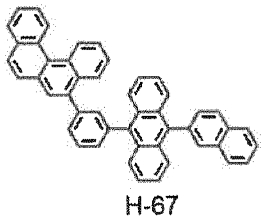

H-67

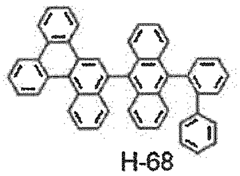

H-68

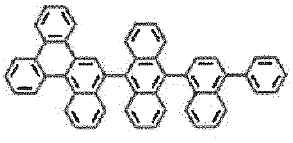

H-69

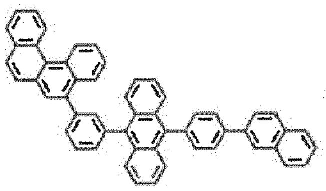

H-70

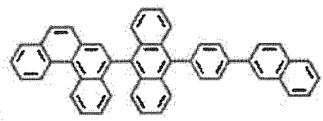

H-71

[Formula 40]

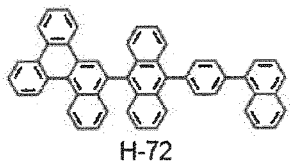
H-72

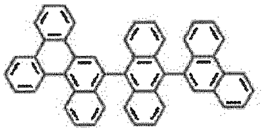
H-73

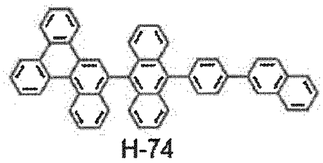
H-74

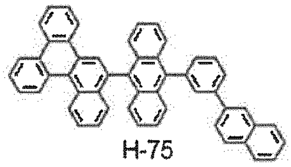
H-75

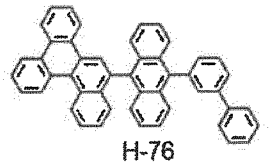
H-76

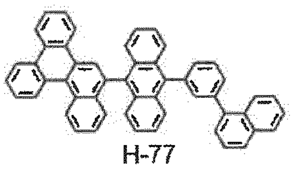
H-77

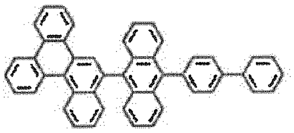
H-78

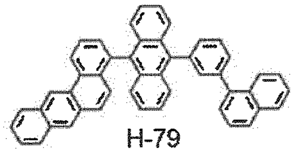
H-79

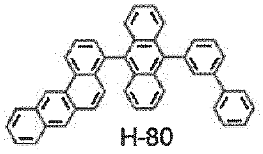
H-80

[Formula 41]

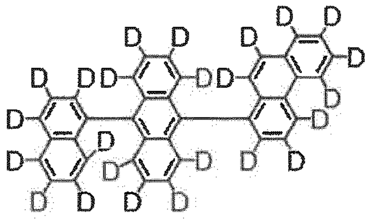
H-81

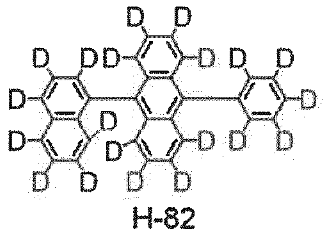
H-82

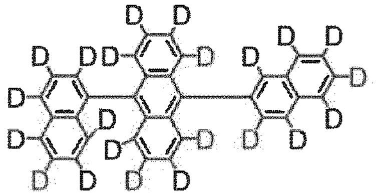
H-83

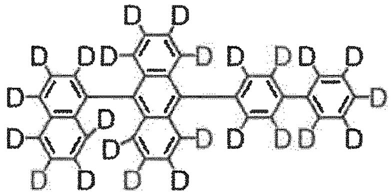
H-84

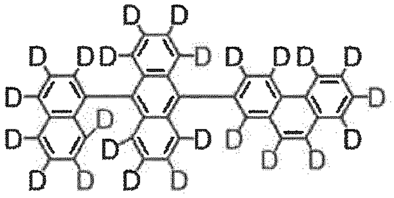
H-85

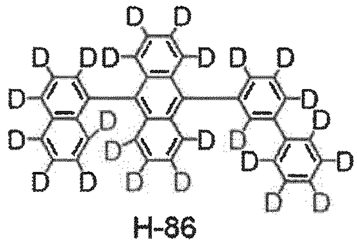
H-86

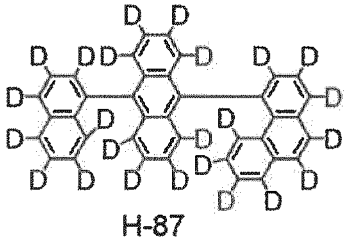
H-87

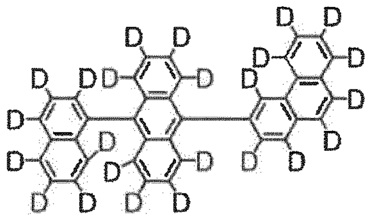
H-88

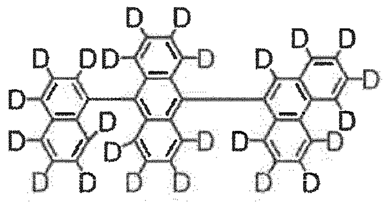
H-89

[Formula 42]

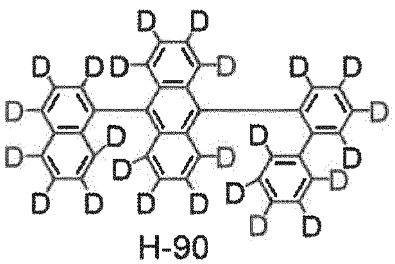
H-90

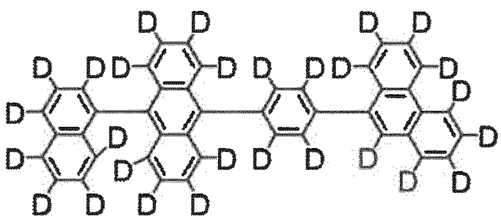
H-91

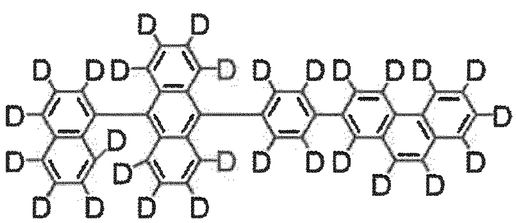
H-92

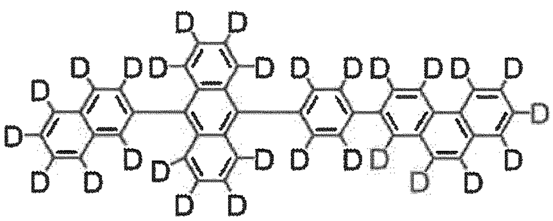
H-93

[Formula 43]

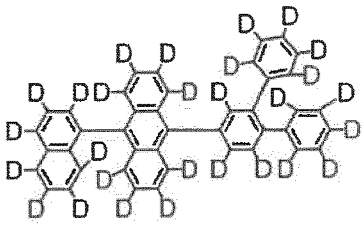
H-94

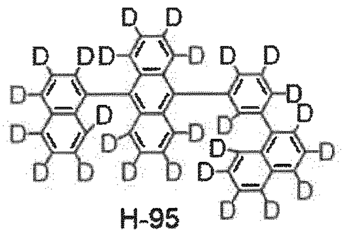
H-95

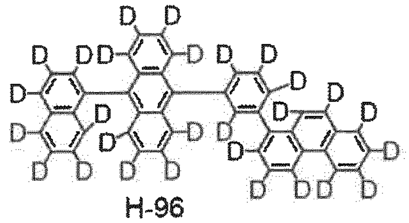
H-96

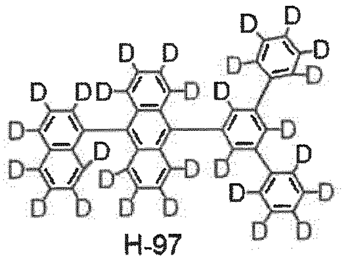
H-97

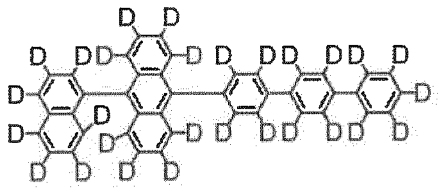
H-98

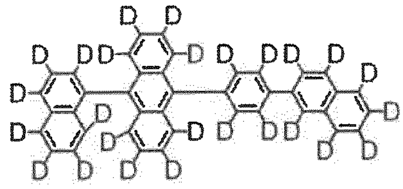
H-99

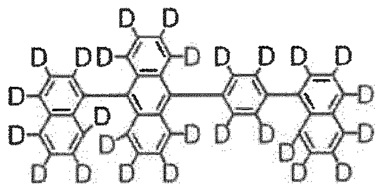
H-100

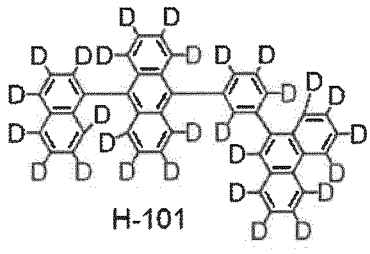
H-101

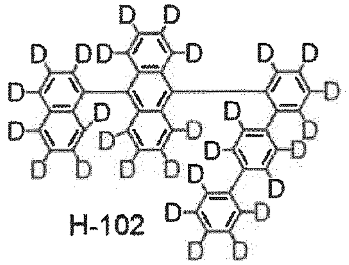
H-102

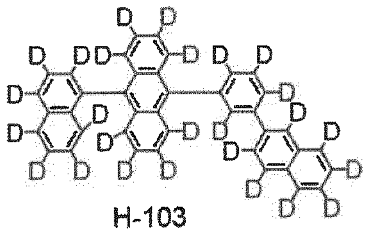
H-103

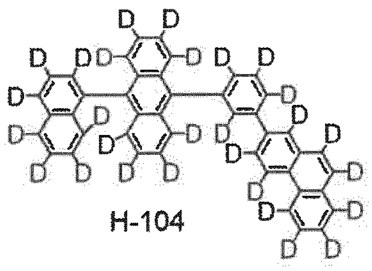
H-104

[Formula 44]

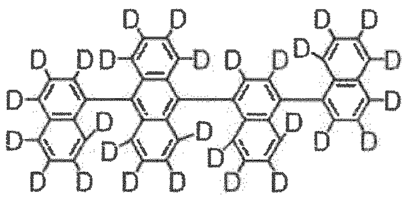

H-105

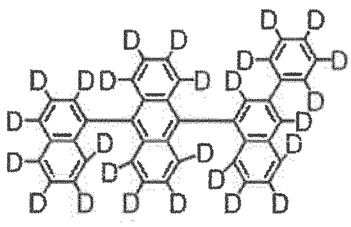

H-106

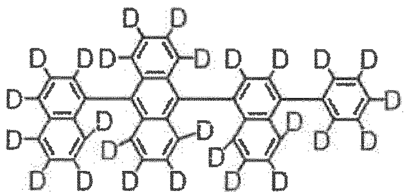

H-107

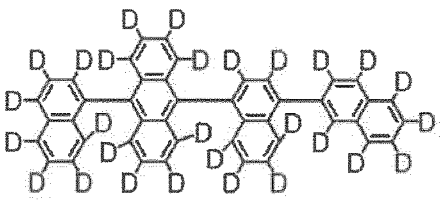

H-108

[Formula 45]

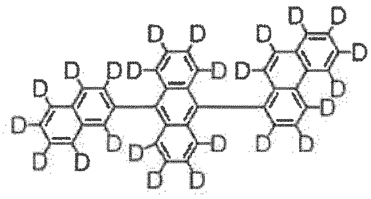

H-109

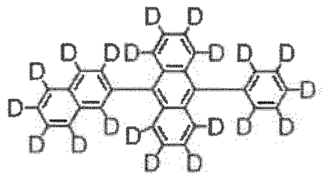

H-110

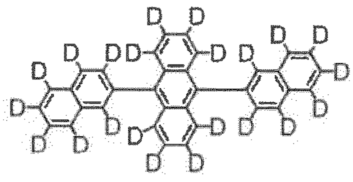

H-111

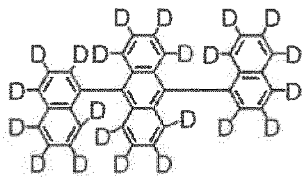

H-112

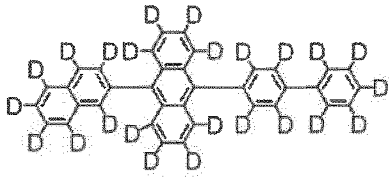

H-113

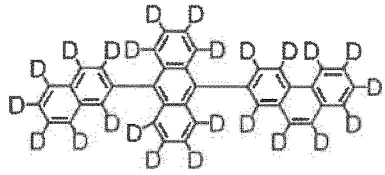

H-114

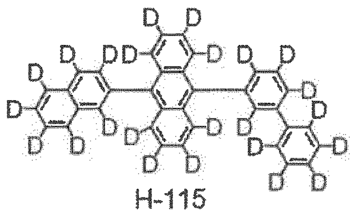

H-115

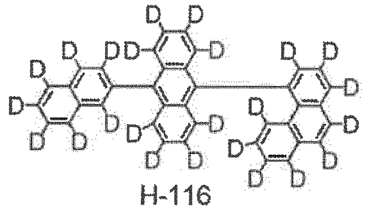

H-116

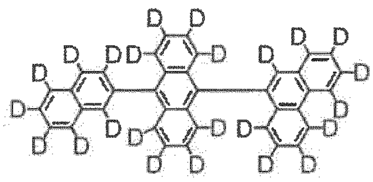

H-117

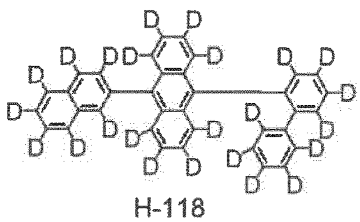

H-118

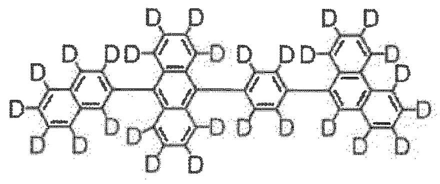

H-119

[Formula 46]

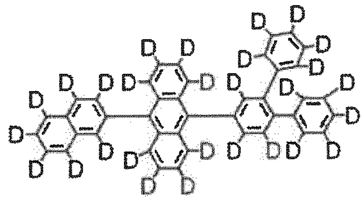

H-120

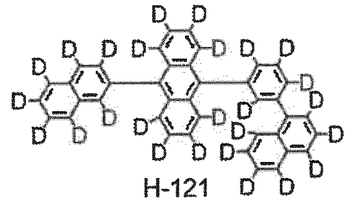

H-121

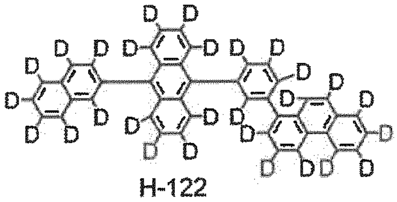

H-122

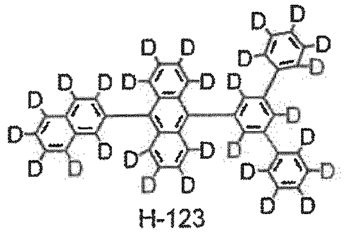

H-123

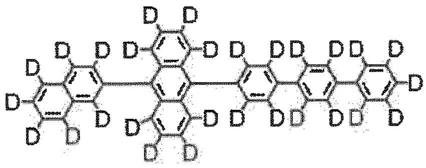

H-124

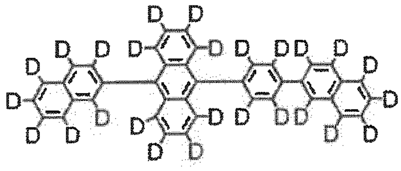

H-125

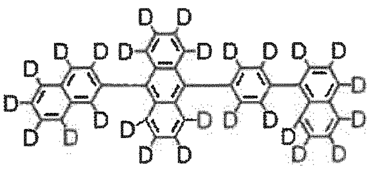

H-126

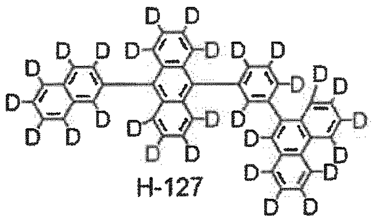

H-127

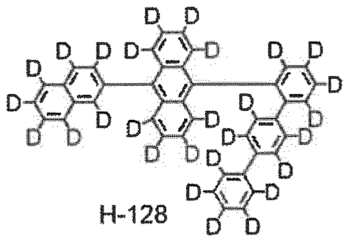

H-128

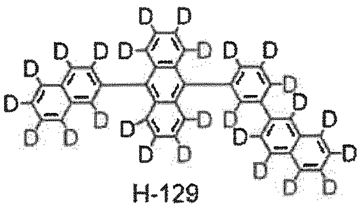

H-129

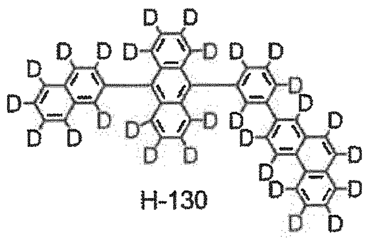

H-130

[Formula 47]

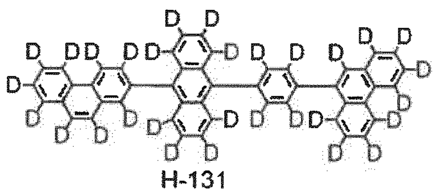

H-131

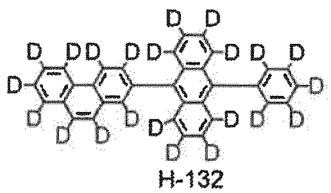

H-132

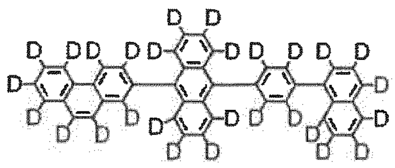

H-133

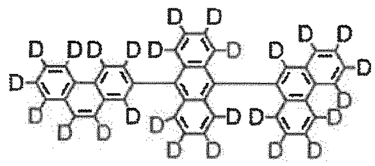

H-134

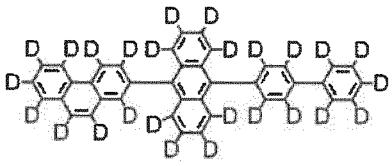

H-135

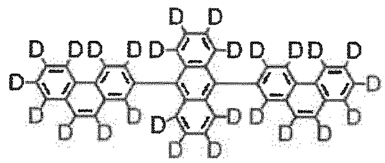

H-136

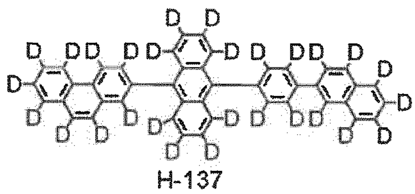

H-137

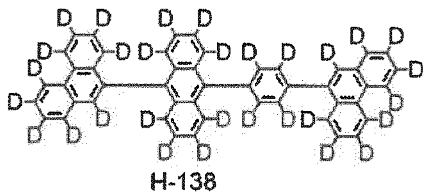

H-138

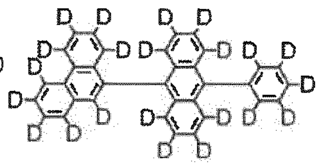

H-139

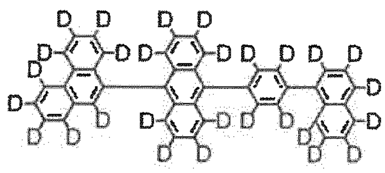

H-140

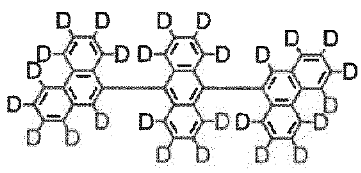

H-141

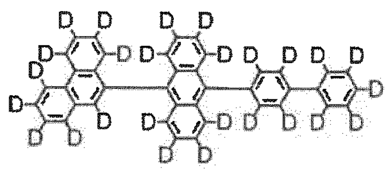

H-142

[Formula 48]

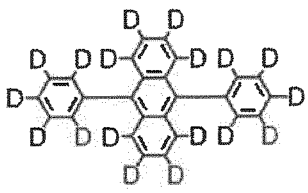

H-143

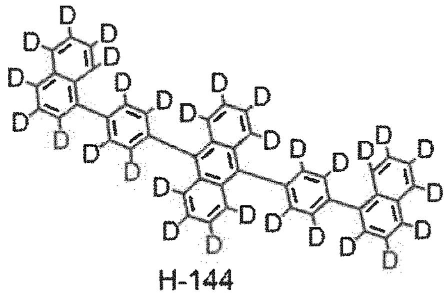

H-144

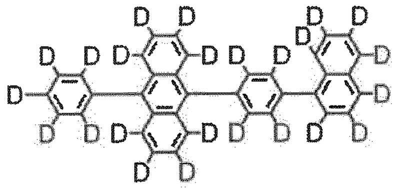

H-145

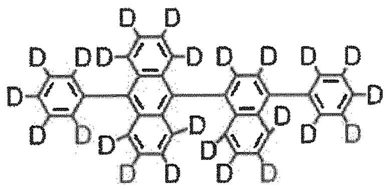

H-146

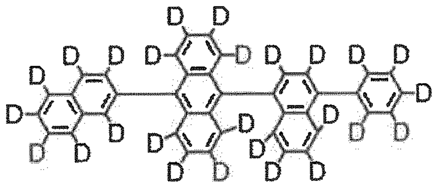

H-147

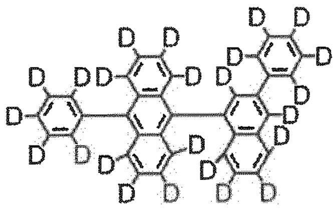

H-148

[Formula 49]

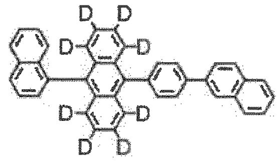
H-149

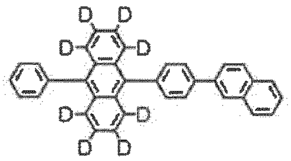
H-150

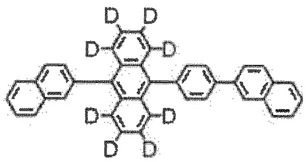
H-151

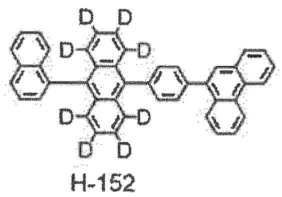
H-152

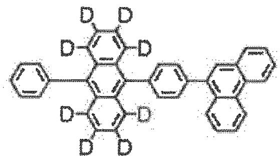
H-153

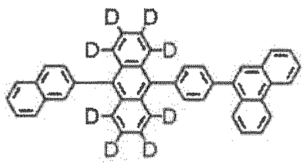
H-154

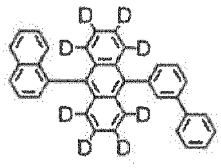
H-155

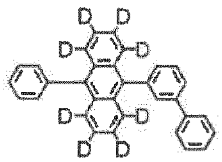
H-156

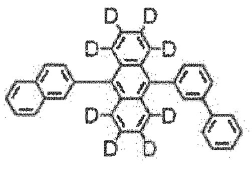
H-157

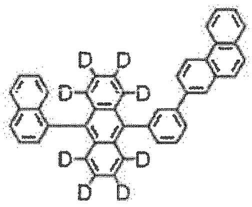
H-158

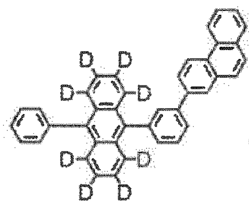
H-159

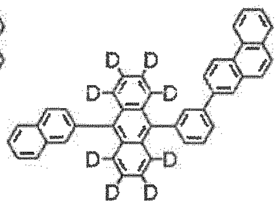
H-160

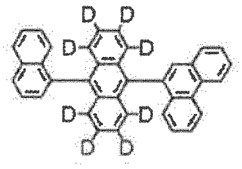
H-161

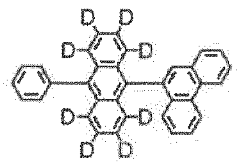
H-162

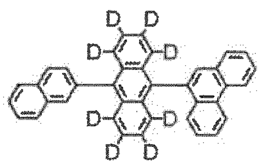
H-163

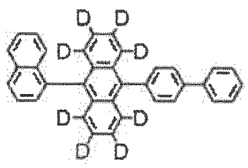
H-164

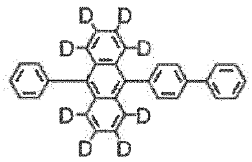
H-165

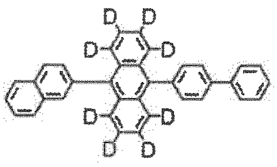
H-166

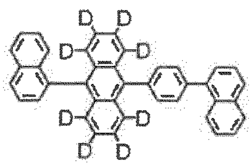
H-167

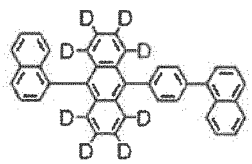
H-168

[Formula 50]

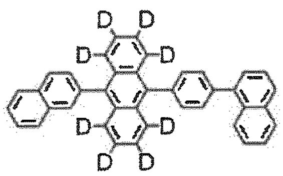
H-169

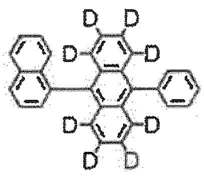
H-170

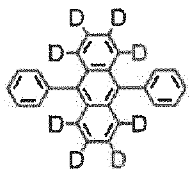
H-171

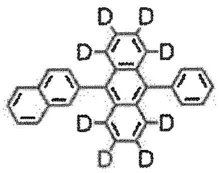
H-172

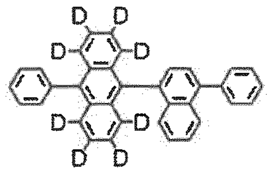
H-173

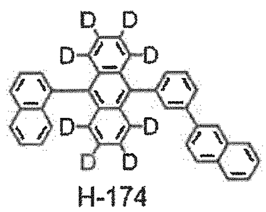
H-174

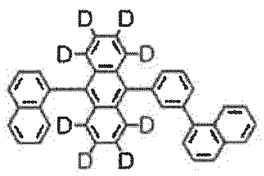
H-175

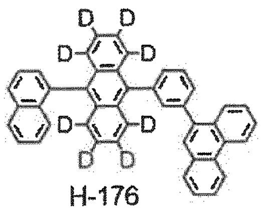
H-176

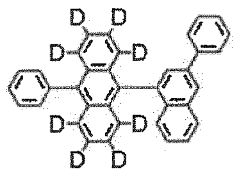
H-177

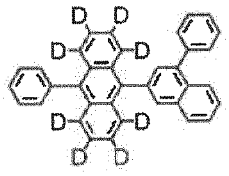
H-178

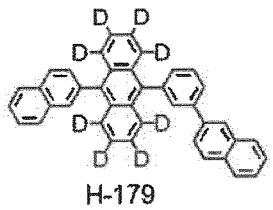
H-179

[Formula 51]

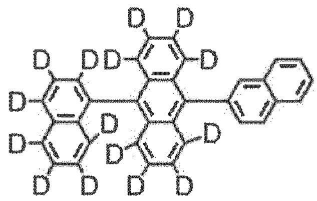
H-180

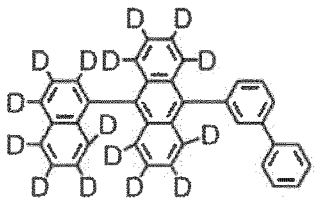
H-181

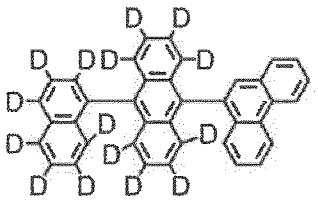
H-182

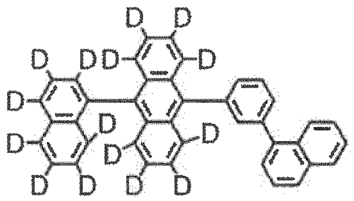
H-183

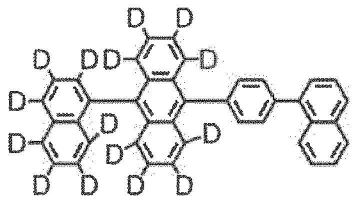
H-184

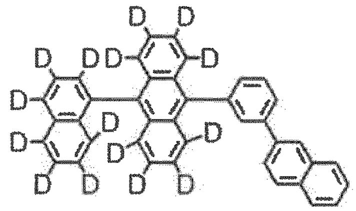
H-185

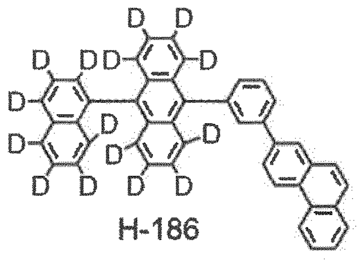
H-186

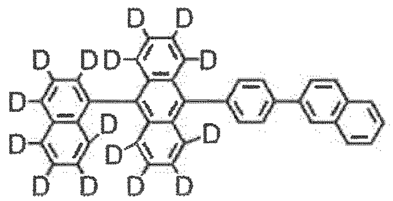
H-187

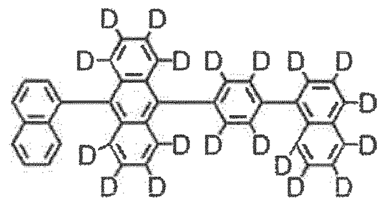
H-188

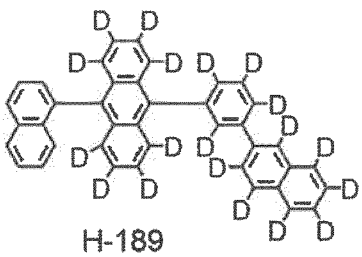
H-189

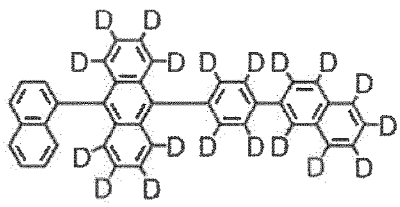
H-190

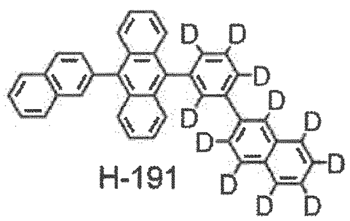
H-191

[Formula 52]

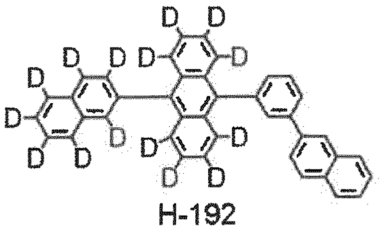
H-192

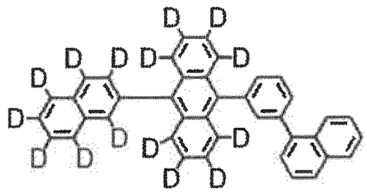
H-193

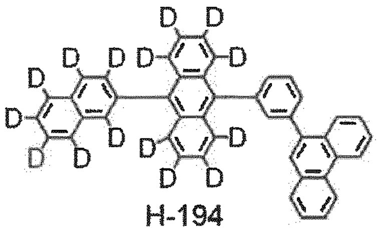
H-194

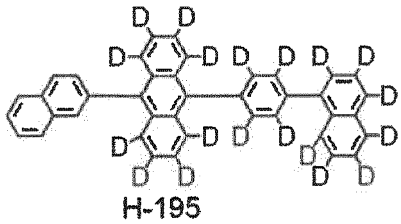
H-195

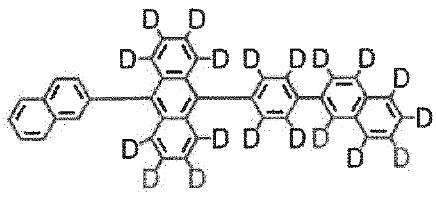
H-196

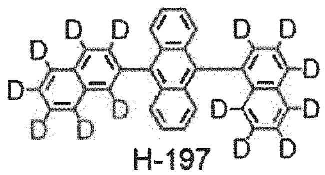
H-197

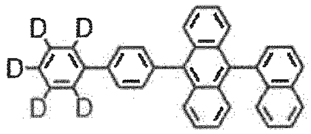
H-198

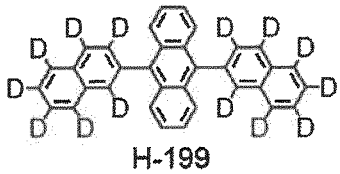
H-199

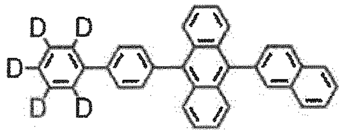
H-200

[Formula 53]

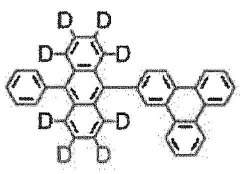
H-201

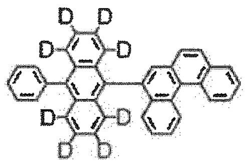
H-202

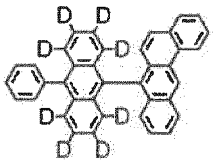
H-203

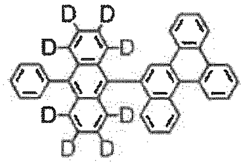
H-204

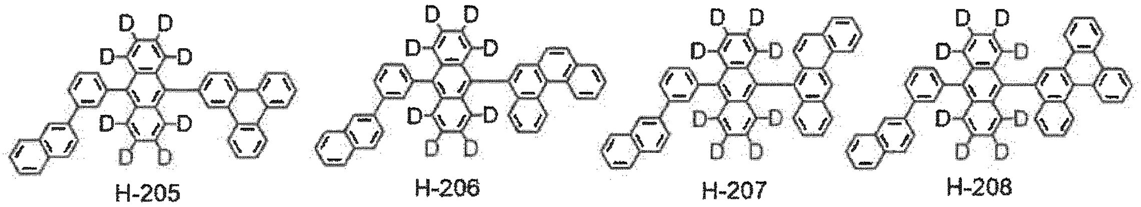
H-205 H-206 H-207 H-208

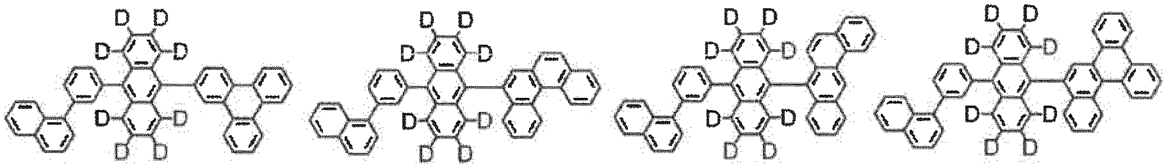
H-209 H-210 H-211 H-212

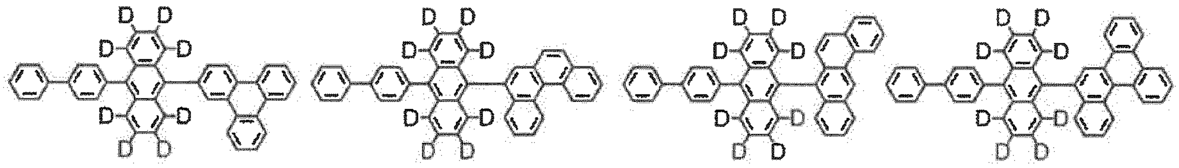
H-213 H-214 H-215 H-216

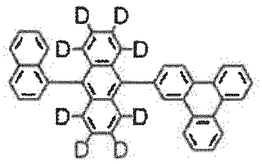
H-217

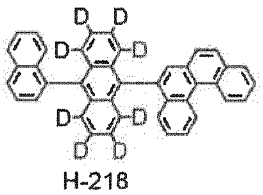
H-218

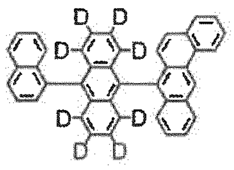
H-219

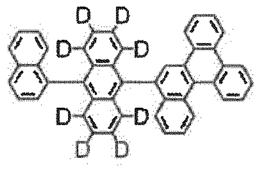
H-220

[Formula 54]

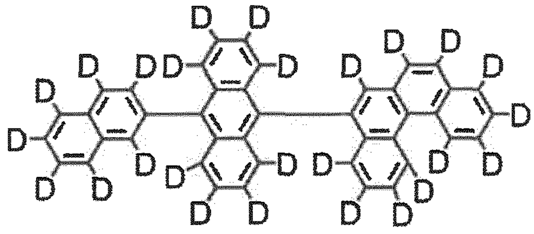

H-221

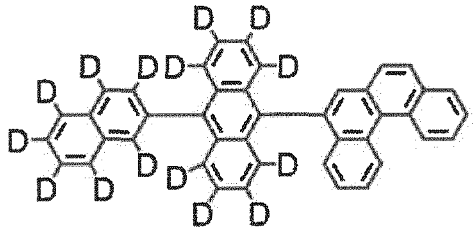

H-222

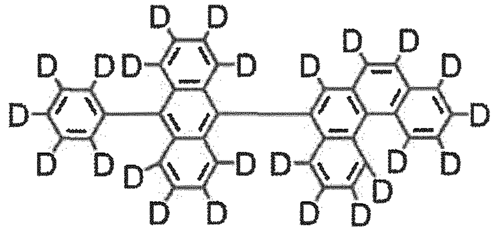

H-223

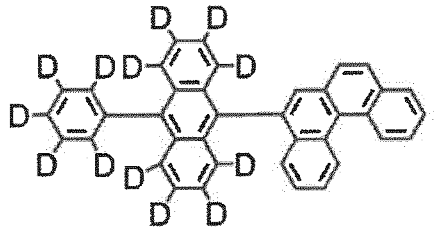

H-224

[Formula 55]

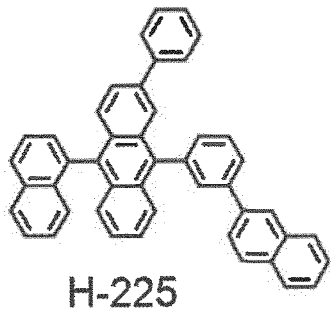

H-225

Specific examples of the mixture are shown in Table 1 to Table 40. In the tables, mixtures each containing a combination of two different compounds selected from the group consisting of Compounds H-1 to H-225 given as examples herein are numbered 1 to 22500. For instance, the mixture of Number 1 is referred to as Mixture 1.

A compound in the row and a compound in the column in each table determine the combination of compounds contained in a mixture. For instance, in Table 1, the number of a mixture containing Compound H-1 in the row and Compound H-2 in the column is 1, and the number of a mixture containing Compound H-10 in the row and Compound H-5 in the column is 895. Combinations of compounds in other mixtures are also determined likewise. Table 1 to Table 40 show combinations of compounds contained in Mixtures 1 to 22500.

**Table 1**

| | H-1 | H-2 | H-3 | H-4 | H-5 | H-6 | H-7 | H-8 | H-9 | H-10 | H-11 | H-12 | H-13 | H-14 | H-15 |
|---|---|---|---|---|---|---|---|---|---|---|---|---|---|---|---|
| H-1 | - | 1 | 2 | 3 | 4 | 5 | 6 | 7 | 8 | 9 | 10 | 11 | 12 | 13 | 14 |
| H-2 | 1 | - | 225 | 226 | 227 | 228 | 229 | 230 | 231 | 232 | 233 | 234 | 235 | 236 | 237 |
| H-3 | 2 | 225 | - | 448 | 449 | 450 | 451 | 452 | 453 | 454 | 455 | 456 | 457 | 458 | 459 |
| H-4 | 3 | 226 | 448 | - | 670 | 671 | 672 | 673 | 674 | 675 | 676 | 677 | 678 | 679 | 680 |
| H-5 | 4 | 227 | 449 | 670 | - | 891 | 892 | 893 | 894 | 895 | 896 | 897 | 898 | 899 | 900 |
| H-6 | 5 | 228 | 450 | 671 | 891 | - | 1111 | 1112 | 1113 | 1114 | 1115 | 1116 | 1117 | 1118 | 1119 |
| H-7 | 6 | 229 | 451 | 672 | 892 | 1111 | - | 1330 | 1331 | 1332 | 1333 | 1334 | 1335 | 1336 | 1337 |
| H-8 | 7 | 230 | 452 | 673 | 893 | 1112 | 1330 | - | 1548 | 1549 | 1550 | 1551 | 1552 | 1553 | 1554 |

(continued)

| | H-1 | H-2 | H-3 | H-4 | H-5 | H-6 | H-7 | H-8 | H-9 | H-10 | H-11 | H-12 | H-13 | H-14 | H-15 |
|---|---|---|---|---|---|---|---|---|---|---|---|---|---|---|---|
| H-9 | 8 | 231 | 453 | 674 | 894 | 1113 | 1331 | 1548 | - | 1765 | 1766 | 1767 | 1768 | 1769 | 1770 |
| H-10 | 9 | 232 | 454 | 675 | 895 | 1114 | 1332 | 1549 | 1765 | - | 1981 | 1982 | 1983 | 1984 | 1985 |
| H-11 | 10 | 233 | 455 | 676 | 896 | 1115 | 1333 | 1550 | 1766 | 1981 | - | 2196 | 2197 | 2198 | 2199 |
| H-12 | 11 | 234 | 456 | 677 | 897 | 1116 | 1334 | 1551 | 1767 | 1982 | 2196 | - | 2410 | 2411 | 2412 |
| H-13 | 12 | 235 | 457 | 678 | 898 | 1117 | 1335 | 1552 | 1768 | 1983 | 2197 | 2410 | - | 2623 | 2624 |
| H-14 | 13 | 236 | 458 | 679 | 899 | 1118 | 1336 | 1553 | 1769 | 1984 | 2198 | 2411 | 2623 | - | 2835 |
| H-15 | 14 | 237 | 459 | 680 | 900 | 1119 | 1337 | 1554 | 1770 | 1985 | 2199 | 2412 | 2624 | 2835 | - |
| H-16 | 15 | 238 | 460 | 681 | 901 | 1120 | 1338 | 1555 | 1771 | 1986 | 2200 | 2413 | 2625 | 2836 | 3046 |
| H-17 | 16 | 239 | 461 | 682 | 902 | 1121 | 1339 | 1556 | 1772 | 1987 | 2201 | 2414 | 2626 | 2837 | 3047 |
| H-18 | 17 | 240 | 462 | 683 | 903 | 1122 | 1340 | 1557 | 1773 | 1988 | 2202 | 2415 | 2627 | 2838 | 3048 |
| H-19 | 18 | 241 | 463 | 684 | 904 | 1123 | 1341 | 1558 | 1774 | 1989 | 2203 | 2416 | 2628 | 2839 | 3049 |
| H-20 | 19 | 242 | 464 | 685 | 905 | 1124 | 1342 | 1559 | 1775 | 1990 | 2204 | 2417 | 2629 | 2840 | 3050 |
| H-21 | 20 | 243 | 465 | 686 | 906 | 1125 | 1343 | 1560 | 1776 | 1991 | 2205 | 2418 | 2630 | 2841 | 3051 |
| H-22 | 21 | 244 | 466 | 687 | 907 | 1126 | 1344 | 1561 | 1777 | 1992 | 2206 | 2419 | 2631 | 2842 | 3052 |
| H-23 | 22 | 245 | 467 | 688 | 908 | 1127 | 1345 | 1562 | 1778 | 1993 | 2207 | 2420 | 2632 | 2843 | 3053 |
| H-24 | 23 | 246 | 468 | 689 | 909 | 1128 | 1346 | 1563 | 1779 | 1994 | 2208 | 2421 | 2633 | 2844 | 3054 |
| H-25 | 24 | 247 | 469 | 690 | 910 | 1129 | 1347 | 1564 | 1780 | 1995 | 2209 | 2422 | 2634 | 2845 | 3055 |
| H-26 | 25 | 248 | 470 | 691 | 911 | 1130 | 1348 | 1565 | 1781 | 1996 | 2210 | 2423 | 2635 | 2846 | 3056 |
| H-27 | 26 | 249 | 471 | 692 | 912 | 1131 | 1349 | 1566 | 1782 | 1997 | 2211 | 2424 | 2636 | 2847 | 3057 |
| H-28 | 27 | 250 | 472 | 693 | 913 | 1132 | 1350 | 1567 | 1783 | 1998 | 2212 | 2425 | 2637 | 2848 | 3058 |
| H-29 | 28 | 251 | 473 | 694 | 914 | 1133 | 1351 | 1568 | 1784 | 1999 | 2213 | 2426 | 2638 | 2849 | 3059 |
| H-30 | 29 | 252 | 474 | 695 | 915 | 1134 | 1352 | 1569 | 1785 | 2000 | 2214 | 2427 | 2639 | 2850 | 3060 |
| H-31 | 30 | 253 | 475 | 696 | 916 | 1135 | 1353 | 1570 | 1786 | 2001 | 2215 | 2428 | 2640 | 2851 | 3061 |
| H-32 | 31 | 254 | 476 | 697 | 917 | 1136 | 1354 | 1571 | 1787 | 2002 | 2216 | 2429 | 2641 | 2852 | 3062 |
| H-33 | 32 | 255 | 477 | 698 | 918 | 1137 | 1355 | 1572 | 1788 | 2003 | 2217 | 2430 | 2642 | 2853 | 3063 |
| H-34 | 33 | 256 | 478 | 699 | 919 | 1138 | 1356 | 1573 | 1789 | 2004 | 2218 | 2431 | 2643 | 2854 | 3064 |
| H-35 | 34 | 257 | 479 | 700 | 920 | 1139 | 1357 | 1574 | 1790 | 2005 | 2219 | 2432 | 2644 | 2855 | 3065 |
| H-36 | 35 | 258 | 480 | 701 | 921 | 1140 | 1358 | 1575 | 1791 | 2006 | 2220 | 2433 | 2645 | 2856 | 3066 |
| H-37 | 36 | 259 | 481 | 702 | 922 | 1141 | 1359 | 1576 | 1792 | 2007 | 2221 | 2434 | 2646 | 2857 | 3067 |
| H-38 | 37 | 260 | 482 | 703 | 923 | 1142 | 1360 | 1577 | 1793 | 2008 | 2222 | 2435 | 2647 | 2858 | 3068 |
| H-39 | 38 | 261 | 483 | 704 | 924 | 1143 | 1361 | 1578 | 1794 | 2009 | 2223 | 2436 | 2648 | 2859 | 3069 |
| H-40 | 39 | 262 | 484 | 705 | 925 | 1144 | 1362 | 1579 | 1795 | 2010 | 2224 | 2437 | 2649 | 2860 | 3070 |
| H-41 | 40 | 263 | 485 | 706 | 926 | 1145 | 1363 | 1580 | 1796 | 2011 | 2225 | 2438 | 2650 | 2861 | 3071 |
| H-42 | 41 | 264 | 486 | 707 | 927 | 1146 | 1364 | 1581 | 1797 | 2012 | 2226 | 2439 | 2651 | 2862 | 3072 |
| H-43 | 42 | 265 | 487 | 708 | 928 | 1147 | 1365 | 1582 | 1798 | 2013 | 2227 | 2440 | 2652 | 2863 | 3073 |
| H-44 | 43 | 266 | 488 | 709 | 929 | 1148 | 1366 | 1583 | 1799 | 2014 | 2228 | 2441 | 2653 | 2864 | 3074 |
| H-45 | 44 | 267 | 489 | 710 | 930 | 1149 | 1367 | 1584 | 1800 | 2015 | 2229 | 2442 | 2654 | 2865 | 3075 |
| H-46 | 45 | 268 | 490 | 711 | 931 | 1150 | 1368 | 1585 | 1801 | 2016 | 2230 | 2443 | 2655 | 2866 | 3076 |

(continued)

| | H-1 | H-2 | H-3 | H-4 | H-5 | H-6 | H-7 | H-8 | H-9 | H-10 | H-11 | H-12 | H-13 | H-14 | H-15 |
|---|---|---|---|---|---|---|---|---|---|---|---|---|---|---|---|
| H-47 | 46 | 269 | 491 | 712 | 932 | 1151 | 1369 | 1586 | 1802 | 2017 | 2231 | 2444 | 2656 | 2867 | 3077 |
| H-48 | 47 | 270 | 492 | 713 | 933 | 1152 | 1370 | 1587 | 1803 | 2018 | 2232 | 2445 | 2657 | 2868 | 3078 |
| H-49 | 48 | 271 | 493 | 714 | 934 | 1153 | 1371 | 1588 | 1804 | 2019 | 2233 | 2446 | 2658 | 2869 | 3079 |
| H-50 | 49 | 272 | 494 | 715 | 935 | 1154 | 1372 | 1589 | 1805 | 2020 | 2234 | 2447 | 2659 | 2870 | 3080 |
| H-51 | 50 | 273 | 495 | 716 | 936 | 1155 | 1373 | 1590 | 1806 | 2021 | 2235 | 2448 | 2660 | 2871 | 3081 |
| H-52 | 51 | 274 | 496 | 717 | 937 | 1156 | 1374 | 1591 | 1807 | 2022 | 2236 | 2449 | 2661 | 2872 | 3082 |
| H-53 | 52 | 275 | 497 | 718 | 938 | 1157 | 1375 | 1592 | 1808 | 2023 | 2237 | 2450 | 2662 | 2873 | 3083 |
| H-54 | 53 | 276 | 498 | 719 | 939 | 1158 | 1376 | 1593 | 1809 | 2024 | 2238 | 2451 | 2663 | 2874 | 3084 |
| H-55 | 54 | 277 | 499 | 720 | 940 | 1159 | 1377 | 1594 | 1810 | 2025 | 2239 | 2452 | 2664 | 2875 | 3085 |

**Table 2**

| | H-16 | H-17 | H-18 | H-19 | H-20 | H-21 | H-22 | H-23 | H-24 | H-25 | H-26 | H-27 | H-28 | H-29 | H-30 |
|---|---|---|---|---|---|---|---|---|---|---|---|---|---|---|---|
| H-1 | 15 | 16 | 17 | 18 | 19 | 20 | 21 | 22 | 23 | 24 | 25 | 26 | 27 | 28 | 29 |
| H-2 | 238 | 239 | 240 | 241 | 242 | 243 | 244 | 245 | 246 | 247 | 248 | 249 | 250 | 251 | 252 |
| H-3 | 460 | 461 | 462 | 463 | 464 | 465 | 466 | 467 | 468 | 469 | 470 | 471 | 472 | 473 | 474 |
| H-4 | 681 | 682 | 683 | 684 | 685 | 686 | 687 | 688 | 689 | 690 | 691 | 692 | 693 | 694 | 695 |
| H-5 | 901 | 902 | 903 | 904 | 905 | 906 | 907 | 908 | 909 | 910 | 911 | 912 | 913 | 914 | 915 |
| H-6 | 1120 | 1121 | 1122 | 1123 | 1124 | 1125 | 1126 | 1127 | 1128 | 1129 | 1130 | 1131 | 1132 | 1133 | 1134 |
| H-7 | 1338 | 1339 | 1340 | 1341 | 1342 | 1343 | 1344 | 1345 | 1346 | 1347 | 1348 | 1349 | 1350 | 1351 | 1352 |
| H-8 | 1555 | 1556 | 1557 | 1558 | 1559 | 1560 | 1561 | 1562 | 1563 | 1564 | 1565 | 1566 | 1567 | 1568 | 1569 |
| H-9 | 1771 | 1772 | 1773 | 1774 | 1775 | 1776 | 1777 | 1778 | 1779 | 1780 | 1781 | 1782 | 1783 | 1784 | 1785 |
| H-10 | 1986 | 1987 | 1988 | 1989 | 1990 | 1991 | 1992 | 1993 | 1994 | 1995 | 1996 | 1997 | 1998 | 1999 | 2000 |
| H-11 | 2200 | 2201 | 2202 | 2203 | 2204 | 2205 | 2206 | 2207 | 2208 | 2209 | 2210 | 2211 | 2212 | 2213 | 2214 |
| H-12 | 2413 | 2414 | 2415 | 2416 | 2417 | 2418 | 2419 | 2420 | 2421 | 2422 | 2423 | 2424 | 2425 | 2426 | 2427 |
| H-13 | 2625 | 2626 | 2627 | 2628 | 2629 | 2630 | 2631 | 2632 | 2633 | 2634 | 2635 | 2636 | 2637 | 2638 | 2639 |
| H-14 | 2836 | 2837 | 2838 | 2839 | 2840 | 2841 | 2842 | 2843 | 2844 | 2845 | 2846 | 2847 | 2848 | 2849 | 2850 |
| H-15 | 3046 | 3047 | 3048 | 3049 | 3050 | 3051 | 3052 | 3053 | 3054 | 3055 | 3056 | 3057 | 3058 | 3059 | 3060 |
| H-16 | - | 3256 | 3257 | 3258 | 3259 | 3260 | 3261 | 3262 | 3263 | 3264 | 3265 | 3266 | 3267 | 3268 | 3269 |
| H-17 | 3256 | - | 3465 | 3466 | 3467 | 3468 | 3469 | 3470 | 3471 | 3472 | 3473 | 3474 | 3475 | 3476 | 3477 |
| H-18 | 3257 | 3465 | - | 3673 | 3674 | 3675 | 3676 | 3677 | 3678 | 3679 | 3680 | 3681 | 3682 | 3683 | 3684 |
| H-19 | 3258 | 3466 | 3673 | - | 3880 | 3881 | 3882 | 3883 | 3884 | 3885 | 3886 | 3887 | 3888 | 3889 | 3890 |
| H-20 | 3259 | 3467 | 3674 | 3880 | - | 4086 | 4087 | 4088 | 4089 | 4090 | 4091 | 4092 | 4093 | 4094 | 4095 |
| H-21 | 3260 | 3468 | 3675 | 3881 | 4086 | - | 4291 | 4292 | 4293 | 4294 | 4295 | 4296 | 4297 | 4298 | 4299 |
| H-22 | 3261 | 3469 | 3676 | 3882 | 4087 | 4291 | - | 4495 | 4496 | 4497 | 4498 | 4499 | 4500 | 4501 | 4502 |
| H-23 | 3262 | 3470 | 3677 | 3883 | 4088 | 4292 | 4495 | - | 4698 | 4699 | 4700 | 4701 | 4702 | 4703 | 4704 |
| H-24 | 3263 | 3471 | 3678 | 3884 | 4089 | 4293 | 4496 | 4698 | - | 4900 | 4901 | 4902 | 4903 | 4904 | 4905 |
| H-25 | 3264 | 3472 | 3679 | 3885 | 4090 | 4294 | 4497 | 4699 | 4900 | - | 5101 | 5102 | 5103 | 5104 | 5105 |

(continued)

| | H-16 | H-17 | H-18 | H-19 | H-20 | H-21 | H-22 | H-23 | H-24 | H-25 | H-26 | H-27 | H-28 | H-29 | H-30 |
|---|---|---|---|---|---|---|---|---|---|---|---|---|---|---|---|
| H-26 | 3265 | 3473 | 3680 | 3886 | 4091 | 4295 | 4498 | 4700 | 4901 | 5101 | - | 5301 | 5302 | 5303 | 5304 |
| H-27 | 3266 | 3474 | 3681 | 3887 | 4092 | 4296 | 4499 | 4701 | 4902 | 5102 | 5301 | - | 5500 | 5501 | 5502 |
| H-28 | 3267 | 3475 | 3682 | 3888 | 4093 | 4297 | 4500 | 4702 | 4903 | 5103 | 5302 | 5500 | - | 5698 | 5699 |
| H-29 | 3268 | 3476 | 3683 | 3889 | 4094 | 4298 | 4501 | 4703 | 4904 | 5104 | 5303 | 5501 | 5698 | - | 5895 |
| H-30 | 3269 | 3477 | 3684 | 3890 | 4095 | 4299 | 4502 | 4704 | 4905 | 5105 | 5304 | 5502 | 5699 | 5895 | - |
| H-31 | 3270 | 3478 | 3685 | 3891 | 4096 | 4300 | 4503 | 4705 | 4906 | 5106 | 5305 | 5503 | 5700 | 5896 | 6091 |
| H-32 | 3271 | 3479 | 3686 | 3892 | 4097 | 4301 | 4504 | 4706 | 4907 | 5107 | 5306 | 5504 | 5701 | 5897 | 6092 |
| H-33 | 3272 | 3480 | 3687 | 3893 | 4098 | 4302 | 4505 | 4707 | 4908 | 5108 | 5307 | 5505 | 5702 | 5898 | 6093 |
| H-34 | 3273 | 3481 | 3688 | 3894 | 4099 | 4303 | 4506 | 4708 | 4909 | 5109 | 5308 | 5506 | 5703 | 5899 | 6094 |
| H-35 | 3274 | 3482 | 3689 | 3895 | 4100 | 4304 | 4507 | 4709 | 4910 | 5110 | 5309 | 5507 | 5704 | 5900 | 6095 |
| H-36 | 3275 | 3483 | 3690 | 3896 | 4101 | 4305 | 4508 | 4710 | 4911 | 5111 | 5310 | 5508 | 5705 | 5901 | 6096 |
| H-37 | 3276 | 3484 | 3691 | 3897 | 4102 | 4306 | 4509 | 4711 | 4912 | 5112 | 5311 | 5509 | 5706 | 5902 | 6097 |
| H-38 | 3277 | 3485 | 3692 | 3898 | 4103 | 4307 | 4510 | 4712 | 4913 | 5113 | 5312 | 5510 | 5707 | 5903 | 6098 |
| H-39 | 3278 | 3486 | 3693 | 3899 | 4104 | 4308 | 4511 | 4713 | 4914 | 5114 | 5313 | 5511 | 5708 | 5904 | 6099 |
| H-40 | 3279 | 3487 | 3694 | 3900 | 4105 | 4309 | 4512 | 4714 | 4915 | 5115 | 5314 | 5512 | 5709 | 5905 | 6100 |
| H-41 | 3280 | 3488 | 3695 | 3901 | 4106 | 4310 | 4513 | 4715 | 4916 | 5116 | 5315 | 5513 | 5710 | 5906 | 6101 |
| H-42 | 3281 | 3489 | 3696 | 3902 | 4107 | 4311 | 4514 | 4716 | 4917 | 5117 | 5316 | 5514 | 5711 | 5907 | 6102 |
| H-43 | 3282 | 3490 | 3697 | 3903 | 4108 | 4312 | 4515 | 4717 | 4918 | 5118 | 5317 | 5515 | 5712 | 5908 | 6103 |
| H-44 | 3283 | 3491 | 3698 | 3904 | 4109 | 4313 | 4516 | 4718 | 4919 | 5119 | 5318 | 5516 | 5713 | 5909 | 6104 |
| H-45 | 3284 | 3492 | 3699 | 3905 | 4110 | 4314 | 4517 | 4719 | 4920 | 5120 | 5319 | 5517 | 5714 | 5910 | 6105 |
| H-46 | 3285 | 3493 | 3700 | 3906 | 4111 | 4315 | 4518 | 4720 | 4921 | 5121 | 5320 | 5518 | 5715 | 5911 | 6106 |
| H-47 | 3286 | 3494 | 3701 | 3907 | 4112 | 4316 | 4519 | 4721 | 4922 | 5122 | 5321 | 5519 | 5716 | 5912 | 6107 |
| H-48 | 3287 | 3495 | 3702 | 3908 | 4113 | 4317 | 4520 | 4722 | 4923 | 5123 | 5322 | 5520 | 5717 | 5913 | 6108 |
| H-49 | 3288 | 3496 | 3703 | 3909 | 4114 | 4318 | 4521 | 4723 | 4924 | 5124 | 5323 | 5521 | 5718 | 5914 | 6109 |
| H-50 | 3289 | 3497 | 3704 | 3910 | 4115 | 4319 | 4522 | 4724 | 4925 | 5125 | 5324 | 5522 | 5719 | 5915 | 6110 |

(continued)

| | H-16 | H-17 | H-18 | H-19 | H-20 | H-21 | H-22 | H-23 | H-24 | H-25 | H-26 | H-27 | H-28 | H-29 | H-30 |
|---|---|---|---|---|---|---|---|---|---|---|---|---|---|---|---|
| H-51 | 3290 | 3498 | 3705 | 3911 | 4116 | 4320 | 4523 | 4725 | 4926 | 5126 | 5325 | 5523 | 5720 | 5916 | 6111 |
| H-52 | 3291 | 3499 | 3706 | 3912 | 4117 | 4321 | 4524 | 4726 | 4927 | 5127 | 5326 | 5524 | 5721 | 5917 | 6112 |
| H-53 | 3292 | 3500 | 3707 | 3913 | 4118 | 4322 | 4525 | 4727 | 4928 | 5128 | 5327 | 5525 | 5722 | 5918 | 6113 |
| H-54 | 3293 | 3501 | 3708 | 3914 | 4119 | 4323 | 4526 | 4728 | 4929 | 5129 | 5328 | 5526 | 5723 | 5919 | 6114 |
| H-55 | 3294 | 3502 | 3709 | 3915 | 4120 | 4324 | 4527 | 4729 | 4930 | 5130 | 5329 | 5527 | 5724 | 5920 | 6115 |

Table 3

| | H-31 | H-32 | H-33 | H-34 | H-35 | H-36 | H-37 | H-38 | H-39 | H-40 | H-41 | H-42 | H-43 | H-44 | H-45 |
|---|---|---|---|---|---|---|---|---|---|---|---|---|---|---|---|
| H-1 | 30 | 31 | 32 | 33 | 34 | 35 | 36 | 37 | 38 | 39 | 40 | 41 | 42 | 43 | 44 |
| H-2 | 253 | 254 | 255 | 256 | 257 | 258 | 259 | 260 | 261 | 262 | 263 | 264 | 265 | 266 | 267 |
| H-3 | 475 | 476 | 477 | 478 | 479 | 480 | 481 | 482 | 483 | 484 | 485 | 486 | 487 | 488 | 489 |
| H-4 | 696 | 697 | 698 | 699 | 700 | 701 | 702 | 703 | 704 | 705 | 706 | 707 | 708 | 709 | 710 |
| H-5 | 916 | 917 | 918 | 919 | 920 | 921 | 922 | 923 | 924 | 925 | 926 | 927 | 928 | 929 | 930 |
| H-6 | 1135 | 1136 | 1137 | 1138 | 1139 | 1140 | 1141 | 1142 | 1143 | 1144 | 1145 | 1146 | 1147 | 1148 | 1149 |
| H-7 | 1353 | 1354 | 1355 | 1356 | 1357 | 1358 | 1359 | 1360 | 1361 | 1362 | 1363 | 1364 | 1365 | 1366 | 1367 |
| H-8 | 1570 | 1571 | 1572 | 1573 | 1574 | 1575 | 1576 | 1577 | 1578 | 1579 | 1580 | 1581 | 1582 | 1583 | 1584 |
| H-9 | 1786 | 1787 | 1788 | 1789 | 1790 | 1791 | 1792 | 1793 | 1794 | 1795 | 1796 | 1797 | 1798 | 1799 | 1800 |
| H-10 | 2001 | 2002 | 2003 | 2004 | 2005 | 2006 | 2007 | 2008 | 2009 | 2010 | 2011 | 2012 | 2013 | 2014 | 2015 |
| H-11 | 2215 | 2216 | 2217 | 2218 | 2219 | 2220 | 2221 | 2222 | 2223 | 2224 | 2225 | 2226 | 2227 | 2228 | 2229 |
| H-12 | 2428 | 2429 | 2430 | 2431 | 2432 | 2433 | 2434 | 2435 | 2436 | 2437 | 2438 | 2439 | 2440 | 2441 | 2442 |
| H-13 | 2640 | 2641 | 2642 | 2643 | 2644 | 2645 | 2646 | 2647 | 2648 | 2649 | 2650 | 2651 | 2652 | 2653 | 2654 |
| H-14 | 2851 | 2852 | 2853 | 2854 | 2855 | 2856 | 2857 | 2858 | 2859 | 2860 | 2861 | 2862 | 2863 | 2864 | 2865 |
| H-15 | 3061 | 3062 | 3063 | 3064 | 3065 | 3066 | 3067 | 3068 | 3069 | 3070 | 3071 | 3072 | 3073 | 3074 | 3075 |
| H-16 | 3270 | 3271 | 3272 | 3273 | 3274 | 3275 | 3276 | 3277 | 3278 | 3279 | 3280 | 3281 | 3282 | 3283 | 3284 |
| H-17 | 3478 | 3479 | 3480 | 3481 | 3482 | 3483 | 3484 | 3485 | 3486 | 3487 | 3488 | 3489 | 3490 | 3491 | 3492 |
| H-18 | 3685 | 3686 | 3687 | 3688 | 3689 | 3690 | 3691 | 3692 | 3693 | 3694 | 3695 | 3696 | 3697 | 3698 | 3699 |
| H-19 | 3891 | 3892 | 3893 | 3894 | 3895 | 3896 | 3897 | 3898 | 3899 | 3900 | 3901 | 3902 | 3903 | 3904 | 3905 |
| H-20 | 4096 | 4097 | 4098 | 4099 | 4100 | 4101 | 4102 | 4103 | 4104 | 4105 | 4106 | 4107 | 4108 | 4109 | 4110 |
| H-21 | 4300 | 4301 | 4302 | 4303 | 4304 | 4305 | 4306 | 4307 | 4308 | 4309 | 4310 | 4311 | 4312 | 4313 | 4314 |
| H-22 | 4503 | 4504 | 4505 | 4506 | 4507 | 4508 | 4509 | 4510 | 4511 | 4512 | 4513 | 4514 | 4515 | 4516 | 4517 |
| H-23 | 4705 | 4706 | 4707 | 4708 | 4709 | 4710 | 4711 | 4712 | 4713 | 4714 | 4715 | 4716 | 4717 | 4718 | 4719 |
| H-24 | 4906 | 4907 | 4908 | 4909 | 4910 | 4911 | 4912 | 4913 | 4914 | 4915 | 4916 | 4917 | 4918 | 4919 | 4920 |
| H-25 | 5106 | 5107 | 5108 | 5109 | 5110 | 5111 | 5112 | 5113 | 5114 | 5115 | 5116 | 5117 | 5118 | 5119 | 5120 |

(continued)

| | H-31 | H-32 | H-33 | H-34 | H-35 | H-36 | H-37 | H-38 | H-39 | H-40 | H-41 | H-42 | H-43 | H-44 | H-45 |
|---|---|---|---|---|---|---|---|---|---|---|---|---|---|---|---|
| H-26 | 5305 | 5306 | 5307 | 5308 | 5309 | 5310 | 5311 | 5312 | 5313 | 5314 | 5315 | 5316 | 5317 | 5318 | 5319 |
| H-27 | 5503 | 5504 | 5505 | 5506 | 5507 | 5508 | 5509 | 5510 | 5511 | 5512 | 5513 | 5514 | 5515 | 5516 | 5517 |
| H-28 | 5700 | 5701 | 5702 | 5703 | 5704 | 5705 | 5706 | 5707 | 5708 | 5709 | 5710 | 5711 | 5712 | 5713 | 5714 |
| H-29 | 5896 | 5897 | 5898 | 5899 | 5900 | 5901 | 5902 | 5903 | 5904 | 5905 | 5906 | 5907 | 5908 | 5909 | 5910 |
| H-30 | 6091 | 6092 | 6093 | 6094 | 6095 | 6096 | 6097 | 6098 | 6099 | 6100 | 6101 | 6102 | 6103 | 6104 | 6105 |
| H-31 | - | 6286 | 6287 | 6288 | 6289 | 6290 | 6291 | 6292 | 6293 | 6294 | 6295 | 6296 | 6297 | 6298 | 6299 |
| H-32 | 6286 | - | 6480 | 6481 | 6482 | 6483 | 6484 | 6485 | 6486 | 6487 | 6488 | 6489 | 6490 | 6491 | 6492 |
| H-33 | 6287 | 6480 | - | 6673 | 6674 | 6675 | 6676 | 6677 | 6678 | 6679 | 6680 | 6681 | 6682 | 6683 | 6684 |
| H-34 | 6288 | 6481 | 6673 | - | 6865 | 6866 | 6867 | 6868 | 6869 | 6870 | 6871 | 6872 | 6873 | 6874 | 6875 |
| H-35 | 6289 | 6482 | 6674 | 6865 | - | 7056 | 7057 | 7058 | 7059 | 7060 | 7061 | 7062 | 7063 | 7064 | 7065 |
| H-36 | 6290 | 6483 | 6675 | 6866 | 7056 | - | 7246 | 7247 | 7248 | 7249 | 7250 | 7251 | 7252 | 7253 | 7254 |
| H-37 | 6291 | 6484 | 6676 | 6867 | 7057 | 7246 | - | 7435 | 7436 | 7437 | 7438 | 7439 | 7440 | 7441 | 7442 |
| H-38 | 6292 | 6485 | 6677 | 6868 | 7058 | 7247 | 7435 | - | 7623 | 7624 | 7625 | 7626 | 7627 | 7628 | 7629 |
| H-39 | 6293 | 6486 | 6678 | 6869 | 7059 | 7248 | 7436 | 7623 | - | 7810 | 7811 | 7812 | 7813 | 7814 | 7815 |
| H-40 | 6294 | 6487 | 6679 | 6870 | 7060 | 7249 | 7437 | 7624 | 7810 | - | 7996 | 7997 | 7998 | 7999 | 8000 |
| H-41 | 6295 | 6488 | 6680 | 6871 | 7061 | 7250 | 7438 | 7625 | 7811 | 7996 | - | 8181 | 8182 | 8183 | 8184 |
| H-42 | 6296 | 6489 | 6681 | 6872 | 7062 | 7251 | 7439 | 7626 | 7812 | 7997 | 8181 | - | 8365 | 8366 | 8367 |
| H-43 | 6297 | 6490 | 6682 | 6873 | 7063 | 7252 | 7440 | 7627 | 7813 | 7998 | 8182 | 8365 | - | 8548 | 8549 |
| H-44 | 6298 | 6491 | 6683 | 6874 | 7064 | 7253 | 7441 | 7628 | 7814 | 7999 | 8183 | 8366 | 8548 | - | 8730 |
| H-45 | 6299 | 6492 | 6684 | 6875 | 7065 | 7254 | 7442 | 7629 | 7815 | 8000 | 8184 | 8367 | 8549 | 8730 | - |
| H-46 | 6300 | 6493 | 6685 | 6876 | 7066 | 7255 | 7443 | 7630 | 7816 | 8001 | 8185 | 8368 | 8550 | 8731 | 8911 |
| H-47 | 6301 | 6494 | 6686 | 6877 | 7067 | 7256 | 7444 | 7631 | 7817 | 8002 | 8186 | 8369 | 8551 | 8732 | 6912 |
| H-48 | 6302 | 6495 | 6687 | 6878 | 7068 | 7257 | 7445 | 7632 | 7818 | 8003 | 8187 | 8370 | 8552 | 8733 | 8913 |
| H-49 | 6303 | 6496 | 6688 | 6879 | 7069 | 7258 | 7446 | 7633 | 7819 | 8004 | 8188 | 8371 | 8553 | 8734 | 8914 |
| H-50 | 6304 | 6497 | 6689 | 6880 | 7070 | 7259 | 7447 | 7634 | 7820 | 8005 | 8189 | 8372 | 8554 | 8735 | 8915 |

(continued)

| | H-31 | H-32 | H-33 | H-34 | H-35 | H-36 | H-37 | H-38 | H-39 | H-40 | H-41 | H-42 | H-43 | H-44 | H-45 |
|---|---|---|---|---|---|---|---|---|---|---|---|---|---|---|---|
| H-51 | 6305 | 6498 | 6690 | 6881 | 7071 | 7260 | 7448 | 7635 | 7821 | 8006 | 8190 | 8373 | 8555 | 8736 | 8916 |
| H-52 | 6306 | 6499 | 6691 | 6882 | 7072 | 7261 | 7449 | 7636 | 7822 | 8007 | 8191 | 8374 | 8556 | 8737 | 8917 |
| H-53 | 6307 | 6500 | 6692 | 6883 | 7073 | 7262 | 7450 | 7637 | 7823 | 8008 | 8192 | 8375 | 8557 | 8738 | 8918 |
| H-54 | 6308 | 6501 | 6693 | 6884 | 7074 | 7263 | 7451 | 7638 | 7824 | 8009 | 8193 | 8376 | 8558 | 8739 | 8919 |
| H-55 | 6309 | 6502 | 6694 | 6885 | 7075 | 7264 | 7452 | 7639 | 7825 | 8010 | 8194 | 8377 | 8559 | 8740 | 8920 |

Table 4

| | H-46 | H-47 | H-48 | H-49 | H-50 | H-51 | H-52 | H-53 | H-54 | H-55 | H-56 | H-57 | H-58 | H-59 | H-60 |
|---|---|---|---|---|---|---|---|---|---|---|---|---|---|---|---|
| H-1 | 45 | 46 | 47 | 48 | 49 | 50 | 51 | 52 | 53 | 54 | 55 | 56 | 57 | 58 | 59 |
| H-2 | 268 | 269 | 270 | 271 | 272 | 273 | 274 | 275 | 276 | 277 | 278 | 279 | 280 | 281 | 282 |
| H-3 | 490 | 491 | 492 | 493 | 494 | 495 | 496 | 497 | 498 | 499 | 500 | 501 | 502 | 503 | 504 |
| H-4 | 711 | 712 | 713 | 714 | 715 | 716 | 717 | 718 | 719 | 720 | 721 | 722 | 723 | 724 | 725 |
| H-5 | 931 | 932 | 933 | 934 | 935 | 936 | 937 | 938 | 939 | 940 | 941 | 942 | 943 | 944 | 945 |
| H-6 | 1150 | 1151 | 1152 | 1153 | 1154 | 1155 | 1156 | 1157 | 1158 | 1159 | 1160 | 1161 | 1162 | 1163 | 1164 |
| H-7 | 1368 | 1369 | 1370 | 1371 | 1372 | 1373 | 1374 | 1375 | 1376 | 1377 | 1378 | 1379 | 1380 | 1381 | 1382 |
| H-8 | 1585 | 1586 | 1587 | 1588 | 1589 | 1590 | 1591 | 1592 | 1593 | 1594 | 1595 | 1596 | 1597 | 1598 | 1599 |
| H-9 | 1801 | 1802 | 1803 | 1804 | 1805 | 1806 | 1807 | 1808 | 1809 | 1810 | 1811 | 1812 | 1813 | 1814 | 1815 |
| H-10 | 2016 | 2017 | 2018 | 2019 | 2020 | 2021 | 2022 | 2023 | 2024 | 2025 | 2026 | 2027 | 2028 | 2029 | 2030 |
| H-11 | 2230 | 2231 | 2232 | 2233 | 2234 | 2235 | 2236 | 2237 | 2238 | 2239 | 2240 | 2241 | 2242 | 2243 | 2244 |
| H-12 | 2443 | 2444 | 2445 | 2446 | 2447 | 2448 | 2449 | 2450 | 2451 | 2452 | 2453 | 2454 | 2455 | 2456 | 2457 |
| H-13 | 2655 | 2656 | 2657 | 2658 | 2659 | 2660 | 2661 | 2662 | 2663 | 2664 | 2665 | 2666 | 2667 | 2668 | 2669 |
| H-14 | 2866 | 2867 | 2868 | 2869 | 2870 | 2871 | 2872 | 2873 | 2874 | 2875 | 2876 | 2877 | 2878 | 2879 | 2880 |
| H-15 | 3076 | 3077 | 3078 | 3079 | 3080 | 3081 | 3082 | 3083 | 3084 | 3085 | 3086 | 3087 | 3088 | 3089 | 3090 |
| H-16 | 3285 | 3286 | 3287 | 3288 | 3289 | 3290 | 3291 | 3292 | 3293 | 3294 | 3295 | 3296 | 3297 | 3298 | 3299 |
| H-17 | 3493 | 3494 | 3495 | 3496 | 3497 | 3498 | 3499 | 3500 | 3501 | 3502 | 3503 | 3504 | 3505 | 3506 | 3507 |
| H-18 | 3700 | 3701 | 3702 | 3703 | 3704 | 3705 | 3706 | 3707 | 3708 | 3709 | 3710 | 3711 | 3712 | 3713 | 3714 |
| H-19 | 3906 | 3907 | 3908 | 3909 | 3910 | 3911 | 3912 | 3913 | 3914 | 3915 | 3916 | 3917 | 3918 | 3919 | 3920 |
| H-20 | 4111 | 4112 | 4113 | 4114 | 4115 | 4116 | 4117 | 4118 | 4119 | 4120 | 4121 | 4122 | 4123 | 4124 | 4125 |
| H-21 | 4315 | 4316 | 4317 | 4318 | 4319 | 4320 | 4321 | 4322 | 4323 | 4324 | 4325 | 4326 | 4327 | 4328 | 4329 |
| H-22 | 4518 | 4519 | 4520 | 4521 | 4522 | 4523 | 4524 | 4525 | 4526 | 4527 | 4528 | 4529 | 4530 | 4531 | 4532 |
| H-23 | 4720 | 4721 | 4722 | 4723 | 4724 | 4725 | 4726 | 4727 | 4728 | 4729 | 4730 | 4731 | 4732 | 4733 | 4734 |
| H-24 | 4921 | 4922 | 4923 | 4924 | 4925 | 4926 | 4927 | 4928 | 4929 | 4930 | 4931 | 4932 | 4933 | 4934 | 4935 |
| H-25 | 5121 | 5122 | 5123 | 5124 | 5125 | 5126 | 5127 | 5128 | 5129 | 5130 | 5131 | 5132 | 5133 | 5134 | 5135 |

(continued)

| | H-46 | H-47 | H-48 | H-49 | H-50 | H-51 | H-52 | H-53 | H-54 | H-55 | H-56 | H-57 | H-58 | H-59 | H-60 |
|---|---|---|---|---|---|---|---|---|---|---|---|---|---|---|---|
| H-26 | 5320 | 5321 | 5322 | 5323 | 5324 | 5325 | 5326 | 5327 | 5328 | 5329 | 5330 | 5331 | 5332 | 5333 | 5334 |
| H-27 | 5518 | 5519 | 5520 | 5521 | 5522 | 5523 | 5524 | 5525 | 5526 | 5527 | 5528 | 5529 | 5530 | 5531 | 5532 |
| H-28 | 5715 | 5716 | 5717 | 5718 | 5719 | 5720 | 5721 | 5722 | 5723 | 5724 | 5725 | 5726 | 5727 | 5728 | 5729 |
| H-29 | 5911 | 5912 | 5913 | 5914 | 5915 | 5916 | 5917 | 5918 | 5919 | 5920 | 5921 | 5922 | 5923 | 5924 | 5925 |
| H-30 | 6106 | 6107 | 6108 | 6109 | 6110 | 6111 | 6112 | 6113 | 6114 | 6115 | 6116 | 6117 | 6118 | 6119 | 6120 |
| H-31 | 6300 | 6301 | 6302 | 6303 | 6304 | 6305 | 6306 | 6307 | 6308 | 6309 | 6310 | 6311 | 6312 | 6313 | 6314 |
| H-32 | 6493 | 6494 | 6495 | 6496 | 6497 | 6498 | 6499 | 6500 | 6501 | 6502 | 6503 | 6504 | 6505 | 6506 | 6507 |
| H-33 | 6685 | 6686 | 6687 | 6688 | 6689 | 6690 | 6691 | 6692 | 6693 | 6694 | 6695 | 6696 | 6697 | 6698 | 6699 |
| H-34 | 6876 | 6877 | 6878 | 6879 | 6880 | 6881 | 6882 | 6883 | 6884 | 6885 | 6886 | 6887 | 6888 | 6889 | 6890 |
| H-35 | 7066 | 7067 | 7068 | 7069 | 7070 | 7071 | 7072 | 7073 | 7074 | 7075 | 7076 | 7077 | 7078 | 7079 | 7080 |
| H-36 | 7255 | 7256 | 7257 | 7258 | 7259 | 7260 | 7261 | 7262 | 7263 | 7264 | 7265 | 7266 | 7267 | 7268 | 7269 |
| H-37 | 7443 | 7444 | 7445 | 7446 | 7447 | 7448 | 7449 | 7450 | 7451 | 7452 | 7453 | 7454 | 7455 | 7456 | 7457 |
| H-38 | 7630 | 7631 | 7632 | 7633 | 7634 | 7635 | 7636 | 7637 | 7638 | 7639 | 7640 | 7641 | 7642 | 7643 | 7644 |
| H-39 | 7816 | 7817 | 7818 | 7819 | 7820 | 7821 | 7822 | 7823 | 7824 | 7825 | 7826 | 7827 | 7828 | 7829 | 7830 |
| H-40 | 8001 | 8002 | 8003 | 8004 | 8005 | 8006 | 8007 | 8008 | 8009 | 8010 | 8011 | 8012 | 8013 | 8014 | 8015 |
| H-41 | 8185 | 8186 | 8187 | 8188 | 8189 | 8190 | 8191 | 8192 | 8193 | 8194 | 8195 | 8196 | 8197 | 8198 | 8199 |
| H-42 | 8368 | 8369 | 8370 | 8371 | 8372 | 8373 | 8374 | 8375 | 8376 | 8377 | 8378 | 8379 | 8380 | 8381 | 8382 |
| H-43 | 8550 | 8551 | 8552 | 8553 | 8554 | 8555 | 8556 | 8557 | 8558 | 8559 | 8560 | 8561 | 8562 | 8563 | 8564 |
| H-44 | 8731 | 8732 | 8733 | 8734 | 8735 | 8736 | 8737 | 8738 | 8739 | 8740 | 8741 | 8742 | 8743 | 8744 | 8745 |
| H-45 | 8911 | 8912 | 8913 | 8914 | 8915 | 8916 | 8917 | 8918 | 8919 | 8920 | 8921 | 8922 | 8923 | 8924 | 8925 |
| H-46 | - | 9091 | 9092 | 9093 | 9094 | 9095 | 9096 | 9097 | 9098 | 9099 | 9100 | 9101 | 9102 | 9103 | 9104 |
| H-47 | 9091 | - | 9270 | 9271 | 9272 | 9273 | 9274 | 9275 | 9276 | 9277 | 9278 | 9279 | 9280 | 9281 | 9282 |
| H-48 | 9092 | 9270 | - | 9448 | 9449 | 9450 | 9451 | 9452 | 9453 | 9454 | 9455 | 9456 | 9457 | 9458 | 9459 |
| H-49 | 9093 | 9271 | 9448 | - | 9625 | 9626 | 9627 | 9628 | 9629 | 9630 | 9631 | 9632 | 9633 | 9634 | 9635 |
| H-50 | 9094 | 9272 | 9449 | 9625 | - | 9801 | 9802 | 9803 | 9804 | 9805 | 9806 | 9807 | 9808 | 9809 | 9810 |

(continued)

| | H-46 | H-47 | H-48 | H-49 | H-50 | H-51 | H-52 | H-53 | H-54 | H-55 | H-56 | H-57 | H-58 | H-59 | H-60 |
|---|---|---|---|---|---|---|---|---|---|---|---|---|---|---|---|
| H-51 | 9095 | 9273 | 9450 | 9626 | 9801 | - | 9976 | 9977 | 9978 | 9979 | 9980 | 9981 | 9982 | 9983 | 9984 |
| H-52 | 9096 | 9274 | 9451 | 9627 | 9802 | 9976 | - | 10150 | 10151 | 10152 | 10153 | 10154 | 10155 | 10156 | 10157 |
| H-53 | 9097 | 9275 | 9452 | 9628 | 9803 | 9977 | 10150 | - | 10323 | 10324 | 10325 | 10326 | 10327 | 10328 | 10329 |
| H-54 | 9098 | 9276 | 9453 | 9629 | 9804 | 9978 | 10151 | 10323 | - | 10495 | 10496 | 10497 | 10498 | 10499 | 10500 |
| H-55 | 9099 | 9277 | 9454 | 9630 | 9805 | 9979 | 10152 | 10324 | 10495 | - | 10666 | 10667 | 10668 | 10669 | 10670 |

**Table 5**

| | H-61 | H-62 | H-63 | H-64 | H-65 | H-66 | H-67 | H-68 | H-69 | H-70 | H-71 | H-72 | H-73 | H-74 | H-75 |
|---|---|---|---|---|---|---|---|---|---|---|---|---|---|---|---|
| H-1 | 60 | 61 | 62 | 63 | 64 | 65 | 66 | 67 | 68 | 69 | 70 | 71 | 72 | 73 | 74 |
| H-2 | 283 | 284 | 285 | 286 | 287 | 288 | 289 | 290 | 291 | 292 | 293 | 294 | 295 | 296 | 297 |
| H-3 | 505 | 506 | 507 | 508 | 509 | 510 | 511 | 512 | 513 | 514 | 515 | 516 | 517 | 518 | 519 |
| H-4 | 726 | 727 | 728 | 729 | 730 | 731 | 732 | 733 | 734 | 735 | 736 | 737 | 738 | 739 | 740 |
| H-5 | 946 | 947 | 948 | 949 | 950 | 951 | 952 | 953 | 954 | 955 | 956 | 957 | 958 | 959 | 960 |
| H-6 | 1165 | 1166 | 1167 | 1168 | 1169 | 1170 | 1171 | 1172 | 1173 | 1174 | 1175 | 1176 | 1177 | 1178 | 1179 |
| H-7 | 1383 | 1384 | 1385 | 1386 | 1387 | 1388 | 1389 | 1390 | 1391 | 1392 | 1393 | 1394 | 1395 | 1396 | 1397 |
| H-8 | 1600 | 1601 | 1602 | 1603 | 1604 | 1605 | 1606 | 1607 | 1608 | 1609 | 1610 | 1611 | 1612 | 1613 | 1614 |
| H-9 | 1816 | 1817 | 1818 | 1819 | 1820 | 1821 | 1822 | 1823 | 1824 | 1825 | 1826 | 1827 | 1828 | 1829 | 1830 |
| H-10 | 2031 | 2032 | 2033 | 2034 | 2035 | 2036 | 2037 | 2038 | 2039 | 2040 | 2041 | 2042 | 2043 | 2044 | 2045 |
| H-11 | 2245 | 2246 | 2247 | 2248 | 2249 | 2250 | 2251 | 2252 | 2253 | 2254 | 2255 | 2256 | 2257 | 2258 | 2259 |
| H-12 | 2458 | 2459 | 2460 | 2461 | 2462 | 2463 | 2464 | 2465 | 2466 | 2467 | 2468 | 2469 | 2470 | 2471 | 2472 |
| H-13 | 2670 | 2671 | 2672 | 2673 | 2674 | 2675 | 2676 | 2677 | 2678 | 2679 | 2680 | 2681 | 2682 | 2683 | 2684 |
| H-14 | 2881 | 2882 | 2883 | 2884 | 2885 | 2886 | 2887 | 2888 | 2889 | 2890 | 2891 | 2892 | 2893 | 2894 | 2895 |
| H-15 | 3091 | 3092 | 3093 | 3094 | 3095 | 3096 | 3097 | 3098 | 3099 | 3100 | 3101 | 3102 | 3103 | 3104 | 3105 |
| H-16 | 3300 | 3301 | 3302 | 3303 | 3304 | 3305 | 3306 | 3307 | 3308 | 3309 | 3310 | 3311 | 3312 | 3313 | 3314 |
| H-17 | 3508 | 3509 | 3510 | 3511 | 3512 | 3513 | 3514 | 3515 | 3516 | 3517 | 3518 | 3519 | 3520 | 3521 | 3522 |
| H-18 | 3715 | 3716 | 3717 | 3718 | 3719 | 3720 | 3721 | 3722 | 3723 | 3724 | 3725 | 3726 | 3727 | 3728 | 3729 |
| H-19 | 3921 | 3922 | 3923 | 3924 | 3925 | 3926 | 3927 | 3928 | 3929 | 3930 | 3931 | 3932 | 3933 | 3934 | 3935 |
| H-20 | 4126 | 4127 | 4128 | 4129 | 4130 | 4131 | 4132 | 4133 | 4134 | 4135 | 4136 | 4137 | 4138 | 4139 | 4140 |
| H-21 | 4330 | 4331 | 4332 | 4333 | 4334 | 4335 | 4336 | 4337 | 4338 | 4339 | 4340 | 4341 | 4342 | 4343 | 4344 |
| H-22 | 4533 | 4534 | 4535 | 4536 | 4537 | 4538 | 4539 | 4540 | 4541 | 4542 | 4543 | 4544 | 4545 | 4546 | 4547 |
| H-23 | 4735 | 4736 | 4737 | 4738 | 4739 | 4740 | 4741 | 4742 | 4743 | 4744 | 4745 | 4746 | 4747 | 4748 | 4749 |
| H-24 | 4936 | 4937 | 4938 | 4939 | 4940 | 4941 | 4942 | 4943 | 4944 | 4945 | 4946 | 4947 | 4948 | 4949 | 4950 |
| H-25 | 5136 | 5137 | 5138 | 5139 | 5140 | 5141 | 5142 | 5143 | 5144 | 5145 | 5146 | 5147 | 5148 | 5149 | 5150 |

(continued)

| | H-61 | H-62 | H-63 | H-64 | H-65 | H-66 | H-67 | H-68 | H-69 | H-70 | H-71 | H-72 | H-73 | H-74 | H-75 |
|---|---|---|---|---|---|---|---|---|---|---|---|---|---|---|---|
| H-26 | 5335 | 5336 | 5337 | 5338 | 5339 | 5340 | 5341 | 5342 | 5343 | 5344 | 5345 | 5346 | 5347 | 5348 | 5349 |
| H-27 | 5533 | 5534 | 5535 | 5536 | 5537 | 5538 | 5539 | 5540 | 5541 | 5542 | 5543 | 5544 | 5545 | 5546 | 5547 |
| H-28 | 5730 | 5731 | 5732 | 5733 | 5734 | 5735 | 5736 | 5737 | 5738 | 5739 | 5740 | 5741 | 5742 | 5743 | 5744 |
| H-29 | 5926 | 5927 | 5928 | 5929 | 5930 | 5931 | 5932 | 5933 | 5934 | 5935 | 5936 | 5937 | 5938 | 5939 | 5940 |
| H-30 | 6121 | 6122 | 6123 | 6124 | 6125 | 6126 | 6127 | 6128 | 6129 | 6130 | 6131 | 6132 | 6133 | 6134 | 6135 |
| H-31 | 6315 | 6316 | 6317 | 6318 | 6319 | 6320 | 6321 | 6322 | 6323 | 6324 | 6325 | 6326 | 6327 | 6328 | 6329 |
| H-32 | 6508 | 6509 | 6510 | 6511 | 6512 | 6513 | 6514 | 6515 | 6516 | 6517 | 6518 | 6519 | 6520 | 6521 | 6522 |
| H-33 | 6700 | 6701 | 6702 | 6703 | 6704 | 6705 | 6706 | 6707 | 6708 | 6709 | 6710 | 6711 | 6712 | 6713 | 6714 |
| H-34 | 6891 | 6892 | 6893 | 6894 | 6895 | 6896 | 6897 | 6898 | 6899 | 6900 | 6901 | 6902 | 6903 | 6904 | 6905 |
| H-35 | 7081 | 7082 | 7083 | 7084 | 7085 | 7086 | 7087 | 7088 | 7089 | 7090 | 7091 | 7092 | 7093 | 7094 | 7095 |
| H-36 | 7270 | 7271 | 7272 | 7273 | 7274 | 7275 | 7276 | 7277 | 7278 | 7279 | 7280 | 7281 | 7282 | 7283 | 7284 |
| H-37 | 7458 | 7459 | 7460 | 7461 | 7462 | 7463 | 7464 | 7465 | 7466 | 7467 | 7468 | 7469 | 7470 | 7471 | 7472 |
| H-38 | 7645 | 7646 | 7647 | 7648 | 7649 | 7650 | 7651 | 7652 | 7653 | 7654 | 7655 | 7656 | 7657 | 7658 | 7659 |
| H-39 | 7831 | 7832 | 7833 | 7834 | 7835 | 7836 | 7837 | 7838 | 7839 | 7840 | 7841 | 7842 | 7843 | 7844 | 7845 |
| H-40 | 8016 | 8017 | 8018 | 8019 | 8020 | 8021 | 8022 | 8023 | 8024 | 8025 | 8026 | 8027 | 8028 | 8029 | 8030 |
| H-41 | 8200 | 8201 | 8202 | 8203 | 8204 | 8205 | 8206 | 8207 | 8208 | 8209 | 8210 | 8211 | 8212 | 8213 | 8214 |
| H-42 | 8383 | 8384 | 8385 | 8386 | 8387 | 8388 | 8389 | 8390 | 8391 | 8392 | 8393 | 8394 | 8395 | 8396 | 8397 |
| H-43 | 8565 | 8566 | 8567 | 8568 | 8569 | 8570 | 8571 | 8572 | 8573 | 8574 | 8575 | 8576 | 8577 | 8578 | 8579 |
| H-44 | 8746 | 8747 | 8748 | 8749 | 8750 | 8751 | 8752 | 8753 | 8754 | 8755 | 8756 | 8757 | 8758 | 8759 | 8760 |
| H-45 | 8926 | 8927 | 8928 | 8929 | 8930 | 8931 | 8932 | 8933 | 8934 | 8935 | 8936 | 8937 | 8938 | 8939 | 8940 |
| H-46 | 9105 | 9106 | 9107 | 9108 | 9109 | 9110 | 9111 | 9112 | 9113 | 9114 | 9115 | 9116 | 9117 | 9118 | 9119 |
| H-47 | 9283 | 9284 | 9285 | 9286 | 9287 | 9288 | 9289 | 9290 | 9291 | 9292 | 9293 | 9294 | 9295 | 9296 | 9297 |
| H-48 | 9460 | 9461 | 9462 | 9463 | 9464 | 9465 | 9466 | 9467 | 9468 | 9469 | 9470 | 9471 | 9472 | 9473 | 9474 |
| H-49 | 9636 | 9637 | 9638 | 9639 | 9640 | 9641 | 9642 | 9643 | 9644 | 9645 | 9646 | 9647 | 9648 | 9649 | 9650 |
| H-50 | 9811 | 9812 | 9813 | 9814 | 9815 | 9816 | 9817 | 9818 | 9819 | 9820 | 9821 | 9822 | 9823 | 9824 | 9825 |

(continued)

| | H-61 | H-62 | H-63 | H-64 | H-65 | H-66 | H-67 | H-68 | H-69 | H-70 | H-71 | H-72 | H-73 | H-74 | H-75 |
|---|---|---|---|---|---|---|---|---|---|---|---|---|---|---|---|
| H-51 | 9985 | 9986 | 9987 | 9988 | 9989 | 9990 | 9991 | 9992 | 9993 | 9994 | 9995 | 9996 | 9997 | 9998 | 9999 |
| H-52 | 10158 | 10159 | 10160 | 10161 | 10162 | 10163 | 10164 | 10165 | 10166 | 10167 | 10168 | 10169 | 10170 | 10171 | 10172 |
| H-53 | 10330 | 10331 | 10332 | 10333 | 10334 | 10335 | 10336 | 10337 | 10338 | 10339 | 10340 | 10341 | 10342 | 10343 | 10344 |
| H-54 | 10501 | 10502 | 10503 | 10504 | 10505 | 10506 | 10507 | 10508 | 10509 | 10510 | 10511 | 10512 | 10513 | 10514 | 10515 |
| H-55 | 10671 | 10672 | 10673 | 10674 | 10675 | 10676 | 10677 | 10678 | 10679 | 10680 | 10681 | 10682 | 10683 | 10684 | 10685 |

**Table 6**

| | H-76 | H-77 | H-78 | H-79 | H-80 | H-81 | H-82 | H-83 | H-84 | H-85 | H-86 | H-87 | H-88 | H-89 | H-90 |
|---|---|---|---|---|---|---|---|---|---|---|---|---|---|---|---|
| H-1 | 75 | 76 | 77 | 78 | 79 | 80 | 81 | 82 | 83 | 84 | 85 | 86 | 87 | 88 | 89 |
| H-2 | 298 | 299 | 300 | 301 | 302 | 303 | 304 | 305 | 306 | 307 | 308 | 309 | 310 | 311 | 312 |
| H-3 | 520 | 521 | 522 | 523 | 524 | 525 | 526 | 527 | 528 | 529 | 530 | 531 | 532 | 533 | 534 |
| H-4 | 741 | 742 | 743 | 744 | 745 | 746 | 747 | 748 | 749 | 750 | 751 | 752 | 753 | 754 | 755 |
| H-5 | 961 | 962 | 963 | 964 | 965 | 966 | 967 | 968 | 969 | 970 | 971 | 972 | 973 | 974 | 975 |
| H-6 | 1180 | 1181 | 1182 | 1183 | 1184 | 1185 | 1186 | 1187 | 1188 | 1189 | 1190 | 1191 | 1192 | 1193 | 1194 |
| H-7 | 1398 | 1399 | 1400 | 1401 | 1402 | 1403 | 1404 | 1405 | 1406 | 1407 | 1408 | 1409 | 1410 | 1411 | 1412 |
| H-8 | 1615 | 1616 | 1617 | 1618 | 1619 | 1620 | 1621 | 1622 | 1623 | 1624 | 1625 | 1626 | 1627 | 1628 | 1629 |
| H-9 | 1831 | 1832 | 1833 | 1834 | 1835 | 1836 | 1837 | 1838 | 1839 | 1840 | 1841 | 1842 | 1843 | 1844 | 1845 |
| H-10 | 2046 | 2047 | 2048 | 2049 | 2050 | 2051 | 2052 | 2053 | 2054 | 2055 | 2056 | 2057 | 2058 | 2059 | 2060 |
| H-11 | 2260 | 2261 | 2262 | 2263 | 2264 | 2265 | 2266 | 2267 | 2268 | 2269 | 2270 | 2271 | 2272 | 2273 | 2274 |
| H-12 | 2473 | 2474 | 2475 | 2476 | 2477 | 2478 | 2479 | 2480 | 2481 | 2482 | 2483 | 2484 | 2485 | 2486 | 2487 |
| H-13 | 2685 | 2686 | 2687 | 2688 | 2689 | 2690 | 2691 | 2692 | 2693 | 2694 | 2695 | 2696 | 2697 | 2698 | 2699 |
| H-14 | 2896 | 2897 | 2898 | 2899 | 2900 | 2901 | 2902 | 2903 | 2904 | 2905 | 2906 | 2907 | 2908 | 2909 | 2910 |
| H-15 | 3106 | 3107 | 3108 | 3109 | 3110 | 3111 | 3112 | 3113 | 3114 | 3115 | 3116 | 3117 | 3118 | 3119 | 3120 |
| H-16 | 3315 | 3316 | 3317 | 3318 | 3319 | 3320 | 3321 | 3322 | 3323 | 3324 | 3325 | 3326 | 3327 | 3328 | 3329 |
| H-17 | 3523 | 3524 | 3525 | 3526 | 3527 | 3528 | 3529 | 3530 | 3531 | 3532 | 3533 | 3534 | 3535 | 3536 | 3537 |
| H-18 | 3730 | 3731 | 3732 | 3733 | 3734 | 3735 | 3736 | 3737 | 3738 | 3739 | 3740 | 3741 | 3742 | 3743 | 3744 |
| H-19 | 3936 | 3937 | 3938 | 3939 | 3940 | 3941 | 3942 | 3943 | 3944 | 3945 | 3946 | 3947 | 3948 | 3949 | 3950 |
| H-20 | 4141 | 4142 | 4143 | 4144 | 4145 | 4146 | 4147 | 4148 | 4149 | 4150 | 4151 | 4152 | 4153 | 4154 | 4155 |
| H-21 | 4345 | 4346 | 4347 | 4348 | 4349 | 4350 | 4351 | 4352 | 4353 | 4354 | 4355 | 4356 | 4357 | 4358 | 4359 |
| H-22 | 4548 | 4549 | 4550 | 4551 | 4552 | 4553 | 4554 | 4555 | 4556 | 4557 | 4558 | 4559 | 4560 | 4561 | 4562 |
| H-23 | 4750 | 4751 | 4752 | 4753 | 4754 | 4755 | 4756 | 4757 | 4758 | 4759 | 4760 | 4761 | 4762 | 4763 | 4764 |
| H-24 | 4951 | 4952 | 4953 | 4954 | 4955 | 4956 | 4957 | 4958 | 4959 | 4960 | 4961 | 4962 | 4963 | 4964 | 4965 |
| H-25 | 5151 | 5152 | 5153 | 5154 | 5155 | 5156 | 5157 | 5158 | 5159 | 5160 | 5161 | 5162 | 5163 | 5164 | 5165 |

(continued)

| | H-76 | H-77 | H-78 | H-79 | H-80 | H-81 | H-82 | H-83 | H-84 | H-85 | H-86 | H-87 | H-88 | H-89 | H-90 |
|---|---|---|---|---|---|---|---|---|---|---|---|---|---|---|---|
| H-26 | 5350 | 5351 | 5352 | 5353 | 5354 | 5355 | 5356 | 5357 | 5358 | 5359 | 5360 | 5361 | 5362 | 5363 | 5364 |
| H-27 | 5548 | 5549 | 5550 | 5551 | 5552 | 5553 | 5554 | 5555 | 5556 | 5557 | 5558 | 5559 | 5560 | 5561 | 5562 |
| H-28 | 5745 | 5746 | 5747 | 5748 | 5749 | 5750 | 5751 | 5752 | 5753 | 5754 | 5755 | 5756 | 5757 | 5758 | 5759 |
| H-29 | 5941 | 5942 | 5943 | 5944 | 5945 | 5946 | 5947 | 5948 | 5949 | 5950 | 5951 | 5952 | 5953 | 5954 | 5955 |
| H-30 | 6136 | 6137 | 6138 | 6139 | 6140 | 6141 | 6142 | 6143 | 6144 | 6145 | 6146 | 6147 | 6148 | 6149 | 6150 |
| H-31 | 6330 | 6331 | 6332 | 6333 | 6334 | 6335 | 6336 | 6337 | 6338 | 6339 | 6340 | 6341 | 6342 | 6343 | 6344 |
| H-32 | 6523 | 6524 | 6525 | 6526 | 6527 | 6528 | 6529 | 6530 | 6531 | 6532 | 6533 | 6534 | 6535 | 6536 | 6537 |
| H-33 | 6715 | 6716 | 6717 | 6718 | 6719 | 6720 | 6721 | 6722 | 6723 | 6724 | 6725 | 6726 | 6727 | 6728 | 6729 |
| H-34 | 6906 | 6907 | 6908 | 6909 | 6910 | 6911 | 6912 | 6913 | 6914 | 6915 | 6916 | 6917 | 6918 | 6919 | 6920 |
| H-35 | 7096 | 7097 | 7098 | 7099 | 7100 | 7101 | 7102 | 7103 | 7104 | 7105 | 7106 | 7107 | 7108 | 7109 | 7110 |
| H-36 | 7285 | 7286 | 7287 | 7288 | 7289 | 7290 | 7291 | 7292 | 7293 | 7294 | 7295 | 7296 | 7297 | 7298 | 7299 |
| H-37 | 7473 | 7474 | 7475 | 7476 | 7477 | 7478 | 7479 | 7480 | 7481 | 7482 | 7483 | 7484 | 7485 | 7486 | 7487 |
| H-38 | 7660 | 7661 | 7662 | 7663 | 7664 | 7665 | 7666 | 7667 | 7668 | 7669 | 7670 | 7671 | 7672 | 7673 | 7674 |
| H-39 | 7846 | 7847 | 7848 | 7849 | 7850 | 7851 | 7852 | 7853 | 7854 | 7855 | 7856 | 7857 | 7858 | 7859 | 7860 |
| H-40 | 8031 | 8032 | 8033 | 8034 | 8035 | 8036 | 8037 | 8038 | 8039 | 8040 | 8041 | 8042 | 8043 | 8044 | 8045 |
| H-41 | 8215 | 8216 | 8217 | 8218 | 8219 | 8220 | 8221 | 8222 | 8223 | 8224 | 8225 | 8226 | 8227 | 8228 | 8229 |
| H-42 | 8398 | 8399 | 8400 | 8401 | 8402 | 8403 | 8404 | 8405 | 8406 | 8407 | 8408 | 8409 | 8410 | 8411 | 8412 |
| H-43 | 8580 | 8581 | 8582 | 8583 | 8584 | 8585 | 8586 | 8587 | 8588 | 8589 | 8590 | 8591 | 8592 | 8593 | 8594 |
| H-44 | 8761 | 8762 | 8763 | 8764 | 8765 | 8766 | 8767 | 8768 | 8769 | 8770 | 8771 | 8772 | 8773 | 8774 | 8775 |
| H-45 | 8941 | 8942 | 8943 | 8944 | 8945 | 8946 | 8947 | 8948 | 8949 | 8950 | 8951 | 8952 | 8953 | 8954 | 8955 |
| H-46 | 9120 | 9121 | 9122 | 9123 | 9124 | 9125 | 9126 | 9127 | 9128 | 9129 | 9130 | 9131 | 9132 | 9133 | 9134 |
| H-47 | 9298 | 9299 | 9300 | 9301 | 9302 | 9303 | 9304 | 9305 | 9306 | 9307 | 9308 | 9309 | 9310 | 9311 | 9312 |
| H-48 | 9475 | 9476 | 9477 | 9478 | 9479 | 9480 | 9481 | 9482 | 9483 | 9484 | 9485 | 9486 | 9487 | 9488 | 9489 |
| H-49 | 9651 | 9652 | 9653 | 9654 | 9655 | 9656 | 9657 | 9658 | 9659 | 9660 | 9661 | 9662 | 9663 | 9664 | 9665 |
| H-50 | 9826 | 9827 | 9828 | 9829 | 9830 | 9831 | 9832 | 9833 | 9834 | 9835 | 9836 | 9837 | 9838 | 9839 | 9840 |

(continued)

| | H-76 | H-77 | H-78 | H-79 | H-80 | H-81 | H-82 | H-83 | H-84 | H-85 | H-86 | H-87 | H-88 | H-89 | H-90 |
|---|---|---|---|---|---|---|---|---|---|---|---|---|---|---|---|
| H-51 | 10000 | 10001 | 10002 | 10003 | 10004 | 10005 | 10006 | 10007 | 10008 | 10009 | 10010 | 10011 | 10012 | 10013 | 10014 |
| H-52 | 10173 | 10174 | 10175 | 10176 | 10177 | 10178 | 10179 | 10180 | 10181 | 10182 | 10183 | 10184 | 10185 | 10186 | 10187 |
| H-53 | 10345 | 10346 | 10347 | 10348 | 10349 | 10350 | 10351 | 10352 | 10353 | 10354 | 10355 | 10356 | 10357 | 10358 | 10359 |
| H-54 | 10516 | 10517 | 10518 | 10519 | 10520 | 10521 | 10522 | 10523 | 10524 | 10525 | 10526 | 10527 | 10528 | 10529 | 10530 |
| H-55 | 10686 | 10687 | 10688 | 10689 | 10690 | 10691 | 10692 | 10693 | 10694 | 10695 | 10696 | 10697 | 10698 | 10699 | 10700 |

**Table 7**

| | H-91 | H-92 | H-93 | H-94 | H-95 | H-96 | H-97 | H-98 | H-99 | H-100 | H-101 | H-102 | H-103 | H-104 | H-105 |
|---|---|---|---|---|---|---|---|---|---|---|---|---|---|---|---|
| H-1 | 90 | 91 | 92 | 93 | 94 | 95 | 96 | 97 | 98 | 99 | 100 | 101 | 102 | 103 | 104 |
| H-2 | 313 | 314 | 315 | 316 | 317 | 318 | 319 | 320 | 321 | 322 | 323 | 324 | 325 | 326 | 327 |
| H-3 | 535 | 536 | 537 | 538 | 539 | 540 | 541 | 542 | 543 | 544 | 545 | 546 | 547 | 548 | 549 |
| H-4 | 756 | 757 | 758 | 759 | 760 | 761 | 762 | 763 | 764 | 765 | 766 | 767 | 768 | 769 | 770 |
| H-5 | 976 | 977 | 978 | 979 | 980 | 981 | 982 | 983 | 984 | 985 | 986 | 987 | 988 | 989 | 990 |
| H-6 | 1195 | 1196 | 1197 | 1198 | 1199 | 1200 | 1201 | 1202 | 1203 | 1204 | 1205 | 1206 | 1207 | 1208 | 1209 |
| H-7 | 1413 | 1414 | 1415 | 1416 | 1417 | 1418 | 1419 | 1420 | 1421 | 1422 | 1423 | 1424 | 1425 | 1426 | 1427 |
| H-8 | 1630 | 1631 | 1632 | 1633 | 1634 | 1635 | 1636 | 1637 | 1638 | 1639 | 1640 | 1641 | 1642 | 1643 | 1644 |
| H-9 | 1846 | 1847 | 1848 | 1849 | 1850 | 1851 | 1852 | 1853 | 1854 | 1855 | 1856 | 1857 | 1858 | 1859 | 1860 |
| H-10 | 2061 | 2062 | 2063 | 2064 | 2065 | 2066 | 2067 | 2068 | 2069 | 2070 | 2071 | 2072 | 2073 | 2074 | 2075 |
| H-11 | 2275 | 2276 | 2277 | 2278 | 2279 | 2280 | 2281 | 2282 | 2283 | 2284 | 2285 | 2286 | 2287 | 2288 | 2289 |
| H-12 | 2488 | 2489 | 2490 | 2491 | 2492 | 2493 | 2494 | 2495 | 2496 | 2497 | 2498 | 2499 | 2500 | 2501 | 2502 |
| H-13 | 2700 | 2701 | 2702 | 2703 | 2704 | 2705 | 2706 | 2707 | 2708 | 2709 | 2710 | 2711 | 2712 | 2713 | 2714 |
| H-14 | 2911 | 2912 | 2913 | 2914 | 2915 | 2916 | 2917 | 2918 | 2919 | 2920 | 2921 | 2922 | 2923 | 2924 | 2925 |
| H-15 | 3121 | 3122 | 3123 | 3124 | 3125 | 3126 | 3127 | 3128 | 3129 | 3130 | 3131 | 3132 | 3133 | 3134 | 3135 |
| H-16 | 3330 | 3331 | 3332 | 3333 | 3334 | 3335 | 3336 | 3337 | 3338 | 3339 | 3340 | 3341 | 3342 | 3343 | 3344 |
| H-17 | 3538 | 3539 | 3540 | 3541 | 3542 | 3543 | 3544 | 3545 | 3546 | 3547 | 3548 | 3549 | 3550 | 3551 | 3552 |
| H-18 | 3745 | 3746 | 3747 | 3748 | 3749 | 3750 | 3751 | 3752 | 3753 | 3754 | 3755 | 3756 | 3757 | 3758 | 3759 |
| H-19 | 3951 | 3952 | 3953 | 3954 | 3955 | 3956 | 3957 | 3958 | 3959 | 3960 | 3961 | 3962 | 3963 | 3964 | 3965 |
| H-20 | 4156 | 4157 | 4158 | 4159 | 4160 | 4161 | 4162 | 4163 | 4164 | 4165 | 4166 | 4167 | 4168 | 4169 | 4170 |
| H-21 | 4360 | 4361 | 4362 | 4363 | 4364 | 4365 | 4366 | 4367 | 4368 | 4369 | 4370 | 4371 | 4372 | 4373 | 4374 |
| H-22 | 4563 | 4564 | 4565 | 4566 | 4567 | 4568 | 4569 | 4570 | 4571 | 4572 | 4573 | 4574 | 4575 | 4576 | 4577 |
| H-23 | 4765 | 4766 | 4767 | 4768 | 4769 | 4770 | 4771 | 4772 | 4773 | 4774 | 4775 | 4776 | 4777 | 4778 | 4779 |
| H-24 | 4966 | 4967 | 4968 | 4969 | 4970 | 4971 | 4972 | 4973 | 4974 | 4975 | 4976 | 4977 | 4978 | 4979 | 4980 |
| H-25 | 5166 | 5167 | 5168 | 5169 | 5170 | 5171 | 5172 | 5173 | 5174 | 5175 | 5176 | 5177 | 5178 | 5179 | 5180 |

(continued)

| | H-91 | H-92 | H-93 | H-94 | H-95 | H-96 | H-97 | H-98 | H-99 | H-100 | H-101 | H-102 | H-103 | H-104 | H-105 |
|---|---|---|---|---|---|---|---|---|---|---|---|---|---|---|---|
| H-26 | 5365 | 5366 | 5367 | 5368 | 5369 | 5370 | 5371 | 5372 | 5373 | 5374 | 5375 | 5376 | 5377 | 5378 | 5379 |
| H-27 | 5563 | 5564 | 5565 | 5566 | 5567 | 5568 | 5569 | 5570 | 5571 | 5572 | 5573 | 5574 | 5575 | 5576 | 5577 |
| H-28 | 5760 | 5761 | 5762 | 5763 | 5764 | 5765 | 5766 | 5767 | 5768 | 5769 | 5770 | 5771 | 5772 | 5773 | 5774 |
| H-29 | 5956 | 5957 | 5958 | 5959 | 5960 | 5961 | 5962 | 5963 | 5964 | 5965 | 5966 | 5967 | 5968 | 5969 | 5970 |
| H-30 | 6151 | 6152 | 6153 | 6154 | 6155 | 6156 | 6157 | 6158 | 6159 | 6160 | 6161 | 6162 | 6163 | 6164 | 6165 |
| H-31 | 6345 | 6346 | 6347 | 6348 | 6349 | 6350 | 6351 | 6352 | 6353 | 6354 | 6355 | 6356 | 6357 | 6358 | 6359 |
| H-32 | 6538 | 6539 | 6540 | 6541 | 6542 | 6543 | 6544 | 6545 | 6546 | 6547 | 6548 | 6549 | 6550 | 6551 | 6552 |
| H-33 | 6730 | 6731 | 6732 | 6733 | 6734 | 6735 | 6736 | 6737 | 6738 | 6739 | 6740 | 6741 | 6742 | 6743 | 6744 |
| H-34 | 6921 | 6922 | 6923 | 6924 | 6925 | 6926 | 6927 | 6928 | 6929 | 6930 | 6931 | 6932 | 6933 | 6934 | 6935 |
| H-35 | 7111 | 7112 | 7113 | 7114 | 7115 | 7116 | 7117 | 7118 | 7119 | 7120 | 7121 | 7122 | 7123 | 7124 | 7125 |
| H-36 | 7300 | 7301 | 7302 | 7303 | 7304 | 7305 | 7306 | 7307 | 7308 | 7309 | 7310 | 7311 | 7312 | 7313 | 7314 |
| H-37 | 7488 | 7489 | 7490 | 7491 | 7492 | 7493 | 7494 | 7495 | 7496 | 7497 | 7498 | 7499 | 7500 | 7501 | 7502 |
| H-38 | 7675 | 7676 | 7677 | 7678 | 7679 | 7680 | 7681 | 7682 | 7683 | 7684 | 7685 | 7686 | 7687 | 7688 | 7689 |
| H-39 | 7861 | 7862 | 7863 | 7864 | 7865 | 7866 | 7867 | 7868 | 7869 | 7870 | 7871 | 7872 | 7873 | 7874 | 7875 |
| H-40 | 8046 | 8047 | 8048 | 8049 | 8050 | 8051 | 8052 | 8053 | 8054 | 8055 | 8056 | 8057 | 8058 | 8059 | 8060 |
| H-41 | 8230 | 8231 | 8232 | 8233 | 8234 | 8235 | 8236 | 8237 | 8238 | 8239 | 8240 | 8241 | 8242 | 8243 | 8244 |
| H-42 | 8413 | 8414 | 8415 | 8416 | 8417 | 8418 | 8419 | 8420 | 8421 | 8422 | 8423 | 8424 | 8425 | 8426 | 8427 |
| H-43 | 8595 | 8596 | 8597 | 8598 | 8599 | 8600 | 8601 | 8602 | 8603 | 8604 | 8605 | 8606 | 8607 | 8608 | 8609 |
| H-44 | 8776 | 8777 | 8778 | 8779 | 8780 | 8781 | 8782 | 8783 | 8784 | 8785 | 8786 | 8787 | 8788 | 8789 | 8790 |
| H-45 | 8956 | 8957 | 8958 | 8959 | 8960 | 8961 | 8962 | 8963 | 8964 | 8965 | 8966 | 8967 | 8968 | 8969 | 8970 |
| H-46 | 9135 | 9136 | 9137 | 9138 | 9139 | 9140 | 9141 | 9142 | 9143 | 9144 | 9145 | 9146 | 9147 | 9148 | 9149 |
| H-47 | 9313 | 9314 | 9315 | 9316 | 9317 | 9318 | 9319 | 9320 | 9321 | 9322 | 9323 | 9324 | 9325 | 9326 | 9327 |
| H-48 | 9490 | 9491 | 9492 | 9493 | 9494 | 9495 | 9496 | 9497 | 9498 | 9499 | 9500 | 9501 | 9502 | 9503 | 9504 |
| H-49 | 9666 | 9667 | 9668 | 9669 | 9670 | 9671 | 9672 | 9673 | 9674 | 9675 | 9676 | 9677 | 9678 | 9679 | 9680 |
| H-50 | 9841 | 9842 | 9843 | 9844 | 9845 | 9846 | 9847 | 9848 | 9849 | 9850 | 9851 | 9852 | 9853 | 9854 | 9855 |

(continued)

| | H-91 | H-92 | H-93 | H-94 | H-95 | H-96 | H-97 | H-98 | H-99 | H-100 | H-101 | H-102 | H-103 | H-104 | H-105 |
|---|---|---|---|---|---|---|---|---|---|---|---|---|---|---|---|
| H-51 | 10015 | 10016 | 10017 | 10018 | 10019 | 10020 | 10021 | 10022 | 10023 | 10024 | 10025 | 10026 | 10027 | 10028 | 10029 |
| H-52 | 10188 | 10189 | 10190 | 10191 | 10192 | 10193 | 10194 | 10195 | 10196 | 10197 | 10198 | 10199 | 10200 | 10201 | 10202 |
| H-53 | 10360 | 10361 | 10362 | 10363 | 10364 | 10365 | 10366 | 10367 | 10368 | 10369 | 10370 | 10371 | 10372 | 10373 | 10374 |
| H-54 | 10531 | 10532 | 10533 | 10534 | 10535 | 10536 | 10537 | 10538 | 10539 | 10540 | 10541 | 10542 | 10543 | 10544 | 10545 |
| H-55 | 10701 | 10702 | 10703 | 10704 | 10705 | 10706 | 10707 | 10708 | 10709 | 10710 | 10711 | 10712 | 10713 | 10714 | 10715 |

**Table 8**

| | H-106 | H-107 | H-108 | H-109 | H-110 | H-111 | H-112 | H-113 | H-114 | H-115 | H-116 | H-117 | H-118 | H-119 | H-120 |
|---|---|---|---|---|---|---|---|---|---|---|---|---|---|---|---|
| H-1 | 105 | 106 | 107 | 108 | 109 | 110 | 111 | 112 | 113 | 114 | 115 | 116 | 117 | 118 | 119 |
| H-2 | 328 | 329 | 330 | 331 | 332 | 333 | 334 | 335 | 336 | 337 | 338 | 339 | 340 | 341 | 342 |
| H-3 | 550 | 551 | 552 | 553 | 554 | 555 | 556 | 557 | 558 | 559 | 560 | 561 | 562 | 563 | 564 |
| H-4 | 771 | 772 | 773 | 774 | 775 | 776 | 777 | 778 | 779 | 780 | 781 | 782 | 783 | 784 | 785 |
| H-5 | 991 | 992 | 993 | 994 | 995 | 996 | 997 | 998 | 999 | 1000 | 1001 | 1002 | 1003 | 1004 | 1005 |
| H-6 | 1210 | 1211 | 1212 | 1213 | 1214 | 1215 | 1216 | 1217 | 1218 | 1219 | 1220 | 1221 | 1222 | 1223 | 1224 |
| H-7 | 1428 | 1429 | 1430 | 1431 | 1432 | 1433 | 1434 | 1435 | 1436 | 1437 | 1438 | 1439 | 1440 | 1441 | 1442 |
| H-8 | 1645 | 1646 | 1647 | 1648 | 1649 | 1650 | 1651 | 1652 | 1653 | 1654 | 1655 | 1656 | 1657 | 1658 | 1659 |
| H-9 | 1861 | 1862 | 1863 | 1864 | 1865 | 1866 | 1867 | 1868 | 1869 | 1870 | 1871 | 1872 | 1873 | 1874 | 1675 |
| H-10 | 2076 | 2077 | 2078 | 2079 | 2080 | 2081 | 2082 | 2083 | 2084 | 2085 | 2086 | 2087 | 2088 | 2089 | 2090 |
| H-11 | 2290 | 2291 | 2292 | 2293 | 2294 | 2295 | 2296 | 2297 | 2298 | 2299 | 2300 | 2301 | 2302 | 2303 | 2304 |
| H-12 | 2503 | 2504 | 2505 | 2506 | 2507 | 2508 | 2509 | 2510 | 2511 | 2512 | 2513 | 2514 | 2515 | 2516 | 2517 |
| H-13 | 2715 | 2716 | 2717 | 2718 | 2719 | 2720 | 2721 | 2722 | 2723 | 2724 | 2725 | 2726 | 2727 | 2728 | 2729 |
| H-14 | 2926 | 2927 | 2928 | 2929 | 2930 | 2931 | 2932 | 2933 | 2934 | 2935 | 2936 | 2937 | 2938 | 2939 | 2940 |
| H-15 | 3136 | 3137 | 3138 | 3139 | 3140 | 3141 | 3142 | 3143 | 3144 | 3145 | 3146 | 3147 | 3148 | 3149 | 3150 |
| H-16 | 3345 | 3346 | 3347 | 3348 | 3349 | 3350 | 3351 | 3352 | 3353 | 3354 | 3355 | 3356 | 3357 | 3358 | 3359 |
| H-17 | 3553 | 3554 | 3555 | 3556 | 3557 | 3558 | 3559 | 3560 | 3561 | 3562 | 3563 | 3564 | 3565 | 3566 | 3567 |
| H-18 | 3760 | 3761 | 3762 | 3763 | 3764 | 3765 | 3766 | 3767 | 3768 | 3769 | 3770 | 3771 | 3772 | 3773 | 3774 |
| H-19 | 3966 | 3967 | 3968 | 3969 | 3970 | 3971 | 3972 | 3973 | 3974 | 3975 | 3976 | 3977 | 3978 | 3979 | 3980 |
| H-20 | 4171 | 4172 | 4173 | 4174 | 4175 | 4176 | 4177 | 4178 | 4179 | 4180 | 4181 | 4182 | 4183 | 4184 | 4185 |
| H-21 | 4375 | 4376 | 4377 | 4378 | 4379 | 4380 | 4381 | 4382 | 4383 | 4384 | 4385 | 4386 | 4387 | 4388 | 4389 |
| H-22 | 4578 | 4579 | 4580 | 4581 | 4582 | β58's | 4584 | 4585 | 4586 | 4587 | 4588 | 4589 | 4590 | 4591 | 4592 |
| H-23 | 4780 | 4781 | 4782 | 4783 | 4784 | 4785 | 4786 | 4787 | 4788 | 4789 | 4790 | 4791 | 4792 | 4793 | 4794 |
| H-24 | 4981 | 4982 | 4983 | 4984 | 4985 | 4986 | 4987 | 4988 | 4989 | 4990 | 4991 | 4992 | 4993 | 4994 | 4995 |
| H-25 | 5181 | 5182 | 5183 | 5184 | 5185 | 5186 | 5187 | 5188 | 5189 | 5190 | 5191 | 5192 | 5193 | 5194 | 5195 |

(continued)

| | H-106 | H-107 | H-108 | H-109 | H-110 | H-111 | H-112 | H-113 | H-114 | H-115 | H-116 | H-117 | H-118 | H-119 | H-120 |
|---|---|---|---|---|---|---|---|---|---|---|---|---|---|---|---|
| H-26 | 5380 | 5381 | 5382 | 5383 | 5384 | 5385 | 5386 | 5387 | 5388 | 5389 | 5390 | 5391 | 5392 | 5393 | 5394 |
| H-27 | 5578 | 5579 | 5580 | 5581 | 5582 | 5583 | 5584 | 5585 | 5586 | 5587 | 5588 | 5589 | 5590 | 5591 | 5592 |
| H-28 | 5775 | 5776 | 5777 | 5778 | 5779 | 5780 | 5781 | 5782 | 5783 | 5784 | 5785 | 5786 | 5787 | 5788 | 5789 |
| H-29 | 5971 | 5972 | 5973 | 5974 | 5975 | 5976 | 5977 | 5978 | 5979 | 5980 | 5981 | 5982 | 5983 | 5984 | 5985 |
| H-30 | 6166 | 6167 | 6168 | 6169 | 6170 | 6171 | 6172 | 6173 | 6174 | 6175 | 6176 | 6177 | 6178 | 6179 | 6180 |
| H-31 | 6360 | 6361 | 6362 | 6363 | 6364 | 6365 | 6366 | 6367 | 6368 | 6369 | 6370 | 6371 | 6372 | 6373 | 6374 |
| H-32 | 6553 | 6554 | 6555 | 6556 | 6557 | 6558 | 6559 | 6560 | 6561 | 6562 | 6563 | 6564 | 6565 | 6566 | 6567 |
| H-33 | 6745 | 6746 | 6747 | 6748 | 6749 | 6750 | 6751 | 6752 | 6753 | 6754 | 6755 | 6756 | 6757 | 6758 | 6759 |
| H-34 | 6936 | 6937 | 6938 | 6939 | 6940 | 6941 | 6942 | 6943 | 6944 | 6945 | 6946 | 6947 | 6948 | 6949 | 6950 |
| H-35 | 7126 | 7127 | 7128 | 7129 | 7130 | 7131 | 7132 | 7133 | 7134 | 7135 | 7136 | 7137 | 7138 | 7139 | 7140 |
| H-36 | 7315 | 7316 | 7317 | 7318 | 7319 | 7320 | 7321 | 7322 | 7323 | 7324 | 7325 | 7326 | 7327 | 7328 | 7329 |
| H-37 | 7503 | 7504 | 7505 | 7506 | 7507 | 7508 | 7509 | 7510 | 7511 | 7512 | 7513 | 7514 | 7515 | 7516 | 7517 |
| H-38 | 7690 | 7691 | 7692 | 7693 | 7694 | 7695 | 7696 | 7697 | 7698 | 7699 | 7700 | 7701 | 7702 | 7703 | 7704 |
| H-39 | 7876 | 7877 | 7878 | 7879 | 7880 | 7881 | 7882 | 7883 | 7884 | 7885 | 7886 | 7887 | 7888 | 7889 | 7890 |
| H-40 | 8061 | 8062 | 8063 | 8064 | 8065 | 8066 | 8067 | 8068 | 8069 | 8070 | 8071 | 8072 | 8073 | 8074 | 8075 |
| H-41 | 8245 | 8246 | 8247 | 8248 | 8249 | 8250 | 8251 | 8252 | 8253 | 8254 | 8255 | 8256 | 8257 | 8258 | 8259 |
| H-42 | 8428 | 8429 | 8430 | 8431 | 8432 | 8433 | 8434 | 8435 | 8436 | 8437 | 8438 | 8439 | 8440 | 8441 | 8442 |
| H-43 | 8610 | 8611 | 8612 | 8613 | 8614 | 8615 | 8616 | 8617 | 8618 | 8619 | 8620 | 8621 | 8622 | 8623 | 8624 |
| H-44 | 8791 | 8792 | 8793 | 8794 | 8795 | 8796 | 8797 | 8798 | 8799 | 8800 | 8801 | 8802 | 8803 | 8804 | 8805 |
| H-45 | 8971 | 8972 | 8973 | 8974 | 8975 | 8976 | 8977 | 8978 | 8979 | 8980 | 8981 | 8982 | 8983 | 8984 | 8985 |
| H-46 | 9150 | 9151 | 9152 | 9153 | 9154 | 9155 | 9156 | 9157 | 9158 | 9159 | 9160 | 9161 | 9162 | 9163 | 9164 |
| H-47 | 9328 | 9329 | 9330 | 9331 | 9332 | 9333 | 9334 | 9335 | 9336 | 9337 | 9338 | 9339 | 9340 | 9341 | 9342 |
| H-48 | 9505 | 9506 | 9507 | 9508 | 9509 | 9510 | 9511 | 9512 | 9513 | 9514 | 9515 | 9516 | 9517 | 9518 | 9519 |
| H-49 | 9681 | 9682 | 9683 | 9684 | 9685 | 9686 | 9687 | 9688 | 9689 | 9690 | 9691 | 9692 | 9693 | 9694 | 9695 |
| H-50 | 9856 | 9857 | 9858 | 9859 | 9860 | 9861 | 9862 | 9863 | 9864 | 9865 | 9866 | 9867 | 9868 | 9869 | 9870 |

(continued)

| | H-106 | H-107 | H-108 | H-109 | H-110 | H-111 | H-112 | H-113 | H-114 | H-115 | H-116 | H-117 | H-118 | H-119 | H-120 |
|---|---|---|---|---|---|---|---|---|---|---|---|---|---|---|---|
| H-51 | 10030 | 10031 | 10032 | 10033 | 10034 | 10035 | 10036 | 10037 | 10038 | 10039 | 10040 | 10041 | 10042 | 10043 | 10044 |
| H-52 | 10203 | 10204 | 10205 | 10206 | 10207 | 10208 | 10209 | 10210 | 10211 | 10212 | 10213 | 10214 | 10215 | 10216 | 10217 |
| H-53 | 10375 | 10376 | 10377 | 10378 | 10379 | 10380 | 10381 | 10382 | 10383 | 10384 | 10385 | 10386 | 10387 | 10388 | 10389 |
| H-54 | 10546 | 10547 | 10548 | 10549 | 10550 | 10551 | 10552 | 10553 | 10554 | 10555 | 10556 | 10557 | 10558 | 10559 | 10560 |
| H-55 | 10716 | 10717 | 10718 | 10719 | 10720 | 10721 | 10722 | 10723 | 10724 | 10725 | 10726 | 10727 | 10728 | 10729 | 10730 |

**Table 9**

| | H-121 | H-122 | H-123 | H-124 | H-125 | H-126 | H-127 | H-128 | H-129 | H-130 | H-131 | H-132 | H-133 | H-134 | H-135 |
|---|---|---|---|---|---|---|---|---|---|---|---|---|---|---|---|
| H-1 | 120 | 121 | 122 | 123 | 124 | 125 | 126 | 127 | 128 | 129 | 130 | 131 | 132 | 133 | 134 |
| H-2 | 343 | 344 | 345 | 346 | 347 | 348 | 349 | 350 | 351 | 352 | 353 | 354 | 355 | 356 | 357 |
| H-3 | 565 | 566 | 567 | 568 | 569 | 570 | 571 | 572 | 573 | 574 | 575 | 576 | 577 | 578 | 579 |
| H-4 | 786 | 787 | 788 | 789 | 790 | 791 | 792 | 793 | 794 | 795 | 796 | 797 | 798 | 799 | 800 |
| H-5 | 1006 | 1007 | 1008 | 1009 | 1010 | 1011 | 1012 | 1013 | 1014 | 1015 | 1016 | 1017 | 1018 | 1019 | 1020 |
| H-6 | 1225 | 1226 | 1227 | 1228 | 1229 | 1230 | 1231 | 1232 | 1233 | 1234 | 1235 | 1236 | 1237 | 1238 | 1239 |
| H-7 | 1443 | 1444 | 1445 | 1446 | 1447 | 1448 | 1449 | 1450 | 1451 | 1452 | 1453 | 1454 | 1455 | 1456 | 1457 |
| H-8 | 1660 | 1661 | 1662 | 1663 | 1664 | 1665 | 1666 | 1667 | 1668 | 1669 | 1670 | 1671 | 1672 | 1673 | 1674 |
| H-9 | 1876 | 1877 | 1878 | 1879 | 1880 | 1881 | 1882 | 1883 | 1884 | 1885 | 1886 | 1887 | 1888 | 1889 | 1890 |
| H-10 | 2091 | 2092 | 2093 | 2094 | 2095 | 2096 | 2097 | 2098 | 2099 | 2100 | 2101 | 2102 | 2103 | 2104 | 2105 |
| H-11 | 2305 | 2306 | 2307 | 2308 | 2309 | 2310 | 2311 | 2312 | 2313 | 2314 | 2315 | 2316 | 2317 | 2318 | 2319 |
| H-12 | 2518 | 2519 | 2520 | 2521 | 2522 | 2523 | 2524 | 2525 | 2526 | 2527 | 2528 | 2529 | 2530 | 2531 | 2532 |
| H-13 | 2730 | 2731 | 2732 | 2733 | 2734 | 2735 | 2736 | 2737 | 2738 | 2739 | 2740 | 2741 | 2742 | 2743 | 2744 |
| H-14 | 2941 | 2942 | 2943 | 2944 | 2945 | 2946 | 2947 | 2948 | 2949 | 2950 | 2951 | 2952 | 2953 | 2954 | 2955 |
| H-15 | 3151 | 3152 | 3153 | 3154 | 3155 | 3156 | 3157 | 3158 | 3159 | 3160 | 3161 | 3162 | 3163 | 3164 | 3165 |
| H-16 | 3360 | 3361 | 3362 | 3363 | 3364 | 3365 | 3366 | 3367 | 3368 | 3369 | 3370 | 3371 | 3372 | 3373 | 3374 |
| H-17 | 3568 | 3569 | 3570 | 3571 | 3572 | 3573 | 3574 | 3575 | 3576 | 3577 | 3578 | 3579 | 3580 | 3581 | 3582 |
| H-18 | 3775 | 3776 | 3777 | 3778 | 3779 | 3780 | 3781 | 3782 | 3783 | 3784 | 3785 | 3786 | 3787 | 3788 | 3789 |
| H-19 | 3981 | 3982 | 3983 | 3984 | 3985 | 3986 | 3987 | 3988 | 3989 | 3990 | 3991 | 3992 | 3993 | 3994 | 3995 |
| H-20 | 4186 | 4187 | 4188 | 4189 | 4190 | 4191 | 4192 | 4193 | 4194 | 4195 | 4196 | 4197 | 4198 | 4199 | 4200 |
| H-21 | 4390 | 4391 | 4392 | 4393 | 4394 | 4395 | 4396 | 4397 | 4398 | 4399 | 4400 | 4401 | 4402 | 4403 | 4404 |
| H-22 | 4593 | 4594 | 4595 | 4596 | 4597 | 4598 | 4599 | 4600 | 4601 | 4602 | 4603 | 4604 | 4605 | 4606 | 4607 |
| H-23 | 4795 | 4796 | 4797 | 4798 | 4799 | 4800 | 4801 | 4802 | 4803 | 4804 | 4805 | 4806 | 4807 | 4808 | 4809 |
| H-24 | 4996 | 4997 | 4998 | 4999 | 5000 | 5001 | 5002 | 5003 | 5004 | 5005 | 5006 | 5007 | 5008 | 5009 | 5010 |
| H-25 | 5196 | 5197 | 5198 | 5199 | 5200 | 5201 | 5202 | 5203 | 5204 | 5205 | 5206 | 5207 | 5208 | 5209 | 5210 |

(continued)

| | H-121 | H-122 | H-123 | H-124 | H-125 | H-126 | H-127 | H-128 | H-129 | H-130 | H-131 | H-132 | H-133 | H-134 | H-135 |
|---|---|---|---|---|---|---|---|---|---|---|---|---|---|---|---|
| H-26 | 5395 | 5396 | 5397 | 5398 | 5399 | 5400 | 5401 | 5402 | 5403 | 5404 | 5405 | 5406 | 5407 | 5408 | 5409 |
| H-27 | 5593 | 5594 | 5595 | 5596 | 5597 | 5598 | 5599 | 5600 | 5601 | 5602 | 5603 | 5604 | 5605 | 5606 | 5607 |
| H-28 | 5790 | 5791 | 5792 | 5793 | 5794 | 5795 | 5796 | 5797 | 5798 | 5799 | 5800 | 5801 | 5802 | 5803 | 5804 |
| H-29 | 5986 | 5987 | 5988 | 5989 | 5990 | 5991 | 5992 | 5993 | 5994 | 5995 | 5996 | 5997 | 5998 | 5999 | 6000 |
| H-30 | 6181 | 6182 | 6183 | 6184 | 6185 | 6186 | 6187 | 6188 | 6189 | 6190 | 6191 | 6192 | 6193 | 6194 | 6195 |
| H-31 | 6375 | 6376 | 6377 | 6378 | 6379 | 6380 | 6381 | 6382 | 6383 | 6384 | 6385 | 6386 | 6387 | 6388 | 6389 |
| H-32 | 6568 | 6569 | 6570 | 6571 | 6572 | 6573 | 6574 | 6575 | 6576 | 6577 | 6578 | 6579 | 6580 | 6581 | 6582 |
| H-33 | 6760 | 6761 | 6762 | 6763 | 6764 | 6765 | 6766 | 6767 | 6768 | 6769 | 6770 | 6771 | 6772 | 6773 | 6774 |
| H-34 | 6951 | 6952 | 6953 | 6954 | 6955 | 6956 | 6957 | 6958 | 6959 | 6960 | 6961 | 6962 | 6963 | 6964 | 6965 |
| H-35 | 7141 | 7142 | 7143 | 7144 | 7145 | 7146 | 7147 | 7148 | 7149 | 7150 | 7151 | 7152 | 7153 | 7154 | 7155 |
| H-36 | 7330 | 7331 | 7332 | 7333 | 7334 | 7335 | 7336 | 7337 | 7338 | 7339 | 7340 | 7341 | 7342 | 7343 | 7344 |
| H-37 | 7518 | 7519 | 7520 | 7521 | 7522 | 7523 | 7524 | 7525 | 7526 | 7527 | 7528 | 7529 | 7530 | 7531 | 7532 |
| H-38 | 7705 | 7706 | 7707 | 7708 | 7709 | 7710 | 7711 | 7712 | 7713 | 7714 | 7715 | 7716 | 7717 | 7718 | 7719 |
| H-39 | 7891 | 7892 | 7893 | 7894 | 7895 | 7896 | 7897 | 7898 | 7899 | 7900 | 7901 | 7902 | 7903 | 7904 | 7905 |
| H-40 | 8076 | 8077 | 8078 | 8079 | 8080 | 8081 | 8082 | 8083 | 8084 | 8085 | 8086 | 8087 | 8088 | 8089 | 8090 |
| H-41 | 8260 | 8261 | 8262 | 8263 | 8264 | 8265 | 8266 | 8267 | 8268 | 8269 | 8270 | 8271 | 8272 | 8273 | 8274 |
| H-42 | 8443 | 8444 | 8445 | 8446 | 8447 | 8448 | 8449 | 8450 | 8451 | 8452 | 8453 | 8454 | 8455 | 8456 | 8457 |
| H-43 | 8625 | 8626 | 8627 | 8628 | 8629 | 8630 | 8631 | 8632 | 8633 | 8634 | 8635 | 8636 | 8637 | 8638 | 8639 |
| H-44 | 8806 | 8807 | 8808 | 8809 | 8810 | 8811 | 8812 | 8813 | 8814 | 8815 | 8816 | 8817 | 8818 | 8819 | 8820 |
| H-45 | 8986 | 8987 | 8988 | 8989 | 8990 | 8991 | 8992 | 8993 | 8994 | 8995 | 8996 | 8997 | 8998 | 8999 | 9000 |
| H-46 | 9165 | 9166 | 9167 | 9168 | 9169 | 9170 | 9171 | 9172 | 9173 | 9174 | 9175 | 9176 | 9177 | 9178 | 9179 |
| H-47 | 9343 | 9344 | 9345 | 9346 | 9347 | 9348 | 9349 | 9350 | 9351 | 9352 | 9353 | 9354 | 9355 | 9356 | 9357 |
| H-48 | 9520 | 9521 | 9522 | 9523 | 9524 | 9525 | 9526 | 9527 | 9528 | 9529 | 9530 | 9531 | 9532 | 9533 | 9534 |
| H-49 | 9696 | 9697 | 9698 | 9699 | 9700 | 9701 | 9702 | 9703 | 9704 | 9705 | 9706 | 9707 | 9708 | 9709 | 9710 |
| H-50 | 9871 | 9872 | 9873 | 9874 | 9875 | 9876 | 9877 | 9878 | 9879 | 9880 | 9881 | 9882 | 9883 | 9884 | 9885 |

(continued)

| | H-121 | H-122 | H-123 | H-124 | H-125 | H-126 | H-127 | H-128 | H-129 | H-130 | H-131 | H-132 | H-133 | H-134 | H-135 |
|---|---|---|---|---|---|---|---|---|---|---|---|---|---|---|---|
| H-51 | 10045 | 10046 | 10047 | 10048 | 10049 | 10050 | 10051 | 10052 | 10053 | 10054 | 10055 | 10056 | 10057 | 10058 | 10059 |
| H-52 | 10218 | 10219 | 10220 | 10221 | 10222 | 10223 | 10224 | 10225 | 10226 | 10227 | 10228 | 10229 | 10230 | 10231 | 10232 |
| H-53 | 10390 | 10391 | 10392 | 10393 | 10394 | 10395 | 10396 | 10397 | 10398 | 10399 | 10400 | 10401 | 10402 | 10403 | 10404 |
| H-54 | 10561 | 10562 | 10563 | 10564 | 10565 | 10566 | 10567 | 10568 | 10569 | 10570 | 10571 | 10572 | 10573 | 10574 | 10575 |
| H-55 | 10731 | 10732 | 10733 | 10734 | 10735 | 10736 | 10737 | 10738 | 10739 | 10740 | 10741 | 10742 | 10743 | 10744 | 10745 |

**Table 10**

| | H-136 | H-137 | H-138 | H-139 | H-140 | H-141 | H-142 | H-143 | H-144 | H-145 | H-146 | H-147 | H-148 | H-149 | H-150 |
|---|---|---|---|---|---|---|---|---|---|---|---|---|---|---|---|
| H-1 | 135 | 136 | 137 | 138 | 139 | 140 | 141 | 142 | 143 | 144 | 145 | 146 | 147 | 148 | 149 |
| H-2 | 358 | 359 | 360 | 361 | 362 | 363 | 364 | 365 | 366 | 367 | 368 | 369 | 370 | 371 | 372 |
| H-3 | 580 | 581 | 582 | 583 | 584 | 585 | 586 | 587 | 588 | 589 | 590 | 591 | 592 | 593 | 594 |
| H-4 | 801 | 802 | 803 | 804 | 805 | 806 | 807 | 808 | 809 | 810 | 811 | 812 | 813 | 814 | 815 |
| H-5 | 1021 | 1022 | 1023 | 1024 | 1025 | 1026 | 1027 | 1028 | 1029 | 1030 | 1031 | 1032 | 1033 | 1034 | 1035 |
| H-6 | 1240 | 1241 | 1242 | 1243 | 1244 | 1245 | 1246 | 1247 | 1248 | 1249 | 1250 | 1251 | 1252 | 1253 | 1254 |
| H-7 | 1458 | 1459 | 1460 | 1461 | 1462 | 1463 | 1464 | 1465 | 1466 | 1467 | 1468 | 1469 | 1470 | 1471 | 1472 |
| H-8 | 1675 | 1676 | 1677 | 1678 | 1679 | 1680 | 1681 | 1682 | 1683 | 1684 | 1685 | 1686 | 1687 | 1688 | 1689 |
| H-9 | 1891 | 1892 | 1893 | 1894 | 1895 | 1896 | 1897 | 1898 | 1899 | 1900 | 1901 | 1902 | 1903 | 1904 | 1905 |
| H-10 | 2106 | 2107 | 2108 | 2109 | 2110 | 2111 | 2112 | 2113 | 2114 | 2115 | 2116 | 2117 | 2118 | 2119 | 2120 |
| H-11 | 2320 | 2321 | 2322 | 2323 | 2324 | 2325 | 2326 | 2327 | 2328 | 2329 | 2330 | 2331 | 2332 | 2333 | 2334 |
| H-12 | 2533 | 2534 | 2535 | 2536 | 2537 | 2538 | 2539 | 2540 | 2541 | 2542 | 2543 | 2544 | 2545 | 2546 | 2547 |
| H-13 | 2745 | 2746 | 2747 | 2748 | 2749 | 2750 | 2751 | 2752 | 2753 | 2754 | 2755 | 2756 | 2757 | 2758 | 2759 |
| H-14 | 2956 | 2957 | 2958 | 2959 | 2960 | 2961 | 2962 | 2963 | 2964 | 2965 | 2966 | 2967 | 2968 | 2969 | 2970 |
| H-15 | 3166 | 3167 | 3168 | 3169 | 3170 | 3171 | 3172 | 3173 | 3174 | 3175 | 3176 | 3177 | 3178 | 3179 | 3180 |
| H-16 | 3375 | 3376 | 3377 | 3378 | 3379 | 3380 | 3381 | 3382 | 3383 | 3384 | 3385 | 3386 | 3387 | 3388 | 3389 |
| H-17 | 3583 | 3584 | 3585 | 3586 | 3587 | 3588 | 3589 | 3590 | 3591 | 3592 | 3593 | 3594 | 3595 | 3596 | 3597 |
| H-18 | 3790 | 3791 | 3792 | 3793 | 3794 | 3795 | 3796 | 3797 | 3798 | 3799 | 3800 | 3801 | 3802 | 3803 | 3804 |
| H-19 | 3996 | 3997 | 3998 | 3999 | 4000 | 4001 | 4002 | 4003 | 4004 | 4005 | 4006 | 4007 | 4008 | 4009 | 4010 |
| H-20 | 4201 | 4202 | 4203 | 4204 | 4205 | 4206 | 4207 | 4208 | 4209 | 4210 | 4211 | 4212 | 4213 | 4214 | 4215 |
| H-21 | 4405 | 4406 | 4407 | 4408 | 4409 | 4410 | 4411 | 4412 | 4413 | 4414 | 4415 | 4416 | 4417 | 4418 | 4419 |
| H-22 | 4608 | 4609 | 4610 | 4611 | 4612 | 4613 | 4614 | 4615 | 4616 | 4617 | 4618 | 4619 | 4620 | 4621 | 4622 |
| H-23 | 4810 | 4811 | 4812 | 4813 | 4814 | 4815 | 4816 | 4817 | 4818 | 4819 | 4820 | 4821 | 4822 | 4823 | 4824 |
| H-24 | 5011 | 5012 | 5013 | 5014 | 5015 | 5016 | 5017 | 5018 | 5019 | 5020 | 5021 | 5022 | 5023 | 5024 | 5025 |
| H-25 | 5211 | 5212 | 5213 | 5214 | 5215 | 5216 | 5217 | 5218 | 5219 | 5220 | 5221 | 5222 | 5223 | 5224 | 5225 |

(continued)

| | H-136 | H-137 | H-138 | H-139 | H-140 | H-141 | H-142 | H-143 | H-144 | H-145 | H-146 | H-147 | H-148 | H-149 | H-150 |
|---|---|---|---|---|---|---|---|---|---|---|---|---|---|---|---|
| H-26 | 5410 | 5411 | 5412 | 5413 | 5414 | 5415 | 5416 | 5417 | 5418 | 5419 | 5420 | 5421 | 5422 | 5423 | 5424 |
| H-27 | 5608 | 5609 | 5610 | 5611 | 5612 | 5613 | 5614 | 5615 | 5616 | 5617 | 5618 | 5619 | 5620 | 5621 | 5622 |
| H-28 | 5805 | 5806 | 5807 | 5808 | 5809 | 5810 | 5811 | 5812 | 5813 | 5814 | 5815 | 5816 | 5817 | 5818 | 5819 |
| H-29 | 6001 | 6002 | 6003 | 6004 | 6005 | 6006 | 6007 | 6008 | 6009 | 6010 | 6011 | 6012 | 6013 | 6014 | 6015 |
| H-30 | 6196 | 6197 | 6198 | 6199 | 6200 | 6201 | 6202 | 6203 | 6204 | 6205 | 6206 | 6207 | 6208 | 6209 | 6210 |
| H-31 | 6390 | 6391 | 6392 | 6393 | 6394 | 6395 | 6396 | 6397 | 6398 | 6399 | 6400 | 6401 | 6402 | 6403 | 6404 |
| H-32 | 6583 | 6584 | 6585 | 6586 | 6587 | 6588 | 6589 | 6590 | 6591 | 6592 | 6593 | 6594 | 6595 | 6596 | 6597 |
| H-33 | 6775 | 6776 | 6777 | 6778 | 6779 | 6780 | 6781 | 6782 | 6783 | 6784 | 6785 | 6786 | 6787 | 6788 | 6789 |
| H-34 | 6966 | 6967 | 6968 | 6969 | 6970 | 6971 | 6972 | 6973 | 6974 | 6975 | 6976 | 6977 | 6978 | 6979 | 6980 |
| H-35 | 7156 | 7157 | 7158 | 7159 | 7160 | 7161 | 7162 | 7163 | 7164 | 7165 | 7166 | 7167 | 7168 | 7169 | 7170 |
| H-36 | 7345 | 7346 | 7347 | 7348 | 7349 | 7350 | 7351 | 7352 | 7353 | 7354 | 7355 | 7356 | 7357 | 7358 | 7359 |
| H-37 | 7533 | 7534 | 7535 | 7536 | 7537 | 7538 | 7539 | 7540 | 7541 | 7542 | 7543 | 7544 | 7545 | 7546 | 7547 |
| H-38 | 7720 | 7721 | 7722 | 7723 | 7724 | 7725 | 7726 | 7727 | 7728 | 7729 | 7730 | 7731 | 7732 | 7733 | 7734 |
| H-39 | 7906 | 7907 | 7908 | 7909 | 7910 | 7911 | 7912 | 7913 | 7914 | 7915 | 7916 | 7917 | 7918 | 7919 | 7920 |
| H-40 | 8091 | 8092 | 8093 | 8094 | 8095 | 8096 | 8097 | 8098 | 8099 | 8100 | 8101 | 8102 | 8103 | 8104 | 8105 |
| H-41 | 8275 | 8276 | 8277 | 8278 | 8279 | 8280 | 8281 | 8282 | 8283 | 8284 | 8285 | 8286 | 8287 | 8288 | 8289 |
| H-42 | 8458 | 8459 | 8460 | 8461 | 8462 | 8463 | 8464 | 8465 | 8466 | 8467 | 8468 | 8469 | 8470 | 8471 | 8472 |
| H-43 | 8640 | 8641 | 8642 | 8643 | 8644 | 8645 | 8646 | 8647 | 8648 | 8649 | 8650 | 8651 | 8652 | 8653 | 8654 |
| H-44 | 8821 | 8822 | 8823 | 8824 | 8825 | 8826 | 8827 | 8828 | 8829 | 8830 | 8831 | 8832 | 8833 | 8834 | 8835 |
| H-45 | 9001 | 9002 | 9003 | 9004 | 9005 | 9006 | 9007 | 9008 | 9009 | 9010 | 9011 | 9012 | 9013 | 9014 | 9015 |
| H-46 | 9180 | 9181 | 9182 | 9183 | 9184 | 9185 | 9186 | 9187 | 9188 | 9189 | 9190 | 9191 | 9192 | 9193 | 9194 |
| H-47 | 9358 | 9359 | 9360 | 9361 | 9362 | 9363 | 9364 | 9365 | 9366 | 9367 | 9368 | 9369 | 9370 | 9371 | 9372 |
| H-48 | 9535 | 9536 | 9537 | 9538 | 9539 | 9540 | 9541 | 9542 | 9543 | 9544 | 9545 | 9546 | 9547 | 9548 | 9549 |
| H-49 | 9711 | 9712 | 9713 | 9714 | 9715 | 9716 | 9717 | 9718 | 9719 | 9720 | 9721 | 9722 | 9723 | 9724 | 9725 |
| H-50 | 9886 | 9887 | 9888 | 9889 | 9890 | 9891 | 9892 | 9893 | 9894 | 9895 | 9896 | 9897 | 9898 | 9899 | 9900 |

(continued)

| | H-136 | H-137 | H-138 | H-139 | H-140 | H-141 | H-142 | H-143 | H-144 | H-145 | H-146 | H-147 | H-148 | H-149 | H-150 |
|---|---|---|---|---|---|---|---|---|---|---|---|---|---|---|---|
| H-51 | 10060 | 10061 | 10062 | 10063 | 10064 | 10065 | 10066 | 10067 | 10068 | 10069 | 10070 | 10071 | 10072 | 10073 | 10074 |
| H-52 | 10233 | 10234 | 10235 | 10236 | 10237 | 10238 | 10239 | 10240 | 10241 | 10242 | 10243 | 10244 | 10245 | 10246 | 10247 |
| H-53 | 10405 | 10406 | 10407 | 10408 | 10409 | 10410 | 10411 | 10412 | 10413 | 10414 | 10415 | 10416 | 10417 | 10418 | 10419 |
| H-54 | 10576 | 10577 | 10578 | 10579 | 10580 | 10581 | 10582 | 10583 | 10584 | 10585 | 10586 | 10587 | 10588 | 10589 | 10590 |
| H-55 | 10746 | 10747 | 10748 | 10749 | 10750 | 10751 | 10752 | 10753 | 10754 | 10755 | 10756 | 10757 | 10758 | 10759 | 10760 |

**Table 11**

| | H-151 | H-152 | H-153 | H-154 | H-155 | H-156 | H-157 | H-158 | H-159 | H-160 | H-161 | H-162 | H-163 | H-164 | H-165 |
|---|---|---|---|---|---|---|---|---|---|---|---|---|---|---|---|
| H-1 | 150 | 151 | 152 | 153 | 154 | 155 | 156 | 157 | 158 | 159 | 160 | 161 | 162 | 163 | 164 |
| H-2 | 373 | 374 | 375 | 376 | 377 | 378 | 379 | 380 | 381 | 382 | 383 | 384 | 385 | 386 | 387 |
| H-3 | 595 | 596 | 597 | 598 | 599 | 600 | 601 | 602 | 603 | 604 | 605 | 606 | 607 | 608 | 609 |
| H-4 | 816 | 817 | 818 | 819 | 820 | 821 | 822 | 823 | 824 | 825 | 826 | 827 | 828 | 829 | 830 |
| H-5 | 1036 | 1037 | 1038 | 1039 | 1040 | 1041 | 1042 | 1043 | 1044 | 1045 | 1046 | 1047 | 1048 | 1049 | 1050 |
| H-6 | 1255 | 1256 | 1257 | 1258 | 1259 | 1260 | 1261 | 1262 | 1263 | 1264 | 1265 | 1266 | 1267 | 1268 | 1269 |
| H-7 | 1473 | 1474 | 1475 | 1476 | 1477 | 1478 | 1479 | 1480 | 1481 | 1482 | 1483 | 1484 | 1485 | 1486 | 1487 |
| H-8 | 1690 | 1691 | 1692 | 1693 | 1694 | 1695 | 1696 | 1697 | 1698 | 1699 | 1700 | 1701 | 1702 | 1703 | 1704 |
| H-9 | 1906 | 1907 | 1908 | 1909 | 1910 | 1911 | 1912 | 1913 | 1914 | 1915 | 1916 | 1917 | 1918 | 1919 | 1920 |
| H-10 | 2121 | 2122 | 2123 | 2124 | 2125 | 2126 | 2127 | 2128 | 2129 | 2130 | 2131 | 2132 | 2133 | 2134 | 2135 |
| H-11 | 2335 | 2336 | 2337 | 2338 | 2339 | 2340 | 2341 | 2342 | 2343 | 2344 | 2345 | 2346 | 2347 | 2348 | 2349 |
| H-12 | 2548 | 2549 | 2550 | 2551 | 2552 | 2553 | 2554 | 2555 | 2556 | 2557 | 2558 | 2559 | 2560 | 2561 | 2562 |
| H-13 | 2760 | 2761 | 2762 | 2763 | 2764 | 2765 | 2766 | 2767 | 2768 | 2769 | 2770 | 2771 | 2772 | 2773 | 2774 |
| H-14 | 2971 | 2972 | 2973 | 2974 | 2975 | 2976 | 2977 | 2978 | 2979 | 2980 | 2981 | 2982 | 2983 | 2984 | 2985 |
| H-15 | 3181 | 3182 | 3183 | 3184 | 3185 | 3186 | 3187 | 3188 | 3189 | 3190 | 3191 | 3192 | 3193 | 3194 | 3195 |
| H-16 | 3390 | 3391 | 3392 | 3393 | 3394 | 3395 | 3396 | 3397 | 3398 | 3399 | 3400 | 3401 | 3402 | 3403 | 3404 |
| H-17 | 3598 | 3599 | 3600 | 3601 | 3602 | 3603 | 3604 | 3605 | 3606 | 3607 | 3608 | 3609 | 3610 | 3611 | 3612 |
| H-18 | 3805 | 3806 | 3807 | 3808 | 3809 | 3810 | 3811 | 3812 | 3813 | 3814 | 3815 | 3816 | 3817 | 3818 | 3819 |
| H-19 | 4011 | 4012 | 4013 | 4014 | 4015 | 4016 | 4017 | 4018 | 4019 | 4020 | 4021 | 4022 | 4023 | 4024 | 4025 |
| H-20 | 4216 | 4217 | 4218 | 4219 | 4220 | 4221 | 4222 | 4223 | 4224 | 4225 | 4226 | 4227 | 4228 | 4229 | 4230 |
| H-21 | 4420 | 4421 | 4422 | 4423 | 4424 | 4425 | 4426 | 4427 | 4428 | 4429 | 4430 | 4431 | 4432 | 4433 | 4434 |
| H-22 | 4623 | 4624 | 4625 | 4626 | 4627 | 4628 | 4629 | 4630 | 4631 | 4632 | 4633 | 4634 | 4635 | 4636 | 4637 |
| H-23 | 4825 | 4826 | 4827 | 4828 | 4829 | 4830 | 4831 | 4832 | 4833 | 4834 | 4835 | 4836 | 4837 | 4838 | 4839 |
| H-24 | 5026 | 5027 | 5028 | 5029 | 5030 | 5031 | 5032 | 5033 | 5034 | 5035 | 5036 | 5037 | 5038 | 5039 | 5040 |
| H-25 | 5226 | 5227 | 5228 | 5229 | 5230 | 5231 | 5232 | 5233 | 5234 | 5235 | 5236 | 5237 | 5238 | 5239 | 5240 |

(continued)

| | H-151 | H-152 | H-153 | H-154 | H-155 | H-156 | H-157 | H-158 | H-159 | H-160 | H-161 | H-162 | H-163 | H-164 | H-165 |
|---|---|---|---|---|---|---|---|---|---|---|---|---|---|---|---|
| H-26 | 5425 | 5426 | 5427 | 5428 | 5429 | 5430 | 5431 | 5432 | 5433 | 5434 | 5435 | 5436 | 5437 | 5438 | 5439 |
| H-27 | 5623 | 5624 | 5625 | 5626 | 5627 | 5628 | 5629 | 5630 | 5631 | 5632 | 5633 | 5634 | 5635 | 5636 | 5637 |
| H-28 | 5820 | 5821 | 5822 | 5823 | 5824 | 5825 | 5826 | 5827 | 5828 | 5829 | 5830 | 5831 | 5832 | 5833 | 5834 |
| H-29 | 6016 | 6017 | 6018 | 6019 | 6020 | 6021 | 6022 | 6023 | 6024 | 6025 | 6026 | 6027 | 6028 | 6029 | 6030 |
| H-30 | 6211 | 6212 | 6213 | 6214 | 6215 | 6216 | 6217 | 6218 | 6219 | 6220 | 6221 | 6222 | 6223 | 6224 | 6225 |
| H-31 | 6405 | 6406 | 6407 | 6408 | 6409 | 6410 | 6411 | 6412 | 6413 | 6414 | 6415 | 6416 | 6417 | 6418 | 6419 |
| H-32 | 6598 | 6599 | 6600 | 6601 | 6602 | 6603 | 6604 | 6605 | 6606 | 6607 | 6608 | 6609 | 6610 | 6612 | 6612 |
| H-33 | 6790 | 6791 | 6792 | 6793 | 6794 | 6795 | 6796 | 6797 | 6798 | 6799 | 6800 | 6801 | 6802 | 6803 | 6804 |
| H-34 | 6981 | 6982 | 6983 | 6984 | 6985 | 6986 | 6987 | 6988 | 6989 | 6990 | 6991 | 6992 | 6993 | 6994 | 6995 |
| H-35 | 7171 | 7172 | 7173 | 7174 | 7175 | 7176 | 7177 | 7178 | 7179 | 7180 | 7181 | 7182 | 7183 | 7184 | 7185 |
| H-36 | 7360 | 7361 | 7362 | 7363 | 7364 | 7365 | 7366 | 7367 | 7368 | 7369 | 7370 | 7371 | 7372 | 7373 | 7374 |
| H-37 | 7548 | 7549 | 7550 | 7551 | 7552 | 7553 | 7554 | 7555 | 7556 | 7557 | 7558 | 7559 | 7560 | 7561 | 7562 |
| H-38 | 7735 | 7736 | 7737 | 7738 | 7739 | 7740 | 7741 | 7742 | 7743 | 7744 | 7745 | 7746 | 7747 | 7748 | 7749 |
| H-39 | 7921 | 7922 | 7923 | 7924 | 7925 | 7926 | 7927 | 7928 | 7929 | 7930 | 7931 | 7932 | 7933 | 7934 | 7935 |
| H-40 | 8106 | 8107 | 8108 | 8109 | 8110 | 8111 | 8112 | 8113 | 8114 | 8115 | 8116 | 8117 | 8118 | 8119 | 8120 |
| H-41 | 8290 | 8291 | 8292 | 8293 | 8294 | 8295 | 8296 | 8297 | 8298 | 8299 | 8300 | 8301 | 8302 | 8303 | 8304 |
| H-42 | 8473 | 8474 | 8475 | 8476 | 8477 | 8478 | 8479 | 8480 | 8481 | 8482 | 8483 | 8484 | 8485 | 8486 | 8487 |
| H-43 | 8655 | 8656 | 8657 | 8658 | 8659 | 8660 | 8661 | 8662 | 8663 | 8664 | 8665 | 8666 | 8667 | 8668 | 8669 |
| H-44 | 8836 | 8837 | 8838 | 8839 | 8840 | 8841 | 8842 | 8843 | 8844 | 8845 | 8846 | 8847 | 8848 | 8849 | 8850 |
| H-45 | 9016 | 9017 | 9018 | 9019 | 9020 | 9021 | 9022 | 9023 | 9024 | 9025 | 9026 | 9027 | 9028 | 9029 | 9030 |
| H-46 | 9195 | 9196 | 9197 | 9198 | 9199 | 9200 | 9201 | 9202 | 9203 | 9204 | 9205 | 9206 | 9207 | 9208 | 9209 |
| H-47 | 9373 | 9374 | 9375 | 9376 | 9377 | 9378 | 9379 | 9380 | 9381 | 9382 | 9383 | 9384 | 9385 | 9386 | 9387 |
| H-48 | 9550 | 9551 | 9552 | 9553 | 9554 | 9555 | 9556 | 9557 | 9558 | 9559 | 9560 | 9561 | 9562 | 9563 | 9564 |
| H-49 | 9726 | 9727 | 9728 | 9729 | 9730 | 9731 | 9732 | 9733 | 9734 | 9735 | 9736 | 9737 | 9738 | 9739 | 9740 |
| H-50 | 9901 | 9902 | 9903 | 9904 | 9905 | 9906 | 9907 | 9908 | 9909 | 9910 | 9911 | 9912 | 9913 | 9914 | 9915 |

(continued)

| | H-151 | H-152 | H-153 | H-154 | H-155 | H-156 | H-157 | H-158 | H-159 | H-160 | H-161 | H-162 | H-163 | H-164 | H-165 |
|---|---|---|---|---|---|---|---|---|---|---|---|---|---|---|---|
| H-51 | 10075 | 10076 | 10077 | 10078 | 10079 | 10080 | 10081 | 10082 | 10083 | 10084 | 10085 | 10086 | 10087 | 10088 | 10089 |
| H-52 | 10248 | 10249 | 10250 | 10251 | 10252 | 10253 | 10254 | 10255 | 10256 | 10257 | 10258 | 10259 | 10260 | 10261 | 10262 |
| H-53 | 10420 | 10421 | 10422 | 10423 | 10424 | 10425 | 10426 | 10427 | 10428 | 10429 | 10430 | 10431 | 10432 | 10433 | 10434 |
| H-54 | 10591 | 10592 | 10593 | 10594 | 10595 | 10596 | 10597 | 10598 | 10599 | 10600 | 10601 | 10602 | 10603 | 10604 | 10605 |
| H-55 | 10761 | 10762 | 10763 | 10764 | 10765 | 10766 | 10767 | 10768 | 10769 | 10770 | 10771 | 10772 | 10773 | 10774 | 10775 |

**Table 12**

| | H-166 | H-167 | H-168 | H-169 | H-170 | H-171 | H-172 | H-173 | H-174 | H-175 | H-176 | H-177 | H-178 | H-179 | H-180 |
|---|---|---|---|---|---|---|---|---|---|---|---|---|---|---|---|
| H-1 | 165 | 166 | 167 | 168 | 169 | 170 | 171 | 172 | 173 | 174 | 175 | 176 | 177 | 178 | 179 |
| H-2 | 388 | 389 | 390 | 391 | 392 | 393 | 394 | 395 | 396 | 397 | 398 | 399 | 400 | 401 | 402 |
| H-3 | 610 | 611 | 612 | 613 | 614 | 615 | 616 | 617 | 618 | 619 | 620 | 621 | 622 | 623 | 624 |
| H-4 | 831 | 832 | 833 | 834 | 835 | 836 | 837 | 838 | 839 | 840 | 841 | 842 | 843 | 844 | 845 |
| H-5 | 1051 | 1052 | 1053 | 1054 | 1055 | 1056 | 1057 | 1058 | 1059 | 1060 | 1061 | 1062 | 1063 | 1064 | 1065 |
| H-6 | 1270 | 1271 | 1272 | 1273 | 1274 | 1275 | 1276 | 1277 | 1278 | 1279 | 1280 | 1281 | 1282 | 1283 | 1284 |
| H-7 | 1488 | 1489 | 1490 | 1491 | 1492 | 1493 | 1494 | 1495 | 1496 | 1497 | 1498 | 1499 | 1500 | 1501 | 1502 |
| H-8 | 1705 | 1706 | 1707 | 1708 | 1709 | 1710 | 1711 | 1712 | 1713 | 1714 | 1715 | 1716 | 1717 | 1718 | 1719 |
| H-9 | 1921 | 1922 | 1923 | 1924 | 1925 | 1926 | 1927 | 1928 | 1929 | 1930 | 1931 | 1932 | 1933 | 1934 | 1935 |
| H-10 | 2136 | 2137 | 2138 | 2139 | 2140 | 2141 | 2142 | 2143 | 2144 | 2145 | 2146 | 2147 | 2148 | 2149 | 2150 |
| H-11 | 2350 | 2351 | 2352 | 2353 | 2354 | 2355 | 2356 | 2357 | 2358 | 2359 | 2360 | 2361 | 2362 | 2363 | 2364 |
| H-12 | 2563 | 2564 | 2565 | 2566 | 2567 | 2568 | 2569 | 2570 | 2571 | 2572 | 2573 | 2574 | 2575 | 2576 | 2577 |
| H-13 | 2775 | 2776 | 2777 | 2778 | 2779 | 2780 | 2781 | 2782 | 2783 | 2784 | 2785 | 2786 | 2787 | 2788 | 2789 |
| H-14 | 2986 | 2987 | 2988 | 2989 | 2990 | 2991 | 2992 | 2993 | 2994 | 2995 | 2996 | 2997 | 2998 | 2999 | 3000 |
| H-15 | 3196 | 3197 | 3198 | 3199 | 3200 | 3201 | 3202 | 3203 | 3204 | 3205 | 3206 | 3207 | 3208 | 3209 | 3210 |
| H-16 | 3405 | 3406 | 3407 | 3408 | 3409 | 3410 | 3411 | 3412 | 3413 | 3414 | 3415 | 3416 | 3417 | 3418 | 3419 |
| H-17 | 3613 | 3614 | 3615 | 3616 | 3617 | 3618 | 3619 | 3620 | 3621 | 3622 | 3623 | 3624 | 3625 | 3626 | 3627 |
| H-18 | 3820 | 3821 | 3822 | 3823 | 3824 | 3825 | 3826 | 3827 | 3828 | 3829 | 3830 | 3831 | 3832 | 3833 | 3834 |
| H-19 | 4026 | 4027 | 4028 | 4029 | 4030 | 4031 | 4032 | 4033 | 4034 | 4035 | 4036 | 4037 | 4038 | 4039 | 4040 |
| H-20 | 4231 | 4232 | 4233 | 4234 | 4235 | 4236 | 4237 | 4238 | 4239 | 4240 | 4241 | 4242 | 4243 | 4244 | 4245 |
| H-21 | 4435 | 4436 | 4437 | 4438 | 4439 | 4440 | 4441 | 4442 | 4443 | 4444 | 4445 | 4446 | 4447 | 4448 | 4449 |
| H-22 | 4638 | 4639 | 4640 | 4641 | 4642 | 4643 | 4644 | 4645 | 4646 | 4647 | 4648 | 4649 | 4650 | 4651 | 4652 |
| H-23 | 4840 | 4841 | 4842 | 4843 | 4844 | 4845 | 4846 | 4847 | 4848 | 4849 | 4850 | 4851 | 4852 | 4853 | 4854 |
| H-24 | 5041 | 5042 | 5043 | 5044 | 5045 | 5046 | 5047 | 5048 | 5049 | 5050 | 5051 | 5052 | 5053 | 5054 | 5055 |
| H-25 | 5241 | 5242 | 5243 | 5244 | 5245 | 5246 | 5247 | 5248 | 5249 | 5250 | 5251 | 5252 | 5253 | 5254 | 5255 |

(continued)

| | H-166 | H-167 | H-168 | H-169 | H-170 | H-171 | H-172 | H-173 | H-174 | H-175 | H-176 | H-177 | H-178 | H-179 | H-180 |
|---|---|---|---|---|---|---|---|---|---|---|---|---|---|---|---|
| H-26 | 5440 | 5441 | 5442 | 5443 | 5444 | 5445 | 5446 | 5447 | 5448 | 5449 | 5450 | 5451 | 5452 | 5453 | 5454 |
| H-27 | 5638 | 5639 | 5640 | 5641 | 5642 | 5643 | 5644 | 5645 | 5646 | 5647 | 5648 | 5649 | 5650 | 5651 | 5652 |
| H-28 | 5835 | 5836 | 5837 | 5838 | 5839 | 5840 | 5841 | 5842 | 5843 | 5844 | 5845 | 5846 | 5847 | 5848 | 5849 |
| H-29 | 6031 | 6032 | 6033 | 6034 | 6035 | 6036 | 6037 | 6038 | 6039 | 6040 | 6041 | 6042 | 6043 | 6044 | 6045 |
| H-30 | 6226 | 6227 | 6228 | 6229 | 6230 | 6231 | 6232 | 6233 | 6234 | 6235 | 6236 | 6237 | 6238 | 6239 | 6240 |
| H-31 | 6420 | 6421 | 6422 | 6423 | 6424 | 6425 | 6426 | 6427 | 6428 | 6429 | 6430 | 6431 | 6432 | 6433 | 6434 |
| H-32 | 6613 | 6614 | 6615 | 6616 | 6617 | 6618 | 6619 | 6620 | 6621 | 6622 | 6623 | 6624 | 6625 | 6626 | 6627 |
| H-33 | 6805 | 6806 | 6807 | 6808 | 6809 | 6810 | 6811 | 6812 | 6813 | 6814 | 6815 | 6816 | 6817 | 6818 | 6819 |
| H-34 | 6996 | 6997 | 6998 | 6999 | 7000 | 7001 | 7002 | 7003 | 7004 | 7005 | 7006 | 7007 | 7008 | 7009 | 7010 |
| H-35 | 7186 | 7187 | 7188 | 7189 | 7190 | 7191 | 7192 | 7193 | 7194 | 7195 | 7196 | 7197 | 7198 | 7199 | 7200 |
| H-36 | 7375 | 7376 | 7377 | 7378 | 7379 | 7380 | 7381 | 7382 | 7383 | 7384 | 7385 | 7386 | 7387 | 7388 | 7389 |
| H-37 | 7563 | 7564 | 7565 | 7566 | 7567 | 7568 | 7569 | 7570 | 7571 | 7572 | 7573 | 7574 | 7575 | 7576 | 7577 |
| H-38 | 7750 | 7751 | 7752 | 7753 | 7754 | 7755 | 7756 | 7757 | 7758 | 7759 | 7760 | 7761 | 7762 | 7763 | 7764 |
| H-39 | 7936 | 7937 | 7938 | 7939 | 7940 | 7941 | 7942 | 7943 | 7944 | 7945 | 7946 | 7947 | 7948 | 7949 | 7950 |
| H-40 | 8121 | 8122 | 8123 | 8124 | 8125 | 8126 | 8127 | 8128 | 8129 | 8130 | 8131 | 8132 | 8133 | 8134 | 8135 |
| H-41 | 8305 | 8306 | 8307 | 8308 | 8309 | 8310 | 8311 | 8312 | 8313 | 8314 | 8315 | 8316 | 8317 | 8318 | 8319 |
| H-42 | 8488 | 8489 | 8490 | 8491 | 8492 | 8493 | 8494 | 8495 | 8496 | 8497 | 8498 | 8499 | 8500 | 8501 | 8502 |
| H-43 | 8670 | 8671 | 8672 | 8673 | 8674 | 8675 | 8676 | 8677 | 8678 | 8679 | 8680 | 8681 | 8682 | 8683 | 8684 |
| H-44 | 8851 | 8852 | 8853 | 8854 | 8855 | 8856 | 8857 | 8858 | 8859 | 8860 | 8861 | 8862 | 8863 | 8864 | 8865 |
| H-45 | 9031 | 9032 | 9033 | 9034 | 9035 | 9036 | 9037 | 9038 | 9039 | 9040 | 9041 | 9042 | 9043 | 9044 | 9045 |
| H-46 | 9210 | 9211 | 9212 | 9213 | 9214 | 9215 | 9216 | 9217 | 9218 | 9219 | 9220 | 9221 | 9222 | 9223 | 9224 |
| H-47 | 9388 | 9389 | 9390 | 9391 | 9392 | 9393 | 9394 | 9395 | 9396 | 9397 | 9398 | 9399 | 9400 | 9401 | 9402 |
| H-48 | 9565 | 9566 | 9567 | 9568 | 9569 | 9570 | 9571 | 9572 | 9573 | 9574 | 9575 | 9576 | 9577 | 9578 | 9579 |
| H-49 | 9741 | 9742 | 9743 | 9744 | 9745 | 9746 | 9747 | 9748 | 9749 | 9750 | 9751 | 9752 | 9753 | 9754 | 9755 |
| H-50 | 9916 | 9917 | 9918 | 9919 | 9920 | 9921 | 9922 | 9923 | 9924 | 9925 | 9926 | 9927 | 9928 | 9929 | 9930 |

(continued)

| | H-166 | H-167 | H-168 | H-169 | H-170 | H-171 | H-172 | H-173 | H-174 | H-175 | H-176 | H-177 | H-178 | H-179 | H-180 |
|---|---|---|---|---|---|---|---|---|---|---|---|---|---|---|---|
| H-51 | 10090 | 10091 | 10092 | 10093 | 10094 | 10095 | 10096 | 10097 | 10098 | 10099 | 10100 | 10101 | 10102 | 10103 | 10104 |
| H-52 | 10263 | 10264 | 10265 | 10266 | 10267 | 10268 | 10269 | 10270 | 10271 | 10272 | 10273 | 10274 | 10275 | 10276 | 10277 |
| H-53 | 10435 | 10436 | 10437 | 10438 | 10439 | 10440 | 10441 | 10442 | 10443 | 10444 | 10445 | 10446 | 10447 | 10448 | 10449 |
| H-54 | 10606 | 10607 | 10608 | 10609 | 10610 | 10611 | 10612 | 10613 | 10614 | 10615 | 10616 | 10617 | 10618 | 10619 | 10620 |
| H-55 | 10776 | 10777 | 10778 | 10779 | 10780 | 10781 | 10782 | 10783 | 10784 | 10785 | 10786 | 10787 | 10788 | 10789 | 10790 |

**Table 13**

| | H-181 | H-182 | H-183 | H-184 | H-185 | H-186 | H-187 | H-188 | H-189 | H-190 | H-191 | H-192 | H-193 | H-194 | H-195 |
|---|---|---|---|---|---|---|---|---|---|---|---|---|---|---|---|
| H-1 | 180 | 181 | 182 | 183 | 184 | 185 | 186 | 187 | 188 | 189 | 190 | 191 | 192 | 193 | 194 |
| H-2 | 403 | 404 | 405 | 406 | 407 | 408 | 409 | 410 | 411 | 412 | 413 | 414 | 415 | 416 | 417 |
| H-3 | 625 | 626 | 627 | 628 | 629 | 630 | 631 | 632 | 633 | 634 | 635 | 636 | 637 | 638 | 639 |
| H-4 | 846 | 847 | 848 | 849 | 850 | 851 | 852 | 853 | 854 | 855 | 856 | 857 | 858 | 859 | 860 |
| H-5 | 1066 | 1067 | 1068 | 1069 | 1070 | 1071 | 1072 | 1073 | 1074 | 1075 | 1076 | 1077 | 1078 | 1079 | 1080 |
| H-6 | 1285 | 1286 | 1287 | 1288 | 1289 | 1290 | 1291 | 1292 | 1293 | 1294 | 1295 | 1296 | 1297 | 1298 | 1299 |
| H-7 | 1503 | 1504 | 1505 | 1506 | 1507 | 1508 | 1509 | 1510 | 1511 | 1512 | 1513 | 1514 | 1515 | 1516 | 1517 |
| H-8 | 1720 | 1721 | 1722 | 1723 | 1724 | 1725 | 1726 | 1727 | 1728 | 1729 | 1730 | 1731 | 1732 | 1733 | 1734 |
| H-9 | 1936 | 1937 | 1938 | 1939 | 1940 | 1941 | 1942 | 1943 | 1944 | 1945 | 1946 | 1947 | 1948 | 1949 | 1950 |
| H-10 | 2151 | 2152 | 2153 | 2154 | 2155 | 2156 | 2157 | 2158 | 2159 | 2160 | 2161 | 2162 | 2163 | 2164 | 2165 |
| H-11 | 2365 | 2366 | 2367 | 2368 | 2369 | 2370 | 2371 | 2372 | 2373 | 2374 | 2375 | 2376 | 2377 | 2378 | 2379 |
| H-12 | 2578 | 2579 | 2580 | 2581 | 2582 | 2583 | 2584 | 2585 | 2586 | 2587 | 2588 | 2589 | 2590 | 2591 | 2592 |
| H-13 | 2790 | 2791 | 2792 | 2793 | 2794 | 2795 | 2796 | 2797 | 2798 | 2799 | 2800 | 2801 | 2802 | 2803 | 2804 |
| H-14 | 3001 | 3002 | 3003 | 3004 | 3005 | 3006 | 3007 | 3008 | 3009 | 3010 | 3011 | 3012 | 3013 | 3014 | 3015 |
| H-15 | 3211 | 3212 | 3213 | 3214 | 3215 | 3216 | 3217 | 3218 | 3219 | 3220 | 3221 | 3222 | 3223 | 3224 | 3225 |
| H-16 | 3420 | 3421 | 3422 | 3423 | 3424 | 3425 | 3426 | 3427 | 3428 | 3429 | 3430 | 3431 | 3432 | 3433 | 3434 |
| H-17 | 3628 | 3629 | 3630 | 3631 | 3632 | 3633 | 3634 | 3635 | 3636 | 3637 | 3638 | 3639 | 3640 | 3641 | 3642 |
| H-18 | 3835 | 3836 | 3837 | 3838 | 3839 | 3840 | 3841 | 3842 | 3843 | 3844 | 3845 | 3846 | 3847 | 3848 | 3849 |
| H-19 | 4041 | 4042 | 4043 | 4044 | 4045 | 4046 | 4047 | 4048 | 4049 | 4050 | 4051 | 4052 | 4053 | 4054 | 4055 |
| H-20 | 4246 | 4247 | 4248 | 4249 | 4250 | 4251 | 4252 | 4253 | 4254 | 4255 | 4256 | 4257 | 4258 | 4259 | 4260 |
| H-21 | 4450 | 4451 | 4452 | 4453 | 4454 | 4455 | 4456 | 4457 | 4458 | 4459 | 4460 | 4461 | 4462 | 4463 | 4464 |
| H-22 | 4653 | 4654 | 4655 | 4656 | 4657 | 4658 | 4659 | 4660 | 4661 | 4662 | 4663 | 4664 | 4665 | 4666 | 4667 |
| H-23 | 4855 | 4856 | 4857 | 4858 | 4859 | 4860 | 4861 | 4862 | 4863 | 4864 | 4865 | 4866 | 4867 | 4868 | 4869 |
| H-24 | 5056 | 5057 | 5058 | 5059 | 5060 | 5061 | 5062 | 5063 | 5064 | 5065 | 5066 | 5067 | 5068 | 5069 | 5070 |
| H-25 | 5256 | 5257 | 5258 | 5259 | 5260 | 5261 | 5262 | 5263 | 5264 | 5265 | 5266 | 5267 | 5268 | 5269 | 5270 |

(continued)

| | H-181 | H-182 | H-183 | H-184 | H-185 | H-186 | H-187 | H-188 | H-189 | H-190 | H-191 | H-192 | H-193 | H-194 | H-195 |
|---|---|---|---|---|---|---|---|---|---|---|---|---|---|---|---|
| H-26 | 5455 | 5456 | 5457 | 5458 | 5459 | 5460 | 5461 | 5462 | 5463 | 5464 | 5465 | 5466 | 5467 | 5468 | 5469 |
| H-27 | 5653 | 5654 | 5655 | 5656 | 5657 | 5658 | 5659 | 5660 | 5661 | 5662 | 5663 | 5664 | 5665 | 5666 | 5667 |
| H-28 | 5850 | 5851 | 5852 | 5853 | 5854 | 5855 | 5856 | 5857 | 5858 | 5859 | 5860 | 5861 | 5862 | 5863 | 5864 |
| H-29 | 6046 | 6047 | 6048 | 6049 | 6050 | 6051 | 6052 | 6053 | 6054 | 6055 | 6056 | 6057 | 6058 | 6059 | 6060 |
| H-30 | 6241 | 6242 | 6243 | 6244 | 6245 | 6246 | 6247 | 6248 | 6249 | 6250 | 6251 | 6252 | 6253 | 6254 | 6255 |
| H-31 | 6435 | 6436 | 6437 | 6438 | 6439 | 6440 | 6441 | 6442 | 6443 | 6444 | 6445 | 6446 | 6447 | 6448 | 6449 |
| H-32 | 6628 | 6629 | 6630 | 6631 | 6632 | 6633 | 6634 | 6635 | 6636 | 6637 | 6638 | 6639 | 6640 | 6641 | 6642 |
| H-33 | 6820 | 6821 | 6822 | 6823 | 6824 | 6825 | 6826 | 6827 | 6828 | 6829 | 6830 | 6831 | 6832 | 6833 | 6834 |
| H-34 | 7011 | 7012 | 7013 | 7014 | 7015 | 7016 | 7017 | 7018 | 7019 | 7020 | 7021 | 7022 | 7023 | 7024 | 7025 |
| H-35 | 7201 | 7202 | 7203 | 7204 | 7205 | 7206 | 7207 | 7208 | 7209 | 7210 | 7211 | 7212 | 7213 | 7214 | 7215 |
| H-36 | 7390 | 7391 | 7392 | 7393 | 7394 | 7395 | 7396 | 7397 | 7398 | 7399 | 7400 | 7401 | 7402 | 7403 | 7404 |
| H-37 | 7578 | 7579 | 7580 | 7581 | 7582 | 7583 | 7584 | 7585 | 7586 | 7587 | 7588 | 7589 | 7590 | 7591 | 7592 |
| H-38 | 7765 | 7766 | 7767 | 7768 | 7769 | 7770 | 7771 | 7772 | 7773 | 7774 | 7775 | 7776 | 7777 | 7778 | 7779 |
| H-39 | 7951 | 7952 | 7953 | 7954 | 7955 | 7956 | 7957 | 7958 | 7959 | 7960 | 7961 | 7962 | 7963 | 7964 | 7965 |
| H-40 | 8136 | 8137 | 8138 | 8139 | 8140 | 8141 | 8142 | 8143 | 8144 | 8145 | 8146 | 8147 | 8148 | 8149 | 8150 |
| H-41 | 8320 | 8321 | 8322 | 8323 | 8324 | 8325 | 8326 | 8327 | 8328 | 8329 | 8330 | 8331 | 8332 | 8333 | 8334 |
| H-42 | 8503 | 8504 | 8505 | 8506 | 8507 | 8508 | 8509 | 8510 | 8511 | 8512 | 8513 | 8514 | 8515 | 8516 | 8517 |
| H-43 | 8685 | 8686 | 8687 | 8688 | 8689 | 8690 | 8691 | 8692 | 8693 | 8694 | 8695 | 8696 | 8697 | 8698 | 8699 |
| H-44 | 8866 | 8867 | 8868 | 8869 | 8870 | 8871 | 8872 | 8873 | 8874 | 8875 | 8876 | 8877 | 8878 | 8879 | 8880 |
| H-45 | 9046 | 9047 | 9048 | 9049 | 9050 | 9051 | 9052 | 9053 | 9054 | 9055 | 9056 | 9057 | 9058 | 9059 | 9060 |
| H-46 | 9225 | 9226 | 9227 | 9228 | 9229 | 9230 | 9231 | 9232 | 9233 | 9234 | 9235 | 9236 | 9237 | 9238 | 9239 |
| H-47 | 9403 | 9404 | 9405 | 9406 | 9407 | 9408 | 9409 | 9410 | 9411 | 9412 | 9413 | 9414 | 9415 | 9416 | 9417 |
| H-48 | 9580 | 9581 | 9582 | 9583 | 9584 | 9585 | 9586 | 9587 | 9588 | 9589 | 9590 | 9591 | 9592 | 9593 | 9594 |
| H-49 | 9756 | 9757 | 9758 | 9759 | 9760 | 9761 | 9762 | 9763 | 9764 | 9765 | 9766 | 9767 | 9768 | 9769 | 9770 |
| H-50 | 9931 | 9932 | 9933 | 9934 | 9935 | 9936 | 9937 | 9938 | 9939 | 9940 | 9941 | 9942 | 9943 | 9944 | 9945 |

(continued)

| | H-181 | H-182 | H-183 | H-184 | H-185 | H-186 | H-187 | H-188 | H-189 | H-190 | H-191 | H-192 | H-193 | H-194 | H-195 |
|---|---|---|---|---|---|---|---|---|---|---|---|---|---|---|---|
| H-51 | 10105 | 10106 | 10107 | 10108 | 10109 | 10110 | 10111 | 10112 | 10113 | 10114 | 10115 | 10116 | 10117 | 10118 | 10119 |
| H-52 | 10278 | 10279 | 10280 | 10281 | 10282 | 10283 | 10284 | 10285 | 10286 | 10287 | 10288 | 10289 | 10290 | 10291 | 10292 |
| H-53 | 10450 | 10451 | 10452 | 10453 | 10454 | 10455 | 10456 | 10457 | 10458 | 10459 | 10460 | 10461 | 10462 | 10463 | 10464 |
| H-54 | 10621 | 10622 | 10623 | 10624 | 10625 | 10626 | 10627 | 10628 | 10629 | 10630 | 10631 | 10632 | 10633 | 10634 | 10635 |
| H-55 | 10791 | 10792 | 10793 | 10794 | 10795 | 10796 | 10797 | 10798 | 10799 | 10800 | 10801 | 10802 | 10803 | 10804 | 10805 |

**Table 14**

| | H-196 | H-197 | H-198 | H-199 | H-200 | H-201 | H-202 | H-203 | H-204 | H-205 | H-206 | H-207 | H-208 | H-209 | H-210 |
|---|---|---|---|---|---|---|---|---|---|---|---|---|---|---|---|
| H-1 | 195 | 196 | 197 | 198 | 199 | 200 | 201 | 202 | 203 | 204 | 205 | 206 | 207 | 208 | 209 |
| H-2 | 418 | 419 | 420 | 421 | 422 | 423 | 424 | 425 | 426 | 427 | 428 | 429 | 430 | 431 | 432 |
| H-3 | 640 | 641 | 642 | 643 | 644 | 645 | 646 | 647 | 648 | 649 | 650 | 651 | 652 | 653 | 654 |
| H-4 | 861 | 862 | 863 | 864 | 865 | 866 | 867 | 868 | 869 | 870 | 871 | 872 | 873 | 874 | 875 |
| H-5 | 1081 | 1082 | 1083 | 1084 | 1085 | 1086 | 1087 | 1088 | 1089 | 1090 | 1091 | 1092 | 1093 | 1094 | 1095 |
| H-6 | 1300 | 1301 | 1302 | 1303 | 1304 | 1305 | 1306 | 1307 | 1308 | 1309 | 1310 | 1311 | 1312 | 1313 | 1314 |
| H-7 | 1518 | 1519 | 1520 | 1521 | 1522 | 1523 | 1524 | 1525 | 1526 | 1527 | 1528 | 1529 | 1530 | 1531 | 1532 |
| H-8 | 1735 | 1736 | 1737 | 1738 | 1739 | 1740 | 1741 | 1742 | 1743 | 1744 | 1745 | 1746 | 1747 | 1748 | 1749 |
| H-9 | 1951 | 1952 | 1953 | 1954 | 1955 | 1956 | 1957 | 1958 | 1959 | 1960 | 1961 | 1962 | 1963 | 1964 | 1965 |
| H-10 | 2166 | 2167 | 2168 | 2169 | 2170 | 2171 | 2172 | 2173 | 2174 | 2175 | 2176 | 2177 | 2178 | 2179 | 2180 |
| H-11 | 2380 | 2381 | 2382 | 2383 | 2384 | 2385 | 2386 | 2387 | 2388 | 2389 | 2390 | 2391 | 2392 | 2393 | 2394 |
| H-12 | 2593 | 2594 | 2595 | 2596 | 2597 | 2598 | 2599 | 2600 | 2601 | 2602 | 2603 | 2604 | 2605 | 2606 | 2607 |
| H-13 | 2805 | 2806 | 2807 | 2808 | 2809 | 2810 | 2811 | 2812 | 2813 | 2814 | 2815 | 2816 | 2817 | 2818 | 2819 |
| H-14 | 3016 | 3017 | 3018 | 3019 | 3020 | 3021 | 3022 | 3023 | 3024 | 3025 | 3026 | 3027 | 3028 | 3029 | 3030 |
| H-15 | 3226 | 3227 | 3228 | 3229 | 3230 | 3231 | 3232 | 3233 | 3234 | 3235 | 3236 | 3237 | 3238 | 3239 | 3240 |
| H-16 | 3435 | 3436 | 3437 | 3438 | 3439 | 3440 | 3441 | 3442 | 3443 | 3444 | 3445 | 3446 | 3447 | 3448 | 3449 |
| H-17 | 3643 | 3644 | 3645 | 3646 | 3647 | 3648 | 3649 | 3650 | 3651 | 3652 | 3653 | 3654 | 3655 | 3656 | 3657 |
| H-18 | 3850 | 3851 | 3852 | 3853 | 3854 | 3855 | 3856 | 3857 | 3858 | 3859 | 3860 | 3861 | 3862 | 3863 | 3864 |
| H-19 | 4056 | 4057 | 4058 | 4059 | 4060 | 4061 | 4062 | 4063 | 4064 | 4065 | 4066 | 4067 | 4068 | 4069 | 4070 |
| H-20 | 4261 | 4262 | 4263 | 4264 | 4265 | 4266 | 4267 | 4268 | 4269 | 4270 | 4271 | 4272 | 4273 | 4274 | 4275 |
| H-21 | 4465 | 4466 | 4467 | 4468 | 4469 | 4470 | 4471 | 4472 | 4473 | 4474 | 4475 | 4476 | 4477 | 4478 | 4479 |
| H-22 | 4668 | 4669 | 4670 | 4671 | 4672 | 4673 | 4674 | 4675 | 4676 | 4677 | 4678 | 4679 | 4680 | 4681 | 4682 |
| H-23 | 4870 | 4871 | 4872 | 4873 | 4874 | 4875 | 4876 | 4877 | 4878 | 4879 | 4880 | 4881 | 4882 | 4883 | 4884 |
| H-24 | 5071 | 5072 | 5073 | 5074 | 5075 | 5076 | 5077 | 5078 | 5079 | 5080 | 5081 | 5082 | 5083 | 5084 | 5085 |
| H-25 | 5271 | 5272 | 5273 | 5274 | 5275 | 5276 | 5277 | 5278 | 5279 | 5280 | 5281 | 5282 | 5283 | 5284 | 5285 |

(continued)

| | H-196 | H-197 | H-198 | H-199 | H-200 | H-201 | H-202 | H-203 | H-204 | H-205 | H-206 | H-207 | H-208 | H-209 | H-210 |
|---|---|---|---|---|---|---|---|---|---|---|---|---|---|---|---|
| H-26 | 5470 | 5471 | 5472 | 5473 | 5474 | 5475 | 5476 | 5477 | 5478 | 5479 | 5480 | 5481 | 5482 | 5483 | 5484 |
| H-27 | 5668 | 5669 | 5670 | 5671 | 5672 | 5673 | 5674 | 5675 | 5676 | 5677 | 5678 | 5679 | 5680 | 5681 | 5682 |
| H-28 | 5865 | 5866 | 5867 | 5868 | 5869 | 5870 | 5871 | 5872 | 5873 | 5874 | 5875 | 5876 | 5877 | 5878 | 5879 |
| H-29 | 6061 | 6062 | 6063 | 6064 | 6065 | 6066 | 6067 | 6068 | 6069 | 6070 | 6071 | 6072 | 6073 | 6074 | 6075 |
| H-30 | 6256 | 6257 | 6258 | 6259 | 6260 | 6261 | 6262 | 6263 | 6264 | 6265 | 6266 | 6267 | 6268 | 6269 | 6270 |
| H-31 | 6450 | 6451 | 6452 | 6453 | 6454 | 6455 | 6456 | 6457 | 6458 | 6459 | 6460 | 6461 | 6462 | 6463 | 6464 |
| H-32 | 6643 | 6644 | 6645 | 6646 | 6647 | 6648 | 6649 | 6650 | 6651 | 6652 | 6653 | 6654 | 6655 | 6656 | 6657 |
| H-33 | 6835 | 6836 | 6837 | 6838 | 6839 | 6840 | 6841 | 6842 | 6843 | 6844 | 6845 | 6846 | 6847 | 6848 | 6849 |
| H-34 | 7026 | 7027 | 7028 | 7029 | 7030 | 7031 | 7032 | 7033 | 7034 | 7035 | 7036 | 7037 | 7038 | 7039 | 7040 |
| H-35 | 7216 | 7217 | 7218 | 7219 | 7220 | 7221 | 7222 | 7223 | 7224 | 7225 | 7226 | 7227 | 7228 | 7229 | 7230 |
| H-36 | 7405 | 7406 | 7407 | 7408 | 7409 | 7410 | 7411 | 7412 | 7413 | 7414 | 7415 | 7416 | 7417 | 7418 | 7419 |
| H-37 | 7593 | 7594 | 7595 | 7596 | 7597 | 7598 | 7599 | 7600 | 7601 | 7602 | 7603 | 7604 | 7605 | 7606 | 7607 |
| H-38 | 7780 | 7781 | 7782 | 7783 | 7784 | 7785 | 7786 | 7787 | 7788 | 7789 | 7790 | 7791 | 7792 | 7793 | 7794 |
| H-39 | 7966 | 7967 | 7968 | 7969 | 7970 | 7971 | 7972 | 7973 | 7974 | 7975 | 7976 | 7977 | 7978 | 7979 | 7980 |
| H-40 | 8151 | 8152 | 8153 | 8154 | 8155 | 8156 | 8157 | 8158 | 8159 | 8160 | 8161 | 8162 | 8163 | 8164 | 8165 |
| H-41 | 8335 | 8336 | 8337 | 8338 | 8339 | 8340 | 8341 | 8342 | 8343 | 8344 | 8345 | 8346 | 8347 | 8348 | 8349 |
| H-42 | 8518 | 8519 | 8520 | 8521 | 8522 | 8523 | 8524 | 8525 | 8526 | 8527 | 8528 | 8529 | 8530 | 8531 | 8532 |
| H-43 | 8700 | 8701 | 8702 | 8703 | 8704 | 8705 | 8706 | 8707 | 8708 | 8709 | 8710 | 8711 | 8712 | 8713 | 8714 |
| H-44 | 8881 | 8882 | 8883 | 8884 | 8885 | 8886 | 8887 | 8888 | 8889 | 8890 | 8891 | 8892 | 8893 | 8894 | 8895 |
| H-45 | 9061 | 9062 | 9063 | 9064 | 9065 | 9066 | 9067 | 9068 | 9069 | 9070 | 9071 | 9072 | 9073 | 9074 | 9075 |
| H-46 | 9240 | 9241 | 9242 | 9243 | 9244 | 9245 | 9246 | 9247 | 9248 | 9249 | 9250 | 9251 | 9252 | 9253 | 9254 |
| H-47 | 9418 | 9419 | 9420 | 9421 | 9422 | 9423 | 9424 | 9425 | 9426 | 9427 | 9428 | 9429 | 9430 | 9431 | 9432 |
| H-48 | 9595 | 9596 | 9597 | 9598 | 9599 | 9600 | 9601 | 9602 | 9603 | 9604 | 9605 | 9606 | 9607 | 9608 | 9609 |
| H-49 | 9771 | 9772 | 9773 | 9774 | 9775 | 9776 | 9777 | 9778 | 9779 | 9780 | 9781 | 9782 | 9783 | 9784 | 9785 |
| H-50 | 9946 | 9947 | 9948 | 9949 | 9950 | 9951 | 9952 | 9953 | 9954 | 9955 | 9956 | 9957 | 9958 | 9959 | 9960 |

(continued)

| | H-196 | H-197 | H-198 | H-199 | H-200 | H-201 | H-202 | H-203 | H-204 | H-205 | H-206 | H-207 | H-208 | H-209 | H-210 |
|---|---|---|---|---|---|---|---|---|---|---|---|---|---|---|---|
| H-51 | 10120 | 10121 | 10122 | 10123 | 10124 | 10125 | 10126 | 10127 | 10128 | 10129 | 10130 | 10131 | 10132 | 10133 | 10134 |
| H-52 | 10293 | 10294 | 10295 | 10296 | 10297 | 10298 | 10299 | 10300 | 10301 | 10302 | 10303 | 10304 | 10305 | 10306 | 10307 |
| H-53 | 10465 | 10466 | 10467 | 10468 | 10469 | 10470 | 10471 | 10472 | 10473 | 10474 | 10475 | 10476 | 10477 | 10478 | 10479 |
| H-54 | 10636 | 10637 | 10638 | 10639 | 10640 | 10641 | 10642 | 10643 | 10644 | 10645 | 10646 | 10647 | 10648 | 10649 | 10650 |
| H-55 | 10806 | 10807 | 10808 | 10809 | 10810 | 10811 | 10812 | 10813 | 10814 | 10815 | 10816 | 10817 | 10818 | 10819 | 10820 |

**Table 15**

| | H-211 | H-212 | H-213 | H-214 | H-215 | H-216 | H-217 | H-218 | H-219 | H-220 | H-221 | H-222 | H-223 | H-224 | H-225 |
|---|---|---|---|---|---|---|---|---|---|---|---|---|---|---|---|
| H-1 | 210 | 211 | 212 | 213 | 214 | 215 | 216 | 217 | 218 | 219 | 220 | 221 | 222 | 223 | 224 |
| H-2 | 433 | 434 | 435 | 436 | 437 | 438 | 439 | 440 | 441 | 442 | 443 | 444 | 445 | 446 | 447 |
| H-3 | 655 | 656 | 657 | 658 | 659 | 660 | 661 | 662 | 663 | 664 | 665 | 666 | 667 | 668 | 669 |
| H-4 | 876 | 877 | 878 | 879 | 880 | 881 | 882 | 883 | 884 | 885 | 886 | 887 | 888 | 889 | 890 |
| H-5 | 1096 | 1097 | 1098 | 1099 | 1100 | 1101 | 1102 | 1103 | 1104 | 1105 | 1106 | 1107 | 1108 | 1109 | 1110 |
| H-6 | 1315 | 1316 | 1317 | 1318 | 1319 | 1320 | 1321 | 1322 | 1323 | 1324 | 1325 | 1326 | 1327 | 1328 | 1329 |
| H-7 | 1533 | 1534 | 1535 | 1536 | 1537 | 1538 | 1539 | 1540 | 1541 | 1542 | 1543 | 1544 | 1545 | 1546 | 1547 |
| H-8 | 1750 | 1751 | 1752 | 1753 | 1754 | 1755 | 1756 | 1757 | 1758 | 1759 | 1760 | 1761 | 1762 | 1763 | 1764 |
| H-9 | 1966 | 1967 | 1968 | 1969 | 1970 | 1971 | 1972 | 1973 | 1974 | 1975 | 1976 | 1977 | 1978 | 1979 | 1980 |
| H-10 | 2181 | 2182 | 2183 | 2184 | 2185 | 2186 | 2187 | 2188 | 2189 | 2190 | 2191 | 2192 | 2193 | 2194 | 2195 |
| H-11 | 2395 | 2396 | 2397 | 2398 | 2399 | 2400 | 2401 | 2402 | 2403 | 2404 | 2405 | 2406 | 2407 | 2408 | 2409 |
| H-12 | 2608 | 2609 | 2610 | 2611 | 2612 | 2613 | 2614 | 2615 | 2616 | 2617 | 2618 | 2619 | 2620 | 2621 | 2622 |
| H-13 | 2820 | 2821 | 2822 | 2823 | 2824 | 2825 | 2826 | 2827 | 2828 | 2829 | 2830 | 2831 | 2832 | 2833 | 2834 |
| H-14 | 3031 | 3032 | 3033 | 3034 | 3035 | 3036 | 3037 | 3038 | 3039 | 3040 | 3041 | 3042 | 3043 | 3044 | 3045 |
| H-15 | 3241 | 3242 | 3243 | 3244 | 3245 | 3246 | 3247 | 3248 | 3249 | 3250 | 3251 | 3252 | 3253 | 3254 | 3255 |
| H-16 | 3450 | 3451 | 3452 | 3453 | 3454 | 3455 | 3456 | 3457 | 3458 | 3459 | 3460 | 3461 | 3462 | 3463 | 3464 |
| H-17 | 3658 | 3659 | 3660 | 3661 | 3662 | 3663 | 3664 | 3665 | 3666 | 3667 | 3668 | 3669 | 3670 | 3671 | 3672 |
| H-18 | 3865 | 3866 | 3867 | 3868 | 3869 | 3870 | 3871 | 3872 | 3873 | 3874 | 3875 | 3876 | 3877 | 3878 | 3879 |
| H-19 | 4071 | 4072 | 4073 | 4074 | 4075 | 4076 | 4077 | 4078 | 4079 | 4080 | 4081 | 4082 | 4083 | 4084 | 4085 |
| H-20 | 4276 | 4277 | 4278 | 4279 | 4280 | 4281 | 4282 | 4283 | 4284 | 4285 | 4286 | 4287 | 4288 | 4289 | 4290 |
| H-21 | 4480 | 4481 | 4482 | 4483 | 4484 | 4485 | 4486 | 4487 | 4488 | 4489 | 4490 | 4491 | 4492 | 4493 | 4494 |
| H-22 | 4683 | 4684 | 4685 | 4686 | 4687 | 4688 | 4689 | 4690 | 4691 | 4692 | 4693 | 4694 | 4695 | 4696 | 4697 |
| H-23 | 4885 | 4886 | 4887 | 4888 | 4889 | 4890 | 4891 | 4892 | 4893 | 4894 | 4895 | 4896 | 4897 | 4898 | 4899 |
| H-24 | 5086 | 5087 | 5088 | 5089 | 5090 | 5091 | 5092 | 5093 | 5094 | 5095 | 5096 | 5097 | 5098 | 5099 | 5100 |
| H-25 | 5286 | 5287 | 5288 | 5289 | 5290 | 5291 | 5292 | 5293 | 5294 | 5295 | 5296 | 5297 | 5298 | 5299 | 5300 |

(continued)

| | H-211 | H-212 | H-213 | H-214 | H-215 | H-216 | H-217 | H-218 | H-219 | H-220 | H-221 | H-222 | H-223 | H-224 | H-225 |
|---|---|---|---|---|---|---|---|---|---|---|---|---|---|---|---|
| H-26 | 5485 | 5486 | 5487 | 5488 | 5489 | 5490 | 5491 | 5492 | 5493 | 5494 | 5495 | 5496 | 5497 | 5498 | 5499 |
| H-27 | 5683 | 5684 | 5685 | 5686 | 5687 | 5688 | 5689 | 5690 | 5691 | 5692 | 5693 | 5694 | 5695 | 5696 | 5697 |
| H-28 | 5880 | 5881 | 5882 | 5883 | 5884 | 5885 | 5886 | 5887 | 5888 | 5889 | 5890 | 5891 | 5892 | 5893 | 5894 |
| H-29 | 6076 | 6077 | 6078 | 6079 | 6080 | 6081 | 6082 | 6083 | 6084 | 6085 | 6086 | 6087 | 6088 | 6089 | 6090 |
| H-30 | 6271 | 6272 | 6273 | 6274 | 6275 | 6276 | 6277 | 6278 | 6279 | 6280 | 6281 | 6282 | 6283 | 6284 | 6285 |
| H-31 | 6465 | 6466 | 6467 | 6468 | 6469 | 6470 | 6471 | 6472 | 6473 | 6474 | 6475 | 6476 | 6477 | 6478 | 6479 |
| H-32 | 6658 | 6659 | 6660 | 6661 | 6662 | 6663 | 6664 | 6665 | 6666 | 6667 | 6668 | 6669 | 6670 | 6671 | 6672 |
| H-33 | 6850 | 6851 | 6852 | 6853 | 6854 | 6855 | 6856 | 6857 | 6858 | 6859 | 6860 | 6861 | 6862 | 6863 | 6864 |
| H-34 | 7041 | 7042 | 7043 | 7044 | 7045 | 7046 | 7047 | 7048 | 7049 | 7050 | 7051 | 7052 | 7053 | 7054 | 7055 |
| H-35 | 7231 | 7232 | 7233 | 7234 | 7235 | 7236 | 7237 | 7238 | 7239 | 7240 | 7241 | 7242 | 7243 | 7244 | 7245 |
| H-36 | 7420 | 7421 | 7422 | 7423 | 7424 | 7425 | 7426 | 7427 | 7428 | 7429 | 7430 | 7431 | 7432 | 7433 | 7434 |
| H-37 | 7608 | 7609 | 7610 | 7611 | 7612 | 7613 | 7614 | 7615 | 7616 | 7617 | 7618 | 7619 | 7620 | 7621 | 7622 |
| H-38 | 7795 | 7796 | 7797 | 7798 | 7799 | 7800 | 7801 | 7802 | 7603 | 7804 | 7305 | 7806 | 7807 | 7808 | 7809 |
| H-39 | 7981 | 7982 | 7983 | 7984 | 7985 | 7986 | 7987 | 7988 | 7989 | 7990 | 7991 | 7992 | 7993 | 7994 | 7995 |
| H-40 | 8166 | 8167 | 8168 | 8169 | 8170 | 8171 | 8172 | 8173 | 8174 | 8175 | 8176 | 8177 | 8178 | 8179 | 8180 |
| H-41 | 8350 | 8351 | 8352 | 8353 | 8354 | 8355 | 8356 | 8357 | 8358 | 8359 | 8360 | 8361 | 8362 | 8363 | 8364 |
| H-42 | 8533 | 8534 | 8535 | 8536 | 8537 | 8538 | 8539 | 8540 | 8541 | 8542 | 8543 | 8544 | 8545 | 8546 | 8547 |
| H-43 | 8715 | 8716 | 8717 | 8718 | 8719 | 8720 | 8721 | 8722 | 8723 | 8724 | 8725 | 8726 | 8727 | 8728 | 8729 |
| H-44 | 8896 | 8897 | 8898 | 8899 | 8900 | 8901 | 8902 | 8903 | 8904 | 8905 | 8906 | 8907 | 8908 | 8909 | 8910 |
| H-45 | 9076 | 9077 | 9078 | 9079 | 9080 | 9081 | 9082 | 9083 | 9084 | 9085 | 9086 | 9087 | 9088 | 9089 | 9090 |
| H-46 | 9255 | 9256 | 9257 | 9258 | 9259 | 9260 | 9261 | 9262 | 9263 | 9264 | 9265 | 9266 | 9267 | 9268 | 9269 |
| H-47 | 9433 | 9434 | 9435 | 9436 | 9437 | 9438 | 9439 | 9440 | 9441 | 9442 | 9443 | 9444 | 9445 | 9446 | 9447 |
| H-48 | 9610 | 9611 | 9612 | 9613 | 9614 | 9615 | 9616 | 9617 | 9618 | 9619 | 9620 | 9621 | 9622 | 9623 | 9624 |
| H-49 | 9786 | 9787 | 9788 | 9789 | 9790 | 9791 | 9792 | 9793 | 9794 | 9795 | 9796 | 9797 | 9798 | 9799 | 9800 |
| H-50 | 9961 | 9962 | 9963 | 9964 | 9965 | 9966 | 9967 | 9968 | 9969 | 9970 | 9971 | 9972 | 9973 | 9974 | 9975 |

(continued)

| | H-211 | H-212 | H-213 | H-214 | H-215 | H-216 | H-217 | H-218 | H-219 | H-220 | H-221 | H-222 | H-223 | H-224 | H-225 |
|---|---|---|---|---|---|---|---|---|---|---|---|---|---|---|---|
| H-51 | 10135 | 10136 | 10137 | 10138 | 10139 | 10140 | 10141 | 10142 | 10143 | 10144 | 10145 | 10146 | 10147 | 10148 | 10149 |
| H-52 | 10308 | 10309 | 10310 | 10311 | 10312 | 10313 | 10314 | 10315 | 10316 | 10317 | 10318 | 10319 | 10320 | 10321 | 10322 |
| H-53 | 10480 | 10481 | 10482 | 10483 | 10484 | 10485 | 10486 | 10487 | 10488 | 10489 | 10490 | 10491 | 10492 | 10493 | 10494 |
| H-54 | 10651 | 10652 | 10653 | 10654 | 10655 | 10656 | 10657 | 10658 | 10659 | 10660 | 10661 | 10662 | 10663 | 10664 | 10665 |
| H-55 | 10821 | 10822 | 10823 | 10824 | 10825 | 10826 | 10827 | 10828 | 10829 | 10830 | 10831 | 10832 | 10833 | 10834 | 10835 |

**Table 16**

| | H-46 | H-47 | H-48 | H-49 | H-50 | H-51 | H-52 | H-53 | H-54 | H-55 | H-56 | H-57 | H-58 | H-59 | H-60 |
|---|---|---|---|---|---|---|---|---|---|---|---|---|---|---|---|
| H-56 | 9100 | 9278 | 9455 | 9631 | 9806 | 9980 | 10153 | 10325 | 10496 | 10666 | - | 10836 | 10837 | 10838 | 10839 |
| H-57 | 9101 | 9279 | 9456 | 9632 | 9807 | 9981 | 10154 | 10326 | 10497 | 10667 | 10836 | - | 11005 | 11006 | 11007 |
| H-58 | 9102 | 9280 | 9457 | 9633 | 9808 | 9982 | 10155 | 10327 | 10498 | 10668 | 10837 | 11005 | - | 11173 | 11174 |
| H-59 | 9103 | 9281 | 9458 | 9634 | 9809 | 9983 | 10156 | 10328 | 10499 | 10669 | 10838 | 11006 | 11173 | - | 11340 |
| H-60 | 9104 | 9282 | 9459 | 9635 | 9810 | 9984 | 10157 | 10329 | 10500 | 10670 | 10839 | 11007 | 11174 | 11340 | - |
| H-61 | 9105 | 9283 | 9460 | 9636 | 9811 | 9985 | 10158 | 10330 | 10501 | 10671 | 10840 | 11008 | 11175 | 11341 | 11506 |
| H-62 | 9106 | 9284 | 9461 | 9637 | 9812 | 9986 | 10159 | 10331 | 10502 | 10672 | 10841 | 11009 | 11176 | 11342 | 11507 |
| H-63 | 9107 | 9285 | 9462 | 9638 | 9813 | 9987 | 10160 | 10332 | 10503 | 10673 | 10842 | 11010 | 11177 | 11343 | 11508 |
| H-64 | 9108 | 9286 | 9463 | 9639 | 9814 | 9988 | 10161 | 10333 | 10504 | 10674 | 10843 | 11011 | 11178 | 11344 | 11509 |
| H-65 | 9109 | 9287 | 9464 | 9640 | 9815 | 9989 | 10162 | 10334 | 10505 | 10675 | 10844 | 11012 | 11179 | 11345 | 11510 |
| H-66 | 9110 | 9288 | 9465 | 9641 | 9816 | 9990 | 10163 | 10335 | 10506 | 10676 | 10845 | 11013 | 11180 | 11346 | 11511 |
| H-67 | 9111 | 9289 | 9466 | 9642 | 9817 | 9991 | 10164 | 10336 | 10507 | 10677 | 10846 | 11014 | 11181 | 11347 | 11512 |
| H-68 | 9112 | 9290 | 9467 | 9643 | 9818 | 9992 | 10165 | 10337 | 10508 | 10678 | 10847 | 11015 | 11182 | 11348 | 11513 |
| H-69 | 9113 | 9291 | 9468 | 9644 | 9819 | 9993 | 10166 | 10338 | 10509 | 10679 | 10848 | 11016 | 11183 | 11349 | 11514 |
| H-70 | 9114 | 9292 | 9469 | 9645 | 9820 | 9994 | 10167 | 10339 | 10510 | 10680 | 10849 | 11017 | 11184 | 11350 | 11515 |
| H-71 | 9115 | 9293 | 9470 | 9646 | 9821 | 9995 | 10168 | 10340 | 10511 | 10681 | 10850 | 11018 | 11185 | 11351 | 11516 |
| H-72 | 9116 | 9294 | 9471 | 9647 | 9822 | 9996 | 10169 | 10341 | 10512 | 10682 | 10851 | 11019 | 11186 | 11352 | 11517 |
| H-73 | 9117 | 9295 | 9472 | 9648 | 9823 | 9997 | 10170 | 10342 | 10513 | 10683 | 10852 | 11020 | 11187 | 11353 | 11518 |
| H-74 | 9118 | 9296 | 9473 | 9649 | 9824 | 9998 | 10171 | 10343 | 10514 | 10684 | 10853 | 11021 | 11188 | 11354 | 11519 |
| H-75 | 9119 | 9297 | 9474 | 9650 | 9825 | 9999 | 10172 | 10344 | 10515 | 10685 | 10854 | 11022 | 11189 | 11355 | 11520 |
| H-76 | 9120 | 9298 | 9475 | 9651 | 9826 | 10000 | 10173 | 10345 | 10516 | 10686 | 10855 | 11023 | 11190 | 11356 | 11521 |
| H-77 | 9121 | 9299 | 9476 | 9652 | 9827 | 10001 | 10174 | 10346 | 10517 | 10687 | 10856 | 11024 | 11191 | 11357 | 11522 |
| H-78 | 9122 | 9300 | 9477 | 9653 | 9828 | 10002 | 10175 | 10347 | 10518 | 10688 | 10857 | 11025 | 11192 | 11358 | 11523 |
| H-79 | 9123 | 9301 | 9478 | 9654 | 9829 | 10003 | 10176 | 10348 | 10519 | 10689 | 10858 | 11026 | 11193 | 11359 | 11524 |
| H-80 | 9124 | 9302 | 9479 | 9655 | 9830 | 10004 | 10177 | 10349 | 10520 | 10690 | 10859 | 11027 | 11194 | 11360 | 11525 |

(continued)

| | H-46 | H-47 | H-48 | H-49 | H-50 | H-51 | H-52 | H-53 | H-54 | H-55 | H-56 | H-57 | H-58 | H-59 | H-60 |
|---|---|---|---|---|---|---|---|---|---|---|---|---|---|---|---|
| H-81 | 9125 | 9303 | 9480 | 9656 | 9831 | 10005 | 10178 | 10350 | 10521 | 10691 | 10860 | 11028 | 11195 | 11361 | 11526 |
| H-82 | 9126 | 9304 | 9481 | 9657 | 9832 | 10006 | 10179 | 10351 | 10522 | 10692 | 10861 | 11029 | 11196 | 11362 | 11527 |
| H-83 | 9127 | 9305 | 9482 | 9658 | 9833 | 10007 | 10180 | 10352 | 10523 | 10693 | 10862 | 11030 | 11197 | 11363 | 11528 |
| H-84 | 9128 | 9306 | 9483 | 9659 | 9834 | 10008 | 10181 | 10353 | 10524 | 10694 | 10863 | 11031 | 11198 | 11364 | 11529 |
| H-85 | 9129 | 9307 | 9484 | 9660 | 9835 | 10009 | 10182 | 10354 | 10525 | 10695 | 10864 | 11032 | 11199 | 11365 | 11530 |
| H-86 | 9130 | 9308 | 9485 | 9661 | 9836 | 10010 | 10183 | 10355 | 10526 | 10696 | 10865 | 11033 | 11200 | 11366 | 11531 |
| H-87 | 9131 | 9309 | 9486 | 9662 | 9837 | 10011 | 10184 | 10356 | 10527 | 10697 | 10866 | 11034 | 11201 | 11367 | 11532 |
| H-88 | 9132 | 9310 | 9487 | 9663 | 9838 | 10012 | 10185 | 10357 | 10528 | 10698 | 10867 | 11035 | 11202 | 11368 | 11533 |
| H-89 | 9133 | 9311 | 9488 | 9664 | 9839 | 10013 | 10186 | 10358 | 10529 | 10699 | 10868 | 11036 | 11203 | 11369 | 11534 |
| H-90 | 9134 | 9312 | 9489 | 9665 | 9840 | 10014 | 10187 | 10359 | 10530 | 10700 | 10869 | 11037 | 11204 | 11370 | 11535 |
| H-91 | 9135 | 9313 | 9490 | 9666 | 9841 | 10015 | 10188 | 10360 | 10531 | 10701 | 10870 | 11038 | 11205 | 11371 | 11536 |
| H-92 | 9136 | 9314 | 9491 | 9667 | 9842 | 10016 | 10189 | 10361 | 10532 | 10702 | 10871 | 11039 | 11206 | 11372 | 11537 |
| H-93 | 9137 | 9315 | 9492 | 9668 | 9843 | 10017 | 10190 | 10362 | 10533 | 10703 | 10872 | 11040 | 11207 | 11373 | 11538 |
| H-94 | 9138 | 9316 | 9493 | 9669 | 9844 | 10018 | 10191 | 10363 | 10534 | 10704 | 10873 | 11041 | 11208 | 11374 | 11539 |
| H-95 | 9139 | 9317 | 9494 | 9670 | 9845 | 10019 | 10192 | 10364 | 10535 | 10705 | 10874 | 11042 | 11209 | 11375 | 11540 |
| H-96 | 9140 | 9318 | 9495 | 9671 | 9846 | 10020 | 10193 | 10365 | 10536 | 10706 | 10875 | 11043 | 11210 | 11376 | 11541 |
| H-97 | 9141 | 9319 | 9496 | 9672 | 9847 | 10021 | 10194 | 10366 | 10537 | 10707 | 10876 | 11044 | 11211 | 11377 | 11542 |
| H-98 | 9142 | 9320 | 9497 | 9673 | 9848 | 10022 | 10195 | 10367 | 10538 | 10708 | 10877 | 11045 | 11212 | 11378 | 11543 |
| H-99 | 9143 | 9321 | 9498 | 9674 | 9849 | 10023 | 10196 | 10368 | 10539 | 10709 | 10878 | 11046 | 11213 | 11379 | 11544 |
| H-100 | 9144 | 9322 | 9499 | 9675 | 9850 | 10024 | 10197 | 10369 | 10540 | 10710 | 10879 | 11047 | 11214 | 11380 | 11545 |
| H-101 | 9145 | 9323 | 9500 | 9676 | 9851 | 10025 | 10198 | 10370 | 10541 | 10711 | 10880 | 11048 | 11215 | 11381 | 11546 |
| H-102 | 9146 | 9324 | 9501 | 9677 | 9852 | 10026 | 10199 | 10371 | 10542 | 10712 | 10881 | 11049 | 11216 | 11382 | 11547 |
| H-103 | 9147 | 9325 | 9502 | 9678 | 9853 | 10027 | 10200 | 10372 | 10543 | 10713 | 10882 | 11050 | 11217 | 11383 | 11548 |
| H-104 | 9148 | 9326 | 9503 | 9679 | 9854 | 10028 | 10201 | 10373 | 10544 | 10714 | 10883 | 11051 | 11218 | 11384 | 11549 |
| H-105 | 9149 | 9327 | 9504 | 9680 | 9855 | 10029 | 10202 | 10374 | 10545 | 10715 | 10884 | 11052 | 11219 | 11385 | 11550 |

(continued)

| | H-46 | H-47 | H-48 | H-49 | H-50 | H-51 | H-52 | H-53 | H-54 | H-55 | H-56 | H-57 | H-58 | H-59 | H-60 |
|---|---|---|---|---|---|---|---|---|---|---|---|---|---|---|---|
| H-106 | 9150 | 9328 | 9505 | 9681 | 9856 | 10030 | 10203 | 10375 | 10546 | 10716 | 10885 | 11053 | 11220 | 11386 | 11551 |
| H-107 | 9151 | 9329 | 9506 | 9682 | 9857 | 10031 | 10204 | 10376 | 10547 | 10717 | 10886 | 11054 | 11221 | 11387 | 11552 |
| H-108 | 9152 | 9330 | 9507 | 9683 | 9858 | 10032 | 10205 | 10377 | 10548 | 10718 | 10887 | 11055 | 11222 | 11388 | 11553 |
| H-109 | 9153 | 9331 | 9508 | 9684 | 9859 | 10033 | 10206 | 10378 | 10549 | 10719 | 10888 | 11056 | 11223 | 11389 | 11554 |
| H-110 | 9154 | 9332 | 9509 | 9685 | 9860 | 10034 | 10207 | 10379 | 10550 | 10720 | 10889 | 11057 | 11224 | 11390 | 11555 |

**Table 17**

| | H-61 | H-62 | H-63 | H-64 | H-65 | H-66 | H-67 | H-68 | H-69 | H-70 | H-71 | H-72 | H-73 | H-74 | H-75 |
|---|---|---|---|---|---|---|---|---|---|---|---|---|---|---|---|
| H-56 | 10840 | 10841 | 10842 | 10843 | 10844 | 10845 | 10846 | 10847 | 10848 | 10849 | 10850 | 10851 | 10852 | 10853 | 10854 |
| H-57 | 11008 | 11009 | 11010 | 11011 | 11012 | 11013 | 11014 | 11015 | 11016 | 11017 | 11018 | 11019 | 11020 | 11021 | 11022 |
| H-58 | 11175 | 11176 | 11177 | 11178 | 11179 | 11180 | 11181 | 11182 | 11183 | 11184 | 11185 | 11186 | 11187 | 11188 | 11189 |
| H-59 | 11341 | 11342 | 11343 | 11344 | 11345 | 11346 | 11347 | 11348 | 11349 | 11350 | 11351 | 11352 | 11353 | 11354 | 11355 |
| H-60 | 11506 | 11507 | 11508 | 11509 | 11510 | 11511 | 11512 | 11513 | 11514 | 11515 | 11516 | 11517 | 11518 | 11519 | 11520 |
| H-61 | - | 11671 | 11672 | 11673 | 11674 | 11675 | 11676 | 11677 | 11678 | 11679 | 11680 | 11681 | 11682 | 11683 | 11684 |
| H-62 | 11671 | - | 11835 | 11836 | 11837 | 11838 | 11839 | 11840 | 11841 | 11842 | 11843 | 11844 | 11845 | 11846 | 11847 |
| H-63 | 11672 | 11835 | - | 11998 | 11999 | 12000 | 12001 | 12002 | 12003 | 12004 | 12005 | 12006 | 12007 | 12008 | 12009 |
| H-64 | 11673 | 11836 | 11998 | - | 12160 | 12161 | 12162 | 12163 | 12164 | 12165 | 12166 | 12167 | 12168 | 12169 | 12170 |
| H-65 | 11674 | 11837 | 11999 | 12160 | - | 12321 | 12322 | 12323 | 12324 | 12325 | 12326 | 12327 | 12328 | 12329 | 12330 |
| H-66 | 11675 | 11838 | 12000 | 12161 | 12321 | - | 12481 | 12482 | 12483 | 12484 | 12485 | 12486 | 12487 | 12488 | 12489 |
| H-67 | 11676 | 11839 | 12001 | 12162 | 12322 | 12481 | - | 12640 | 12641 | 12642 | 12643 | 12644 | 12645 | 12646 | 12647 |
| H-68 | 11677 | 11840 | 12002 | 12163 | 12323 | 12482 | 12640 | - | 12798 | 12799 | 12800 | 12801 | 12802 | 12803 | 12804 |
| H-69 | 11678 | 11841 | 12003 | 12164 | 12324 | 12483 | 12641 | 12798 | - | 12955 | 12956 | 12957 | 12958 | 12959 | 12960 |
| H-70 | 11679 | 11842 | 12004 | 12165 | 12325 | 12484 | 12642 | 12799 | 12955 | - | 13111 | 13112 | 13113 | 13114 | 13115 |
| H-71 | 11680 | 11843 | 12005 | 12166 | 12326 | 12485 | 12643 | 12800 | 12956 | 13111 | - | 13266 | 13267 | 13268 | 13269 |
| H-72 | 11681 | 11844 | 12006 | 12167 | 12327 | 12486 | 12644 | 12801 | 12957 | 13112 | 13266 | - | 13420 | 13421 | 13422 |
| H-73 | 11682 | 11845 | 12007 | 12168 | 12328 | 12487 | 12645 | 12802 | 12958 | 13113 | 13267 | 13420 | - | 13573 | 13574 |
| H-74 | 11683 | 11846 | 12008 | 12169 | 12329 | 12488 | 12646 | 12803 | 12959 | 13114 | 13268 | 13421 | 13573 | - | 13725 |
| H-75 | 11684 | 11847 | 12009 | 12170 | 12330 | 12489 | 12647 | 12804 | 12960 | 13115 | 13269 | 13422 | 13574 | 13725 | - |
| H-76 | 11685 | 11848 | 12010 | 12171 | 12331 | 12490 | 12648 | 12805 | 12961 | 13116 | 13270 | 13423 | 13575 | 13726 | 13876 |
| H-77 | 11686 | 11849 | 12011 | 12172 | 12332 | 12491 | 12649 | 12806 | 12962 | 13117 | 13271 | 13424 | 13576 | 13727 | 13877 |
| H-78 | 11687 | 11850 | 12012 | 12173 | 12333 | 12492 | 12650 | 12807 | 12963 | 13118 | 13272 | 13425 | 13577 | 13728 | 13878 |
| H-79 | 11688 | 11851 | 12013 | 12174 | 12334 | 12493 | 12651 | 12808 | 12964 | 13119 | 13273 | 13426 | 13578 | 13729 | 13879 |
| H-80 | 11689 | 11852 | 12014 | 12175 | 12335 | 12494 | 12652 | 12809 | 12965 | 13120 | 13274 | 13427 | 13579 | 13730 | 13880 |

(continued)

| | H-61 | H-62 | H-63 | H-64 | H-65 | H-66 | H-67 | H-68 | H-69 | H-70 | H-71 | H-72 | H-73 | H-74 | H-75 |
|---|---|---|---|---|---|---|---|---|---|---|---|---|---|---|---|
| H-81 | 11690 | 11853 | 12015 | 12176 | 12336 | 12495 | 12653 | 12810 | 12966 | 13121 | 13275 | 13428 | 13580 | 13731 | 13881 |
| H-82 | 11691 | 11854 | 12016 | 12177 | 12337 | 12496 | 12654 | 12811 | 12967 | 13122 | 13276 | 13429 | 13581 | 13732 | 13882 |
| H-83 | 11692 | 11855 | 12017 | 12178 | 12338 | 12497 | 12655 | 12812 | 12968 | 13123 | 13277 | 13430 | 13582 | 13733 | 13883 |
| H-84 | 11693 | 11856 | 12018 | 12179 | 12339 | 12498 | 12656 | 12813 | 12969 | 13124 | 13278 | 13431 | 13583 | 13734 | 13884 |
| H-85 | 11694 | 11857 | 12019 | 12180 | 12340 | 12499 | 12657 | 12814 | 12970 | 13125 | 13279 | 13432 | 13584 | 13735 | 13885 |
| H-86 | 11695 | 11858 | 12020 | 12181 | 12341 | 12500 | 12658 | 12815 | 12971 | 13126 | 13280 | 13433 | 13585 | 13736 | 13886 |
| H-87 | 11696 | 11859 | 12021 | 12182 | 12342 | 12501 | 12659 | 12816 | 12972 | 13127 | 13281 | 13434 | 13586 | 13737 | 13887 |
| H-68 | 11697 | 11860 | 12022 | 12183 | 12343 | 12502 | 12660 | 12817 | 12973 | 13128 | 13282 | 13435 | 13587 | 13738 | 13888 |
| H-89 | 11698 | 11861 | 12023 | 12184 | 12344 | 12503 | 12661 | 12818 | 12974 | 13129 | 13283 | 13436 | 13588 | 13739 | 13889 |
| H-90 | 11699 | 11862 | 12024 | 12185 | 12345 | 12504 | 12662 | 12819 | 12975 | 13130 | 13284 | 13437 | 13589 | 13740 | 13890 |
| H-91 | 11700 | 11863 | 12025 | 12186 | 12346 | 12505 | 12663 | 12820 | 12976 | 13131 | 13285 | 13438 | 13590 | 13741 | 13891 |
| H-92 | 11701 | 11864 | 12026 | 12187 | 12347 | 12506 | 12664 | 12821 | 12977 | 13132 | 13286 | 13439 | 13591 | 13742 | 13892 |
| H-93 | 11702 | 11865 | 12027 | 12188 | 12348 | 12507 | 12665 | 12822 | 12978 | 13133 | 13287 | 13440 | 13592 | 13743 | 13893 |
| H-94 | 11703 | 11866 | 12028 | 12189 | 12349 | 12508 | 12666 | 12823 | 12979 | 13134 | 13288 | 13441 | 13593 | 13744 | 13894 |
| H-95 | 11704 | 11867 | 12029 | 12190 | 12350 | 12509 | 12667 | 12824 | 12980 | 13135 | 13289 | 13442 | 13594 | 13745 | 13895 |
| H-96 | 11705 | 11868 | 12030 | 12191 | 12351 | 12510 | 12668 | 12825 | 12981 | 13136 | 13290 | 13443 | 13595 | 13746 | 13896 |
| H-97 | 11706 | 11869 | 12031 | 12192 | 12352 | 12511 | 12669 | 12826 | 12982 | 13137 | 13291 | 13444 | 13596 | 13747 | 13897 |
| H-98 | 11707 | 11870 | 12032 | 12193 | 12353 | 12512 | 12670 | 12827 | 12983 | 13138 | 13292 | 13445 | 13597 | 13748 | 13898 |
| H-99 | 11708 | 11871 | 12033 | 12194 | 12354 | 12513 | 12671 | 12828 | 12984 | 13139 | 13293 | 13446 | 13598 | 13749 | 13899 |
| H-100 | 11709 | 11872 | 12034 | 12195 | 12355 | 12514 | 12672 | 12829 | 12985 | 13140 | 13294 | 13447 | 13599 | 13750 | 13900 |
| H-101 | 11710 | 11873 | 12035 | 12196 | 12356 | 12515 | 12673 | 12830 | 12986 | 13141 | 13295 | 13448 | 13600 | 13751 | 13901 |
| H-102 | 11711 | 11874 | 12036 | 12197 | 12357 | 12516 | 12674 | 12831 | 12987 | 13142 | 13296 | 13449 | 13601 | 13752 | 13902 |
| H-103 | 11712 | 11875 | 12037 | 12198 | 12358 | 12517 | 12675 | 12832 | 12988 | 13143 | 13297 | 13450 | 13602 | 13753 | 13903 |
| H-104 | 11713 | 11876 | 12038 | 12199 | 12359 | 12518 | 12676 | 12833 | 12989 | 13144 | 13298 | 13451 | 13603 | 13754 | 13904 |
| H-105 | 11714 | 11877 | 12039 | 12200 | 12360 | 12519 | 12677 | 12834 | 12990 | 13145 | 13299 | 13452 | 13604 | 13755 | 13905 |

(continued)

| | H-61 | H-62 | H-63 | H-64 | H-65 | H-66 | H-67 | H-68 | H-69 | H-70 | H-71 | H-72 | H-73 | H-74 | H-75 |
|---|---|---|---|---|---|---|---|---|---|---|---|---|---|---|---|
| H-106 | 11715 | 11878 | 12040 | 12201 | 12361 | 12520 | 12678 | 12835 | 12991 | 13146 | 13300 | 13453 | 13605 | 13756 | 13906 |
| H-107 | 11716 | 11879 | 12041 | 12202 | 12362 | 12521 | 12679 | 12836 | 12992 | 13147 | 13301 | 13454 | 13606 | 13757 | 13907 |
| H-108 | 11717 | 11880 | 12042 | 12203 | 12363 | 12522 | 12680 | 12837 | 12993 | 13148 | 13302 | 13455 | 13607 | 13758 | 13908 |
| H-109 | 11718 | 11881 | 12043 | 12204 | 12364 | 12523 | 12681 | 12838 | 12994 | 13149 | 13303 | 13456 | 13608 | 13759 | 13909 |
| H-110 | 11719 | 11882 | 12044 | 12205 | 12365 | 12524 | 12682 | 12839 | 12995 | 13150 | 13304 | 13457 | 13609 | 13760 | 13910 |

**Table 18**

| | H-76 | H-77 | H-78 | H-79 | H-80 | H-81 | H-82 | H-83 | H-84 | H-85 | H-86 | H-87 | H-88 | H-89 | H-90 |
|---|---|---|---|---|---|---|---|---|---|---|---|---|---|---|---|
| H-56 | 10855 | 10856 | 10857 | 10858 | 10859 | 10860 | 10861 | 10862 | 10863 | 10864 | 10865 | 10866 | 10867 | 10868 | 10869 |
| H-57 | 11023 | 11024 | 11025 | 11026 | 11027 | 11028 | 11029 | 11030 | 11031 | 11032 | 11033 | 11034 | 11035 | 11036 | 11037 |
| H-58 | 11190 | 11191 | 11192 | 11193 | 11194 | 11195 | 11196 | 11197 | 11198 | 11199 | 11200 | 11201 | 11202 | 11203 | 11204 |
| H-59 | 11356 | 11357 | 11358 | 11359 | 11360 | 11361 | 11362 | 11363 | 11364 | 11365 | 11366 | 11367 | 11368 | 11369 | 11370 |
| H-60 | 11521 | 11522 | 11523 | 11524 | 11525 | 11526 | 11527 | 11528 | 11529 | 11530 | 11531 | 11532 | 11533 | 11534 | 11535 |
| H-61 | 11685 | 11686 | 11687 | 11688 | 11689 | 11690 | 11691 | 11692 | 11693 | 11694 | 11695 | 11696 | 11697 | 11698 | 11699 |
| H-62 | 11848 | 11849 | 11850 | 11851 | 11852 | 11853 | 11854 | 11855 | 11856 | 11857 | 11858 | 11859 | 11860 | 11861 | 11862 |
| H-63 | 12010 | 12011 | 12012 | 12013 | 12014 | 12015 | 12016 | 12017 | 12018 | 12019 | 12020 | 12021 | 12022 | 12023 | 12024 |
| H-64 | 12171 | 12172 | 12173 | 12174 | 12175 | 12176 | 12177 | 12178 | 12179 | 12180 | 12181 | 12182 | 12183 | 12184 | 12185 |
| H-65 | 12331 | 12332 | 12333 | 12334 | 12335 | 12336 | 12337 | 12338 | 12339 | 12340 | 12341 | 12342 | 12343 | 12344 | 12345 |
| H-66 | 12490 | 12491 | 12492 | 12493 | 12494 | 12495 | 12496 | 12497 | 12498 | 12499 | 12500 | 12501 | 12502 | 12503 | 12504 |
| H-67 | 12648 | 12649 | 12650 | 12651 | 12652 | 12653 | 12654 | 12655 | 12656 | 12657 | 12658 | 12659 | 12660 | 12661 | 12662 |
| H-68 | 12805 | 12806 | 12807 | 12808 | 12809 | 12810 | 12811 | 12812 | 12813 | 12814 | 12815 | 12816 | 12817 | 12818 | 12819 |
| H-69 | 12961 | 12962 | 12963 | 12964 | 12965 | 12966 | 12967 | 12968 | 12969 | 12970 | 12971 | 12972 | 12973 | 12974 | 12975 |
| H-70 | 13116 | 13117 | 13118 | 13119 | 13120 | 13121 | 13122 | 13123 | 13124 | 13125 | 13126 | 13127 | 13128 | 13129 | 13130 |
| H-71 | 13270 | 13271 | 13272 | 13273 | 13274 | 13275 | 13276 | 13277 | 13278 | 13279 | 13280 | 13281 | 13282 | 13283 | 13284 |
| H-72 | 13423 | 13424 | 13425 | 13426 | 13427 | 13428 | 13429 | 13430 | 13431 | 13432 | 13433 | 13434 | 13435 | 13436 | 13437 |
| H-73 | 13575 | 13576 | 13577 | 13578 | 13579 | 13580 | 13581 | 13582 | 13583 | 13584 | 13585 | 13586 | 13587 | 13588 | 13589 |
| H-74 | 13726 | 13727 | 13728 | 13729 | 13730 | 13731 | 13732 | 13733 | 13734 | 13735 | 13736 | 13737 | 13738 | 13739 | 13740 |
| H-75 | 13876 | 13877 | 13878 | 13879 | 13880 | 13881 | 13882 | 13883 | 13884 | 13885 | 13886 | 13887 | 13888 | 13889 | 13890 |
| H-76 | - | 14026 | 14027 | 14028 | 14029 | 14030 | 14031 | 14032 | 14033 | 14034 | 14035 | 14036 | 14037 | 14038 | 14039 |
| H-77 | 14026 | - | 14175 | 14176 | 14177 | 14178 | 14179 | 14180 | 14181 | 14182 | 14183 | 14184 | 14185 | 14186 | 14187 |
| H-78 | 14027 | 14175 | - | 14323 | 14324 | 14325 | 14326 | 14327 | 14328 | 14329 | 14330 | 14331 | 14332 | 14333 | 14334 |
| H-79 | 14028 | 14176 | 14323 | - | 14470 | 14471 | 14472 | 14473 | 14474 | 14475 | 14476 | 14477 | 14478 | 14479 | 14480 |
| H-80 | 14029 | 14177 | 14324 | 14470 | - | 14616 | 14617 | 14618 | 14619 | 14620 | 14621 | 14622 | 14623 | 14624 | 14625 |

(continued)

| | H-76 | H-77 | H-78 | H-79 | H-80 | H-81 | H-82 | H-83 | H-84 | H-85 | H-86 | H-87 | H-88 | H-89 | H-90 |
|---|---|---|---|---|---|---|---|---|---|---|---|---|---|---|---|
| H-81 | 14030 | 14178 | 14325 | 14471 | 14616 | - | 14761 | 14762 | 14763 | 14764 | 14765 | 14766 | 14767 | 14768 | 14769 |
| H-82 | 14031 | 14179 | 14326 | 14472 | 14617 | 14761 | - | 14905 | 14906 | 14907 | 14908 | 14909 | 14910 | 14911 | 14912 |
| H-83 | 14032 | 14180 | 14327 | 14473 | 14618 | 14762 | 14905 | - | 15048 | 15049 | 15050 | 15051 | 15052 | 15053 | 15054 |
| H-84 | 14033 | 14181 | 14328 | 14474 | 14619 | 14763 | 14906 | 15048 | - | 15190 | 15191 | 15192 | 15193 | 15194 | 15195 |
| H-85 | 14034 | 14182 | 14329 | 14475 | 14620 | 14764 | 14907 | 15049 | 15190 | - | 15331 | 15332 | 15333 | 15334 | 15335 |
| H-86 | 14035 | 14183 | 14330 | 14476 | 14621 | 14765 | 14908 | 15050 | 15191 | 15331 | - | 15471 | 15472 | 15473 | 15474 |
| H-87 | 14036 | 14184 | 14331 | 14477 | 14622 | 14766 | 14909 | 15051 | 15192 | 15332 | 15471 | - | 15610 | 15611 | 15612 |
| H-88 | 14037 | 14185 | 14332 | 14478 | 14623 | 14767 | 14910 | 15052 | 15193 | 15333 | 15472 | 15610 | - | 15748 | 15749 |
| H-89 | 14038 | 14186 | 14333 | 14479 | 14624 | 14768 | 14911 | 15053 | 15194 | 15334 | 15473 | 15611 | 15748 | - | 15885 |
| H-90 | 14039 | 14187 | 14334 | 14480 | 14625 | 14769 | 14912 | 15054 | 15195 | 15335 | 15474 | 15612 | 15749 | 15885 | - |
| H-91 | 14040 | 14188 | 14335 | 14481 | 14626 | 14770 | 14913 | 15055 | 15196 | 15336 | 15475 | 15613 | 15750 | 15886 | 16021 |
| H-92 | 14041 | 14189 | 14336 | 14482 | 14627 | 14771 | 14914 | 15056 | 15197 | 15337 | 15476 | 15614 | 15751 | 15887 | 16022 |
| H-93 | 14042 | 14190 | 14337 | 14483 | 14628 | 14772 | 14915 | 15057 | 15198 | 15338 | 15477 | 15615 | 15752 | 15888 | 16023 |
| H-94 | 14043 | 14191 | 14338 | 14484 | 14629 | 14773 | 14916 | 15058 | 15199 | 15339 | 15478 | 15616 | 15753 | 15889 | 16024 |
| H-95 | 14044 | 14192 | 14339 | 14485 | 14630 | 14774 | 14917 | 15059 | 15200 | 15340 | 15479 | 15617 | 15754 | 15890 | 16025 |
| H-96 | 14045 | 14193 | 14340 | 14486 | 14631 | 14775 | 14918 | 15060 | 15201 | 15341 | 15480 | 15618 | 15755 | 15891 | 16026 |
| H-97 | 14046 | 14194 | 14341 | 14487 | 14632 | 14776 | 14919 | 15061 | 15202 | 15342 | 15481 | 15619 | 15756 | 15892 | 16027 |
| H-98 | 14047 | 14195 | 14342 | 14488 | 14633 | 14777 | 14920 | 15062 | 15203 | 15343 | 15482 | 15620 | 15757 | 15893 | 16028 |
| H-99 | 14048 | 14196 | 14343 | 14489 | 14634 | 14778 | 14921 | 15063 | 15204 | 15344 | 15483 | 15621 | 15758 | 15894 | 16029 |
| H-100 | 14049 | 14197 | 14344 | 14490 | 14635 | 14779 | 14922 | 15064 | 15205 | 15345 | 15484 | 15622 | 15759 | 15895 | 16030 |
| H-101 | 14050 | 14198 | 14345 | 14491 | 14636 | 14780 | 14923 | 15065 | 15206 | 15346 | 15485 | 15623 | 15760 | 15896 | 16031 |
| H-102 | 14051 | 14199 | 14346 | 14492 | 14637 | 14781 | 14924 | 15066 | 15207 | 15347 | 15486 | 15624 | 15761 | 15897 | 16032 |
| H-103 | 14052 | 14200 | 14347 | 14493 | 14638 | 14782 | 14925 | 15067 | 15208 | 15348 | 15487 | 15625 | 15762 | 15898 | 16033 |
| H-104 | 14053 | 14201 | 14348 | 14494 | 14639 | 14783 | 14926 | 15068 | 15209 | 15349 | 15488 | 15626 | 15763 | 15899 | 16034 |
| H-105 | 14054 | 14202 | 14349 | 14495 | 14640 | 14784 | 14927 | 15069 | 15210 | 15350 | 15489 | 15627 | 15764 | 15900 | 16035 |

(continued)

| | H-76 | H-77 | H-78 | H-79 | H-80 | H-81 | H-82 | H-83 | H-84 | H-85 | H-86 | H-87 | H-88 | H-89 | H-90 |
|---|---|---|---|---|---|---|---|---|---|---|---|---|---|---|---|
| H-106 | 14055 | 14203 | 14350 | 14496 | 14641 | 14785 | 14928 | 15070 | 15211 | 15351 | 15490 | 15628 | 15765 | 15901 | 16036 |
| H-107 | 14056 | 14204 | 14351 | 14497 | 14642 | 14786 | 14929 | 15071 | 15212 | 15352 | 15491 | 15629 | 15766 | 15902 | 16037 |
| H-108 | 14057 | 14205 | 14352 | 14498 | 14643 | 14787 | 14930 | 15072 | 15213 | 15353 | 15492 | 15630 | 15767 | 15903 | 16038 |
| H-109 | 14058 | 14206 | 14353 | 14499 | 14644 | 14788 | 14931 | 15073 | 15214 | 15354 | 15493 | 15631 | 15768 | 15904 | 16039 |
| H-110 | 14059 | 14207 | 14354 | 14500 | 14645 | 14789 | 14932 | 15074 | 15215 | 15355 | 15494 | 15632 | 15769 | 15905 | 16040 |

**Table 19**

| | H-91 | H-92 | H-93 | H-94 | H-95 | H-96 | H-97 | H-98 | H-99 | H-100 | H-101 | H-102 | H-103 | H-104 | H-105 |
|---|---|---|---|---|---|---|---|---|---|---|---|---|---|---|---|
| H-56 | 10870 | 10871 | 10872 | 10873 | 10874 | 10875 | 10876 | 10877 | 10878 | 10879 | 10880 | 10881 | 10882 | 10883 | 10884 |
| H-57 | 11038 | 11039 | 11040 | 11041 | 11042 | 11043 | 11044 | 11045 | 11046 | 11047 | 11048 | 11049 | 11050 | 11051 | 11052 |
| H-58 | 11205 | 11206 | 11207 | 11208 | 11209 | 11210 | 11211 | 11212 | 11213 | 11214 | 11215 | 11216 | 11217 | 11218 | 11219 |
| H-59 | 11371 | 11372 | 11373 | 11374 | 11375 | 11376 | 11377 | 11378 | 11379 | 11380 | 11381 | 11382 | 11383 | 11384 | 11385 |
| H-60 | 11536 | 11537 | 11538 | 11539 | 11540 | 11541 | 11542 | 11543 | 11544 | 11545 | 11546 | 11547 | 11548 | 11549 | 11550 |
| H-61 | 11700 | 11701 | 11702 | 11703 | 11704 | 11705 | 11706 | 11707 | 11708 | 11709 | 11710 | 11711 | 11712 | 11713 | 11714 |
| H-62 | 11863 | 11864 | 11865 | 11866 | 11867 | 11868 | 11869 | 11870 | 11871 | 11872 | 11873 | 11874 | 11875 | 11876 | 11877 |
| H-63 | 12025 | 12026 | 12027 | 12028 | 12029 | 12030 | 12031 | 12032 | 12033 | 12034 | 12035 | 12036 | 12037 | 12038 | 12039 |
| H-64 | 12186 | 12187 | 12188 | 12189 | 12190 | 12191 | 12192 | 12193 | 12194 | 12195 | 12196 | 12197 | 12198 | 12199 | 12200 |
| H-65 | 12346 | 12347 | 12348 | 12349 | 12350 | 12351 | 12352 | 12353 | 12354 | 12355 | 12356 | 12357 | 12358 | 12359 | 12360 |
| H-66 | 12505 | 12506 | 12507 | 12508 | 12509 | 12510 | 12511 | 12512 | 12513 | 12514 | 12515 | 12516 | 12517 | 12518 | 12519 |
| H-67 | 12663 | 12664 | 12665 | 12666 | 12667 | 12668 | 12669 | 12670 | 12671 | 12672 | 12673 | 12674 | 12675 | 12676 | 12677 |
| H-68 | 12820 | 12821 | 12822 | 12823 | 12824 | 12825 | 12826 | 12827 | 12828 | 12829 | 12830 | 12831 | 12832 | 12833 | 12834 |
| H-69 | 12976 | 12977 | 12978 | 12979 | 12980 | 12981 | 12982 | 12983 | 12984 | 12985 | 12986 | 12987 | 12988 | 12989 | 12990 |
| H-70 | 13131 | 13132 | 13133 | 13134 | 13135 | 13136 | 13137 | 13138 | 13139 | 13140 | 13141 | 13142 | 13143 | 13144 | 13145 |
| H-71 | 13285 | 13286 | 13287 | 13288 | 13289 | 13290 | 13291 | 13292 | 13293 | 13294 | 13295 | 13296 | 13297 | 13298 | 13299 |
| H-72 | 13438 | 13439 | 13440 | 13441 | 13442 | 13443 | 13444 | 13445 | 13446 | 13447 | 13448 | 13449 | 13450 | 13451 | 13452 |
| H-73 | 13590 | 13591 | 13592 | 13593 | 13594 | 13595 | 13596 | 13597 | 13598 | 13599 | 13600 | 13601 | 13602 | 13603 | 13604 |
| H-74 | 13741 | 13742 | 13743 | 13744 | 13745 | 13746 | 13747 | 13748 | 13749 | 13750 | 13751 | 13752 | 13753 | 13754 | 13755 |
| H-75 | 13891 | 13892 | 13893 | 13894 | 13895 | 13896 | 13897 | 13898 | 13899 | 13900 | 13901 | 13902 | 13903 | 13904 | 13905 |
| H-76 | 14040 | 14041 | 14042 | 14043 | 14044 | 14045 | 14046 | 14047 | 14048 | 14049 | 14050 | 14051 | 14052 | 14053 | 14054 |
| H-77 | 14188 | 14189 | 14190 | 14191 | 14192 | 14193 | 14194 | 14195 | 14196 | 14197 | 14198 | 14199 | 14200 | 14201 | 14202 |
| H-78 | 14335 | 14336 | 14337 | 14338 | 14339 | 14340 | 14341 | 14342 | 14343 | 14344 | 14345 | 14346 | 14347 | 14348 | 14349 |
| H-79 | 14481 | 14482 | 14483 | 14484 | 14485 | 14486 | 14487 | 14488 | 14489 | 14490 | 14491 | 14492 | 14493 | 14494 | 14495 |
| H-80 | 14626 | 14627 | 14628 | 14629 | 14630 | 14631 | 14632 | 14633 | 14634 | 14635 | 14636 | 14637 | 14638 | 14639 | 14640 |

(continued)

| | H-91 | H-92 | H-93 | H-94 | H-95 | H-96 | H-97 | H-98 | H-99 | H-100 | H-101 | H-102 | H-103 | H-104 | H-105 |
|---|---|---|---|---|---|---|---|---|---|---|---|---|---|---|---|
| H-81 | 14770 | 14771 | 14772 | 14773 | 14774 | 14775 | 14776 | 14777 | 14778 | 14779 | 14780 | 14781 | 14782 | 14783 | 14784 |
| H-82 | 14913 | 14914 | 14915 | 14916 | 14917 | 14918 | 14919 | 14920 | 14921 | 14922 | 14923 | 14924 | 14925 | 14926 | 14927 |
| H-83 | 15055 | 15056 | 15057 | 15058 | 15059 | 15060 | 15061 | 15062 | 15063 | 15064 | 15065 | 15066 | 15067 | 15068 | 15069 |
| H-84 | 15196 | 15197 | 15198 | 15199 | 15200 | 15201 | 15202 | 15203 | 15204 | 15205 | 15206 | 15207 | 15208 | 15209 | 15210 |
| H-85 | 15336 | 15337 | 15338 | 15339 | 15340 | 15341 | 15342 | 15343 | 15344 | 15345 | 15346 | 15347 | 15348 | 15349 | 15350 |
| H-86 | 15475 | 15476 | 15477 | 15478 | 15479 | 15480 | 15481 | 15482 | 15483 | 15484 | 15485 | 15486 | 15487 | 15488 | 15489 |
| H-87 | 15613 | 15614 | 15615 | 15616 | 15617 | 15618 | 15619 | 15620 | 15621 | 15622 | 15623 | 15624 | 15625 | 15626 | 15627 |
| H-88 | 15750 | 15751 | 15752 | 15753 | 15754 | 15755 | 15756 | 15757 | 15758 | 15759 | 15760 | 15761 | 15762 | 15763 | 15764 |
| H-89 | 15886 | 15887 | 15888 | 15889 | 15890 | 15891 | 15892 | 15893 | 15894 | 15895 | 15896 | 15897 | 15898 | 15899 | 15900 |
| H-90 | 16021 | 16022 | 16023 | 16024 | 16025 | 16026 | 16027 | 16028 | 16029 | 16030 | 16031 | 16032 | 16033 | 16034 | 16035 |
| H-91 | - | 16156 | 16157 | 16158 | 16159 | 16160 | 16161 | 16162 | 16163 | 16164 | 16165 | 16166 | 16167 | 16168 | 16169 |
| H-92 | 16156 | - | 16290 | 16291 | 16292 | 16293 | 16294 | 16295 | 16296 | 16297 | 16298 | 16299 | 16300 | 16301 | 16302 |
| H-93 | 16157 | 16290 | - | 16423 | 16424 | 16425 | 16426 | 16427 | 16428 | 16429 | 16430 | 16431 | 16432 | 16433 | 16434 |
| H-94 | 16158 | 16291 | 16423 | - | 16555 | 16556 | 16557 | 16558 | 16559 | 16560 | 16561 | 16562 | 16563 | 16564 | 16565 |
| H-95 | 16159 | 16292 | 16424 | 16555 | - | 16686 | 16687 | 16688 | 16689 | 16690 | 16691 | 16692 | 16693 | 16694 | 16695 |
| H-96 | 16160 | 16293 | 16425 | 16556 | 16686 | - | 16816 | 16817 | 16818 | 16819 | 16820 | 16821 | 16822 | 16823 | 16824 |
| H-97 | 16161 | 16294 | 16426 | 16557 | 16687 | 16816 | - | 16945 | 16946 | 16947 | 16948 | 16949 | 16950 | 16951 | 16952 |
| H-98 | 16162 | 16295 | 16427 | 16558 | 16688 | 16817 | 16945 | - | 17073 | 17074 | 17075 | 17076 | 17077 | 17078 | 17079 |
| H-99 | 16163 | 16296 | 16428 | 16559 | 16689 | 16818 | 16946 | 17073 | - | 17200 | 17201 | 17202 | 17203 | 17204 | 17205 |
| H-100 | 16164 | 16297 | 16429 | 16560 | 16690 | 16819 | 16947 | 17074 | 17200 | - | 17326 | 17327 | 17328 | 17329 | 17330 |
| H-101 | 16165 | 16298 | 16430 | 16561 | 16691 | 16820 | 16948 | 17075 | 17201 | 17326 | - | 17451 | 17452 | 17453 | 17454 |
| H-102 | 16166 | 16299 | 16431 | 16562 | 16692 | 16821 | 16949 | 17076 | 17202 | 17327 | 17451 | - | 17575 | 17576 | 17577 |
| H-103 | 16167 | 16300 | 16432 | 16563 | 16693 | 16822 | 16950 | 17077 | 17203 | 17328 | 17452 | 17575 | - | 17698 | 17699 |
| H-104 | 16168 | 16301 | 16433 | 16564 | 16694 | 16823 | 16951 | 17078 | 17204 | 17329 | 17453 | 17576 | 17698 | - | 17820 |
| H-105 | 16169 | 16302 | 16434 | 16565 | 16695 | 16824 | 16952 | 17079 | 17205 | 17330 | 17454 | 17577 | 17699 | 17820 | - |

(continued)

| | H-91 | H-92 | H-93 | H-94 | H-95 | H-96 | H-97 | H-98 | H-99 | H-100 | H-101 | H-102 | H-103 | H-104 | H-105 |
|---|---|---|---|---|---|---|---|---|---|---|---|---|---|---|---|
| H-106 | 16170 | 16303 | 16435 | 16566 | 16696 | 16825 | 16953 | 17080 | 17206 | 17331 | 17455 | 17578 | 17700 | 17821 | 17941 |
| H-107 | 16171 | 16304 | 16436 | 16567 | 16697 | 16826 | 16954 | 17081 | 17207 | 17332 | 17456 | 17579 | 17701 | 17822 | 17942 |
| H-108 | 16172 | 16305 | 16437 | 16568 | 16698 | 16827 | 16955 | 17082 | 17208 | 17333 | 17457 | 17580 | 17702 | 17823 | 17943 |
| H-109 | 16173 | 16306 | 16438 | 16569 | 16699 | 16828 | 16956 | 17083 | 17209 | 17334 | 17458 | 17581 | 17703 | 17824 | 17944 |
| H-110 | 16174 | 16307 | 16439 | 16570 | 16700 | 16829 | 16957 | 17084 | 17210 | 17335 | 17459 | 17582 | 17704 | 17825 | 17945 |

**Table 20**

| | H-106 | H-107 | H-108 | H-109 | H-110 | H-111 | H-112 | H-113 | H-114 | H-115 | H-116 | H-117 | H-118 | H-119 | H-120 |
|---|---|---|---|---|---|---|---|---|---|---|---|---|---|---|---|
| H-56 | 10885 | 10886 | 10887 | 10888 | 10889 | 10890 | 10891 | 10892 | 10893 | 10894 | 10895 | 10896 | 10897 | 10898 | 10899 |
| H-57 | 11053 | 11054 | 11055 | 11056 | 11057 | 11058 | 11059 | 11060 | 11061 | 11062 | 11063 | 11064 | 11065 | 11066 | 11067 |
| H-58 | 11220 | 11221 | 11222 | 11223 | 11224 | 11225 | 11226 | 11227 | 11228 | 11229 | 11230 | 11231 | 11232 | 11233 | 11234 |
| H-59 | 11386 | 11387 | 11388 | 11389 | 11390 | 11391 | 11392 | 11393 | 11394 | 11395 | 11396 | 11397 | 11398 | 11399 | 11400 |
| H-60 | 11551 | 11552 | 11553 | 11554 | 11555 | 11556 | 11557 | 11558 | 11559 | 11560 | 11561 | 11562 | 11563 | 11564 | 11565 |
| H-61 | 11715 | 11716 | 11717 | 11718 | 11719 | 11720 | 11721 | 11722 | 11723 | 11724 | 11725 | 11726 | 11727 | 11728 | 11729 |
| H-62 | 11878 | 11879 | 11880 | 11881 | 11882 | 11883 | 11884 | 11885 | 11886 | 11887 | 11888 | 11889 | 11890 | 11891 | 11892 |
| H-63 | 12040 | 12041 | 12042 | 12043 | 12044 | 12045 | 12046 | 12047 | 12048 | 12049 | 12050 | 12051 | 12052 | 12053 | 12054 |
| H-64 | 12201 | 12202 | 12203 | 12204 | 12205 | 12206 | 12207 | 12208 | 12209 | 12210 | 12211 | 12212 | 12213 | 12214 | 12215 |
| H-65 | 12361 | 12362 | 12363 | 12364 | 12365 | 12366 | 12367 | 12368 | 12369 | 12370 | 12371 | 12372 | 12373 | 12374 | 12375 |
| H-66 | 12520 | 12521 | 12522 | 12523 | 12524 | 12525 | 12526 | 12527 | 12528 | 12529 | 12530 | 12531 | 12532 | 12533 | 12534 |
| H-67 | 12678 | 12679 | 12680 | 12681 | 12682 | 12683 | 12684 | 12685 | 12686 | 12687 | 12688 | 12689 | 12690 | 12691 | 12692 |
| H-68 | 12835 | 12836 | 12837 | 12838 | 12839 | 12840 | 12841 | 12842 | 12843 | 12844 | 12845 | 12846 | 12847 | 12848 | 12849 |
| H-69 | 12991 | 12992 | 12993 | 12994 | 12995 | 12996 | 12997 | 12998 | 12999 | 13000 | 13001 | 13002 | 13003 | 13004 | 13005 |
| H-70 | 13146 | 13147 | 13148 | 13149 | 13150 | 13151 | 13152 | 13153 | 13154 | 13155 | 13156 | 13157 | 13158 | 13159 | 13160 |
| H-71 | 13300 | 13301 | 13302 | 13303 | 13304 | 13305 | 13306 | 13307 | 13308 | 13309 | 13310 | 13311 | 13312 | 13313 | 13314 |
| H-72 | 13453 | 13454 | 13455 | 13456 | 13457 | 13458 | 13459 | 13460 | 13461 | 13462 | 13463 | 13464 | 13465 | 13466 | 13467 |
| H-73 | 13605 | 13606 | 13607 | 13608 | 13609 | 13610 | 13611 | 13612 | 13613 | 13614 | 13615 | 13616 | 13617 | 13618 | 13619 |
| H-74 | 13756 | 13757 | 13758 | 13759 | 13760 | 13761 | 13762 | 13763 | 13764 | 13765 | 13766 | 13767 | 13768 | 13769 | 13770 |
| H-75 | 13906 | 13907 | 13908 | 13909 | 13910 | 13911 | 13912 | 13913 | 13914 | 13915 | 13916 | 13917 | 13918 | 13919 | 13920 |
| H-76 | 14055 | 14056 | 14057 | 14058 | 14059 | 14060 | 14061 | 14062 | 14063 | 14064 | 14065 | 14066 | 14067 | 14068 | 14069 |
| H-77 | 14203 | 14204 | 14205 | 14206 | 14207 | 14208 | 14209 | 14210 | 14211 | 14212 | 14213 | 14214 | 14215 | 14216 | 14217 |
| H-78 | 14350 | 14351 | 14352 | 14353 | 14354 | 14355 | 14356 | 14357 | 14358 | 14359 | 14360 | 14361 | 14362 | 14363 | 14364 |
| H-79 | 14496 | 14497 | 14498 | 14499 | 14500 | 14501 | 14502 | 14503 | 14504 | 14505 | 14506 | 14507 | 14508 | 14509 | 14510 |
| H-80 | 14641 | 14642 | 14643 | 14644 | 14645 | 14646 | 14647 | 14648 | 14649 | 14650 | 14651 | 14652 | 14653 | 14654 | 14655 |

(continued)

| | H-106 | H-107 | H-108 | H-109 | H-110 | H-111 | H-112 | H-113 | H-114 | H-115 | H-116 | H-117 | H-118 | H-119 | H-120 |
|---|---|---|---|---|---|---|---|---|---|---|---|---|---|---|---|
| H-81 | 14785 | 14786 | 14787 | 14788 | 14789 | 14790 | 14791 | 14792 | 14793 | 14794 | 14795 | 14796 | 14797 | 14798 | 14799 |
| H-82 | 14928 | 14929 | 14930 | 14931 | 14932 | 14933 | 14934 | 14935 | 14936 | 14937 | 14938 | 14939 | 14940 | 14941 | 14942 |
| H-83 | 15070 | 15071 | 15072 | 15073 | 15074 | 15075 | 15076 | 15077 | 15078 | 15079 | 15080 | 15081 | 15082 | 15083 | 15084 |
| H-84 | 15211 | 15212 | 15213 | 15214 | 15215 | 15216 | 15217 | 15218 | 15219 | 15220 | 15221 | 15222 | 15223 | 15224 | 15225 |
| H-85 | 15351 | 15352 | 15353 | 15354 | 15355 | 15356 | 15357 | 15358 | 15359 | 15360 | 15361 | 15362 | 15363 | 15364 | 15365 |
| H-86 | 15490 | 15491 | 15492 | 15493 | 15494 | 15495 | 15496 | 15497 | 15498 | 15499 | 15500 | 15501 | 15502 | 15503 | 15504 |
| H-87 | 15628 | 15629 | 15630 | 15631 | 15632 | 15633 | 15634 | 15635 | 15636 | 15637 | 15638 | 15639 | 15640 | 15641 | 15642 |
| H-88 | 15765 | 15766 | 15767 | 15768 | 15769 | 15770 | 15771 | 15772 | 15773 | 15774 | 15775 | 15776 | 15777 | 15778 | 15779 |
| H-89 | 15901 | 15902 | 15903 | 15904 | 15905 | 15906 | 15907 | 15908 | 15909 | 15910 | 15911 | 15912 | 15913 | 15914 | 15915 |
| H-90 | 16036 | 16037 | 16038 | 16039 | 16040 | 16041 | 16042 | 16043 | 16044 | 16045 | 16046 | 16047 | 16048 | 16049 | 16050 |
| H-91 | 16170 | 16171 | 16172 | 16173 | 16174 | 16175 | 16176 | 16177 | 16178 | 16179 | 16180 | 16181 | 16182 | 16183 | 16184 |
| H-92 | 16303 | 16304 | 16305 | 16306 | 16307 | 16308 | 16309 | 16310 | 16311 | 16312 | 16313 | 16314 | 16315 | 16316 | 16317 |
| H-93 | 16435 | 16436 | 16437 | 16438 | 16439 | 16440 | 16441 | 16442 | 16443 | 16444 | 16445 | 16446 | 16447 | 16448 | 16449 |
| H-94 | 16566 | 16567 | 16568 | 16569 | 16570 | 16571 | 16572 | 16573 | 16574 | 16575 | 16576 | 16577 | 16578 | 16579 | 16580 |
| H-95 | 16696 | 16697 | 16698 | 16699 | 16700 | 16701 | 16702 | 16703 | 16704 | 16705 | 16706 | 16707 | 16708 | 16709 | 16710 |
| H-96 | 16825 | 16826 | 16827 | 16828 | 16829 | 16830 | 16831 | 16832 | 16833 | 16834 | 16835 | 16836 | 16837 | 16838 | 16839 |
| H-97 | 16953 | 16954 | 16955 | 16956 | 16957 | 16958 | 16959 | 16960 | 16961 | 16962 | 16963 | 16964 | 16965 | 16966 | 16967 |
| H-98 | 17080 | 17081 | 17082 | 17083 | 17084 | 17085 | 17086 | 17087 | 17088 | 17089 | 17090 | 17091 | 17092 | 17093 | 17094 |
| H-99 | 17206 | 17207 | 17208 | 17209 | 17210 | 17211 | 17212 | 17213 | 17214 | 17215 | 17216 | 17217 | 17218 | 17219 | 17220 . |
| H-100 | 17331 | 17332 | 17333 | 17334 | 17335 | 17336 | 17337 | 17338 | 17339 | 17340 | 17341 | 17342 | 17343 | 17344 | 17345 |
| H-101 | 17455 | 17456 | 17457 | 17458 | 17459 | 17460 | 17461 | 17462 | 17463 | 17464 | 17465 | 17466 | 17467 | 17468 | 17469 |
| H-102 | 17578 | 17579 | 17580 | 17581 | 17582 | 17583 | 17584 | 17585 | 17586 | 17587 | 17588 | 17589 | 17590 | 17591 | 17592 |
| H-103 | 17700 | 17701 | 17702 | 17703 | 17704 | 17705 | 17706 | 17707 | 17708 | 17709 | 17710 | 17711 | 17712 | 17713 | 17714 |
| H-104 | 17821 | 17822 | 17823 | 17824 | 17825 | 17826 | 17827 | 17828 | 17829 | 17830 | 17831 | 17832 | 17833 | 17834 | 17835 |
| H-105 | 17941 | 17942 | 17943 | 17944 | 17945 | 17946 | 17947 | 17948 | 17949 | 17950 | 17951 | 17952 | 17953 | 17954 | 17955 |

(continued)

| | H-106 | H-107 | H-108 | H-109 | H-110 | H-111 | H-112 | H-113 | H-114 | H-115 | H-116 | H-117 | H-118 | H-119 | H-120 |
|---|---|---|---|---|---|---|---|---|---|---|---|---|---|---|---|
| H-106 | - | 18061 | 18062 | 18063 | 18064 | 18065 | 18066 | 18067 | 18068 | 18069 | 18070 | 18071 | 18072 | 18073 | 18074 |
| H-107 | 18061 | - | 18180 | 18181 | 18182 | 18183 | 18184 | 18185 | 18186 | 18187 | 18188 | 18189 | 18190 | 18191 | 18192 |
| H-108 | 18062 | 18180 | - | 18298 | 18299 | 18300 | 18301 | 18302 | 18303 | 18304 | 18305 | 18306 | 18307 | 18308 | 18309 |
| H-109 | 18063 | 18181 | 18298 | - | 18415 | 18416 | 18417 | 18418 | 18419 | 18420 | 18421 | 18422 | 18423 | 18424 | 18425 |
| H-110 | 18064 | 18182 | 18299 | 18415 | - | 18531 | 18532 | 18533 | 18534 | 18535 | 18536 | 18537 | 18538 | 18539 | 18540 |

**Table 21**

| | H-121 | H-122 | H-123 | H-124 | H-125 | H-126 | H-127 | H-128 | H-129 | H-130 | H-131 | H-132 | H-133 | H-134 | H-135 |
|---|---|---|---|---|---|---|---|---|---|---|---|---|---|---|---|
| H-56 | 10900 | 10901 | 10902 | 10903 | 10904 | 10905 | 10906 | 10907 | 10908 | 10909 | 10910 | 10911 | 10912 | 10913 | 10914 |
| H-57 | 11068 | 11069 | 11070 | 11071 | 11072 | 11073 | 11074 | 11075 | 11076 | 11077 | 11078 | 11079 | 11080 | 11081 | 11082 |
| H-58 | 11235 | 11236 | 11237 | 11238 | 11239 | 11240 | 11241 | 11242 | 11243 | 11244 | 11245 | 11246 | 11247 | 11248 | 11249 |
| H-59 | 11401 | 11402 | 11403 | 11404 | 11405 | 11406 | 11407 | 11408 | 11409 | 11410 | 11411 | 11412 | 11413 | 11414 | 11415 |
| H-60 | 11566 | 11567 | 11568 | 11569 | 11570 | 11571 | 11572 | 11573 | 11574 | 11575 | 11576 | 11577 | 11578 | 11579 | 11580 |
| H-61 | 11730 | 11731 | 11732 | 11733 | 11734 | 11735 | 11736 | 11737 | 11738 | 11739 | 11740 | 11741 | 11742 | 11743 | 11744 |
| H-62 | 11893 | 11894 | 11895 | 11896 | 11897 | 11898 | 11899 | 11900 | 11901 | 11902 | 11903 | 11904 | 11905 | 11906 | 11907 |
| H-63 | 12055 | 12056 | 12057 | 12058 | 12059 | 12060 | 12061 | 12062 | 12063 | 12064 | 12065 | 12066 | 12067 | 12068 | 12069 |
| H-64 | 12216 | 12217 | 12218 | 12219 | 12220 | 12221 | 12222 | 12223 | 12224 | 12225 | 12226 | 12227 | 12228 | 12229 | 12230 |
| H-65 | 12376 | 12377 | 12378 | 12379 | 12380 | 12381 | 12382 | 12383 | 12384 | 12385 | 12386 | 12387 | 12388 | 12389 | 12390 |
| H-66 | 12535 | 12536 | 12537 | 12538 | 12539 | 12540 | 12541 | 12542 | 12543 | 12544 | 12545 | 12546 | 12547 | 12548 | 12549 |
| H-67 | 12693 | 12694 | 12695 | 12696 | 12697 | 12698 | 12699 | 12700 | 12701 | 12702 | 12703 | 12704 | 12705 | 12706 | 12707 |
| H-68 | 12850 | 12851 | 12852 | 12853 | 12854 | 12855 | 12856 | 12857 | 12858 | 12859 | 12860 | 12861 | 12862 | 12863 | 12864 |
| H-69 | 13006 | 13007 | 13008 | 13009 | 13010 | 13011 | 13012 | 13013 | 13014 | 13015 | 13016 | 13017 | 13018 | 13019 | 13020 |
| H-70 | 13161 | 13162 | 13163 | 13164 | 13165 | 13166 | 13167 | 13168 | 13169 | 13170 | 13171 | 13172 | 13173 | 13174 | 13175 |
| H-71 | 13315 | 13316 | 13317 | 13318 | 13319 | 13320 | 13321 | 13322 | 13323 | 13324 | 13325 | 13326 | 13327 | 13328 | 13329 |
| H-72 | 13468 | 13469 | 13470 | 13471 | 13472 | 13473 | 13474 | 13475 | 13476 | 13477 | 13478 | 13479 | 13480 | 13481 | 13482 |
| H-73 | 13620 | 13621 | 13622 | 13623 | 13624 | 13625 | 13626 | 13627 | 13628 | 13629 | 13630 | 13631 | 13632 | 13633 | 13634 |
| H-74 | 13771 | 13772 | 13773 | 13774 | 13775 | 13776 | 13777 | 13778 | 13779 | 13780 | 13781 | 13782 | 13783 | 13784 | 13785 |
| H-75 | 13921 | 13922 | 13923 | 13924 | 13925 | 13926 | 13927 | 13928 | 13929 | 13930 | 13931 | 13932 | 13933 | 13934 | 13935 |
| H-76 | 14070 | 14071 | 14072 | 14073 | 14074 | 14075 | 14076 | 14077 | 14078 | 14079 | 14080 | 14081 | 14082 | 14083 | 14084 |
| H-77 | 14218 | 14219 | 14220 | 14221 | 14222 | 14223 | 14224 | 14225 | 14226 | 14227 | 14228 | 14229 | 14230 | 14231 | 14232 |
| H-78 | 14365 | 14366 | 14367 | 14368 | 14369 | 14370 | 14371 | 14372 | 14373 | 14374 | 14375 | 14376 | 14377 | 14378 | 14379 |
| H-79 | 14511 | 14512 | 14513 | 14514 | 14515 | 14516 | 14517 | 14518 | 14519 | 14520 | 14521 | 14522 | 14523 | 14524 | 14525 |
| H-80 | 14656 | 14657 | 14658 | 14659 | 14660 | 14661 | 14662 | 14663 | 14664 | 14665 | 14666 | 14667 | 14668 | 14669 | 14670 |

(continued)

| | H-121 | H-122 | H-123 | H-124 | H-125 | H-126 | H-127 | H-128 | H-129 | H-130 | H-131 | H-132 | H-133 | H-134 | H-135 |
|---|---|---|---|---|---|---|---|---|---|---|---|---|---|---|---|
| H-81 | 14800 | 14801 | 14802 | 14803 | 14804 | 14805 | 14806 | 14807 | 14808 | 14809 | 14810 | 14811 | 14812 | 14813 | 14814 |
| H-82 | 14943 | 14944 | 14945 | 14946 | 14947 | 14948 | 14949 | 14950 | 14951 | 14952 | 14953 | 14954 | 14955 | 14956 | 14957 |
| H-83 | 15085 | 15086 | 15087 | 15088 | 15089 | 15090 | 15091 | 15092 | 15093 | 15094 | 15095 | 15096 | 15097 | 15098 | 15099 |
| H-84 | 15226 | 15227 | 15228 | 15229 | 15230 | 15231 | 15232 | 15233 | 15234 | 15235 | 15236 | 15237 | 15238 | 15239 | 15240 |
| H-85 | 15366 | 15367 | 15368 | 15369 | 15370 | 15371 | 15372 | 15373 | 15374 | 15375 | 15376 | 15377 | 15378 | 15379 | 15380 |
| H-86 | 15505 | 15506 | 15507 | 15508 | 15509 | 15510 | 15511 | 15512 | 15513 | 15514 | 15515 | 15516 | 15517 | 15518 | 15519 |
| H-87 | 15643 | 15644 | 15645 | 15646 | 15647 | 15648 | 15649 | 15650 | 15651 | 15652 | 15653 | 15654 | 15655 | 15656 | 15657 |
| H-88 | 15780 | 15781 | 15782 | 15783 | 15784 | 15785 | 15786 | 15787 | 15788 | 15789 | 15790 | 15791 | 15792 | 15793 | 15794 |
| H-89 | 15916 | 15917 | 15918 | 15919 | 15920 | 15921 | 15922 | 15923 | 15924 | 15925 | 15926 | 15927 | 15928 | 15929 | 15930 |
| H-90 | 16051 | 16052 | 16053 | 16054 | 16055 | 16056 | 16057 | 16058 | 16059 | 16060 | 16061 | 16062 | 16063 | 16064 | 16065 |
| H-91 | 16185 | 16186 | 16187 | 16188 | 16189 | 16190 | 16191 | 16192 | 16193 | 16194 | 16195 | 16196 | 16197 | 16198 | 16199 |
| H-92 | 16318 | 16319 | 16320 | 16321 | 16322 | 16323 | 16324 | 16325 | 16326 | 16327 | 16328 | 16329 | 16330 | 16331 | 16332 |
| H-93 | 16450 | 16451 | 16452 | 16453 | 16454 | 16455 | 16456 | 16457 | 16458 | 16459 | 16460 | 16461 | 16462 | 16463 | 16464 |
| H-94 | 16581 | 16582 | 16583 | 16584 | 16585 | 16586 | 16587 | 16588 | 16589 | 16590 | 16591 | 16592 | 16593 | 16594 | 16595 |
| H-95 | 16711 | 16712 | 16713 | 16714 | 16715 | 16716 | 16717 | 16718 | 16719 | 16720 | 16721 | 16722 | 16723 | 16724 | 16725 |
| H-96 | 16840 | 16841 | 16842 | 16843 | 16844 | 16845 | 16846 | 16847 | 16848 | 16849 | 16850 | 16851 | 16852 | 16853 | 16854 |
| H-97 | 16968 | 16969 | 16970 | 16971 | 16972 | 16973 | 16974 | 16975 | 16976 | 16977 | 16978 | 16979 | 16980 | 16981 | 16982 |
| H-98 | 17095 | 17096 | 17097 | 17098 | 17099 | 17100 | 17101 | 17102 | 17103 | 17104 | 17105 | 17106 | 17107 | 17108 | 17109 |
| H-99 | 17221 | 17222 | 17223 | 17224 | 17225 | 17226 | 17227 | 17228 | 17229 | 17230 | 17231 | 17232 | 17233 | 17234 | 17235 |
| H-100 | 17346 | 17347 | 17348 | 17349 | 17350 | 17351 | 17352 | 17353 | 17354 | 17355 | 17356 | 17357 | 17358 | 17359 | 17360 |
| H-101 | 17470 | 17471 | 17472 | 17473 | 17474 | 17475 | 17476 | 17477 | 17478 | 17479 | 17480 | 17481 | 17482 | 17483 | 17484 |
| H-102 | 17593 | 17594 | 17595 | 17596 | 17597 | 17598 | 17599 | 17600 | 17601 | 17602 | 17603 | 17604 | 17605 | 17606 | 17607 |
| H-103 | 17715 | 17716 | 17717 | 17718 | 17719 | 17720 | 17721 | 17722 | 17723 | 17724 | 17725 | 17726 | 17727 | 17728 | 17729 |
| H-104 | 17836 | 17837 | 17838 | 17839 | 17840 | 17841 | 17842 | 17843 | 17844 | 17845 | 17846 | 17847 | 17848 | 17849 | 17850 |
| H-105 | 17956 | 17957 | 17958 | 17959 | 17960 | 17961 | 17962 | 17963 | 17964 | 17965 | 17966 | 17967 | 17968 | 17969 | 17970 |

(continued)

| | H-121 | H-122 | H-123 | H-124 | H-125 | H-126 | H-127 | H-128 | H-129 | H-130 | H-131 | H-132 | H-133 | H-134 | H-135 |
|---|---|---|---|---|---|---|---|---|---|---|---|---|---|---|---|
| H-106 | 18075 | 18076 | 18077 | 18078 | 18079 | 18080 | 18081 | 18082 | 18083 | 18084 | 18085 | 18086 | 18087 | 18088 | 18089 |
| H-107 | 18193 | 18194 | 18195 | 18196 | 18197 | 18198 | 18199 | 18200 | 18201 | 18202 | 18203 | 18204 | 18205 | 18206 | 18207 |
| H-108 | 18310 | 18311 | 18312 | 18313 | 18314 | 18315 | 18316 | 18317 | 18318 | 18319 | 18320 | 18321 | 18322 | 18323 | 18324 |
| H-109 | 18426 | 18427 | 18428 | 18429 | 18430 | 18431 | 18432 | 18433 | 18434 | 18435 | 18436 | 18437 | 18438 | 18439 | 18440 |
| H-110 | 18541 | 18542 | 18543 | 18544 | 18545 | 18546 | 18547 | 18548 | 18549 | 18550 | 18551 | 18552 | 18553 | 18554 | 18555 |

**Table 22**

| | H-136 | H-137 | H-138 | H-139 | H-140 | H-141 | H-142 | H-143 | H-144 | H-145 | H-146 | H-147 | H-148 | H-149 | H-150 |
|---|---|---|---|---|---|---|---|---|---|---|---|---|---|---|---|
| H-56 | 10915 | 10916 | 10917 | 10918 | 10919 | 10920 | 10921 | 10922 | 10923 | 10924 | 10925 | 10926 | 10927 | 10928 | 10929 |
| H-57 | 11083 | 11084 | 11085 | 11086 | 11087 | 11088 | 11089 | 11090 | 11091 | 11092 | 11093 | 11094 | 11095 | 11096 | 11097 |
| H-58 | 11250 | 11251 | 11252 | 11253 | 11254 | 11255 | 11256 | 11257 | 11258 | 11259 | 11260 | 11261 | 11262 | 11263 | 11264 |
| H-59 | 11416 | 11417 | 11418 | 11419 | 11420 | 11421 | 11422 | 11423 | 11424 | 11425 | 11426 | 11427 | 11428 | 11429 | 11430 |
| H-60 | 11581 | 11582 | 11583 | 11584 | 11585 | 11586 | 11587 | 11588 | 11589 | 11590 | 11591 | 11592 | 11593 | 11594 | 11595 |
| H-61 | 11745 | 11746 | 11747 | 11748 | 11749 | 11750 | 11751 | 11752 | 11753 | 11754 | 11755 | 11756 | 11757 | 11758 | 11759 |
| H-62 | 11908 | 11909 | 11910 | 11911 | 11912 | 11913 | 11914 | 11915 | 11916 | 11917 | 11918 | 11919 | 11920 | 11921 | 11922 |
| H-63 | 12070 | 12071 | 12072 | 12073 | 12074 | 12075 | 12076 | 12077 | 12078 | 12079 | 12080 | 12081 | 12082 | 12083 | 12084 |
| H-64 | 12231 | 12232 | 12233 | 12234 | 12235 | 12236 | 12237 | 12238 | 12239 | 12240 | 12241 | 12242 | 12243 | 12244 | 12245 |
| H-65 | 12391 | 12392 | 12393 | 12394 | 12395 | 12396 | 12397 | 12398 | 12399 | 12400 | 12401 | 12402 | 12403 | 12404 | 12405 |
| H-66 | 12550 | 12551 | 12552 | 12553 | 12554 | 12555 | 12556 | 12557 | 12558 | 12559 | 12560 | 12561 | 12562 | 12563 | 12564 |
| H-67 | 12708 | 12709 | 12710 | 12711 | 12712 | 12713 | 12714 | 12715 | 12716 | 12717 | 12718 | 12719 | 12720 | 12721 | 12722 |
| H-68 | 12865 | 12866 | 12867 | 12868 | 12869 | 12870 | 12871 | 12872 | 12873 | 12874 | 12875 | 12876 | 12877 | 12878 | 12879 |
| H-69 | 13021 | 13022 | 13023 | 13024 | 13025 | 13026 | 13027 | 13028 | 13029 | 13030 | 13031 | 13032 | 13033 | 13034 | 13035 |
| H-70 | 13176 | 13177 | 13178 | 13179 | 13180 | 13181 | 13182 | 13183 | 13184 | 13185 | 13186 | 13187 | 13188 | 13189 | 13190 |
| H-71 | 13330 | 13331 | 13332 | 13333 | 13334 | 13335 | 13336 | 13337 | 13338 | 13339 | 13340 | 13341 | 13342 | 13343 | 13344 |
| H-72 | 13483 | 13484 | 13485 | 13486 | 13487 | 13488 | 13489 | 13490 | 13491 | 13492 | 13493 | 13494 | 13495 | 13496 | 13497 |
| H-73 | 13635 | 13636 | 13637 | 13638 | 13639 | 13640 | 13641 | 13642 | 13643 | 13644 | 13645 | 13646 | 13647 | 13648 | 13649 |
| H-74 | 13786 | 13787 | 13788 | 13789 | 13790 | 13791 | 13792 | 13793 | 13794 | 13795 | 13796 | 13797 | 13798 | 13799 | 13800 |
| H-75 | 13936 | 13937 | 13938 | 13939 | 13940 | 13941 | 13942 | 13943 | 13944 | 13945 | 13946 | 13947 | 13948 | 13949 | 13950 |
| H-76 | 14085 | 14086 | 14087 | 14088 | 14089 | 14090 | 14091 | 14092 | 14093 | 14094 | 14095 | 14096 | 14097 | 14098 | 14099 |
| H-77 | 14233 | 14234 | 14235 | 14236 | 14237 | 14238 | 14239 | 14240 | 14241 | 14242 | 14243 | 14244 | 14245 | 14246 | 14247 |
| H-78 | 14380 | 14381 | 14382 | 14383 | 14384 | 14385 | 14386 | 14387 | 14388 | 14389 | 14390 | 14391 | 14392 | 14393 | 14394 |
| H-79 | 14526 | 14527 | 14528 | 14529 | 14530 | 14531 | 14532 | 14533 | 14534 | 14535 | 14536 | 14537 | 14538 | 14539 | 14540 |
| H-80 | 14671 | 14672 | 14673 | 14674 | 14675 | 14676 | 14677 | 14678 | 14679 | 14680 | 14681 | 14682 | 14683 | 14684 | 14685 |

(continued)

| | H-136 | H-137 | H-138 | H-139 | H-140 | H-141 | H-142 | H-143 | H-144 | H-145 | H-146 | H-147 | H-148 | H-149 | H-150 |
|---|---|---|---|---|---|---|---|---|---|---|---|---|---|---|---|
| H-81 | 14815 | 14816 | 14817 | 14818 | 14819 | 14820 | 14821 | 14822 | 14823 | 14824 | 14825 | 14826 | 14827 | 14826 | 14829 |
| H-82 | 14958 | 14959 | 14960 | 14961 | 14962 | 14963 | 14964 | 14965 | 14966 | 14957 | 14968 | 14969 | 14970 | 14971 | 14972 |
| H-83 | 15100 | 15101 | 15102 | 15103 | 15104 | 15105 | 15106 | 15107 | 15108 | 15109 | 15110 | 15111 | 15112 | 15113 | 15114 |
| H-84 | 15241 | 15242 | 15243 | 15244 | 15245 | 15246 | 15247 | 15248 | 15249 | 15250 | 15251 | 15252 | 15253 | 15254 | 15255 |
| H-85 | 15381 | 15382 | 15383 | 15384 | 15385 | 15386 | 15387 | 15388 | 15389 | 15390 | 15391 | 15392 | 15393 | 15394 | 15395 |
| H-86 | 15520 | 15521 | 15522 | 15523 | 15524 | 15525 | 15526 | 15527 | 15528 | 15529 | 15530 | 15531 | 15532 | 15533 | 15534 |
| H-87 | 15658 | 15659 | 15660 | 15661 | 15662 | 15663 | 15664 | 15665 | 15666 | 15667 | 15668 | 15669 | 15670 | 15671 | 15672 |
| H-88 | 15795 | 15796 | 15797 | 15798 | 15799 | 15800 | 15801 | 15802 | 15803 | 15804 | 15805 | 15806 | 15807 | 15808 | 15809 |
| H-89 | 15931 | 15932 | 15933 | 15934 | 15935 | 15936 | 15937 | 15938 | 15939 | 15940 | 15941 | 15942 | 15943 | 15944 | 15945 |
| H-90 | 16066 | 16067 | 16068 | 16069 | 16070 | 16071 | 16072 | 16073 | 16074 | 16075 | 16076 | 16077 | 16078 | 16079 | 16080 |
| H-91 | 16200 | 16201 | 16202 | 16203 | 16204 | 16205 | 16206 | 16207 | 16208 | 16209 | 16210 | 16211 | 16212 | 16213 | 16214 |
| H-92 | 16333 | 16334 | 16335 | 16336 | 16337 | 16338 | 16339 | 16340 | 16341 | 16342 | 16343 | 16344 | 16345 | 16346 | 16347 |
| H-93 | 16465 | 16466 | 16467 | 16468 | 16469 | 16470 | 16471 | 16472 | 16473 | 16474 | 16475 | 16476 | 16477 | 16478 | 16479 |
| H-94 | 16596 | 16597 | 16598 | 16599 | 16600 | 16601 | 16602 | 16603 | 16604 | 16605 | 16606 | 16607 | 16608 | 16609 | 16610 |
| H-95 | 16726 | 16727 | 16728 | 16729 | 16730 | 16731 | 16732 | 16733 | 16734 | 16735 | 16736 | 16737 | 16738 | 16739 | 16740 |
| H-96 | 16855 | 16856 | 16857 | 16858 | 16859 | 16860 | 16861 | 16862 | 16863 | 16864 | 16865 | 16866 | 16867 | 16868 | 16869 |
| H-97 | 16983 | 16984 | 16985 | 16986 | 16987 | 16988 | 16989 | 16990 | 16991 | 16992 | 16993 | 16994 | 16995 | 16996 | 16997 |
| H-98 | 17110 | 17111 | 17112 | 17113 | 17114 | 17115 | 17116 | 17117 | 17118 | 17119 | 17120 | 17121 | 17122 | 17123 | 17124 |
| H-99 | 17236 | 17237 | 17238 | 17239 | 17240 | 17241 | 17242 | 17243 | 17244 | 17245 | 17246 | 17247 | 17248 | 17249 | 17250 |
| H-100 | 17361 | 17362 | 17363 | 17364 | 17365 | 17366 | 17367 | 17368 | 17369 | 17370 | 17371 | 17372 | 17373 | 17374 | 17375 |
| H-101 | 17485 | 17486 | 17487 | 17488 | 17489 | 17490 | 17491 | 17492 | 17493 | 17494 | 17495 | 17496 | 17497 | 17498 | 17499 |
| H-102 | 17608 | 17609 | 17610 | 17611 | 17612 | 17613 | 17614 | 17615 | 17616 | 17617 | 17618 | 17619 | 17620 | 17621 | 17622 |
| H-103 | 17730 | 17731 | 17732 | 17733 | 17734 | 17735 | 17736 | 17737 | 17738 | 17739 | 17740 | 17741 | 17742 | 17743 | 17744 |
| H-104 | 17851 | 17852 | 17853 | 17854 | 17855 | 17856 | 17857 | 17858 | 17859 | 17860 | 17861 | 17862 | 17863 | 17864 | 17865 |
| H-105 | 17971 | 17972 | 17973 | 17974 | 17975 | 17976 | 17977 | 17978 | 17979 | 17980 | 17981 | 17982 | 17983 | 17984 | 17985 |

(continued)

| | H-136 | H-137 | H-138 | H-139 | H-140 | H-141 | H-142 | H-143 | H-144 | H-145 | H-146 | H-147 | H-148 | H-149 | H-150 |
|---|---|---|---|---|---|---|---|---|---|---|---|---|---|---|---|
| H-106 | 18090 | 18091 | 18092 | 18093 | 18094 | 18095 | 18096 | 18097 | 18098 | 18099 | 18100 | 18101 | 18102 | 18103 | 18104 |
| H-107 | 18208 | 18209 | 18210 | 18211 | 18212 | 18213 | 18214 | 18215 | 18216 | 18217 | 18218 | 18219 | 18220 | 18221 | 18222 |
| H-108 | 18325 | 18326 | 18327 | 18328 | 18329 | 18330 | 18331 | 18332 | 18333 | 18334 | 18335 | 18336 | 18337 | 18338 | 18339 |
| H-109 | 18441 | 18442 | 18443 | 18444 | 18445 | 18446 | 18447 | 18448 | 18449 | 18450 | 18451 | 18452 | 18453 | 18454 | 18455 |
| H-110 | 18556 | 18557 | 18558 | 18559 | 18560 | 18561 | 18562 | 18563 | 18564 | 18565 | 18566 | 18567 | 18568 | 18569 | 18570 |

**Table 23**

| | H-151 | H-152 | H-153 | H-154 | H-155 | H-156 | H-157 | H-158 | H-159 | H-160 | H-161 | H-162 | H-163 | H-164 | H-165 |
|---|---|---|---|---|---|---|---|---|---|---|---|---|---|---|---|
| H-56 | 10930 | 10931 | 10932 | 10933 | 10934 | 10935 | 10936 | 10937 | 10938 | 10939 | 10940 | 10941 | 10942 | 10943 | 10944 |
| H-57 | 11098 | 11099 | 11100 | 11101 | 11102 | 11103 | 11104 | 11105 | 11106 | 11107 | 11108 | 11109 | 11110 | 11111 | 11112 |
| H-58 | 11265 | 11266 | 11267 | 11268 | 11269 | 11270 | 11271 | 11272 | 11273 | 11274 | 11275 | 11276 | 11277 | 11278 | 11279 |
| H-59 | 11431 | 11432 | 11433 | 11434 | 11435 | 11436 | 11437 | 11438 | 11439 | 11440 | 11441 | 11442 | 11443 | 11444 | 11445 |
| H-60 | 11596 | 11597 | 11598 | 11599 | 11600 | 11601 | 11602 | 11603 | 11604 | 11605 | 11606 | 11607 | 11608 | 11609 | 11610 |
| H-61 | 11760 | 11761 | 11762 | 11763 | 11764 | 11765 | 11766 | 11767 | 11768 | 11769 | 11770 | 11771 | 11772 | 11773 | 11774 |
| H-62 | 11923 | 11924 | 11925 | 11926 | 11927 | 11928 | 11929 | 11930 | 11931 | 11932 | 11933 | 11934 | 11935 | 11936 | 11937 |
| H-63 | 12085 | 12086 | 12087 | 12088 | 12089 | 12090 | 12091 | 12092 | 12093 | 12094 | 12095 | 12096 | 12097 | 12098 | 12099 |
| H-64 | 12246 | 12247 | 12248 | 12249 | 12250 | 12251 | 12252 | 12253 | 12254 | 12255 | 12256 | 12257 | 12258 | 12259 | 12260 |
| H-65 | 12406 | 12407 | 12408 | 12409 | 12410 | 12411 | 12412 | 12413 | 12414 | 12415 | 12416 | 12417 | 12418 | 12419 | 12420 |
| H-66 | 12565 | 12566 | 12567 | 12568 | 12569 | 12570 | 12571 | 12572 | 12573 | 12574 | 12575 | 12576 | 12577 | 12578 | 12579 |
| H-67 | 12723 | 12724 | 12725 | 12726 | 12727 | 12728 | 12729 | 12730 | 12731 | 12732 | 12733 | 12734 | 12735 | 12736 | 12737 |
| H-68 | 12880 | 12881 | 12882 | 12883 | 12884 | 12885 | 12886 | 12887 | 12888 | 12889 | 12890 | 12891 | 12892 | 12893 | 12894 |
| H-69 | 13036 | 13037 | 13038 | 13039 | 13040 | 13041 | 13042 | 13043 | 13044 | 13045 | 13046 | 13047 | 13048 | 13049 | 13050 |
| H-70 | 13191 | 13192 | 13193 | 13194 | 13195 | 13196 | 13197 | 13198 | 13199 | 13200 | 13201 | 13202 | 13203 | 13204 | 13205 |
| H-71 | 13345 | 13346 | 13347 | 13348 | 13349 | 13350 | 13351 | 13352 | 13353 | 13354 | 13355 | 13356 | 13357 | 13358 | 13359 |
| H-72 | 13498 | 13499 | 13500 | 13501 | 13502 | 13503 | 13504 | 13505 | 13506 | 13507 | 13508 | 13509 | 13510 | 13511 | 13512 |
| H-73 | 13650 | 13651 | 13652 | 13653 | 13654 | 13655 | 13656 | 13657 | 13658 | 13659 | 13660 | 13661 | 13662 | 13663 | 13664 |
| H-74 | 13801 | 13802 | 13803 | 13804 | 13805 | 13806 | 13807 | 13808 | 13809 | 13810 | 13811 | 13812 | 13813 | 13814 | 13815 |
| H-75 | 13951 | 13952 | 13953 | 13954 | 13955 | 13956 | 13957 | 13958 | 13959 | 13960 | 13961 | 13962 | 13963 | 13964 | 13965 |
| H-76 | 14100 | 14101 | 14102 | 14103 | 14104 | 14105 | 14106 | 14107 | 14108 | 14109 | 14110 | 14111 | 14112 | 14113 | 14114 |
| H-77 | 14248 | 14249 | 14250 | 14251 | 14252 | 14253 | 14254 | 14255 | 14256 | 14257 | 14258 | 14259 | 14260 | 14261 | 14262 |
| H-78 | 14395 | 14396 | 14397 | 14398 | 14399 | 14400 | 14401 | 14402 | 14403 | 14404 | 14405 | 14406 | 14407 | 14408 | 14409 |
| H-79 | 14541 | 14542 | 14543 | 14544 | 14545 | 14546 | 14547 | 14548 | 14549 | 14550 | 14551 | 14552 | 14553 | 14554 | 14555 |
| H-80 | 14686 | 14687 | 14688 | 14689 | 14690 | 14691 | 14692 | 14693 | 14694 | 14695 | 14696 | 14697 | 14698 | 14699 | 14700 |

(continued)

| | H-151 | H-152 | H-153 | H-154 | H-155 | H-156 | H-157 | H-158 | H-159 | H-160 | H-161 | H-162 | H-163 | H-164 | H-165 |
|---|---|---|---|---|---|---|---|---|---|---|---|---|---|---|---|
| H-81 | 14830 | 14831 | 14832 | 14833 | 14834 | 14835 | 14836 | 14837 | 14838 | 14839 | 14840 | 14841 | 14842 | 14843 | 14844 |
| H-82 | 14973 | 14974 | 14975 | 14976 | 14977 | 14978 | 14979 | 14980 | 14981 | 14982 | 14983 | 14984 | 14985 | 14986 | 14987 |
| H-83 | 15115 | 15116 | 15117 | 15118 | 15119 | 15120 | 15121 | 15122 | 15123 | 15124 | 15125 | 15126 | 15127 | 15128 | 15129 |
| H-84 | 15256 | 15257 | 15258 | 15259 | 15260 | 15261 | 15262 | 15263 | 15264 | 15265 | 15266 | 15267 | 15268 | 15269 | 15270 |
| H-85 | 15396 | 15397 | 15398 | 15399 | 15400 | 15401 | 15402 | 15403 | 15404 | 15405 | 15406 | 15407 | 15408 | 15409 | 15410 |
| H-86 | 15535 | 15536 | 15537 | 15538 | 15539 | 15540 | 15541 | 15542 | 15543 | 15544 | 15545 | 15546 | 15547 | 15548 | 15549 |
| H-87 | 15673 | 15674 | 15675 | 15676 | 15677 | 15678 | 15679 | 15680 | 15681 | 15682 | 15683 | 15684 | 15685 | 15686 | 15687 |
| H-88 | 15810 | 15811 | 15812 | 15813 | 15814 | 15815 | 15816 | 15817 | 15818 | 15819 | 15820 | 15821 | 15822 | 15823 | 15824 |
| H-89 | 15946 | 15947 | 15948 | 15949 | 15950 | 15951 | 15952 | 15953 | 15954 | 15955 | 15956 | 15957 | 15958 | 15959 | 15960 |
| H-90 | 16081 | 16082 | 16083 | 16084 | 16085 | 16086 | 16087 | 16088 | 16089 | 16090 | 16091 | 16092 | 16093 | 16094 | 16095 |
| H-91 | 16215 | 16216 | 16217 | 16218 | 16219 | 16220 | 16221 | 16222 | 16223 | 16224 | 16225 | 16226 | 16227 | 16228 | 16229 |
| H-92 | 16348 | 16349 | 16350 | 16351 | 16352 | 16353 | 16354 | 16355 | 16356 | 16357 | 16358 | 16359 | 16360 | 16361 | 16362 |
| H-93 | 16480 | 16481 | 16482 | 16483 | 16484 | 16485 | 16486 | 16487 | 16488 | 16489 | 16490 | 16491 | 16492 | 16493 | 16494 |
| H-94 | 16611 | 16612 | 16613 | 16614 | 16615 | 16616 | 16617 | 16618 | 16619 | 16620 | 16621 | 16622 | 16623 | 16624 | 16625 |
| H-95 | 16741 | 16742 | 16743 | 16744 | 16745 | 16746 | 16747 | 16748 | 16749 | 16750 | 16751 | 16752 | 16753 | 16754 | 16755 |
| H-96 | 16870 | 16871 | 16872 | 16873 | 16874 | 16875 | 16876 | 16877 | 16878 | 16879 | 16880 | 16881 | 16882 | 16883 | 16884 |
| H-97 | 16998 | 16999 | 17000 | 17001 | 17002 | 17003 | 17004 | 17005 | 17006 | 17007 | 17008 | 17009 | 17010 | 17011 | 17012 |
| H-98 | 17125 | 17126 | 17127 | 17128 | 17129 | 17130 | 17131 | 17132 | 17133 | 17134 | 17135 | 17136 | 17137 | 17138 | 17139 |
| H-99 | 17251 | 17252 | 17253 | 17254 | 17255 | 17256 | 17257 | 17258 | 17259 | 17260 | 17261 | 17262 | 17263 | 17264 | 17265 |
| H-100 | 17376 | 17377 | 17378 | 17379 | 17380 | 17381 | 17382 | 17383 | 17384 | 17385 | 17386 | 17387 | 17388 | 17389 | 17390 |
| H-101 | 17500 | 17501 | 17502 | 17503 | 17504 | 17505 | 17506 | 17507 | 17508 | 17509 | 17510 | 17511 | 17512 | 17513 | 17514 |
| H-102 | 17623 | 17624 | 17625 | 17626 | 17627 | 17628 | 17629 | 17630 | 17631 | 17632 | 17633 | 17634 | 17635 | 17636 | 17637 |
| H-103 | 17745 | 17746 | 17747 | 17748 | 17749 | 17750 | 17751 | 17752 | 17753 | 17754 | 17755 | 17756 | 17757 | 17758 | 17759 |
| H-104 | 17866 | 17867 | 17868 | 17869 | 17870 | 17871 | 17872 | 17873 | 17874 | 17875 | 17876 | 17877 | 17878 | 17879 | 17880 |
| H-105 | 17986 | 17987 | 17988 | 17989 | 17990 | 17991 | 17992 | 17993 | 17994 | 17995 | 17996 | 17997 | 17998 | 17999 | 16000 |

(continued)

| | H-151 | H-152 | H-153 | H-154 | H-155 | H-156 | H-157 | H-158 | H-159 | H-160 | H-161 | H-162 | H-163 | H-164 | H-165 |
|---|---|---|---|---|---|---|---|---|---|---|---|---|---|---|---|
| H-106 | 18105 | 18106 | 18107 | 18108 | 18109 | 18110 | 18111 | 18112 | 18113 | 18114 | 18115 | 18116 | 18117 | 18118 | 18119 |
| H-107 | 18223 | 18224 | 18225 | 18226 | 18227 | 18228 | 18229 | 18230 | 18231 | 18232 | 18233 | 18234 | 18235 | 18236 | 18237 |
| H-108 | 18340 | 18341 | 18342 | 18343 | 18344 | 18345 | 18346 | 18347 | 18348 | 18349 | 18350 | 18351 | 18352 | 18353 | 18354 |
| H-109 | 18456 | 18457 | 18458 | 18459 | 18460 | 18461 | 18462 | 18463 | 18464 | 18465 | 18466 | 18467 | 18468 | 18469 | 18470 |
| H-110 | 18571 | 18572 | 18573 | 18574 | 18575 | 18576 | 18577 | 18578 | 18579 | 18580 | 18581 | 18582 | 18583 | 18584 | 18585 |

**Table 24**

| | H-166 | H-167 | H-168 | H-169 | H-170 | H-171 | H-172 | H-173 | H-174 | H-175 | H-176 | H-177 | H-178 | H-179 | H-180 |
|---|---|---|---|---|---|---|---|---|---|---|---|---|---|---|---|
| H-56 | 10945 | 10946 | 10947 | 10948 | 10949 | 10950 | 10951 | 10952 | 10953 | 10954 | 10955 | 10956 | 10957 | 10958 | 10959 |
| H-57 | 11113 | 11114 | 11115 | 11116 | 11117 | 11118 | 11119 | 11120 | 11121 | 11122 | 11123 | 11124 | 11125 | 11126 | 11127 |
| H-58 | 11280 | 11281 | 11282 | 11283 | 11284 | 11285 | 11286 | 11287 | 11288 | 11289 | 11290 | 11291 | 11292 | 11293 | 11294 |
| H-59 | 11446 | 11447 | 11448 | 11449 | 11450 | 11451 | 11452 | 11453 | 11454 | 11455 | 11456 | 11457 | 11458 | 11459 | 11460 |
| H-60 | 11611 | 11612 | 11613 | 11614 | 11615 | 11616 | 11617 | 11618 | 11619 | 11620 | 11621 | 11622 | 11623 | 11624 | 11625 |
| H-61 | 11775 | 11776 | 11777 | 11778 | 11779 | 11780 | 11781 | 11782 | 11783 | 11784 | 11785 | 11786 | 11787 | 11788 | 11789 |
| H-62 | 11938 | 11939 | 11940 | 11941 | 11942 | 11943 | 11944 | 11945 | 11946 | 11947 | 11948 | 11949 | 11950 | 11951 | 11952 |
| H-63 | 12100 | 12101 | 12102 | 12103 | 12104 | 12105 | 12106 | 12107 | 12108 | 12109 | 12110 | 12111 | 12112 | 12113 | 12114 |
| H-64 | 12261 | 12262 | 12263 | 12264 | 12265 | 12266 | 12267 | 12268 | 12269 | 12270 | 12271 | 12272 | 12273 | 12274 | 12275 |
| H-65 | 12421 | 12422 | 12423 | 12424 | 12425 | 12426 | 12427 | 12428 | 12429 | 12430 | 12431 | 12432 | 12433 | 12434 | 12435 |
| H-66 | 12580 | 12581 | 12582 | 12583 | 12584 | 12585 | 12586 | 12587 | 12588 | 12589 | 12590 | 12591 | 12592 | 12593 | 12594 |
| H-67 | 12738 | 12739 | 12740 | 12741 | 12742 | 12743 | 12744 | 12745 | 12746 | 12747 | 12748 | 12749 | 12750 | 12751 | 12752 |
| H-68 | 12895 | 12896 | 12897 | 12898 | 12899 | 12900 | 12901 | 12902 | 12903 | 12904 | 12905 | 12906 | 12907 | 12908 | 12909 |
| H-69 | 13051 | 13052 | 13053 | 13054 | 13055 | 13056 | 13057 | 13058 | 13059 | 13060 | 13061 | 13062 | 13063 | 13064 | 13065 |
| H-70 | 13206 | 13207 | 13208 | 13209 | 13210 | 13211 | 13212 | 13213 | 13214 | 13215 | 13216 | 13217 | 13218 | 13219 | 13220 |
| H-71 | 13360 | 13361 | 13362 | 13363 | 13364 | 13365 | 13366 | 13367 | 13368 | 13369 | 13370 | 13371 | 13372 | 13373 | 13374 |
| H-72 | 13513 | 13514 | 13515 | 13516 | 13517 | 13518 | 13519 | 13520 | 13521 | 13522 | 13523 | 13524 | 13525 | 13526 | 13527 |
| H-73 | 13665 | 13666 | 13667 | 13668 | 13669 | 13670 | 13671 | 13672 | 13673 | 13674 | 13675 | 13676 | 13677 | 13678 | 13679 |
| H-74 | 13816 | 13817 | 13818 | 13819 | 13820 | 13821 | 13822 | 13823 | 13824 | 13825 | 13826 | 13827 | 13828 | 13829 | 13830 |
| H-75 | 13966 | 13967 | 13968 | 13969 | 13970 | 13971 | 13972 | 13973 | 13974 | 13975 | 13976 | 13977 | 13978 | 13979 | 13980 |
| H-76 | 14115 | 14116 | 14117 | 14118 | 14119 | 14120 | 14121 | 14122 | 14123 | 14124 | 14125 | 14126 | 14127 | 14128 | 14129 |
| H-77 | 14263 | 14264 | 14265 | 14266 | 14267 | 14268 | 14269 | 14270 | 14271 | 14272 | 14273 | 14274 | 14275 | 14276 | 14277 |
| H-78 | 14410 | 14411 | 14412 | 14413 | 14414 | 14415 | 14416 | 14417 | 14418 | 14419 | 14420 | 14421 | 14422 | 14423 | 14424 |
| H-79 | 14556 | 14557 | 14558 | 14559 | 14560 | 14561 | 14562 | 14563 | 14564 | 14565 | 14566 | 14567 | 14568 | 14569 | 14570 |
| H-80 | 14701 | 14702 | 14703 | 14704 | 14705 | 14706 | 14707 | 14708 | 14709 | 14710 | 14711 | 14712 | 14713 | 14714 | 14715 |

(continued)

| | H-166 | H-167 | H-168 | H-169 | H-170 | H-171 | H-172 | H-173 | H-174 | H-175 | H-176 | H-177 | H-178 | H-179 | H-180 |
|---|---|---|---|---|---|---|---|---|---|---|---|---|---|---|---|
| H-81 | 14845 | 14846 | 14847 | 14848 | 14849 | 14850 | 14851 | 14852 | 14853 | 14854 | 14855 | 14856 | 14857 | 14858 | 14859 |
| H-82 | 14988 | 14989 | 14990 | 14991 | 14992 | 14993 | 14994 | 14995 | 14996 | 14997 | 14998 | 14999 | 15000 | 15001 | 15002 |
| H-83 | 15130 | 15131 | 15132 | 15133 | 15134 | 15135 | 15136 | 15137 | 15138 | 15139 | 15140 | 15141 | 15142 | 15143 | 15144 |
| H-84 | 15271 | 15272 | 15273 | 15274 | 15275 | 15276 | 15277 | 15278 | 15279 | 15280 | 15281 | 15282 | 15283 | 15284 | 15285 |
| H-85 | 15411 | 15412 | 15413 | 15414 | 15415 | 15416 | 15417 | 15418 | 15419 | 15420 | 15421 | 15422 | 15423 | 15424 | 15425 |
| H-86 | 15550 | 15551 | 15552 | 15553 | 15554 | 15555 | 15556 | 15557 | 15558 | 15559 | 15560 | 15561 | 15562 | 15563 | 15564 |
| H-87 | 15688 | 15689 | 15690 | 15691 | 15692 | 15693 | 15694 | 15695 | 15696 | 15697 | 15698 | 15699 | 15700 | 15701 | 15702 |
| H-88 | 15825 | 15826 | 15827 | 15828 | 15829 | 15830 | 15831 | 15832 | 15833 | 15834 | 15835 | 15836 | 15837 | 15838 | 15839 |
| H-89 | 15961 | 15962 | 15963 | 15964 | 15965 | 15966 | 15967 | 15968 | 15969 | 15970 | 15971 | 15972 | 15973 | 15974 | 15975 |
| H-90 | 16096 | 16097 | 16098 | 16099 | 16100 | 16101 | 16102 | 16103 | 16104 | 16105 | 16106 | 16107 | 16108 | 16109 | 16110 |
| H-91 | 16230 | 16231 | 16232 | 16233 | 16234 | 16235 | 16236 | 16237 | 16238 | 16239 | 16240 | 16241 | 16242 | 16243 | 16244 |
| H-92 | 16363 | 16364 | 16365 | 16366 | 16367 | 16368 | 16369 | 16370 | 16371 | 16372 | 16373 | 16374 | 16375 | 16376 | 16377 |
| H-93 | 16495 | 16496 | 16497 | 16498 | 16499 | 16500 | 16501 | 16502 | 16503 | 16504 | 16505 | 16506 | 16507 | 16508 | 16509 |
| H-94 | 16626 | 16627 | 16628 | 16629 | 16630 | 16631 | 16632 | 16633 | 16634 | 16635 | 16636 | 16637 | 16638 | 16639 | 16640 |
| H-95 | 16756 | 16757 | 16758 | 16759 | 16760 | 16761 | 16762 | 16763 | 16764 | 16765 | 16766 | 16767 | 16768 | 16769 | 16770 |
| H-96 | 16885 | 16886 | 16887 | 16888 | 16889 | 16890 | 16891 | 16892 | 16893 | 16894 | 16895 | 16896 | 16897 | 16898 | 16899 |
| H-97 | 17013 | 17014 | 17015 | 17016 | 17017 | 17018 | 17019 | 17020 | 17021 | 17022 | 17023 | 17024 | 17025 | 17026 | 17027 |
| H-98 | 17140 | 17141 | 17142 | 17143 | 17144 | 17145 | 17146 | 17147 | 17148 | 17149 | 17150 | 17151 | 17152 | 17153 | 17154 |
| H-99 | 17266 | 17267 | 17268 | 17269 | 17270 | 17271 | 17272 | 17273 | 17274 | 17275 | 17276 | 17277 | 17278 | 17279 | 17280 |
| H-100 | 17391 | 17392 | 17393 | 17394 | 17395 | 17396 | 17397 | 17398 | 17399 | 17400 | 17401 | 17402 | 17403 | 17404 | 17405 |
| H-101 | 17515 | 17516 | 17517 | 17518 | 17519 | 17520 | 17521 | 17522 | 17523 | 17524 | 17525 | 17526 | 17527 | 17528 | 17529 |
| H-102 | 17638 | 17639 | 17640 | 17641 | 17642 | 17643 | 17644 | 17645 | 17646 | 17647 | 17648 | 17649 | 17650 | 17651 | 17652 |
| H-103 | 17760 | 17761 | 17762 | 17763 | 17764 | 17765 | 17766 | 17767 | 17768 | 17769 | 17770 | 17771 | 17772 | 17773 | 17774 |
| H-104 | 17881 | 17882 | 17883 | 17884 | 17885 | 17886 | 17887 | 17888 | 17889 | 17890 | 17891 | 17892 | 17893 | 17894 | 17895 |
| H-105 | 18001 | 18002 | 18003 | 18004 | 18005 | 18006 | 18007 | 18008 | 18009 | 18010 | 18011 | 18012 | 18013 | 18014 | 18015 |

(continued)

| | H-166 | H-167 | H-168 | H-169 | H-170 | H-171 | H-172 | H-173 | H-174 | H-175 | H-176 | H-177 | H-178 | H-179 | H-180 |
|---|---|---|---|---|---|---|---|---|---|---|---|---|---|---|---|
| H-106 | 18120 | 18121 | 18122 | 18123 | 18124 | 18125 | 18126 | 18127 | 18128 | 18129 | 18130 | 18131 | 18132 | 18133 | 18134 |
| H-107 | 18238 | 18239 | 18240 | 18241 | 18242 | 18243 | 18244 | 18245 | 18246 | 18247 | 18248 | 18249 | 18250 | 18251 | 18252 |
| H-108 | 18355 | 18356 | 18357 | 18358 | 18359 | 18360 | 18361 | 18362 | 18363 | 18364 | 18365 | 18366 | 18367 | 18368 | 18369 |
| H-109 | 18471 | 18472 | 18473 | 18474 | 18475 | 18476 | 18477 | 18478 | 18479 | 18480 | 18481 | 18482 | 18483 | 18484 | 18485 |
| H-110 | 18586 | 18587 | 18588 | 18589 | 18590 | 18591 | 18592 | 18593 | 18594 | 18595 | 18596 | 18597 | 18598 | 18599 | 18600 |

**Table 25**

| | H-181 | H-182 | H-183 | H-184 | H-185 | H-186 | H-187 | H-188 | H-189 | H-190 | H-191 | H-192 | H-193 | H-194 | H-195 |
|---|---|---|---|---|---|---|---|---|---|---|---|---|---|---|---|
| H-56 | 10960 | 10961 | 10962 | 10963 | 10964 | 10965 | 10966 | 10967 | 10968 | 10969 | 10970 | 10971 | 10972 | 10973 | 10974 |
| H-57 | 11128 | 11129 | 11130 | 11131 | 11132 | 11133 | 11134 | 11135 | 11136 | 11137 | 11138 | 11139 | 11140 | 11141 | 11142 |
| H-58 | 11295 | 11296 | 11297 | 11298 | 11299 | 11300 | 11301 | 11302 | 11303 | 11304 | 11305 | 11306 | 11307 | 11308 | 11309 |
| H-59 | 11461 | 11462 | 11463 | 11464 | 11465 | 11466 | 11467 | 11468 | 11469 | 11470 | 11471 | 11472 | 11473 | 11474 | 11475 |
| H-60 | 11626 | 11627 | 11628 | 11629 | 11630 | 11631 | 11632 | 11633 | 11634 | 11635 | 11636 | 11637 | 11638 | 11639 | 11640 |
| H-61 | 11790 | 11791 | 11792 | 11793 | 11794 | 11795 | 11796 | 11797 | 11798 | 11799 | 11800 | 11801 | 11802 | 11803 | 11804 |
| H-62 | 11953 | 11954 | 11955 | 11956 | 11957 | 11958 | 11959 | 11960 | 11961 | 11962 | 11963 | 11964 | 11965 | 11966 | 11967 |
| H-63 | 12115 | 12116 | 12117 | 12118 | 12119 | 12120 | 12121 | 12122 | 12123 | 12124 | 12125 | 12126 | 12127 | 12128 | 12129 |
| H-64 | 12276 | 12277 | 12278 | 12279 | 12280 | 12281 | 12282 | 12283 | 12284 | 12285 | 12286 | 12287 | 12288 | 12289 | 12290 |
| H-65 | 12436 | 12437 | 12438 | 12439 | 12440 | 12441 | 12442 | 12443 | 12444 | 12445 | 12446 | 12447 | 12448 | 12449 | 12450 |
| H-66 | 12595 | 12596 | 12597 | 12598 | 12599 | 12600 | 12601 | 12602 | 12603 | 12604 | 12605 | 12606 | 12607 | 12608 | 12609 |
| H-67 | 12753 | 12754 | 12755 | 12756 | 12757 | 12758 | 12759 | 12760 | 12761 | 12762 | 12763 | 12764 | 12765 | 12766 | 12767 |
| H-68 | 12910 | 12911 | 12912 | 12913 | 12914 | 12915 | 12916 | 12917 | 12918 | 12919 | 12920 | 12921 | 12922 | 12923 | 12924 |
| H-69 | 13066 | 13067 | 13068 | 13069 | 13070 | 13071 | 13072 | 13073 | 13074 | 13075 | 13076 | 13077 | 13078 | 13079 | 13080 |
| H-70 | 13221 | 13222 | 13223 | 13224 | 13225 | 13226 | 13227 | 13228 | 13229 | 13230 | 13231 | 13232 | 13233 | 13234 | 13235 |
| H-71 | 13375 | 13376 | 13377 | 13378 | 13379 | 13380 | 13381 | 13382 | 13383 | 13384 | 13385 | 13386 | 13387 | 13388 | 13389 |
| H-72 | 13528 | 13529 | 13530 | 13531 | 13532 | 13533 | 13534 | 13535 | 13536 | 13537 | 13538 | 13539 | 13540 | 13541 | 13542 |
| H-73 | 13680 | 13681 | 13682 | 13683 | 13684 | 13685 | 13686 | 13687 | 13688 | 13689 | 13690 | 13691 | 13692 | 13693 | 13694 |
| H-74 | 13831 | 13832 | 13833 | 13834 | 13835 | 13836 | 13837 | 13838 | 13839 | 13840 | 13841 | 13842 | 13843 | 13844 | 13845 |
| H-75 | 13981 | 13982 | 13983 | 13984 | 13985 | 13986 | 13987 | 13988 | 13989 | 13990 | 13991 | 13992 | 13993 | 13994 | 13995 |
| H-76 | 14130 | 14131 | 14132 | 14133 | 14134 | 14135 | 14136 | 14137 | 14138 | 14139 | 14140 | 14141 | 14142 | 14143 | 14144 |
| H-77 | 14278 | 14279 | 14280 | 14281 | 14282 | 14283 | 14284 | 14285 | 14286 | 14287 | 14288 | 14289 | 14290 | 14291 | 14292 |
| H-78 | 14425 | 14426 | 14427 | 14428 | 14429 | 14430 | 14431 | 14432 | 14433 | 14434 | 14435 | 14436 | 14437 | 14438 | 14439 |
| H-79 | 14571 | 14572 | 14573 | 14574 | 14575 | 14576 | 14577 | 14578 | 14579 | 14580 | 14581 | 14582 | 14583 | 14584 | 14585 |
| H-80 | 14716 | 14717 | 14718 | 14719 | 14720 | 14721 | 14722 | 14723 | 14724 | 14725 | 14726 | 14727 | 14728 | 14729 | 14730 |

(continued)

| | H-181 | H-182 | H-183 | H-184 | H-185 | H-186 | H-187 | H-188 | H-189 | H-190 | H-191 | H-192 | H-193 | H-194 | H-195 |
|---|---|---|---|---|---|---|---|---|---|---|---|---|---|---|---|
| H-81 | 14860 | 14861 | 14862 | 14863 | 14864 | 14865 | 14866 | 14867 | 14868 | 14869 | 14870 | 14871 | 14872 | 14873 | 14874 |
| H-82 | 15003 | 15004 | 15005 | 15006 | 15007 | 15008 | 15009 | 15010 | 15011 | 15012 | 15013 | 15014 | 15015 | 15016 | 15017 |
| H-83 | 15145 | 15146 | 15147 | 15148 | 15149 | 15150 | 15151 | 15152 | 15153 | 15154 | 15155 | 15156 | 15157 | 15158 | 15159 |
| H-84 | 15286 | 15287 | 15288 | 15289 | 15290 | 15291 | 15292 | 15293 | 15294 | 15295 | 15296 | 15297 | 15298 | 15299 | 15300 |
| H-85 | 15426 | 15427 | 15428 | 15429 | 15430 | 15431 | 15432 | 15433 | 15434 | 15435 | 15436 | 15437 | 15438 | 15439 | 15440 |
| H-86 | 15565 | 15566 | 15567 | 15568 | 15569 | 15570 | 15571 | 15572 | 15573 | 15574 | 15575 | 15576 | 15577 | 15578 | 15579 |
| H-87 | 15703 | 15704 | 15705 | 15706 | 15707 | 15708 | 15709 | 15710 | 15711 | 15712 | 15713 | 15714 | 15715 | 15716 | 15717 |
| H-88 | 15840 | 15841 | 15842 | 15843 | 15844 | 15845 | 15846 | 15847 | 15848 | 15849 | 15850 | 15851 | 15852 | 15853 | 15854 |
| H-89 | 15976 | 15977 | 15978 | 15979 | 15980 | 15981 | 15982 | 15983 | 15984 | 15985 | 15986 | 15987 | 15988 | 15989 | 15990 |
| H-90 | 16111 | 16112 | 16113 | 16114 | 16115 | 16116 | 16117 | 16118 | 16119 | 16120 | 16121 | 16122 | 16123 | 16124 | 16125 |
| H-91 | 16245 | 16246 | 16247 | 16248 | 16249 | 16250 | 16251 | 16252 | 16253 | 16254 | 16255 | 16256 | 16257 | 16258 | 16259 |
| H-92 | 16378 | 16379 | 16380 | 16381 | 16382 | 16383 | 16384 | 16385 | 16386 | 16387 | 16388 | 16389 | 16390 | 16391 | 16392 |
| H-93 | 16510 | 16511 | 16512 | 16513 | 16514 | 16515 | 16516 | 16517 | 16518 | 16519 | 16520 | 16521 | 16522 | 16523 | 16524 |
| H-94 | 16641 | 16642 | 16643 | 16644 | 16645 | 16646 | 16647 | 16648 | 16649 | 16650 | 16651 | 16652 | 16653 | 16654 | 16655 |
| H-95 | 16771 | 16772 | 16773 | 16774 | 16775 | 16776 | 16777 | 16778 | 16779 | 16780 | 16781 | 16782 | 16783 | 16784 | 16785 |
| H-96 | 16900 | 16901 | 16902 | 16903 | 16904 | 16905 | 16906 | 16907 | 16908 | 16909 | 16910 | 16911 | 16912 | 16913 | 16914 |
| H-97 | 17028 | 17029 | 17030 | 17031 | 17032 | 17033 | 17034 | 17035 | 17036 | 17037 | 17038 | 17039 | 17040 | 17041 | 17042 |
| H-98 | 17155 | 17156 | 17157 | 17158 | 17159 | 17160 | 17161 | 17162 | 17163 | 17164 | 17165 | 17166 | 17167 | 17168 | 17169 |
| H-99 | 17281 | 17282 | 17283 | 17284 | 17285 | 17286 | 17287 | 17288 | 17289 | 17290 | 17291 | 17292 | 17293 | 17294 | 17295 |
| H-100 | 17406 | 17407 | 17408 | 17409 | 17410 | 17411 | 17412 | 17413 | 17414 | 17415 | 17416 | 17417 | 17418 | 17419 | 17420 |
| H-101 | 17530 | 17531 | 17532 | 17533 | 17534 | 17535 | 17536 | 17537 | 17538 | 17539 | 17540 | 17541 | 17542 | 17543 | 17544 |
| H-102 | 17653 | 17654 | 17655 | 17656 | 17657 | 17658 | 17659 | 17660 | 17661 | 17662 | 17663 | 17664 | 17665 | 17666 | 17667 |
| H-103 | 17775 | 17776 | 17777 | 17778 | 17779 | 17780 | 17781 | 17782 | 17783 | 17784 | 17785 | 17786 | 17787 | 17788 | 17789 |
| H-104 | 17896 | 17897 | 17898 | 17899 | 17900 | 17901 | 17902 | 17903 | 17904 | 17905 | 17906 | 17907 | 17908 | 17909 | 17910 |
| H-105 | 18016 | 18017 | 18018 | 18019 | 18020 | 18021 | 18022 | 18023 | 18024 | 18025 | 18026 | 18027 | 18028 | 18029 | 18030 |

(continued)

| | H-181 | H-182 | H-183 | H-184 | H-185 | H-186 | H-187 | H-188 | H-189 | H-190 | H-191 | H-192 | H-193 | H-194 | H-195 |
|---|---|---|---|---|---|---|---|---|---|---|---|---|---|---|---|
| H-106 | 18135 | 18136 | 18137 | 18138 | 18139 | 18140 | 18141 | 18142 | 18143 | 18144 | 18145 | 18146 | 18147 | 18148 | 18149 |
| H-107 | 18253 | 18254 | 18255 | 18256 | 18257 | 18258 | 18259 | 18260 | 18261 | 18262 | 18263 | 18264 | 18265 | 18266 | 18267 |
| H-108 | 18370 | 18371 | 18372 | 18373 | 18374 | 18375 | 18376 | 18377 | 18378 | 18379 | 18380 | 18381 | 18382 | 18383 | 18384 |
| H-109 | 18486 | 18487 | 18488 | 18489 | 18490 | 18491 | 18492 | 18493 | 18494 | 18495 | 18496 | 18497 | 18498 | 18499 | 18500 |
| H-110 | 18601 | 18602 | 18603 | 18604 | 18605 | 18606 | 18607 | 18608 | 18609 | 18610 | 18611 | 18612 | 18613 | 18614 | 18615 |

Table 26

| | H-196 | H-197 | H-198 | H-199 | H-200 | H-201 | H-202 | H-203 | H-204 | H-205 | H-206 | H-207 | H-208 | H-209 | H-210 |
|---|---|---|---|---|---|---|---|---|---|---|---|---|---|---|---|
| H-56 | 10975 | 10976 | 10977 | 10978 | 10979 | 10980 | 10981 | 10982 | 10983 | 10984 | 10985 | 10986 | 10987 | 10988 | 10989 |
| H-57 | 11143 | 11144 | 11145 | 11146 | 11147 | 11148 | 11149 | 11150 | 11151 | 11152 | 11153 | 11154 | 11155 | 11156 | 11157 |
| H-58 | 11310 | 11311 | 11312 | 11313 | 11314 | 11315 | 11316 | 11317 | 11318 | 11319 | 11320 | 11321 | 11322 | 11323 | 11324 |
| H-59 | 11476 | 11477 | 11478 | 11479 | 11480 | 11481 | 11482 | 11483 | 11484 | 11485 | 11486 | 11487 | 11488 | 11489 | 11490 |
| H-60 | 11641 | 11642 | 11643 | 11644 | 11645 | 11646 | 11647 | 11648 | 11649 | 11650 | 11651 | 11652 | 11653 | 11654 | 11655 |
| H-61 | 11805 | 11806 | 11807 | 11808 | 11809 | 11810 | 11811 | 11812 | 11813 | 11814 | 11815 | 11816 | 11817 | 11818 | 11819 |
| H-62 | 11968 | 11969 | 11970 | 11971 | 11972 | 11973 | 11974 | 11975 | 11976 | 11977 | 11978 | 11979 | 11980 | 11981 | 11982 |
| H-63 | 12130 | 12131 | 12132 | 12133 | 12134 | 12135 | 12136 | 12137 | 12138 | 12139 | 12140 | 12141 | 12142 | 12143 | 12144 |
| H-64 | 12291 | 12292 | 12293 | 12294 | 12295 | 12296 | 12297 | 12298 | 12299 | 12300 | 12301 | 12302 | 12303 | 12304 | 12305 |
| H-65 | 12451 | 12452 | 12453 | 12454 | 12455 | 12456 | 12457 | 12458 | 12459 | 12460 | 12461 | 12462 | 12463 | 12464 | 12465 |
| H-66 | 12610 | 12611 | 12612 | 12613 | 12614 | 12615 | 12616 | 12617 | 12618 | 12619 | 12620 | 12621 | 12622 | 12623 | 12624 |
| H-67 | 12768 | 12769 | 12770 | 12771 | 12772 | 12773 | 12774 | 12775 | 12776 | 12777 | 12778 | 12779 | 12780 | 12781 | 12782 |
| H-68 | 12925 | 12926 | 12927 | 12928 | 12929 | 12930 | 12931 | 12932 | 12933 | 12934 | 12935 | 12936 | 12937 | 12938 | 12939 |
| H-69 | 13081 | 13082 | 13083 | 13084 | 13085 | 13086 | 13087 | 13088 | 13089 | 13090 | 13091 | 13092 | 13093 | 13094 | 13095 |
| H-70 | 13236 | 13237 | 13238 | 13239 | 13240 | 13241 | 13242 | 13243 | 13244 | 13245 | 13246 | 13247 | 13248 | 13249 | 13250 |
| H-71 | 13390 | 13391 | 13392 | 13393 | 13394 | 13395 | 13396 | 13397 | 13398 | 13399 | 13400 | 13401 | 13402 | 13403 | 13404 |
| H-72 | 13543 | 13544 | 13545 | 13546 | 13547 | 13548 | 13549 | 13550 | 13551 | 13552 | 13553 | 13554 | 13555 | 13556 | 13557 |
| H-73 | 13695 | 13696 | 13697 | 13698 | 13699 | 13700 | 13701 | 13702 | 13703 | 13704 | 13705 | 13706 | 13707 | 13708 | 13709 |
| H-74 | 13846 | 13847 | 13848 | 13849 | 13850 | 13851 | 13852 | 13853 | 13854 | 13855 | 13856 | 13857 | 13858 | 13859 | 13860 |
| H-75 | 13996 | 13997 | 13998 | 13999 | 14000 | 14001 | 14002 | 14003 | 14004 | 14005 | 14006 | 14007 | 14008 | 14009 | 14010 |
| H-76 | 14145 | 14146 | 14147 | 14148 | 14149 | 14150 | 14151 | 14152 | 14153 | 14154 | 14155 | 14156 | 14157 | 14158 | 14159 |
| H-77 | 14293 | 14294 | 14295 | 14296 | 14297 | 14298 | 14299 | 14300 | 14301 | 14302 | 14303 | 14304 | 14305 | 14306 | 14307 |
| H-78 | 14440 | 14441 | 14442 | 14443 | 14444 | 14445 | 14446 | 14447 | 14448 | 14449 | 14450 | 14451 | 14452 | 14453 | 14454 |
| H-79 | 14586 | 14587 | 14588 | 14589 | 14590 | 14591 | 14592 | 14593 | 14594 | 14595 | 14596 | 14597 | 14598 | 14599 | 14600 |
| H-80 | 14731 | 14732 | 14733 | 14734 | 14735 | 14736 | 14737 | 14738 | 14739 | 14740 | 14741 | 14742 | 14743 | 14744 | 14745 |

(continued)

| | H-196 | H-197 | H-198 | H-199 | H-200 | H-201 | H-202 | H-203 | H-204 | H-205 | H-206 | H-207 | H-208 | H-209 | H-210 |
|---|---|---|---|---|---|---|---|---|---|---|---|---|---|---|---|
| H-81 | 14875 | 14876 | 14877 | 14878 | 14879 | 14880 | 14881 | 14882 | 14883 | 14884 | 14885 | 14886 | 14887 | 14888 | 14889 |
| H-82 | 15018 | 15019 | 15020 | 15021 | 15022 | 15023 | 15024 | 15025 | 15026 | 15027 | 15028 | 15029 | 15030 | 15031 | 15032 |
| H-83 | 15160 | 15161 | 15162 | 15163 | 15164 | 15165 | 15166 | 15167 | 15168 | 15169 | 15170 | 15171 | 15172 | 15173 | 15174 |
| H-84 | 15301 | 15302 | 15303 | 15304 | 15305 | 15306 | 15307 | 15308 | 15309 | 15310 | 15311 | 15312 | 15313 | 15314 | 15315 |
| H-85 | 15441 | 15442 | 15443 | 15444 | 15445 | 15446 | 15447 | 15448 | 15449 | 15450 | 15451 | 15452 | 15453 | 15454 | 15455 |
| H-86 | 15580 | 15581 | 15582 | 15583 | 15584 | 15585 | 15586 | 15587 | 15588 | 15589 | 15590 | 15591 | 15592 | 15593 | 15594 |
| H-87 | 15718 | 15719 | 15720 | 15721 | 15722 | 15723 | 15724 | 15725 | 15726 | 15727 | 15728 | 15729 | 15730 | 15731 | 15732 |
| H-88 | 15855 | 15856 | 15857 | 15858 | 15859 | 15860 | 15861 | 15862 | 15863 | 15864 | 15865 | 15866 | 15867 | 15868 | 15869 |
| H-89 | 15991 | 15992 | 15993 | 15994 | 15995 | 15996 | 15997 | 15998 | 15999 | 16000 | 16001 | 16002 | 16003 | 16004 | 16005 |
| H-90 | 16126 | 16127 | 16128 | 16129 | 16130 | 16131 | 16132 | 16133 | 16134 | 16135 | 16136 | 16137 | 16138 | 16139 | 16140 |
| H-91 | 16260 | 16261 | 16262 | 16263 | 16264 | 16265 | 16266 | 16267 | 16268 | 16269 | 16270 | 16271 | 16272 | 16273 | 16274 |
| H-92 | 16393 | 16394 | 16395 | 16396 | 16397 | 16398 | 16399 | 16400 | 16401 | 16402 | 16403 | 16404 | 16405 | 16406 | 16407 |
| H-93 | 16525 | 16526 | 16527 | 16528 | 16529 | 16530 | 16531 | 16532 | 16533 | 16534 | 16535 | 16536 | 16537 | 16538 | 16539 |
| H-94 | 16656 | 16657 | 16658 | 16659 | 16660 | 16661 | 16662 | 16663 | 16664 | 16665 | 16666 | 16667 | 16668 | 16669 | 16670 |
| H-95 | 16786 | 16787 | 16788 | 16789 | 16790 | 16791 | 16792 | 16793 | 16794 | 16795 | 16796 | 16797 | 16798 | 16799 | 16800 |
| H-96 | 16915 | 16916 | 16917 | 16918 | 16919 | 16920 | 16921 | 16922 | 16923 | 16924 | 16925 | 16926 | 16927 | 16928 | 16929 |
| H-97 | 17043 | 17044 | 17045 | 17046 | 17047 | 17048 | 17049 | 17050 | 17051 | 17052 | 17053 | 17054 | 17055 | 17056 | 17057 |
| H-98 | 17170 | 17171 | 17172 | 17173 | 17174 | 17175 | 17176 | 17177 | 17178 | 17179 | 17180 | 17181 | 17182 | 17183 | 17184 |
| H-99 | 17296 | 17297 | 17298 | 17299 | 17300 | 17301 | 17302 | 17303 | 17304 | 17305 | 17306 | 17307 | 17308 | 17309 | 17310 |
| H-100 | 17421 | 17422 | 17423 | 17424 | 17425 | 17426 | 17427 | 17428 | 17429 | 17430 | 17431 | 17432 | 17433 | 17434 | 17435 |
| H-101 | 17545 | 17546 | 17547 | 17548 | 17549 | 17550 | 17551 | 17552 | 17553 | 17554 | 17555 | 17556 | 17557 | 17558 | 17559 |
| H-102 | 17668 | 17669 | 17670 | 17671 | 17672 | 17673 | 17674 | 17675 | 17676 | 17677 | 17678 | 17679 | 17680 | 17681 | 17682 |
| H-103 | 17790 | 17791 | 17792 | 17793 | 17794 | 17795 | 17796 | 17797 | 17798 | 17799 | 17800 | 17801 | 17802 | 17803 | 17804 |
| H-104 | 17911 | 17912 | 17913 | 17914 | 17915 | 17916 | 17917 | 17918 | 17919 | 17920 | 17921 | 17922 | 17923 | 17924 | 17925 |
| H-105 | 18031 | 18032 | 18033 | 18034 | 18035 | 18036 | 18037 | 18038 | 18039 | 18040 | 18041 | 18042 | 18043 | 18044 | 18045 |

(continued)

| | H-196 | H-197 | H-198 | H-199 | H-200 | H-201 | H-202 | H-203 | H-204 | H-205 | H-206 | H-207 | H-208 | H-209 | H-210 |
|---|---|---|---|---|---|---|---|---|---|---|---|---|---|---|---|
| H-106 | 18150 | 18151 | 18152 | 18153 | 18154 | 18155 | 18156 | 18157 | 18158 | 18159 | 18160 | 18161 | 18162 | 18163 | 18164 |
| H-107 | 18268 | 18269 | 18270 | 18271 | 18272 | 18273 | 18274 | 18275 | 18276 | 18277 | 18278 | 18279 | 18280 | 18281 | 18282 |
| H-108 | 18385 | 18386 | 18387 | 18388 | 18389 | 18390 | 18391 | 18392 | 18393 | 18394 | 18395 | 18396 | 18397 | 18398 | 18399 |
| H-109 | 18501 | 18502 | 18503 | 18504 | 18505 | 18506 | 18507 | 18508 | 18509 | 18510 | 18511 | 18512 | 18513 | 18514 | 18515 |
| H-110 | 18616 | 18617 | 18618 | 18619 | 18620 | 18621 | 18622 | 18623 | 18624 | 18625 | 18626 | 18627 | 18628 | 18629 | 18630 |

Table 27

| | H-211 | H-212 | H-213 | H-214 | H-215 | H-216 | H-217 | H-218 | H-219 | H-220 | H-221 | H-222 | H-223 | H-224 | H-225 |
|---|---|---|---|---|---|---|---|---|---|---|---|---|---|---|---|
| H-56 | 10990 | 10991 | 10992 | 10993 | 10994 | 10995 | 10996 | 10997 | 10998 | 10999 | 11000 | 11001 | 11002 | 11003 | 11004 |
| H-57 | 11158 | 11159 | 11160 | 11161 | 11162 | 11163 | 11164 | 11165 | 11166 | 11167 | 11168 | 11169 | 11170 | 11171 | 11172 |
| H-58 | 11325 | 11326 | 11327 | 11328 | 11329 | 11330 | 11331 | 11332 | 11333 | 11334 | 11335 | 11336 | 11337 | 11338 | 11339 |
| H-59 | 11491 | 11492 | 11493 | 11494 | 11495 | 11496 | 11497 | 11498 | 11499 | 11500 | 11501 | 11502 | 11503 | 11504 | 11505 |
| H-60 | 11656 | 11657 | 11658 | 11659 | 11660 | 11661 | 11662 | 11663 | 11664 | 11665 | 11666 | 11667 | 11668 | 11669 | 11670 |
| H-61 | 11820 | 11821 | 11822 | 11823 | 11824 | 11825 | 11826 | 11827 | 11828 | 11829 | 11830 | 11831 | 11832 | 11833 | 11834 |
| H-62 | 11983 | 11984 | 11985 | 11986 | 11987 | 11988 | 11989 | 11990 | 11991 | 11992 | 11993 | 11994 | 11995 | 11996 | 11997 |
| H-63 | 12145 | 12146 | 12147 | 12148 | 12149 | 12150 | 12151 | 12152 | 12153 | 12154 | 12155 | 12156 | 12157 | 12158 | 12159 |
| H-64 | 12306 | 12307 | 12308 | 12309 | 12310 | 12311 | 12312 | 12313 | 12314 | 12315 | 12316 | 12317 | 12318 | 12319 | 12320 |
| H-65 | 12466 | 12467 | 12468 | 12469 | 12470 | 12471 | 12472 | 12473 | 12474 | 12475 | 12476 | 12477 | 12478 | 12479 | 12480 |
| H-66 | 12625 | 12626 | 12627 | 12628 | 12629 | 12630 | 12631 | 12632 | 12633 | 12634 | 12635 | 12636 | 12637 | 12638 | 12639 |
| H-67 | 12783 | 12784 | 12785 | 12786 | 12787 | 12788 | 12789 | 12790 | 12791 | 12792 | 12793 | 12794 | 12795 | 12796 | 12797 |
| H-68 | 12940 | 12941 | 12942 | 12943 | 12944 | 12945 | 12946 | 12947 | 12948 | 12949 | 12950 | 12951 | 12952 | 12953 | 12954 |
| H-69 | 13096 | 13097 | 13098 | 13099 | 13100 | 13101 | 13102 | 13103 | 13104 | 13105 | 13106 | 13107 | 13108 | 13109 | 13110 |
| H-70 | 13251 | 13252 | 13253 | 13254 | 13255 | 13256 | 13257 | 13258 | 13259 | 13260 | 13261 | 13262 | 13263 | 13264 | 13265 |
| H-71 | 13405 | 13406 | 13407 | 13408 | 13409 | 13410 | 13411 | 13412 | 13413 | 13414 | 13415 | 13416 | 13417 | 13418 | 13419 |
| H-72 | 13558 | 13559 | 13560 | 13561 | 13562 | 13563 | 13564 | 13565 | 13566 | 13567 | 13568 | 13569 | 13570 | 13571 | 13572 |
| H-73 | 13710 | 13711 | 13712 | 13713 | 13714 | 13715 | 13716 | 13717 | 13718 | 13719 | 13720 | 13721 | 13722 | 13723 | 13724 |
| H-74 | 13861 | 13862 | 13863 | 13864 | 13865 | 13866 | 13867 | 13868 | 13869 | 13870 | 13871 | 13872 | 13873 | 13874 | 13875 |
| H-75 | 14011 | 14012 | 14013 | 14014 | 14015 | 14016 | 14017 | 14018 | 14019 | 14020 | 14021 | 14022 | 14023 | 14024 | 14025 |
| H-76 | 14160 | 14161 | 14162 | 14163 | 14164 | 14165 | 14166 | 14167 | 14168 | 14169 | 14170 | 14171 | 14172 | 14173 | 14174 |
| H-77 | 14308 | 14309 | 14310 | 14311 | 14312 | 14313 | 14314 | 14315 | 14316 | 14317 | 14318 | 14319 | 14320 | 14321 | 14322 |
| H-78 | 14455 | 14456 | 14457 | 14458 | 14459 | 14460 | 14461 | 14462 | 14463 | 14464 | 14465 | 14466 | 14467 | 14468 | 14469 |
| H-79 | 14601 | 14602 | 14603 | 14604 | 14605 | 14606 | 14607 | 14608 | 14609 | 14610 | 14611 | 14612 | 14613 | 14614 | 14615 |
| H-80 | 14746 | 14747 | 14748 | 14749 | 14750 | 14751 | 14752 | 14753 | 14754 | 14755 | 14756 | 14757 | 14758 | 14759 | 14760 |

(continued)

| | H-211 | H-212 | H-213 | H-214 | H-215 | H-216 | H-217 | H-218 | H-219 | H-220 | H-221 | H-222 | H-223 | H-224 | H-225 |
|---|---|---|---|---|---|---|---|---|---|---|---|---|---|---|---|
| H-81 | 14890 | 14891 | 14892 | 14893 | 14894 | 14895 | 14896 | 14897 | 14898 | 14899 | 14900 | 14901 | 14902 | 14903 | 14904 |
| H-82 | 15033 | 15034 | 15035 | 15036 | 15037 | 15038 | 15039 | 15040 | 15041 | 15042 | 15043 | 15044 | 15045 | 15046 | 15047 |
| H-83 | 15175 | 15176 | 15177 | 15178 | 15179 | 15180 | 15181 | 15182 | 15183 | 15184 | 15185 | 15186 | 15187 | 15188 | 15189 |
| H-84 | 15316 | 15317 | 15318 | 15319 | 15320 | 15321 | 15322 | 15323 | 15324 | 15325 | 15326 | 15327 | 15328 | 15329 | 15330 |
| H-85 | 15456 | 15457 | 15458 | 15459 | 15460 | 15461 | 15462 | 15463 | 15464 | 15465 | 15466 | 15467 | 15468 | 15469 | 15470 |
| H-86 | 15595 | 15596 | 15597 | 15598 | 15599 | 15600 | 15601 | 15602 | 15603 | 15604 | 15605 | 15606 | 15607 | 15608 | 15609 |
| H-87 | 15733 | 15734 | 15735 | 15736 | 15737 | 15738 | 15739 | 15740 | 15741 | 15742 | 15743 | 15744 | 15745 | 15746 | 15747 |
| H-88 | 15870 | 15871 | 15872 | 15873 | 15874 | 15875 | 15876 | 15877 | 15878 | 15879 | 15880 | 15881 | 15882 | 15883 | 15884 |
| H-89 | 16006 | 16007 | 16008 | 16009 | 16010 | 16011 | 16012 | 16013 | 16014 | 16015 | 16016 | 16017 | 16018 | 16019 | 16020 |
| H-90 | 16141 | 16142 | 16143 | 16144 | 16145 | 16146 | 16147 | 16148 | 16149 | 16150 | 16151 | 16152 | 16153 | 16154 | 16155 |
| H-91 | 16275 | 16276 | 16277 | 16278 | 16279 | 16280 | 16281 | 16282 | 16283 | 16284 | 16285 | 16286 | 16287 | 16288 | 16289 |
| H-92 | 16408 | 16409 | 16410 | 16411 | 16412 | 16413 | 16414 | 16415 | 16416 | 16417 | 16418 | 16419 | 16420 | 16421 | 16422 |
| H-93 | 16540 | 16541 | 16542 | 16543 | 16544 | 16545 | 16546 | 16547 | 16548 | 16549 | 16550 | 16551 | 16552 | 16553 | 16554 |
| H-94 | 16671 | 16672 | 16673 | 16674 | 16675 | 16676 | 16677 | 16678 | 16679 | 16680 | 16681 | 16682 | 16683 | 16684 | 16685 |
| H-95 | 16801 | 16802 | 16803 | 16804 | 16805 | 16806 | 16807 | 16808 | 16809 | 16810 | 16811 | 16812 | 16813 | 16814 | 16815 |
| H-96 | 16930 | 16931 | 16932 | 16933 | 16934 | 16935 | 16936 | 16937 | 16938 | 16939 | 16940 | 16941 | 16942 | 16943 | 16944 |
| H-97 | 17058 | 17059 | 17060 | 17061 | 17062 | 17063 | 17064 | 17065 | 17066 | 17067 | 17068 | 17069 | 17070 | 17071 | 17072 |
| H-98 | 17185 | 17186 | 17187 | 17188 | 17189 | 17190 | 17191 | 17192 | 17193 | 17194 | 17195 | 17196 | 17197 | 17198 | 17199 |
| H-99 | 17311 | 17312 | 17313 | 17314 | 17315 | 17316 | 17317 | 17318 | 17319 | 17320 | 17321 | 17322 | 17323 | 17324 | 17325 |
| H-100 | 17436 | 17437 | 17438 | 17439 | 17440 | 17441 | 17442 | 17443 | 17444 | 17445 | 17446 | 17447 | 17448 | 17449 | 17450 |
| H-101 | 17560 | 17561 | 17562 | 17563 | 17564 | 17565 | 17566 | 17567 | 17568 | 17569 | 17570 | 17571 | 17572 | 17573 | 17574 |
| H-102 | 17683 | 17684 | 17685 | 17686 | 17687 | 17688 | 17689 | 17690 | 17691 | 17692 | 17693 | 17694 | 17695 | 17696 | 17697 |
| H-103 | 17805 | 17806 | 17807 | 17808 | 17809 | 17810 | 17811 | 17812 | 17813 | 17814 | 17815 | 17816 | 17817 | 17818 | 17819 |
| H-104 | 17926 | 17927 | 17928 | 17929 | 17930 | 17931 | 17932 | 17933 | 17934 | 17935 | 17936 | 17937 | 17938 | 17939 | 17940 |
| H-105 | 18046 | 18047 | 18048 | 18049 | 18050 | 18051 | 18052 | 18053 | 18054 | 18055 | 18056 | 18057 | 18058 | 18059 | 18060 |

(continued)

| | H-211 | H-212 | H-213 | H-214 | H-215 | H-216 | H-217 | H-218 | H-219 | H-220 | H-221 | H-222 | H-223 | H-224 | H-225 |
|---|---|---|---|---|---|---|---|---|---|---|---|---|---|---|---|
| H-106 | 18165 | 18166 | 18167 | 18168 | 18169 | 18170 | 18171 | 18172 | 18173 | 18174 | 18175 | 18176 | 18177 | 18178 | 18179 |
| H-107 | 18283 | 18284 | 18285 | 18286 | 18287 | 18288 | 18289 | 18290 | 18291 | 18292 | 18293 | 18294 | 18295 | 18296 | 18297 |
| H-108 | 18400 | 18401 | 18402 | 18403 | 18404 | 18405 | 18406 | 18407 | 18408 | 18409 | 18410 | 18411 | 18412 | 18413 | 18414 |
| H-109 | 18516 | 18517 | 18518 | 18519 | 18520 | 18521 | 18522 | 18523 | 18524 | 18525 | 18526 | 18527 | 18528 | 18529 | 18530 |
| H-110 | 18631 | 18632 | 18633 | 18634 | 18635 | 18636 | 18637 | 18638 | 18639 | 18640 | 18641 | 18642 | 18643 | 18644 | 18645 |

Table 28

| | H-106 | H-107 | H-108 | H-109 | H-110 | H-111 | H-112 | H-113 | H-114 | H-115 | H-116 | H-117 | H-118 | H-119 | H-120 |
|---|---|---|---|---|---|---|---|---|---|---|---|---|---|---|---|
| H-111 | 18065 | 18183 | 18300 | 18416 | 18531 | - | 18646 | 18647 | 18648 | 18649 | 18650 | 18651 | 18652 | 18653 | 18654 |
| H-112 | 18066 | 18184 | 18301 | 18417 | 18532 | 18646 | - | 18760 | 18761 | 18762 | 18763 | 18764 | 18765 | 18766 | 18767 |
| H-113 | 18067 | 18185 | 18302 | 18418 | 18533 | 18647 | 18760 | - | 18873 | 18874 | 18875 | 18876 | 18877 | 18878 | 18879 |
| H-114 | 18068 | 18186 | 18303 | 18419 | 18534 | 18648 | 18761 | 18873 | - | 18985 | 18986 | 18987 | 18988 | 18989 | 18990 |
| H-115 | 18069 | 18187 | 18304 | 18420 | 18535 | 18649 | 18762 | 18874 | 18985 | - | 19096 | 19097 | 19098 | 19099 | 19100 |
| H-116 | 18070 | 18188 | 18305 | 18421 | 18536 | 18650 | 18763 | 18875 | 18986 | 19096 | - | 19206 | 19207 | 19208 | 19209 |
| H-117 | 18071 | 18189 | 18306 | 18422 | 18537 | 18651 | 18764 | 18876 | 18987 | 19097 | 19206 | - | 19315 | 19316 | 19317 |
| H-118 | 18072 | 18190 | 18307 | 18423 | 18538 | 18652 | 18765 | 18877 | 18988 | 19098 | 19207 | 19315 | - | 19423 | 19424 |
| H-119 | 18073 | 18191 | 18308 | 18424 | 18539 | 18653 | 18766 | 18878 | 18989 | 19099 | 19208 | 19316 | 19423 | - | 19530 |
| H-120 | 18074 | 18192 | 18309 | 18425 | 18540 | 18654 | 18767 | 18879 | 18990 | 19100 | 19209 | 19317 | 19424 | 19530 | - |
| H-121 | 18075 | 18193 | 18310 | 18426 | 18541 | 18655 | 18768 | 18880 | 18991 | 19101 | 19210 | 19318 | 19425 | 19531 | 19636 |
| H-122 | 18076 | 18194 | 18311 | 18427 | 18542 | 18656 | 18769 | 18881 | 18992 | 19102 | 19211 | 19319 | 19426 | 19532 | 19637 |
| H-123 | 18077 | 18195 | 18312 | 18428 | 18543 | 18657 | 18770 | 18882 | 18993 | 19103 | 19212 | 19320 | 19427 | 19533 | 19638 |
| H-124 | 18078 | 18196 | 18313 | 18429 | 18544 | 18658 | 18771 | 18883 | 18994 | 19104 | 19213 | 19321 | 19428 | 19534 | 19639 |
| H-125 | 18079 | 18197 | 18314 | 18430 | 18545 | 18659 | 18772 | 18884 | 18995 | 19105 | 19214 | 19322 | 19429 | 19535 | 19640 |
| H-126 | 18080 | 18198 | 18315 | 18431 | 18546 | 18660 | 18773 | 18885 | 18996 | 19106 | 19215 | 19323 | 19430 | 19536 | 19641 |
| H-127 | 18081 | 18199 | 18316 | 18432 | 18547 | 18661 | 18774 | 18886 | 18997 | 19107 | 19216 | 19324 | 19431 | 19537 | 19642 |
| H-128 | 18082 | 18200 | 18317 | 18433 | 18548 | 18662 | 18775 | 18887 | 18998 | 19108 | 19217 | 19325 | 19432 | 19538 | 19643 |
| H-129 | 18083 | 18201 | 18318 | 18434 | 18549 | 18663 | 18776 | 18888 | 18999 | 19109 | 19218 | 19326 | 19433 | 19539 | 19644 |
| H-130 | 18084 | 18202 | 18319 | 18435 | 18550 | 18664 | 18777 | 18889 | 19000 | 19110 | 19219 | 19327 | 19434 | 19540 | 19645 |
| H-131 | 18085 | 18203 | 18320 | 18436 | 18551 | 18665 | 18778 | 18890 | 19001 | 19111 | 19220 | 19328 | 19435 | 19541 | 19646 |
| H-132 | 18086 | 18204 | 18321 | 18437 | 18552 | 18666 | 18779 | 18891 | 19002 | 19112 | 19221 | 19329 | 19436 | 19542 | 19647 |
| H-133 | 18087 | 18205 | 18322 | 18438 | 18553 | 18667 | 18780 | 18892 | 19003 | 19113 | 19222 | 19330 | 19437 | 19543 | 19648 |
| H-134 | 18088 | 18206 | 18323 | 18439 | 18554 | 18668 | 18781 | 18893 | 19004 | 19114 | 19223 | 19331 | 19438 | 19544 | 19649 |
| H-135 | 18089 | 18207 | 18324 | 18440 | 18555 | 18669 | 18782 | 18894 | 19005 | 19115 | 19224 | 19332 | 19439 | 19545 | 19650 |

(continued)

| | H-106 | H-107 | H-108 | H-109 | H-110 | H-111 | H-112 | H-113 | H-114 | H-115 | H-116 | H-117 | H-118 | H-119 | H-120 |
|---|---|---|---|---|---|---|---|---|---|---|---|---|---|---|---|
| H-136 | 18090 | 18208 | 18325 | 18441 | 18556 | 18670 | 18783 | 18895 | 19006 | 19116 | 19225 | 19333 | 19440 | 19546 | 19651 |
| H-137 | 18091 | 18209 | 18326 | 18442 | 18557 | 18671 | 18784 | 18896 | 19007 | 19117 | 19226 | 19334 | 19441 | 19547 | 19652 |
| H-138 | 18092 | 18210 | 18327 | 18443 | 18558 | 18672 | 18785 | 18897 | 19008 | 19118 | 19227 | 19335 | 19442 | 19548 | 19653 |
| H-139 | 18093 | 18211 | 18328 | 18444 | 18559 | 18673 | 18786 | 18898 | 19009 | 19119 | 19228 | 19336 | 19443 | 19549 | 19654 |
| H-140 | 18094 | 18212 | 18329 | 18445 | 18560 | 18674 | 18787 | 18899 | 19010 | 19120 | 19229 | 19337 | 19444 | 19550 | 19655 |
| H-141 | 18095 | 18213 | 18330 | 18446 | 18561 | 18675 | 18788 | 18900 | 19011 | 19121 | 19230 | 19338 | 19445 | 19551 | 19656 |
| H-142 | 18096 | 18214 | 18331 | 18447 | 18562 | 18676 | 18789 | 18901 | 19012 | 19122 | 19231 | 19339 | 19446 | 19552 | 19657 |
| H-143 | 18097 | 18215 | 18332 | 18448 | 18563 | 18677 | 18790 | 18902 | 19013 | 19123 | 19232 | 19340 | 19447 | 19553 | 19658 |
| H-144 | 18098 | 18216 | 18333 | 18449 | 18564 | 18678 | 18791 | 18903 | 19014 | 19124 | 19233 | 19341 | 19448 | 19554 | 19659 |
| H-145 | 18099 | 18217 | 18334 | 18450 | 18565 | 18679 | 18792 | 18904 | 19015 | 19125 | 19234 | 19342 | 19449 | 19555 | 19660 |
| H-146 | 18100 | 18218 | 18335 | 18451 | 18566 | 18680 | 18793 | 18905 | 19016 | 19126 | 19235 | 19343 | 19450 | 19556 | 19661 |
| H-147 | 18101 | 18219 | 18336 | 18452 | 18567 | 18681 | 18794 | 18906 | 19017 | 19127 | 19236 | 19344 | 19451 | 19557 | 19662 |
| H-148 | 18102 | 18220 | 18337 | 18453 | 18568 | 18682 | 18795 | 18907 | 19018 | 19128 | 19237 | 19345 | 19452 | 19558 | 19663 |
| H-149 | 18103 | 18221 | 18338 | 18454 | 18569 | 18683 | 18796 | 18908 | 19019 | 19129 | 19238 | 19346 | 19453 | 19559 | 19664 |
| H-150 | 18104 | 18222 | 18339 | 18455 | 18570 | 18684 | 18797 | 18909 | 19020 | 19130 | 19239 | 19347 | 19454 | 19560 | 19665 |
| H-151 | 18105 | 18223 | 18340 | 18456 | 18571 | 18685 | 18798 | 18910 | 19021 | 19131 | 19240 | 19348 | 19455 | 19561 | 19666 |
| H-152 | 18106 | 18224 | 18341 | 18457 | 18572 | 18686 | 18799 | 18911 | 19022 | 19132 | 19241 | 19349 | 19456 | 19562 | 19667 |
| H-153 | 18107 | 18225 | 18342 | 18458 | 18573 | 18687 | 18800 | 18912 | 19023 | 19133 | 19242 | 19350 | 19457 | 19563 | 19668 |
| H-154 | 18108 | 18226 | 18343 | 18459 | 18574 | 18688 | 18801 | 18913 | 19024 | 19134 | 19243 | 19351 | 19458 | 19564 | 19669 |
| H-155 | 18109 | 18227 | 18344 | 18460 | 18575 | 18689 | 18802 | 18914 | 19025 | 19135 | 19244 | 19352 | 19459 | 19565 | 19670 |
| H-156 | 18110 | 18228 | 18345 | 18461 | 18576 | 18690 | 18803 | 18915 | 19026 | 19136 | 19245 | 19353 | 19460 | 19566 | 19671 |
| H-157 | 18111 | 18229 | 18346 | 18462 | 18577 | 18691 | 18804 | 18916 | 19027 | 19137 | 19246 | 19354 | 19461 | 19567 | 19672 |
| H-158 | 18112 | 18230 | 18347 | 18463 | 18578 | 18692 | 18805 | 18917 | 19028 | 19138 | 19247 | 19355 | 19462 | 19568 | 19673 |
| H-159 | 18113 | 18231 | 18348 | 18464 | 18579 | 18693 | 18806 | 18918 | 19029 | 19139 | 19248 | 19356 | 19463 | 19569 | 19674 |
| H-160 | 18114 | 18232 | 18349 | 18465 | 18580 | 18694 | 18807 | 18919 | 19030 | 19140 | 19249 | 19357 | 19464 | 19570 | 19675 |

(continued)

| | H-106 | H-107 | H-108 | H-109 | H-110 | H-111 | H-112 | H-113 | H-114 | H-115 | H-116 | H-117 | H-118 | H-119 | H-120 |
|---|---|---|---|---|---|---|---|---|---|---|---|---|---|---|---|
| H-161 | 18115 | 18233 | 18350 | 18466 | 18581 | 18695 | 18808 | 18920 | 19031 | 19141 | 19250 | 19358 | 19465 | 19571 | 19676 |
| H-162 | 18116 | 18234 | 18351 | 18467 | 18582 | 18696 | 18809 | 18921 | 19032 | 19142 | 19251 | 19359 | 19466 | 19572 | 19677 |
| H-163 | 18117 | 18235 | 18352 | 18468 | 18583 | 18697 | 18810 | 18922 | 19033 | 19143 | 19252 | 19360 | 19467 | 19573 | 19678 |
| H-164 | 18118 | 18236 | 18353 | 18469 | 18584 | 18698 | 18811 | 18923 | 19034 | 19144 | 19253 | 19361 | 19468 | 19574 | 19679 |
| H-165 | 18119 | 18237 | 18354 | 18470 | 18585 | 18699 | 18812 | 18924 | 19035 | 19145 | 19254 | 19362 | 19469 | 19575 | 19680 |

Table 29

| | H-121 | H-122 | H-123 | H-124 | H-125 | H-126 | H-127 | H-128 | H-129 | H-130 | H-131 | H-132 | H-133 | H-134 | H-135 |
|---|---|---|---|---|---|---|---|---|---|---|---|---|---|---|---|
| H-111 | 18655 | 18656 | 18657 | 18658 | 18659 | 18660 | 18661 | 18662 | 18663 | 18664 | 18665 | 18666 | 18667 | 18668 | 18669 |
| H-112 | 18768 | 18769 | 18770 | 18771 | 18772 | 18773 | 18774 | 18775 | 18776 | 18777 | 18778 | 18779 | 18780 | 18781 | 18782 |
| H-113 | 18880 | 18881 | 18882 | 18883 | 18884 | 18885 | 18886 | 18887 | 18888 | 18889 | 18890 | 18891 | 18892 | 18893 | 18894 |
| H-124 | 18991 | 18992 | 18993 | 18994 | 18995 | 18996 | 18997 | 18998 | 18999 | 19000 | 19001 | 19002 | 19003 | 19004 | 19005 |
| H-115 | 19101 | 19102 | 19103 | 19104 | 19105 | 19106 | 19107 | 19108 | 19109 | 19110 | 19111 | 19112 | 19113 | 19114 | 19115 |
| H-116 | 19210 | 19211 | 19212 | 19213 | 19214 | 19215 | 19216 | 19217 | 19218 | 19219 | 19220 | 19221 | 19222 | 19223 | 19224 |
| H-117 | 19318 | 19319 | 19320 | 19321 | 19322 | 19323 | 19324 | 19325 | 19326 | 19327 | 19328 | 19329 | 19330 | 19331 | 19332 |
| H-118 | 19425 | 19426 | 19427 | 19428 | 19429 | 19430 | 19431 | 19432 | 19433 | 19434 | 19435 | 19436 | 19437 | 19438 | 19439 |
| H-119 | 19531 | 19532 | 19533 | 19534 | 19535 | 19536 | 19537 | 19538 | 19539 | 19540 | 19541 | 19542 | 19543 | 19544 | 19545 |
| H-120 | 19636 | 19637 | 19638 | 19639 | 19640 | 19641 | 19642 | 19643 | 19644 | 19645 | 19646 | 19647 | 19648 | 19649 | 19650 |
| H-121 | - | 19741 | 19742 | 19743 | 19744 | 19745 | 19746 | 19747 | 19748 | 19749 | 19750 | 19751 | 19752 | 19753 | 19754 |
| H-122 | 19741 | - | 19845 | 19846 | 19847 | 19848 | 19849 | 19850 | 19851 | 19852 | 19853 | 19854 | 19855 | 19856 | 19857 |
| H-123 | 19742 | 19845 | - | 19948 | 19949 | 19950 | 19951 | 19952 | 19953 | 19954 | 19955 | 19956 | 19957 | 19958 | 19959 |
| H-124 | 19743 | 19846 | 19948 | - | 20050 | 20051 | 20052 | 20053 | 20054 | 20055 | 20056 | 20057 | 20058 | 20059 | 20060 |
| H-125 | 19744 | 19847 | 19949 | 20050 | - | 20151 | 20152 | 20153 | 20154 | 20155 | 20156 | 20157 | 20158 | 20159 | 20160 |
| H-126 | 19745 | 19848 | 19950 | 20051 | 20151 | - | 20251 | 20252 | 20253 | 20254 | 20255 | 20256 | 20257 | 20258 | 20259 |
| H-127 | 19746 | 19849 | 19951 | 20052 | 20152 | 20251 | - | 20350 | 20351 | 20352 | 20353 | 20354 | 20355 | 20356 | 20357 |
| H-128 | 19747 | 19850 | 19952 | 20053 | 20153 | 20252 | 20350 | - | 20448 | 20449 | 20450 | 20451 | 20452 | 20453 | 20454 |
| H-129 | 19748 | 19851 | 19953 | 20054 | 20154 | 20253 | 20351 | 20448 | - | 20545 | 20546 | 20547 | 20548 | 20549 | 20550 |
| H-130 | 19749 | 19852 | 19954 | 20055 | 20155 | 20254 | 20352 | 20449 | 20545 | - | 20641 | 20642 | 20643 | 20644 | 20645 |
| H-131 | 19750 | 19853 | 19955 | 20056 | 20156 | 20255 | 20353 | 20450 | 20546 | 20641 | - | 20736 | 20737 | 20738 | 20739 |
| H-132 | 19751 | 19854 | 19956 | 20057 | 20157 | 20256 | 20354 | 20451 | 20547 | 20642 | 20736 | - | 20830 | 20831 | 20832 |
| H-133 | 19752 | 19855 | 19957 | 20058 | 20158 | 20257 | 20355 | 20452 | 20548 | 20643 | 20737 | 20830 | - | 20923 | 20924 |
| H-134 | 19753 | 19856 | 19958 | 20059 | 20159 | 20258 | 20356 | 20453 | 20549 | 20644 | 20738 | 20831 | 20923 | - | 21015 |
| H-135 | 19754 | 19857 | 19959 | 20060 | 20160 | 20259 | 20357 | 20454 | 20550 | 20645 | 20739 | 20832 | 20924 | 21015 | - |

(continued)

| | H-121 | H-122 | H-123 | H-124 | H-125 | H-126 | H-127 | H-128 | H-129 | H-130 | H-131 | H-132 | H-133 | H-134 | H-135 |
|---|---|---|---|---|---|---|---|---|---|---|---|---|---|---|---|
| H-136 | 19755 | 19858 | 19960 | 20061 | 20161 | 20260 | 20358 | 20455 | 20551 | 20646 | 20740 | 20833 | 20925 | 21016 | 21106 |
| H-137 | 19756 | 19859 | 19961 | 20062 | 20162 | 20261 | 20359 | 20456 | 20552 | 20647 | 20741 | 20834 | 20926 | 21017 | 21107 |
| H-138 | 19757 | 19860 | 19962 | 20063 | 20163 | 20262 | 20360 | 20457 | 20553 | 20648 | 20742 | 20835 | 20927 | 21018 | 21108 |
| H-139 | 19758 | 19861 | 19963 | 20064 | 20164 | 20263 | 20361 | 20458 | 20554 | 20649 | 20743 | 20836 | 20928 | 21019 | 21109 |
| H-140 | 19759 | 19862 | 19964 | 20065 | 20165 | 20264 | 20362 | 20459 | 20555 | 20650 | 20744 | 20837 | 20929 | 21020 | 21110 |
| H-141 | 19760 | 19863 | 19965 | 20066 | 20166 | 20265 | 20363 | 20460 | 20556 | 20651 | 20745 | 20838 | 20930 | 21021 | 21111 |
| H-142 | 19761 | 19864 | 19966 | 20067 | 20167 | 20266 | 20364 | 20461 | 20557 | 20652 | 20746 | 20839 | 20931 | 21022 | 21112 |
| H-143 | 19762 | 19865 | 19967 | 20068 | 20168 | 20267 | 20365 | 20462 | 20558 | 20653 | 20747 | 20840 | 20932 | 21023 | 21113 |
| H-144 | 19763 | 19866 | 19968 | 20069 | 20169 | 20268 | 20366 | 20463 | 20559 | 20654 | 20748 | 20841 | 20933 | 21024 | 21114 |
| H-145 | 19764 | 19867 | 19969 | 20070 | 20170 | 20269 | 20367 | 20464 | 20560 | 20655 | 20749 | 20842 | 20934 | 21025 | 21115 |
| H-146 | 19765 | 19868 | 19970 | 20071 | 20171 | 20270 | 20368 | 20465 | 20561 | 20656 | 20750 | 20843 | 20935 | 21026 | 21116 |
| H-147 | 19766 | 19869 | 19971 | 20072 | 20172 | 20271 | 20369 | 20466 | 20562 | 20657 | 20751 | 20844 | 20936 | 21027 | 21117 |
| H-148 | 19767 | 19870 | 19972 | 20073 | 20173 | 20272 | 20370 | 20467 | 20563 | 20658 | 20752 | 20845 | 20937 | 21028 | 21118 |
| H-149 | 19768 | 19871 | 19973 | 20074 | 20174 | 20273 | 20371 | 20468 | 20564 | 20659 | 20753 | 20846 | 20938 | 21029 | 21119 |
| H-150 | 19769 | 19872 | 19974 | 20075 | 20175 | 20274 | 20372 | 20469 | 20565 | 20660 | 20754 | 20847 | 20939 | 21030 | 21120 |
| H-151 | 19770 | 19873 | 19975 | 20076 | 20176 | 20275 | 20373 | 20470 | 20566 | 20661 | 20755 | 20848 | 20940 | 21031 | 21121 |
| H-152 | 19771 | 19874 | 19976 | 20077 | 20177 | 20276 | 20374 | 20471 | 20567 | 20662 | 20756 | 20849 | 20941 | 21032 | 21122 |
| H-153 | 19772 | 19875 | 19977 | 20078 | 20178 | 20277 | 20375 | 20472 | 20568 | 20663 | 20757 | 20850 | 20942 | 21033 | 21123 |
| H-154 | 19773 | 19876 | 19978 | 20079 | 20179 | 20278 | 20376 | 20473 | 20569 | 20664 | 20758 | 20851 | 20943 | 21034 | 21124 |
| H-155 | 19774 | 19877 | 19979 | 20080 | 20180 | 20279 | 20377 | 20474 | 20570 | 20665 | 20759 | 20852 | 20944 | 21035 | 21125 |
| H-156 | 19775 | 19878 | 19980 | 20081 | 20181 | 20280 | 20378 | 20475 | 20571 | 20666 | 20760 | 20853 | 20945 | 21036 | 21126 |
| H-157 | 19776 | 19879 | 19981 | 20082 | 20182 | 20281 | 20379 | 20476 | 20572 | 20667 | 20761 | 20854 | 20946 | 21037 | 21127 |
| H-158 | 19777 | 19880 | 19982 | 20083 | 20183 | 20282 | 20380 | 20477 | 20573 | 20668 | 20762 | 20855 | 20947 | 21038 | 21128 |
| H-159 | 19778 | 19881 | 19983 | 20084 | 20184 | 20283 | 20381 | 20478 | 20574 | 20669 | 20763 | 20856 | 20948 | 21039 | 21129 |
| H-160 | 19779 | 19882 | 19984 | 20085 | 20185 | 20284 | 20382 | 20479 | 20575 | 20670 | 20764 | 20857 | 20949 | 21040 | 21130 |

(continued)

| | H-121 | H-122 | H-123 | H-124 | H-125 | H-126 | H-127 | H-128 | H-129 | H-130 | H-131 | H-132 | H-133 | H-134 | H-135 |
|---|---|---|---|---|---|---|---|---|---|---|---|---|---|---|---|
| H-161 | 19780 | 19883 | 19985 | 20086 | 20186 | 20285 | 20383 | 20480 | 20576 | 20671 | 20765 | 20858 | 20950 | 21041 | 21131 |
| H-162 | 19781 | 19884 | 19986 | 20087 | 20187 | 20286 | 20384 | 20481 | 20577 | 20672 | 20766 | 20859 | 20951 | 21042 | 21132 |
| H-163 | 19782 | 19885 | 19987 | 20088 | 20188 | 20287 | 20385 | 20482 | 20578 | 20673 | 20767 | 20860 | 20952 | 21043 | 21133 |
| H-164 | 19783 | 19886 | 19988 | 20089 | 20189 | 20288 | 20386 | 20483 | 20579 | 20674 | 20768 | 20861 | 20953 | 21044 | 21134 |
| H-165 | 19784 | 19887 | 19989 | 20090 | 20190 | 20289 | 20387 | 20484 | 20580 | 20675 | 20769 | 20862 | 20954 | 21045 | 21135 |

Table 30

| | H-136 | H-137 | H-138 | H-139 | H-140 | H-141 | H-142 | H-143 | H-144 | H-145 | H-146 | H-147 | H-148 | H-149 | H-150 |
|---|---|---|---|---|---|---|---|---|---|---|---|---|---|---|---|
| H-111 | 18670 | 18671 | 18672 | 18673 | 18674 | 18675 | 18676 | 18677 | 18678 | 18679 | 18680 | 18681 | 18682 | 18683 | 18684 |
| H-112 | 18783 | 18784 | 18785 | 18786 | 18787 | 18788 | 18789 | 18790 | 18791 | 18792 | 18793 | 18794 | 18795 | 18796 | 18797 |
| H-113 | 18895 | 18896 | 18897 | 18898 | 18899 | 18900 | 18901 | 18902 | 18903 | 18904 | 18905 | 18906 | 18907 | 18908 | 18909 |
| H-114 | 19006 | 19007 | 19008 | 19009 | 19010 | 19011 | 19012 | 19013 | 19014 | 19015 | 19016 | 19017 | 19018 | 19019 | 19020 |
| H-115 | 19116 | 19117 | 19118 | 19119 | 19120 | 19121 | 19122 | 19123 | 19124 | 19125 | 19126 | 19127 | 19128 | 19129 | 19130 |
| H-116 | 19225 | 19226 | 19227 | 19228 | 19229 | 19230 | 19231 | 19232 | 19233 | 19234 | 19235 | 19236 | 19237 | 19238 | 19239 |
| H-117 | 19333 | 19334 | 19335 | 19336 | 19337 | 19338 | 19339 | 19340 | 19341 | 19342 | 19343 | 19344 | 19345 | 19346 | 19347 |
| H-118 | 19440 | 19441 | 19442 | 19443 | 19444 | 19445 | 19446 | 19447 | 19448 | 19449 | 19450 | 19451 | 19452 | 19453 | 19454 |
| H-119 | 19546 | 19547 | 19548 | 19549 | 19550 | 19551 | 19552 | 19553 | 19554 | 19555 | 19556 | 19557 | 19558 | 19559 | 19560 |
| H-120 | 19651 | 19652 | 19653 | 19654 | 19655 | 19656 | 19657 | 19658 | 19659 | 19660 | 19661 | 19662 | 19663 | 19664 | 19665 |
| H-121 | 19755 | 19756 | 19757 | 19758 | 19759 | 19760 | 19761 | 19762 | 19763 | 19764 | 19765 | 19766 | 19767 | 19768 | 19769 |
| H-122 | 19858 | 19859 | 19860 | 19861 | 19862 | 19863 | 19864 | 19865 | 19866 | 19867 | 19868 | 19869 | 19870 | 19871 | 19872 |
| H-123 | 19960 | 19961 | 19962 | 19963 | 19964 | 19965 | 19966 | 19967 | 19968 | 19969 | 19970 | 19971 | 19972 | 19973 | 19974 |
| H-124 | 20061 | 20062 | 20063 | 20064 | 20065 | 20066 | 20067 | 20068 | 20069 | 20070 | 20071 | 20072 | 20073 | 20074 | 20075 |
| H-125 | 20161 | 20162 | 20163 | 20164 | 20165 | 20166 | 20167 | 20168 | 20169 | 20170 | 20171 | 20172 | 20173 | 20174 | 20175 |
| H-126 | 20260 | 20261 | 20262 | 20263 | 20264 | 20265 | 20266 | 20267 | 20268 | 20269 | 20270 | 20271 | 20272 | 20273 | 20274 |
| H-127 | 20358 | 20359 | 20360 | 20361 | 20362 | 20363 | 20364 | 20365 | 20366 | 20367 | 20368 | 20369 | 20370 | 20371 | 20372 |
| H-128 | 20455 | 20456 | 20457 | 20458 | 20459 | 20460 | 20461 | 20462 | 20463 | 20464 | 20465 | 20466 | 20467 | 20468 | 20469 |
| H-129 | 20551 | 20552 | 20553 | 20554 | 20555 | 20556 | 20557 | 20558 | 20559 | 20560 | 20561 | 20562 | 20563 | 20564 | 20565 |
| H-130 | 20646 | 20647 | 20648 | 20649 | 20650 | 20651 | 20652 | 20653 | 20654 | 20655 | 20656 | 20657 | 20658 | 20659 | 20660 |
| H-131 | 20740 | 20741 | 20742 | 20743 | 20744 | 20745 | 20746 | 20747 | 20748 | 20749 | 20750 | 20751 | 20752 | 20753 | 20754 |
| H-132 | 20833 | 20834 | 20835 | 20836 | 20837 | 20838 | 20839 | 20840 | 20841 | 20842 | 20843 | 20844 | 20845 | 20846 | 20847 |
| H-133 | 20925 | 20926 | 20927 | 20928 | 20929 | 20930 | 20931 | 20932 | 20933 | 20934 | 20935 | 20936 | 20937 | 20938 | 20939 |
| H-134 | 21016 | 21017 | 21018 | 21019 | 21020 | 21021 | 21022 | 21023 | 21024 | 21025 | 21026 | 21027 | 21028 | 21029 | 21030 |
| H-135 | 21106 | 21107 | 21108 | 21109 | 21110 | 21111 | 21112 | 21113 | 21114 | 21115 | 21116 | 21117 | 21118 | 21119 | 21120 |

(continued)

| | H-136 | H-137 | H-138 | H-139 | H-140 | H-141 | H-142 | H-143 | H-144 | H-145 | H-146 | H-147 | H-148 | H-149 | H-150 |
|---|---|---|---|---|---|---|---|---|---|---|---|---|---|---|---|
| H-136 | - | 21196 | 21197 | 21198 | 21199 | 21200 | 21201 | 21202 | 21203 | 21204 | 21205 | 21206 | 21207 | 21208 | 21209 |
| H-137 | 21196 | - | 21285 | 21286 | 21287 | 21288 | 21289 | 21290 | 21291 | 21292 | 21293 | 21294 | 21295 | 21296 | 21297 |
| H-138 | 21197 | 21285 | - | 21373 | 21374 | 21375 | 21376 | 21377 | 21378 | 21379 | 21380 | 21381 | 21382 | 21383 | 21384 |
| H-139 | 21198 | 21286 | 21373 | - | 21460 | 21461 | 21462 | 21463 | 21464 | 21465 | 21466 | 21467 | 21468 | 21469 | 21470 |
| H-140 | 21199 | 21287 | 21374 | 21460 | - | 21546 | 21547 | 21548 | 21549 | 21550 | 21551 | 21552 | 21553 | 21554 | 21555 |
| H-141 | 21200 | 21288 | 21375 | 21461 | 21546 | - | 21631 | 21632 | 21633 | 21634 | 21635 | 21636 | 21637 | 21638 | 21639 |
| H-142 | 21201 | 21289 | 21376 | 21462 | 21547 | 21631 | - | 21715 | 21716 | 21717 | 21718 | 21719 | 21720 | 21721 | 21722 |
| H-143 | 21202 | 21290 | 21377 | 21463 | 21548 | 21632 | 21715 | - | 21798 | 21799 | 21800 | 21801 | 21802 | 21803 | 21804 |
| H-144 | 21203 | 21291 | 21378 | 21464 | 21549 | 21633 | 21716 | 21798 | - | 21880 | 21881 | 21882 | 21883 | 21884 | 21885 |
| H-145 | 21204 | 21292 | 21379 | 21465 | 21550 | 21634 | 21717 | 21799 | 21880 | - | 21961 | 21962 | 21963 | 21964 | 21965 |
| H-146 | 21205 | 21293 | 21380 | 21466 | 21551 | 21635 | 21718 | 21800 | 21881 | 21961 | - | 22041 | 22042 | 22043 | 22044 |
| H-147 | 21206 | 21294 | 21381 | 21467 | 21552 | 21636 | 21719 | 21801 | 21882 | 21962 | 22041 | - | 22120 | 22121 | 22122 |
| H-148 | 21207 | 21295 | 21382 | 21468 | 21553 | 21637 | 21720 | 21802 | 21883 | 21963 | 22042 | 22120 | - | 22198 | 22199 |
| H-149 | 21208 | 21296 | 21383 | 21469 | 21554 | 21638 | 21721 | 21803 | 21884 | 21964 | 22043 | 22121 | 22198 | - | 22275 |
| H-150 | 21209 | 21297 | 21384 | 21470 | 21555 | 21639 | 21722 | 21804 | 21885 | 21965 | 22044 | 22122 | 22199 | 22275 | - |
| H-151 | 21210 | 21298 | 21385 | 21471 | 21556 | 21640 | 21723 | 21805 | 21886 | 21966 | 22045 | 22123 | 22200 | 22276 | 22351 |
| H-152 | 21211 | 21299 | 21386 | 21472 | 21557 | 21641 | 21724 | 21806 | 21887 | 21967 | 22046 | 22124 | 22201 | 22277 | 22352 |
| H-153 | 21212 | 21300 | 21387 | 21473 | 21558 | 21642 | 21725 | 21807 | 21888 | 21968 | 22047 | 22125 | 22202 | 22278 | 22353 |
| H-154 | 21213 | 21301 | 21388 | 21474 | 21559 | 21643 | 21726 | 21808 | 21889 | 21969 | 22048 | 22126 | 22203 | 22279 | 22354 |
| H-155 | 21214 | 21302 | 21389 | 21475 | 21560 | 21644 | 21727 | 21809 | 21890 | 21970 | 22049 | 22127 | 22204 | 22280 | 22355 |
| H-156 | 21215 | 21303 | 21390 | 21476 | 21561 | 21645 | 21728 | 21810 | 21891 | 21971 | 22050 | 22128 | 22205 | 22281 | 22356 |
| H-157 | 21216 | 21304 | 21391 | 21477 | 21562 | 21646 | 21729 | 21811 | 21892 | 21972 | 22051 | 22129 | 22206 | 22282 | 22357 |
| H-158 | 21217 | 21305 | 21392 | 21478 | 21563 | 21647 | 21730 | 21812 | 21893 | 21973 | 22052 | 22130 | 22207 | 22283 | 22358 |
| H-159 | 21218 | 21306 | 21393 | 21479 | 21564 | 21648 | 21731 | 21813 | 21894 | 21974 | 22053 | 22131 | 22208 | 22284 | 22359 |
| H-160 | 21219 | 21307 | 21394 | 21480 | 21565 | 21649 | 21732 | 21814 | 21895 | 21975 | 22054 | 22132 | 22209 | 22285 | 22360 |

(continued)

| | H-136 | H-137 | H-138 | H-139 | H-140 | H-141 | H-142 | H-143 | H-144 | H-145 | H-146 | H-147 | H-148 | H-149 | H-150 |
|---|---|---|---|---|---|---|---|---|---|---|---|---|---|---|---|
| H-161 | 21220 | 21308 | 21395 | 21481 | 21566 | 21650 | 21733 | 21815 | 21896 | 21976 | 22055 | 22133 | 22210 | 22286 | 22361 |
| H-162 | 21221 | 21309 | 21396 | 21482 | 21567 | 21651 | 21734 | 21816 | 21897 | 21977 | 22056 | 22134 | 22211 | 22287 | 22362 |
| H-163 | 21222 | 21310 | 21397 | 21483 | 21568 | 21652 | 21735 | 21817 | 21898 | 21978 | 22057 | 22135 | 22212 | 22288 | 22363 |
| H-164 | 21223 | 21311 | 21398 | 21484 | 21569 | 21653 | 21736 | 21818 | 21899 | 21979 | 22058 | 22136 | 22213 | 22289 | 22364 |
| H-165 | 21224 | 21312 | 21399 | 21485 | 21570 | 21654 | 21737 | 21819 | 21900 | 21980 | 22059 | 22137 | 22214 | 22290 | 22365 |

Table 31

| | H-151 | H-152 | H-153 | H-154 | H-155 | H-156 | H-157 | H-158 | H-159 | H-160 | H-161 | H-162 | H-163 | H-164 | H-165 |
|---|---|---|---|---|---|---|---|---|---|---|---|---|---|---|---|
| H-111 | 18685 | 18686 | 18687 | 18688 | 18689 | 18690 | 18691 | 18692 | 18693 | 18694 | 18695 | 18696 | 18697 | 18698 | 18699 |
| H-112 | 18798 | 18799 | 18800 | 18801 | 18802 | 18803 | 18804 | 18805 | 18806 | 18807 | 18808 | 18809 | 18810 | 18811 | 18812 |
| H-113 | 18910 | 18911 | 18912 | 18913 | 18914 | 18915 | 18916 | 18917 | 18918 | 18919 | 18920 | 18921 | 18922 | 18923 | 18924 |
| H-114 | 19021 | 19022 | 19023 | 19024 | 19025 | 19026 | 19027 | 19028 | 19029 | 19030 | 19031 | 19032 | 19033 | 19034 | 19035 |
| H-115 | 19131 | 19132 | 19133 | 19134 | 19135 | 19136 | 19137 | 19138 | 19139 | 19140 | 19141 | 19142 | 19143 | 19144 | 19145 |
| H-116 | 19240 | 19241 | 19242 | 19243 | 19244 | 19245 | 19246 | 19247 | 19248 | 19249 | 19250 | 19251 | 19252 | 19253 | 19254 |
| H-117 | 19348 | 19349 | 19350 | 19351 | 19352 | 1 19353 | 19354 | 19355 | 19356 | 19357 | 19358 | 19359 | 19360 | 19361 | 19362 |
| H-118 | 19455 | 19456 | 19457 | 19458 | 19459 | 19460 | 19461 | 19462 | 19463 | 19464 | 19465 | 19466 | 19467 | 19468 | 19469 |
| H-119 | 19561 | 19562 | 19563 | 19564 | 19565 | 19566 | 19567 | 19568 | 19569 | 19570 | 19571 | 19572 | 19573 | 19574 | 19575 |
| H-120 | 19666 | 19667 | 19668 | 19669 | 19670 | 19671 | 19672 | 19673 | 19674 | 19675 | 19676 | 19677 | 19678 | 19679 | 19680 |
| H-121 | 19770 | 19771 | 19772 | 19773 | 19774 | 19775 | 19776 | 19777 | 19778 | 19779 | 19780 | 19781 | 19782 | 19783 | 19784 |
| H-122 | 19873 | 19874 | 19875 | 19876 | 19877 | 19878 | 19879 | 19880 | 19881 | 19882 | 19883 | 19884 | 19885 | 19886 | 19887 |
| H-123 | 19975 | 19976 | 19977 | 19978 | 19979 | 19980 | 19981 | 19982 | 19983 | 19984 | 19985 | 19986 | 19987 | 19988 | 19989 |
| H-124 | 20076 | 20077 | 20078 | 20079 | 20080 | 20081 | 20082 | 20083 | 20084 | 20085 | 20086 | 20087 | 20088 | 20089 | 20090 |
| H-125 | 20176 | 20177 | 20178 | 20179 | 20180 | 20181 | 20182 | 20183 | 20184 | 20185 | 20186 | 20187 | 20188 | 20189 | 20190 |
| H-126 | 20275 | 20276 | 20277 | 20278 | 20279 | 20280 | 20281 | 20282 | 20283 | 20284 | 20285 | 20286 | 20287 | 20288 | 20289 |
| H-127 | 20373 | 20374 | 20375 | 20376 | 20377 | 20378 | 20379 | 20380 | 20381 | 20382 | 20383 | 20384 | 20385 | 20386 | 20387 |
| H-128 | 20470 | 20471 | 20472 | 20473 | 20474 | 20475 | 20476 | 20477 | 20478 | 20479 | 20480 | 20481 | 20482 | 20483 | 20484 |
| H-129 | 20566 | 20567 | 20568 | 20569 | 20570 | 20571 | 20572 | 20573 | 20574 | 20575 | 20576 | 20577 | 20578 | 20579 | 20580 |
| H-130 | 20661 | 20662 | 20663 | 20664 | 20665 | 20666 | 20667 | 20668 | 20669 | 20670 | 20671 | 20672 | 20673 | 20674 | 20675 |
| H-131 | 20755 | 20756 | 20757 | 20758 | 20759 | 20760 | 20761 | 20762 | 20763 | 20764 | 20765 | 20766 | 20767 | 20768 | 20769 |
| H-132 | 20848 | 20849 | 20850 | 20851 | 20852 | 20853 | 20854 | 20855 | 20856 | 20857 | 20858 | 20859 | 20860 | 20861 | 20862 |
| H-133 | 20940 | 20941 | 20942 | 20943 | 20944 | 20945 | 20946 | 20947 | 20948 | 20949 | 20950 | 20951 | 20952 | 20953 | 20954 |
| H-134 | 21031 | 21032 | 21033 | 21034 | 21035 | 21036 | 21037 | 21038 | 21039 | 21040 | 21041 | 21042 | 21043 | 21044 | 21045 |
| H-135 | 21121 | 21122 | 21123 | 21124 | 21125 | 21126 | 21127 | 21128 | 21129 | 21130 | 21131 | 21132 | 21133 | 21134 | 21135 |

(continued)

| | H-151 | H-152 | H-153 | H-154 | H-155 | H-156 | H-157 | H-158 | H-159 | H-160 | H-161 | H-162 | H-163 | H-164 | H-165 |
|---|---|---|---|---|---|---|---|---|---|---|---|---|---|---|---|
| H-136 | 21210 | 21211 | 21212 | 21213 | 21214 | 21215 | 21216 | 21217 | 21218 | 21219 | 21220 | 21221 | 21222 | 21223 | 21224 |
| H-137 | 21298 | 21299 | 21300 | 21301 | 21302 | 21303 | 21304 | 21305 | 21306 | 21307 | 21308 | 21309 | 21310 | 21311 | 21312 |
| H-138 | 21385 | 21386 | 21387 | 21388 | 21389 | 21390 | 21391 | 21392 | 21393 | 21394 | 21395 | 21396 | 21397 | 21398 | 21399 |
| H-139 | 21471 | 21472 | 21473 | 21474 | 21475 | 21476 | 21477 | 21478 | 21479 | 21480 | 21481 | 21482 | 21483 | 21484 | 21485 |
| H-140 | 21556 | 21557 | 21558 | 21559 | 21560 | 21561 | 21562 | 21563 | 21564 | 21565 | 21566 | 21567 | 21568 | 21569 | 21570 |
| H-141 | 21640 | 21641 | 21642 | 21643 | 21644 | 21645 | 21646 | 21647 | 21648 | 21649 | 21650 | 21651 | 21652 | 21653 | 21654 |
| H-142 | 21723 | 21724 | 21725 | 21726 | 21727 | 21728 | 21729 | 21730 | 21731 | 21732 | 21733 | 21734 | 21735 | 21736 | 21737 |
| H-143 | 21805 | 21806 | 21807 | 21808 | 21809 | 21810 | 21811 | 21812 | 21813 | 21814 | 21815 | 21816 | 21817 | 21818 | 21819 |
| H-144 | 21886 | 21887 | 21888 | 21889 | 21890 | 21891 | 21892 | 21893 | 21894 | 21895 | 21896 | 21897 | 21898 | 21899 | 21900 |
| H-145 | 21966 | 21967 | 21968 | 21969 | 21970 | 21971 | 21972 | 21973 | 21974 | 21975 | 21976 | 21977 | 21978 | 21979 | 21980 |
| H-146 | 22045 | 22046 | 22047 | 22048 | 22049 | 22050 | 22051 | 22052 | 22053 | 22054 | 22055 | 22056 | 22057 | 22058 | 22059 |
| H-147 | 22123 | 22124 | 22125 | 22126 | 22127 | 22128 | 22129 | 22130 | 22131 | 22132 | 22133 | 22134 | 22135 | 22136 | 22137 |
| H-148 | 22200 | 22201 | 22202 | 22203 | 22204 | 22205 | 22206 | 22207 | 22208 | 22209 | 22210 | 22211 | 22212 | 22213 | 22214 |
| H-149 | 22276 | 22277 | 22278 | 22279 | 22280 | 22281 | 22282 | 22283 | 22284 | 22285 | 22286 | 22287 | 22288 | 22289 | 22290 |
| H-150 | 22351 | 22352 | 22353 | 22354 | 22355 | 22356 | 22357 | 22358 | 22359 | 22360 | 22361 | 22362 | 22363 | 22364 | 22365 |
| H-151 | - | 22426 | 22427 | 22428 | 22429 | 22430 | 22431 | 22432 | 22433 | 22434 | 22435 | 22436 | 22437 | 22438 | 22439 |
| H-152 | 22426 | - | 22500 | 22501 | 22502 | 22503 | 22504 | 22505 | 22506 | 22507 | 22508 | 22509 | 22510 | 22511 | 22512 |
| H-153 | 22427 | 22500 | - | 22573 | 22574 | 22575 | 22576 | 22577 | 22578 | 22579 | 22580 | 22581 | 22582 | 22583 | 22584 |
| H-154 | 22428 | 22501 | 22573 | - | 22645 | 22646 | 22647 | 22648 | 22649 | 22650 | 22651 | 22652 | 22653 | 22654 | 22655 |
| H-155 | 22429 | 22502 | 22574 | 22645 | - | 22716 | 22717 | 22718 | 22719 | 22720 | 22721 | 22722 | 22723 | 22724 | 22725 |
| H-156 | 22430 | 22503 | 22575 | 22646 | 22716 | - | 22786 | 22787 | 22788 | 22789 | 22790 | 22791 | 22792 | 22793 | 22794 |
| H-157 | 22431 | 22504 | 22576 | 22647 | 22717 | 22786 | - | 22855 | 22856 | 22857 | 22858 | 22859 | 22860 | 22861 | 22862 |
| H-158 | 22432 | 22505 | 22577 | 22648 | 22718 | 22787 | 22855 | - | 22923 | 22924 | 22925 | 22926 | 22927 | 22928 | 22929 |
| H-159 | 22433 | 22506 | 22578 | 22649 | 22719 | 22788 | 22856 | 22923 | - | 22990 | 22991 | 22992 | 22993 | 22994 | 22995 |
| H-160 | 22434 | 22507 | 22579 | 22650 | 22720 | 22789 | 22857 | 22924 | 22990 | - | 23056 | 23057 | 23058 | 23059 | 23060 |

(continued)

| | H-151 | H-152 | H-153 | H-154 | H-155 | H-156 | H-157 | H-158 | H-159 | H-160 | H-161 | H-162 | H-163 | H-164 | H-165 |
|---|---|---|---|---|---|---|---|---|---|---|---|---|---|---|---|
| H-161 | 22435 | 22508 | 22580 | 22651 | 22721 | 22790 | 22858 | 22925 | 22991 | 23056 | - | 23121 | 23122 | 23123 | 23124 |
| H-162 | 22436 | 22509 | 22581 | 22652 | 22722 | 22791 | 22859 | 22926 | 22992 | 23057 | 23121 | - | 23185 | 23186 | 23187 |
| H-163 | 22437 | 22510 | 22582 | 22653 | 22723 | 22792 | 22860 | 22927 | 22993 | 23058 | 23122 | 23185 | - | 23248 | 23249 |
| H-164 | 22438 | 22511 | 22583 | 22654 | 22724 | 22793 | 22861 | 22928 | 22994 | 23059 | 23123 | 23186 | 23248 | - | 23310 |
| H-165 | 22439 | 22512 | 22584 | 22655 | 22725 | 22794 | 22862 | 22929 | 22995 | 23060 | 23124 | 23187 | 23249 | 23310 | - |

Table 32

| | H-166 | H-167 | H-168 | H-169 | H-170 | H-171 | H-172 | H-173 | H-174 | H-175 | H-176 | H-177 | H-178 | H-179 | H-180 |
|---|---|---|---|---|---|---|---|---|---|---|---|---|---|---|---|
| H-111 | 18700 | 18701 | 18702 | 18703 | 18704 | 18705 | 18706 | 18707 | 18708 | 18709 | 18710 | 18711 | 18712 | 18713 | 18714 |
| H-112 | 18813 | 18814 | 18815 | 18816 | 18817 | 18818 | 18819 | 18820 | 18821 | 18822 | 18823 | 18824 | 18825 | 18826 | 18827 |
| H-113 | 18925 | 18926 | 18927 | 18928 | 18929 | 18930 | 18931 | 18932 | 18933 | 18934 | 18935 | 18936 | 18937 | 18938 | 18939 |
| H-114 | 19036 | 19037 | 19038 | 19039 | 19040 | 19041 | 19042 | 19043 | 19044 | 19045 | 19046 | 19047 | 19048 | 19049 | 19050 |
| H-115 | 19146 | 19147 | 19148 | 19149 | 19150 | 19151 | 19152 | 19153 | 19154 | 19155 | 19156 | 19157 | 19158 | 19159 | 19160 |
| H-116 | 19255 | 19256 | 19257 | 19258 | 19259 | 19260 | 19261 | 19262 | 19263 | 19264 | 19265 | 19266 | 19267 | 19268 | 19269 |
| H-117 | 19363 | 19364 | 19365 | 19366 | 19367 | 19368 | 19369 | 19370 | 19371 | 19372 | 19373 | 19374 | 19375 | 19376 | 19377 |
| H-118 | 19470 | 19471 | 19472 | 19473 | 19474 | 19475 | 19476 | 19477 | 19478 | 19479 | 19480 | 19481 | 19482 | 19483 | 19484 |
| H-119 | 19576 | 19577 | 19578 | 19579 | 19580 | 19581 | 19582 | 19583 | 19584 | 19585 | 19586 | 19587 | 19588 | 19589 | 19590 |
| H-120 | 19681 | 19682 | 19683 | 19684 | 19685 | 19686 | 19687 | 19688 | 19689 | 19690 | 19691 | 19692 | 19693 | 19694 | 19695 |
| H-121 | 19785 | 19786 | 19787 | 19788 | 19789 | 19790 | 19791 | 19792 | 19793 | 19794 | 19795 | 19796 | 19797 | 19798 | 19799 |
| H-122 | 19888 | 19889 | 19890 | 19891 | 19892 | 19893 | 19894 | 19895 | 19896 | 19897 | 19898 | 19899 | 19900 | 19901 | 19902 |
| H-123 | 19990 | 19991 | 19992 | 19993 | 19994 | 19995 | 19996 | 19997 | 19998 | 19999 | 20000 | 20001 | 20002 | 20003 | 20004 |
| H-124 | 20091 | 20092 | 20093 | 20094 | 20095 | 20096 | 20097 | 20098 | 20099 | 20100 | 20101 | 20102 | 20103 | 20104 | 20105 |
| H-125 | 20191 | 20192 | 20193 | 20194 | 20195 | 20196 | 20197 | 20198 | 20199 | 20200 | 20201 | 20202 | 20203 | 20204 | 20205 |
| H-126 | 20290 | 20291 | 20292 | 20293 | 20294 | 20295 | 20296 | 20297 | 20298 | 20299 | 20300 | 20301 | 20302 | 20303 | 20304 |
| H-127 | 20388 | 20389 | 20390 | 20391 | 20392 | 20393 | 20394 | 20395 | 20396 | 20397 | 20398 | 20399 | 20400 | 20401 | 20402 |
| H-128 | 20485 | 20486 | 20487 | 20488 | 20489 | 20490 | 20491 | 20492 | 20493 | 20494 | 20495 | 20496 | 20497 | 20498 | 20499 |
| H-129 | 20581 | 20582 | 20583 | 20584 | 20585 | 20586 | 20587 | 20588 | 20589 | 20590 | 20591 | 20592 | 20593 | 20594 | 20595 |
| H-130 | 20676 | 20677 | 20678 | 20679 | 20680 | 20681 | 20682 | 20683 | 20684 | 20685 | 20686 | 20687 | 20688 | 20689 | 20690 |
| H-131 | 20770 | 20771 | 20772 | 20773 | 20774 | 20775 | 20776 | 20777 | 20778 | 20779 | 20780 | 20781 | 20782 | 20783 | 20784 |
| H-132 | 20863 | 20864 | 20865 | 20866 | 20867 | 20868 | 20869 | 20870 | 20871 | 20872 | 20873 | 20874 | 20875 | 20876 | 20877 |
| H-133 | 20955 | 20956 | 20957 | 20958 | 20959 | 20960 | 20961 | 20962 | 20963 | 20964 | 20965 | 20966 | 20967 | 20968 | 20969 |
| H-134 | 21046 | 21047 | 21048 | 21049 | 21050 | 21051 | 21052 | 21053 | 21054 | 21055 | 21056 | 21057 | 21058 | 21059 | 21060 |
| H-135 | 21136 | 21137 | 21138 | 21139 | 21140 | 21141 | 21142 | 21143 | 21144 | 21145 | 21146 | 21147 | 21148 | 21149 | 21150 |

(continued)

| | H-166 | H-167 | H-168 | H-169 | H-170 | H-171 | H-172 | H-173 | H-174 | H-175 | H-176 | H-177 | H-178 | H-179 | H-180 |
|---|---|---|---|---|---|---|---|---|---|---|---|---|---|---|---|
| H-136 | 21225 | 21226 | 21227 | 21228 | 21229 | 21230 | 21231 | 21232 | 21233 | 21234 | 21235 | 21236 | 21237 | 21238 | 21239 |
| H-137 | 21313 | 21314 | 21315 | 21316 | 21317 | 21318 | 21319 | 21320 | 21321 | 21322 | 21323 | 21324 | 21325 | 21326 | 21327 |
| H-138 | 21400 | 21401 | 21402 | 21403 | 21404 | 21405 | 21406 | 21407 | 21408 | 21409 | 21410 | 21411 | 21412 | 21413 | 21414 |
| H-139 | 21486 | 21487 | 21488 | 21489 | 21490 | 21491 | 21492 | 21493 | 21494 | 21495 | 21496 | 21497 | 21498 | 21499 | 21500 |
| H-140 | 21571 | 21572 | 21573 | 21574 | 21575 | 21576 | 21577 | 21578 | 21579 | 21580 | 21581 | 21582 | 21583 | 21584 | 21585 |
| H-141 | 21655 | 21656 | 21657 | 21658 | 21659 | 21660 | 21661 | 21662 | 21663 | 21664 | 21665 | 21666 | 21667 | 21668 | 21669 |
| H-142 | 21738 | 21739 | 21740 | 21741 | 21742 | 21743 | 21744 | 21745 | 21746 | 21747 | 21748 | 21749 | 21750 | 21751 | 21752 |
| H-143 | 21820 | 21821 | 21822 | 21823 | 21824 | 21825 | 21826 | 21827 | 21828 | 21829 | 21830 | 21831 | 21832 | 21833 | 21834 |
| H-144 | 21901 | 21902 | 21903 | 21904 | 21905 | 21906 | 21907 | 21908 | 21909 | 21910 | 21911 | 21912 | 21913 | 21914 | 21915 |
| H-145 | 21981 | 21982 | 21983 | 21984 | 21985 | 21986 | 21987 | 21988 | 21989 | 21990 | 21991 | 21992 | 21993 | 21994 | 21995 |
| H-146 | 22060 | 22061 | 22062 | 22063 | 22064 | 22065 | 22066 | 22067 | 22068 | 22069 | 22070 | 22071 | 22072 | 22073 | 22074 |
| H-147 | 22138 | 22139 | 22140 | 22141 | 22142 | 22143 | 22144 | 22145 | 22146 | 22147 | 22148 | 22149 | 22150 | 22151 | 22152 |
| H-148 | 22215 | 22216 | 22217 | 22218 | 22219 | 22220 | 22221 | 22222 | 22223 | 22224 | 22225 | 22226 | 22227 | 22228 | 22229 |
| H-149 | 22291 | 22292 | 22293 | 22294 | 22295 | 22296 | 22297 | 22298 | 22299 | 22300 | 22301 | 22302 | 22303 | 22304 | 22305 |
| H-150 | 22366 | 22367 | 22368 | 22369 | 22370 | 22371 | 22372 | 22373 | 22374 | 22375 | 22376 | 22377 | 22378 | 22379 | 22380 |
| H-151 | 22440 | 22441 | 22442 | 22443 | 22444 | 22445 | 22446 | 22447 | 22448 | 22449 | 22450 | 22451 | 22452 | 22453 | 22454 |
| H-152 | 22513 | 22514 | 22515 | 22516 | 22517 | 22518 | 22519 | 22520 | 22521 | 22522 | 22523 | 22524 | 22525 | 22526 | 22527 |
| H-153 | 22585 | 22586 | 22587 | 22588 | 22589 | 22590 | 22591 | 22592 | 22593 | 22594 | 22595 | 22596 | 22597 | 22598 | 22599 |
| H-154 | 22656 | 22657 | 22658 | 22659 | 22660 | 22661 | 22662 | 22663 | 22664 | 22665 | 22666 | 22667 | 22668 | 22669 | 22670 |
| H-155 | 22726 | 22727 | 22728 | 22729 | 22730 | 22731 | 22732 | 22733 | 22734 | 22735 | 22736 | 22737 | 22738 | 22739 | 22740 |
| H-156 | 22795 | 22796 | 22797 | 22798 | 22799 | 22800 | 22801 | 22802 | 22803 | 22804 | 22805 | 22806 | 22807 | 22808 | 22809 |
| H-157 | 22863 | 22864 | 22865 | 22866 | 22867 | 22868 | 22869 | 22870 | 22871 | 22872 | 22873 | 22874 | 22875 | 22876 | 22877 |
| H-158 | 22930 | 22931 | 22932 | 22933 | 22934 | 22935 | 22936 | 22937 | 22938 | 22939 | 22940 | 22941 | 22942 | 22943 | 22944 |
| H-159 | 22996 | 22997 | 22998 | 22999 | 23000 | 23001 | 23002 | 23003 | 23004 | 23005 | 23006 | 23007 | 23008 | 23009 | 23010 |
| H-160 | 23061 | 23062 | 23063 | 23064 | 23065 | 23066 | 23067 | 23068 | 23069 | 23070 | 23071 | 23072 | 23073 | 23074 | 23075 |

(continued)

| | H-166 | H-167 | H-168 | H-169 | H-170 | H-171 | H-172 | H-173 | H-174 | H-175 | H-176 | H-177 | H-178 | H-179 | H-180 |
|---|---|---|---|---|---|---|---|---|---|---|---|---|---|---|---|
| H-161 | 23125 | 23126 | 23127 | 23128 | 23129 | 23130 | 23131 | 23132 | 23133 | 23134 | 23135 | 23136 | 23137 | 23138 | 23139 |
| H-162 | 23188 | 23189 | 23190 | 23191 | 23192 | 23193 | 23194 | 23195 | 23196 | 23197 | 23198 | 23199 | 23200 | 23201 | 23202 |
| H-163 | 23250 | 23251 | 23252 | 23253 | 23254 | 23255 | 23256 | 23257 | 23258 | 23259 | 23260 | 23261 | 23262 | 23263 | 23264 |
| H-164 | 23311 | 23312 | 23313 | 23314 | 23315 | 23316 | 23317 | 23318 | 23319 | 23320 | 23321 | 23322 | 23323 | 23324 | 23325 |
| H-165 | 23371 | 23372 | 23373 | 23374 | 23375 | 23376 | 23377 | 23378 | 23379 | 23380 | 23381 | 23382 | 23383 | 23384 | 23385 |

Table 33

| | H-181 | H-182 | H-183 | H-184 | H-185 | H-186 | H-187 | H-188 | H-189 | H-190 | H-191 | H-192 | H-193 | H-194 | H-195 |
|---|---|---|---|---|---|---|---|---|---|---|---|---|---|---|---|
| H-111 | 18715 | 18716 | 18717 | 18718 | 18719 | 18720 | 18721 | 18722 | 18723 | 18724 | 18725 | 18726 | 18727 | 18728 | 18729 |
| H-112 | 18828 | 18829 | 18830 | 18831 | 18832 | 18833 | 18834 | 18835 | 18836 | 18837 | 18838 | 18839 | 18840 | 18841 | 18842 |
| H-113 | 18940 | 18941 | 18942 | 18943 | 18944 | 18945 | 18946 | 18947 | 18948 | 18949 | 18950 | 18951 | 18952 | 18953 | 18954 |
| H-114 | 19051 | 19052 | 19053 | 19054 | 19055 | 19056 | 19057 | 19058 | 19059 | 19060 | 19061 | 19062 | 19063 | 19064 | 19065 |
| H-115 | 19161 | 19162 | 19163 | 19164 | 19165 | 19166 | 19167 | 19168 | 19169 | 19170 | 19171 | 19172 | 19173 | 19174 | 19175 |
| H-116 | 19270 | 19271 | 19272 | 19273 | 19274 | 19275 | 19276 | 19277 | 19278 | 19279 | 19280 | 19281 | 19282 | 19283 | 19284 |
| H-117 | 19378 | 19379 | 19380 | 19381 | 19382 | 19383 | 19384 | 19385 | 19386 | 19387 | 19388 | 19389 | 19390 | 19391 | 19392 |
| H-118 | 19485 | 19486 | 19487 | 19488 | 19489 | 19490 | 19491 | 19492 | 19493 | 19494 | 19495 | 19496 | 19497 | 19498 | 19499 |
| H-119 | 19591 | 19592 | 19593 | 19594 | 19595 | 19596 | 19597 | 19598 | 19599 | 19600 | 19601 | 19602 | 19603 | 19604 | 19605 |
| H-120 | 19696 | 19697 | 19698 | 19699 | 19700 | 19701 | 19702 | 19703 | 19704 | 19705 | 19706 | 19707 | 19708 | 19709 | 19710 |
| H-121 | 19800 | 19801 | 19802 | 19803 | 19804 | 19805 | 19806 | 19807 | 19808 | 19809 | 19810 | 19811 | 19812 | 19813 | 19814 |
| H-122 | 19903 | 19904 | 19905 | 19906 | 19907 | 19908 | 19909 | 19910 | 19911 | 19912 | 19913 | 19914 | 19915 | 19916 | 19917 |
| H-123 | 20005 | 20006 | 20007 | 20008 | 20009 | 20010 | 20011 | 20012 | 20013 | 20014 | 20015 | 20016 | 20017 | 20018 | 20019 |
| H-124 | 20106 | 20107 | 20108 | 20109 | 20110 | 20111 | 20112 | 20113 | 20114 | 20115 | 20116 | 20117 | 20118 | 20119 | 20120 |
| H-125 | 20206 | 20207 | 20208 | 20209 | 20210 | 20211 | 20212 | 20213 | 20214 | 20215 | 20216 | 20217 | 20218 | 20219 | 20220 |
| H-126 | 20305 | 20306 | 20307 | 20308 | 20309 | 20310 | 20311 | 20312 | 20313 | 20314 | 20315 | 20316 | 20317 | 20318 | 20319 |
| H-127 | 20403 | 20404 | 20405 | 20406 | 20407 | 20408 | 20409 | 20410 | 20411 | 20412 | 20413 | 20414 | 20415 | 20416 | 20417 |
| H-128 | 20500 | 20501 | 20502 | 20503 | 20504 | 20505 | 20506 | 20507 | 20508 | 20509 | 20510 | 20511 | 20512 | 20513 | 20514 |
| H-129 | 20596 | 20597 | 20598 | 20599 | 20600 | 20601 | 20602 | 20603 | 20604 | 20605 | 20606 | 20607 | 20608 | 20609 | 20610 |
| H-130 | 20691 | 20692 | 20693 | 20694 | 20695 | 20696 | 20697 | 20698 | 20699 | 20700 | 20701 | 20702 | 20703 | 20704 | 20705 |
| H-131 | 20785 | 20786 | 20787 | 20788 | 20789 | 20790 | 20791 | 20792 | 20793 | 20794 | 20795 | 20796 | 20797 | 20798 | 20799 |
| H-132 | 20878 | 20879 | 20880 | 20861 | 20882 | 20883 | 20884 | 20885 | 20886 | 20887 | 20888 | 20889 | 20890 | 20891 | 20892 |
| H-133 | 20970 | 20971 | 20972 | 20973 | 20974 | 20975 | 20976 | 20977 | 20978 | 20979 | 20980 | 20981 | 20982 | 20983 | 20984 |
| H-134 | 21061 | 21062 | 21063 | 21064 | 21065 | 21066 | 21067 | 21068 | 21069 | 21070 | 21071 | 21072 | 21073 | 21074 | 21075 |
| H-135 | 21151 | 21152 | 21153 | 21154 | 21155 | 21156 | 21157 | 21158 | 21159 | 21160 | 21161 | 21162 | 21163 | 21164 | 21165 |

(continued)

| | H-181 | H-182 | H-183 | H-184 | H-185 | H-186 | H-187 | H-188 | H-189 | H-190 | H-191 | H-192 | H-193 | H-194 | H-195 |
|---|---|---|---|---|---|---|---|---|---|---|---|---|---|---|---|
| H-136 | 21240 | 21241 | 21242 | 21243 | 21244 | 21245 | 21246 | 21247 | 21248 | 21249 | 21250 | 21251 | 21252 | 21253 | 21254 |
| H-137 | 21328 | 21329 | 21330 | 21331 | 21332 | 21333 | 21334 | 21335 | 21336 | 21337 | 21338 | 21339 | 21340 | 21341 | 21342 |
| H-138 | 21415 | 21416 | 21417 | 21418 | 21419 | 21420 | 21421 | 21422 | 21423 | 21424 | 21425 | 21426 | 21427 | 21428 | 21429 |
| H-139 | 21501 | 21502 | 21503 | 21504 | 21505 | 21506 | 21507 | 21508 | 21509 | 21510 | 21511 | 21512 | 21513 | 21514 | 21515 |
| H-140 | 21586 | 21587 | 21588 | 21589 | 21590 | 21591 | 21592 | 21593 | 21594 | 21595 | 21596 | 21597 | 21598 | 21599 | 21600 |
| H-141 | 21670 | 21671 | 21672 | 21673 | 21674 | 21675 | 21676 | 21677 | 21678 | 21679 | 21680 | 21681 | 21682 | 21683 | 21684 |
| H-142 | 21753 | 21754 | 21755 | 21756 | 21757 | 21758 | 21759 | 21760 | 21761 | 21762 | 21763 | 21764 | 21765 | 21766 | 21767 |
| H-143 | 21835 | 21836 | 21837 | 21838 | 21839 | 21840 | 21841 | 21842 | 21843 | 21844 | 21845 | 21846 | 21847 | 21848 | 21849 |
| H-144 | 21916 | 21917 | 21918 | 21919 | 21920 | 21921 | 21922 | 21923 | 21924 | 21925 | 21926 | 21927 | 21928 | 21929 | 21930 |
| H-145 | 21996 | 21997 | 21998 | 21999 | 22000 | 22001 | 22002 | 22003 | 22004 | 22005 | 22006 | 22007 | 22008 | 22009 | 22010 |
| H-146 | 22075 | 22076 | 22077 | 22078 | 22079 | 22080 | 22081 | 22082 | 22083 | 22084 | 22085 | 22086 | 22087 | 22088 | 22089 |
| H-147 | 22153 | 22154 | 22155 | 22156 | 22157 | 22158 | 22159 | 22160 | 22161 | 22162 | 22163 | 22164 | 22165 | 22166 | 22167 |
| H-148 | 22230 | 22231 | 22232 | 22233 | 22234 | 22235 | 22236 | 22237 | 22238 | 22239 | 22240 | 22241 | 22242 | 22243 | 22244 |
| H-149 | 22306 | 22307 | 22308 | 22309 | 22310 | 22311 | 22312 | 22313 | 22314 | 22315 | 22316 | 22317 | 22318 | 22319 | 22320 |
| H-150 | 22381 | 22382 | 22383 | 22384 | 22385 | 22386 | 22387 | 22388 | 22389 | 22390 | 22391 | 22392 | 22393 | 22394 | 22395 |
| H-151 | 22455 | 22456 | 22457 | 22458 | 22459 | 22460 | 22461 | 22462 | 22463 | 22464 | 22465 | 22466 | 22467 | 22468 | 22469 |
| H-152 | 22528 | 22529 | 22530 | 22531 | 22532 | 22533 | 22534 | 22535 | 22536 | 22537 | 22538 | 22539 | 22540 | 22541 | 22542 |
| H-153 | 22600 | 22601 | 22602 | 22603 | 22604 | 22605 | 22606 | 22607 | 22608 | 22609 | 22610 | 22611 | 22612 | 22613 | 22614 |
| H-154 | 22671 | 22672 | 22673 | 22674 | 22675 | 22676 | 22677 | 22678 | 22679 | 22680 | 22681 | 22682 | 22683 | 22684 | 22685 |
| H-155 | 22741 | 22742 | 22743 | 22744 | 22745 | 22746 | 22747 | 22748 | 22749 | 22750 | 22751 | 22752 | 22753 | 22754 | 22755 |
| H-156 | 22810 | 22811 | 22812 | 22813 | 22814 | 22815 | 22816 | 22817 | 22818 | 22819 | 22820 | 22821 | 22822 | 22823 | 22824 |
| H-157 | 22878 | 22879 | 22880 | 22881 | 22882 | 22883 | 22884 | 22885 | 22886 | 22887 | 22888 | 22889 | 22890 | 22891 | 22892 |
| H-158 | 22945 | 22946 | 22947 | 22948 | 22949 | 22950 | 22951 | 22952 | 22953 | 22954 | 22955 | 22956 | 22957 | 22958 | 22959 |
| H-159 | 23011 | 23012 | 23013 | 23014 | 23015 | 23016 | 23017 | 23018 | 23019 | 23020 | 23021 | 23022 | 23023 | 23024 | 23025 |
| H-160 | 23076 | 23077 | 23078 | 23079 | 23080 | 23081 | 23082 | 23083 | 23084 | 23085 | 23086 | 23087 | 23088 | 23089 | 23090 |

(continued)

| | H-181 | H-182 | H-183 | H-184 | H-185 | H-186 | H-187 | H-188 | H-189 | H-190 | H-191 | H-192 | H-193 | H-194 | H-195 |
|---|---|---|---|---|---|---|---|---|---|---|---|---|---|---|---|
| H-161 | 23140 | 23141 | 23142 | 23143 | 23144 | 23145 | 23146 | 23147 | 23148 | 23149 | 23150 | 23151 | 23152 | 23153 | 23154 |
| H-162 | 23203 | 23204 | 23205 | 23206 | 23207 | 23208 | 23209 | 23210 | 23211 | 23212 | 23213 | 23214 | 23215 | 23216 | 23217 |
| H-163 | 23265 | 23266 | 23267 | 23268 | 23269 | 23270 | 23271 | 23272 | 23273 | 23274 | 23275 | 23276 | 23277 | 23278 | 23279 |
| H-164 | 23326 | 23327 | 23328 | 23329 | 23330 | 23331 | 23332 | 23333 | 23334 | 23335 | 23336 | 23337 | 23338 | 23339 | 23340 |
| H-165 | 23386 | 23387 | 23388 | 23389 | 23390 | 23391 | 23392 | 23393 | 23394 | 23395 | 23396 | 23397 | 23398 | 23399 | 23400 |

Table 34

| | H-196 | H-197 | H-198 | H-199 | H-200 | H-201 | H-202 | H-203 | H-204 | H-205 | H-206 | H-207 | H-208 | H-209 | H-210 |
|---|---|---|---|---|---|---|---|---|---|---|---|---|---|---|---|
| H-111 | 18730 | 18731 | 18732 | 18733 | 18734 | 18735 | 18736 | 18737 | 18738 | 18739 | 18740 | 18741 | 18742 | 18743 | 18744 |
| H-112 | 18843 | 18844 | 18845 | 18846 | 18847 | 18848 | 18849 | 18850 | 18851 | 18852 | 18853 | 18854 | 18855 | 18856 | 18857 |
| H-113 | 18955 | 18956 | 18957 | 18958 | 18959 | 18960 | 18961 | 18962 | 18963 | 18964 | 18965 | 18966 | 18967 | 18968 | 18969 |
| H-114 | 19066 | 19067 | 19068 | 19069 | 19070 | 19071 | 19072 | 19073 | 19074 | 19075 | 19076 | 19077 | 19078 | 19079 | 19080 |
| H-115 | 19176 | 19177 | 19178 | 19179 | 19180 | 19181 | 19182 | 19183 | 19184 | 19185 | 19186 | 19187 | 19188 | 19189 | 19190 |
| H-116 | 19285 | 19286 | 19287 | 19288 | 19289 | 19290 | 19291 | 19292 | 19293 | 19294 | 19295 | 19296 | 19297 | 19298 | 19299 |
| H-117 | 19393 | 19394 | 19395 | 19396 | 19397 | 19398 | 19399 | 19400 | 19401 | 19402 | 19403 | 19404 | 19405 | 19406 | 19407 |
| H-118 | 19500 | 19501 | 19502 | 19503 | 19504 | 19505 | 19506 | 19507 | 19508 | 19509 | 19510 | 19511 | 19512 | 19513 | 19514 |
| H-119 | 19606 | 19607 | 19608 | 19609 | 19610 | 19611 | 19612 | 19613 | 19614 | 19615 | 19616 | 19617 | 19618 | 19619 | 19620 |
| H-120 | 19711 | 19712 | 19713 | 19714 | 19715 | 19716 | 19717 | 19718 | 19719 | 19720 | 19721 | 19722 | 19723 | 19724 | 19725 |
| H-121 | 19815 | 19816 | 19817 | 19818 | 19819 | 19820 | 19821 | 19822 | 19823 | 19824 | 19825 | 19826 | 19827 | 19828 | 19829 |
| H-122 | 19918 | 19919 | 19920 | 19921 | 19922 | 19923 | 19924 | 19925 | 19926 | 19927 | 19928 | 19929 | 19930 | 19931 | 19932 |
| H-123 | 20020 | 20021 | 20022 | 20023 | 20024 | 20025 | 20026 | 20027 | 20028 | 20029 | 20030 | 20031 | 20032 | 20033 | 20034 |
| H-124 | 20121 | 20122 | 20123 | 20124 | 20125 | 20126 | 20127 | 20128 | 20129 | 20130 | 20131 | 20132 | 20133 | 20134 | 20135 |
| H-125 | 20221 | 20222 | 20223 | 20224 | 20225 | 20226 | 20227 | 20228 | 20229 | 20230 | 20231 | 20232 | 20233 | 20234 | 20235 |
| H-126 | 20320 | 20321 | 20322 | 20323 | 20324 | 20325 | 20326 | 20327 | 20328 | 20329 | 20330 | 20331 | 20332 | 20333 | 20334 |
| H-127 | 20418 | 20419 | 20420 | 20421 | 20422 | 20423 | 20424 | 20425 | 20426 | 20427 | 20428 | 20429 | 20430 | 20431 | 20432 |
| H-128 | 20515 | 20516 | 20517 | 20518 | 20519 | 20520 | 20521 | 20522 | 20523 | 20524 | 20525 | 20526 | 20527 | 20528 | 20529 |
| H-129 | 20611 | 20612 | 20613 | 20614 | 20615 | 20616 | 20617 | 20618 | 20619 | 20620 | 20621 | 20622 | 20623 | 20624 | 20625 |
| H-130 | 20706 | 20707 | 20708 | 20709 | 20710 | 20711 | 20712 | 20713 | 20714 | 20715 | 20716 | 20717 | 20718 | 20719 | 20720 |
| H-131 | 20800 | 20801 | 20802 | 20803 | 20804 | 20805 | 20806 | 20807 | 20808 | 20809 | 20810 | 20811 | 20812 | 20813 | 20814 |
| H-132 | 20893 | 20894 | 20895 | 20896 | 20897 | 20898 | 20899 | 20900 | 20901 | 20902 | 20903 | 20904 | 20905 | 20906 | 20907 |
| H-133 | 20985 | 20986 | 20987 | 20988 | 20989 | 20990 | 20991 | 20992 | 20993 | 20994 | 20995 | 20996 | 20997 | 20998 | 20999 |
| H-134 | 21076 | 21077 | 21078 | 21079 | 21080 | 21081 | 21082 | 21083 | 21084 | 21085 | 21086 | 21087 | 21088 | 21089 | 21090 |
| H-135 | 21166 | 21167 | 21168 | 21169 | 21170 | 21171 | 21172 | 21173 | 21174 | 21175 | 21176 | 21177 | 21178 | 21179 | 21180 |

(continued)

| | H-196 | H-197 | H-198 | H-199 | H-200 | H-201 | H-202 | H-203 | H-204 | H-205 | H-206 | H-207 | H-208 | H-209 | H-210 |
|---|---|---|---|---|---|---|---|---|---|---|---|---|---|---|---|
| H-136 | 21255 | 21256 | 21257 | 21258 | 21259 | 21260 | 21261 | 21262 | 21263 | 21264 | 21265 | 21266 | 21267 | 21268 | 21269 |
| H-137 | 21343 | 21344 | 21345 | 21346 | 21347 | 21348 | 21349 | 21350 | 21351 | 21352 | 21353 | 21354 | 21355 | 21356 | 21357 |
| H-138 | 21430 | 21431 | 21432 | 21433 | 21434 | 21435 | 21436 | 21437 | 21438 | 21439 | 21440 | 21441 | 21442 | 21443 | 21444 |
| H-139 | 21516 | 21517 | 21518 | 21519 | 21520 | 21521 | 21522 | 21523 | 21524 | 21525 | 21526 | 21527 | 21528 | 21529 | 21530 |
| H-140 | 21601 | 21602 | 21603 | 21604 | 21605 | 21606 | 21607 | 21608 | 21609 | 21610 | 21611 | 21612 | 21613 | 21614 | 21615 |
| H-141 | 21685 | 21686 | 21687 | 21688 | 21689 | 21690 | 21691 | 21692 | 21693 | 21694 | 21695 | 21696 | 21697 | 21698 | 21699 |
| H-142 | 21768 | 21769 | 21770 | 21771 | 21772 | 21773 | 21774 | 21775 | 21776 | 21777 | 21778 | 21779 | 21780 | 21781 | 21782 |
| H-143 | 21850 | 21851 | 21852 | 21853 | 21854 | 21855 | 21856 | 21857 | 21858 | 21859 | 21860 | 21861 | 21862 | 21863 | 21864 |
| H-144 | 21931 | 21932 | 21933 | 21934 | 21935 | 21936 | 21937 | 21938 | 21939 | 21940 | 21941 | 21942 | 21943 | 21944 | 21945 |
| H-145 | 22011 | 22012 | 22013 | 22014 | 22015 | 22016 | 22017 | 22018 | 22019 | 22020 | 22021 | 22022 | 22023 | 22024 | 22025 |
| H-146 | 22090 | 22091 | 22092 | 22093 | 22094 | 22095 | 22096 | 22097 | 22098 | 22099 | 22100 | 22101 | 22102 | 22103 | 22104 |
| H-147 | 22168 | 22169 | 22170 | 22171 | 22172 | 22173 | 22174 | 22175 | 22176 | 22177 | 22178 | 22179 | 22180 | 22181 | 22182 |
| H-148 | 22245 | 22246 | 22247 | 22248 | 22249 | 22250 | 22251 | 22252 | 22253 | 22254 | 22255 | 22256 | 22257 | 22258 | 22259 |
| H-149 | 22321 | 22322 | 22323 | 22324 | 22325 | 22326 | 22327 | 22328 | 22329 | 22330 | 22331 | 22332 | 22333 | 22334 | 22335 |
| H-150 | 22396 | 22397 | 22398 | 22399 | 22400 | 22401 | 22402 | 22403 | 22404 | 22405 | 22406 | 22407 | 22408 | 22409 | 22410 |
| H-151 | 22470 | 22471 | 22472 | 22473 | 22474 | 22475 | 22476 | 22477 | 22478 | 22479 | 22480 | 22481 | 22482 | 22483 | 22484 |
| H-152 | 22543 | 22544 | 22545 | 22546 | 22547 | 22548 | 22549 | 22550 | 22551 | 22552 | 22553 | 22554 | 22555 | 22556 | 22557 |
| H-153 | 22615 | 22616 | 22617 | 22618 | 22619 | 22620 | 22621 | 22622 | 22623 | 22624 | 22625 | 22626 | 22627 | 22628 | 22629 |
| H-154 | 22686 | 22687 | 22688 | 22689 | 22690 | 22691 | 22692 | 22693 | 22694 | 22695 | 22696 | 22697 | 22698 | 22699 | 22700 |
| H-155 | 22756 | 22757 | 22758 | 22759 | 22760 | 22761 | 22762 | 22763 | 22764 | 22765 | 22766 | 22767 | 22768 | 22769 | 22770 |
| H-156 | 22825 | 22826 | 22827 | 22828 | 22829 | 22830 | 22831 | 22832 | 22833 | 22834 | 22835 | 22836 | 22837 | 22838 | 22839 |
| H-157 | 22893 | 22894 | 22895 | 22896 | 22897 | 22898 | 22899 | 22900 | 22901 | 22902 | 22903 | 22904 | 22905 | 22906 | 22907 |
| H-158 | 22960 | 22961 | 22962 | 22963 | 22964 | 22965 | 22966 | 22967 | 22968 | 22969 | 22970 | 22971 | 22972 | 22973 | 22974 |
| H-159 | 23026 | 23027 | 23028 | 23029 | 23030 | 23031 | 23032 | 23033 | 23034 | 23035 | 23036 | 23037 | 23038 | 23039 | 23040 |
| H-160 | 23091 | 23092 | 23093 | 23094 | 23095 | 23096 | 23097 | 23098 | 23099 | 23100 | 23101 | 23102 | 23103 | 23104 | 23105 |

(continued)

| | H-196 | H-197 | H-198 | H-199 | H-200 | H-201 | H-202 | H-203 | H-204 | H-205 | H-206 | H-207 | H-208 | H-209 | H-210 |
|---|---|---|---|---|---|---|---|---|---|---|---|---|---|---|---|
| H-161 | 23155 | 23156 | 23157 | 23158 | 23159 | 23160 | 23161 | 23162 | 23163 | 23164 | 23165 | 23166 | 23167 | 23168 | 23169 |
| H-162 | 23218 | 23219 | 23220 | 23221 | 23222 | 23223 | 23224 | 23225 | 23226 | 23227 | 23228 | 23229 | 23230 | 23231 | 23232 |
| H-163 | 23280 | 23281 | 23282 | 23283 | 23284 | 23285 | 23286 | 23287 | 23288 | 23289 | 23290 | 23291 | 23292 | 23293 | 23294 |
| H-164 | 23341 | 23342 | 23343 | 23344 | 23345 | 23346 | 23347 | 23348 | 23349 | 23350 | 23351 | 23352 | 23353 | 23354 | 23355 |
| H-165 | 23401 | 23402 | 23403 | 23404 | 23405 | 23406 | 23407 | 23408 | 23409 | 23410 | 23411 | 23412 | 23413 | 23414 | 23415 |

Table 35

| | H-211 | H-212 | H-213 | H-214 | H-215 | H-216 | H-217 | H-218 | H-219 | H-220 | H-221 | H-222 | H-223 | H-224 | H-225 |
|---|---|---|---|---|---|---|---|---|---|---|---|---|---|---|---|
| H-111 | 18745 | 18746 | 18747 | 18748 | 18749 | 18750 | 18751 | 18752 | 18753 | 18754 | 18755 | 18756 | 18757 | 18758 | 18759 |
| H-112 | 18858 | 18859 | 18860 | 18861 | 18862 | 18863 | 18864 | 18865 | 18866 | 18867 | 18868 | 18869 | 18870 | 18871 | 18872 |
| H-113 | 18970 | 18971 | 18972 | 18973 | 18974 | 18975 | 18976 | 18977 | 18978 | 18979 | 18980 | 18981 | 18982 | 18983 | 18984 |
| H-114 | 19081 | 19082 | 19083 | 19084 | 19085 | 19086 | 19087 | 19088 | 19089 | 19090 | 19091 | 19092 | 19093 | 19094 | 19095 |
| H-115 | 19191 | 19192 | 19193 | 19194 | 19195 | 19196 | 19197 | 19198 | 19199 | 19200 | 19201 | 19202 | 19203 | 19204 | 19205 |
| H-116 | 19300 | 19301 | 19302 | 19303 | 19304 | 19305 | 19306 | 19307 | 19308 | 19309 | 19310 | 19311 | 19312 | 19313 | 19314 |
| H-117 | 19408 | 19409 | 19410 | 19411 | 19412 | 19413 | 19414 | 19415 | 19416 | 19417 | 19418 | 19419 | 19420 | 19421 | 19422 |
| H-118 | 19515 | 19516 | 19517 | 19518 | 19519 | 19520 | 19521 | 19522 | 19523 | 19524 | 19525 | 19526 | 19527 | 19528 | 19529 |
| H-119 | 19621 | 19622 | 19623 | 19624 | 19625 | 19626 | 19627 | 19628 | 19629 | 19630 | 19631 | 19632 | 19633 | 19634 | 19635 |
| H-120 | 19726 | 19727 | 19728 | 19729 | 19730 | 19731 | 19732 | 19733 | 19734 | 19735 | 19736 | 19737 | 19738 | 19739 | 19740 |
| H-121 | 19830 | 19831 | 19832 | 19833 | 19834 | 19835 | 19836 | 19837 | 19838 | 19839 | 19840 | 19841 | 19842 | 19843 | 19844 |
| H-122 | 19933 | 19934 | 19935 | 19936 | 19937 | 19938 | 19939 | 19940 | 19941 | 19942 | 19943 | 19944 | 19945 | 19946 | 19947 |
| H-123 | 20035 | 20036 | 20037 | 20038 | 20039 | 20040 | 20041 | 20042 | 20043 | 20044 | 20045 | 20046 | 20047 | 20048 | 20049 |
| H-124 | 20136 | 20137 | 20138 | 20139 | 20140 | 20141 | 20142 | 20143 | 20144 | 20145 | 20146 | 20147 | 20148 | 20149 | 20150 |
| H-125 | 20236 | 20237 | 20238 | 20239 | 20240 | 20241 | 20242 | 20243 | 20244 | 20245 | 20246 | 20247 | 20248 | 20249 | 20250 |
| H-126 | 20335 | 20336 | 20337 | 20338 | 20339 | 20340 | 20341 | 20342 | 20343 | 20344 | 20345 | 20346 | 20347 | 20348 | 20349 |
| H-127 | 20433 | 20434 | 20435 | 20436 | 20437 | 20438 | 20439 | 20440 | 20441 | 20442 | 20443 | 20444 | 20445 | 20446 | 20447 |
| H-128 | 20530 | 20531 | 20532 | 20533 | 20534 | 20535 | 20536 | 20537 | 20538 | 20539 | 20540 | 20541 | 20542 | 20543 | 20544 |
| H-129 | 20626 | 20627 | 20628 | 20629 | 20630 | 20631 | 20632 | 20633 | 20634 | 20635 | 20636 | 20637 | 20638 | 20639 | 20640 |
| H-130 | 20721 | 20722 | 20723 | 20724 | 20725 | 20726 | 20727 | 20728 | 20729 | 20730 | 20731 | 20732 | 20733 | 20734 | 20735 |
| H-131 | 20815 | 20816 | 20817 | 20818 | 20819 | 20820 | 20821 | 20822 | 20823 | 20824 | 20825 | 20826 | 20827 | 20828 | 20829 |
| H-132 | 20908 | 20909 | 20910 | 20911 | 20912 | 20913 | 20914 | 20915 | 20916 | 20917 | 20918 | 20919 | 20920 | 20921 | 20922 |
| H-133 | 21000 | 21001 | 21002 | 21003 | 21004 | 21005 | 21006 | 21007 | 21008 | 21009 | 21010 | 21011 | 21012 | 21013 | 21014 |
| H-134 | 21091 | 21092 | 21093 | 21094 | 21095 | 21096 | 21097 | 21098 | 21099 | 21100 | 21101 | 21102 | 21103 | 21104 | 21105 |
| H-135 | 21181 | 21182 | 21183 | 21184 | 21185 | 21186 | 21187 | 21188 | 21189 | 21190 | 21191 | 21192 | 21193 | 21194 | 21195 |

(continued)

| | H-211 | H-212 | H-213 | H-214 | H-215 | H-216 | H-217 | H-218 | H-219 | H-220 | H-221 | H-222 | H-223 | H-224 | H-225 |
|---|---|---|---|---|---|---|---|---|---|---|---|---|---|---|---|
| H-136 | 21270 | 21271 | 21272 | 21273 | 21274 | 21275 | 21276 | 21277 | 21278 | 21279 | 21280 | 21281 | 21282 | 21283 | 21284 |
| H-137 | 21358 | 21359 | 21360 | 21361 | 21362 | 21363 | 21364 | 21365 | 21366 | 21367 | 21368 | 21369 | 21370 | 21371 | 21372 |
| H-138 | 21445 | 21446 | 21447 | 21448 | 21449 | 21450 | 21451 | 21452 | 21453 | 21454 | 21455 | 21456 | 21457 | 21458 | 21459 |
| H-139 | 21531 | 21532 | 21533 | 21534 | 21535 | 21536 | 21537 | 21538 | 21539 | 21540 | 21541 | 21542 | 21543 | 21544 | 21545 |
| H-140 | 21616 | 21617 | 21618 | 21619 | 21620 | 21621 | 21622 | 21623 | 21624 | 21625 | 21626 | 21627 | 21628 | 21629 | 21630 |
| H-141 | 21700 | 21701 | 21702 | 21703 | 21704 | 21705 | 21706 | 21707 | 21708 | 21709 | 21710 | 21711 | 21712 | 21713 | 21714 |
| H-142 | 21783 | 21784 | 21785 | 21786 | 21787 | 21788 | 21789 | 21790 | 21791 | 21792 | 21793 | 21794 | 21795 | 21796 | 21797 |
| H-143 | 21865 | 21866 | 21867 | 21868 | 21869 | 21870 | 21871 | 21872 | 21873 | 21874 | 21875 | 21876 | 21877 | 21878 | 21879 |
| H-144 | 21946 | 21947 | 21948 | 21949 | 21950 | 21951 | 21952 | 21953 | 21954 | 21955 | 21956 | 21957 | 21958 | 21959 | 21960 |
| H-145 | 22026 | 22027 | 22028 | 22029 | 22030 | 22031 | 22032 | 22033 | 22034 | 22035 | 22036 | 22037 | 22038 | 22039 | 22040 |
| H-146 | 22105 | 22106 | 22107 | 22108 | 22109 | 22110 | 22111 | 22112 | 22113 | 22114 | 22115 | 22116 | 22117 | 22118 | 22119 |
| H-147 | 22183 | 22184 | 22185 | 22186 | 22187 | 22188 | 22189 | 22190 | 22191 | 22192 | 22193 | 22194 | 22195 | 22196 | 22197 |
| H-148 | 22260 | 22261 | 22262 | 22263 | 22264 | 22265 | 22266 | 22267 | 22268 | 22269 | 22270 | 22271 | 22272 | 22273 | 22274 |
| H-149 | 22336 | 22337 | 22338 | 22339 | 22340 | 22341 | 22342 | 22343 | 22344 | 22345 | 22346 | 22347 | 22348 | 22349 | 22350 |
| H-150 | 22411 | 22412 | 22413 | 22414 | 22415 | 22416 | 22417 | 22418 | 22419 | 22420 | 22421 | 22422 | 22423 | 22424 | 22425 |
| H-151 | 22485 | 22486 | 22487 | 22488 | 22489 | 22490 | 22491 | 22492 | 22493 | 22494 | 22495 | 22496 | 22497 | 22498 | 22499 |
| H-152 | 22558 | 22559 | 22560 | 22561 | 22562 | 22563 | 22564 | 22565 | 22566 | 22567 | 22568 | 22569 | 22570 | 22571 | 22572 |
| H-153 | 22630 | 22631 | 22632 | 22633 | 22634 | 22635 | 22636 | 22637 | 22638 | 22639 | 22640 | 22641 | 22642 | 22643 | 22644 |
| H-154 | 22701 | 22702 | 22703 | 22704 | 22705 | 22706 | 22707 | 22708 | 22709 | 22710 | 22711 | 22712 | 22713 | 22714 | 22715 |
| H-155 | 22771 | 22772 | 22773 | 22774 | 22775 | 22776 | 22777 | 22778 | 22779 | 22780 | 22781 | 22782 | 22783 | 22784 | 22785 |
| H-156 | 22840 | 22841 | 22842 | 22843 | 22844 | 22845 | 22846 | 22847 | 22848 | 22849 | 22850 | 22851 | 22852 | 22853 | 22854 |
| H-157 | 22908 | 22909 | 22910 | 22911 | 22912 | 22913 | 22914 | 22915 | 22916 | 22917 | 22918 | 22919 | 22920 | 22921 | 22922 |
| H-158 | 22975 | 22976 | 22977 | 22978 | 22979 | 22980 | 22981 | 22982 | 22983 | 22984 | 22985 | 22986 | 22987 | 22988 | 22989 |
| H-159 | 23041 | 23042 | 23043 | 23044 | 23045 | 23046 | 23047 | 23048 | 23049 | 23050 | 23051 | 23052 | 23053 | 23054 | 23055 |
| H-160 | 23106 | 23107 | 23108 | 23109 | 23110 | 23111 | 23112 | 23113 | 23114 | 23115 | 23116 | 23117 | 23118 | 23119 | 23120 |

(continued)

| | H-211 | H-212 | H-213 | H-214 | H-215 | H-216 | H-217 | H-218 | H-219 | H-220 | H-221 | H-222 | H-223 | H-224 | H-225 |
|---|---|---|---|---|---|---|---|---|---|---|---|---|---|---|---|
| H-161 | 23170 | 23171 | 23172 | 23173 | 23174 | 23175 | 23176 | 23177 | 23178 | 23179 | 23180 | 23181 | 23182 | 23183 | 23184 |
| H-162 | 23233 | 23234 | 23235 | 23236 | 23237 | 23238 | 23239 | 23240 | 23241 | 23242 | 23243 | 23244 | 23245 | 23246 | 23247 |
| H-163 | 23295 | 23296 | 23297 | 23298 | 23299 | 23300 | 23301 | 23302 | 23303 | 23304 | 23305 | 23306 | 23307 | 23308 | 23309 |
| H-164 | 23356 | 23357 | 23358 | 23359 | 23360 | 23361 | 23362 | 23363 | 23364 | 23365 | 23366 | 23367 | 23368 | 23369 | 23370 |
| H-165 | 23416 | 23417 | 23418 | 23419 | 23420 | 23421 | 23422 | 23423 | 23424 | 23425 | 23426 | 23427 | 23428 | 23429 | 23430 |

Table 36

| | H-166 | H-167 | H-168 | H-169 | H-170 | H-171 | H-172 | H-173 | H-174 | H-175 | H-176 | H-177 | H-178 | H-179 | H-180 |
|---|---|---|---|---|---|---|---|---|---|---|---|---|---|---|---|
| H-166 | - | 23431 | 23432 | 23433 | 23434 | 23435 | 23436 | 23437 | 23438 | 23439 | 23440 | 23441 | 23442 | 23443 | 23444 |
| H-167 | 23431 | - | 23490 | 23491 | 23492 | 23493 | 23494 | 23495 | 23496 | 23497 | 23498 | 23499 | 23500 | 23501 | 23502 |
| H-168 | 23432 | 23490 | - | 23548 | 23549 | 23550 | 23551 | 23552 | 23553 | 23554 | 23555 | 23556 | 23557 | 23558 | 23559 |
| H-169 | 23433 | 23491 | 23548 | - | 23605 | 23606 | 23607 | 23608 | 23609 | 23610 | 23611 | 23612 | 23613 | 23614 | 23615 |
| H-170 | 23434 | 23492 | 23549 | 23605 | - | 23661 | 23662 | 23663 | 23664 | 23665 | 23666 | 23667 | 23668 | 23669 | 23670 |
| H-171 | 23435 | 23493 | 23550 | 23606 | 23661 | - | 23716 | 23717 | 23718 | 23719 | 23720 | 23721 | 23722 | 23723 | 23724 |
| H-172 | 23436 | 23494 | 23551 | 23607 | 23662 | 23716 | - | 23770 | 23771 | 23772 | 23773 | 23774 | 23775 | 23776 | 23777 |
| H-173 | 23437 | 23495 | 23552 | 23608 | 23663 | 23717 | 23770 | - | 23823 | 23824 | 23825 | 23826 | 23827 | 23828 | 23829 |
| H-174 | 23438 | 23496 | 23553 | 23609 | 23664 | 23718 | 23771 | 23823 | - | 23875 | 23876 | 23877 | 23878 | 23879 | 23880 |
| H-175 | 23439 | 23497 | 23554 | 23610 | 23665 | 23719 | 23772 | 23824 | 23875 | - | 23926 | 23927 | 23928 | 23929 | 23930 |
| H-176 | 23440 | 23498 | 23555 | 23611 | 23666 | 23720 | 23773 | 23825 | 23876 | 23926 | - | 23976 | 23977 | 23978 | 23979 |
| H-177 | 23441 | 23499 | 23556 | 23612 | 23667 | 23721 | 23774 | 23826 | 23877 | 23927 | 23976 | - | 24025 | 24026 | 24027 |
| H-178 | 23442 | 23500 | 23557 | 23613 | 23668 | 23722 | 23775 | 23827 | 23878 | 23928 | 23977 | 24025 | - | 24073 | 24074 |
| H-179 | 23443 | 23501 | 23558 | 23614 | 23669 | 23723 | 23776 | 23828 | 23879 | 23929 | 23978 | 24026 | 24073 | - | 24120 |
| H-180 | 23444 | 23502 | 23559 | 23615 | 23670 | 23724 | 23777 | 23829 | 23880 | 23930 | 23979 | 24027 | 24074 | 24120 | - |
| H-181 | 23445 | 23503 | 23560 | 23616 | 23671 | 23725 | 23778 | 23830 | 23881 | 23931 | 23980 | 24028 | 24075 | 24121 | 24166 |
| H-182 | 23446 | 23504 | 23561 | 23617 | 23672 | 23726 | 23779 | 23831 | 23882 | 23932 | 23981 | 24029 | 24076 | 24122 | 24167 |
| H-183 | 23447 | 23505 | 23562 | 23618 | 23673 | 23727 | 23780 | 23832 | 23883 | 23933 | 23982 | 24030 | 24077 | 24123 | 24168 |
| H-184 | 23448 | 23506 | 23563 | 23619 | 23674 | 23728 | 23781 | 23833 | 23884 | 23934 | 23983 | 24031 | 24078 | 24124 | 24169 |
| H-185 | 23449 | 23507 | 23564 | 23620 | 23675 | 23729 | 23782 | 23834 | 23885 | 23935 | 23984 | 24032 | 24079 | 24125 | 24170 |
| H-186 | 23450 | 23508 | 23565 | 23621 | 23676 | 23730 | 23783 | 23835 | 23886 | 23936 | 23985 | 24033 | 24080 | 24126 | 24171 |
| H-187 | 23451 | 23509 | 23566 | 23622 | 23677 | 23731 | 23784 | 23836 | 23887 | 23937 | 23986 | 24034 | 24081 | 24127 | 24172 |
| H-188 | 23452 | 23510 | 23567 | 23623 | 23678 | 23732 | 23785 | 23837 | 23888 | 23938 | 23987 | 24035 | 24082 | 24128 | 24173 |
| H-189 | 23453 | 23511 | 23568 | 23624 | 23679 | 23733 | 23786 | ' 23838 | 23889 | 23939 | 23988 | 24036 | 24083 | 24129 | 24174 |
| H-190 | 23454 | 23512 | 23569 | 23625 | 23680 | 23734 | 23787 | 23839 | 23890 | 23940 | 23989 | 24037 | 24084 | 24130 | 24175 |

(continued)

| | H-166 | H-167 | H-168 | H-169 | H-170 | H-171 | H-172 | H-173 | H-174 | H-175 | H-176 | H-177 | H-178 | H-179 | H-180 |
|---|---|---|---|---|---|---|---|---|---|---|---|---|---|---|---|
| H-191 | 23455 | 23513 | 23570 | 23626 | 23681 | 23735 | 23788 | 23840 | 23891 | 23941 | 23990 | 24038 | 24085 | 24131 | 24176 |
| H-192 | 23456 | 23514 | 23571 | 23627 | 23682 | 23736 | 23789 | 23841 | 23892 | 23942 | 23991 | 24039 | 24086 | 24132 | 24177 |
| H-193 | 23457 | 23515 | 23572 | 23628 | 23683 | 23737 | 23790 | 23842 | 23893 | 23943 | 23992 | 24040 | 24087 | 24133 | 24178 |
| H-194 | 23458 | 23516 | 23573 | 23629 | 23684 | 23738 | 23791 | 23843 | 23894 | 23944 | 23993 | 24041 | 24088 | 24134 | 24179 |
| H-195 | 23459 | 23517 | 23574 | 23630 | 23685 | 23739 | 23792 | 23844 | 23895 | 23945 | 23994 | 24042 | 24089 | 24135 | 24180 |
| H-196 | 23460 | 23518 | 23575 | 23631 | 23686 | 23740 | 23793 | 23845 | 23896 | 23946 | 23995 | 24043 | 24090 | 24136 | 24181 |
| H-197 | 23461 | 23519 | 23576 | 23632 | 23687 | 23741 | 23794 | 23846 | 23897 | 23947 | 23996 | 24044 | 24091 | 24137 | 24182 |
| H-198 | 23462 | 23520 | 23577 | 23633 | 23688 | 23742 | 23795 | 23847 | 23898 | 23948 | 23997 | 24045 | 24092 | 24138 | 24183 |
| H-199 | 23463 | 23521 | 23578 | 23634 | 23689 | 23743 | 23796 | 23848 | 23899 | 23949 | 23998 | 24046 | 24093 | 24139 | 24184 |
| H-200 | 23464 | 23522 | 23579 | 23635 | 23690 | 23744 | 23797 | 23849 | 23900 | 23950 | 23999 | 24047 | 24094 | 24140 | 24185 |
| H-201 | 23465 | 23523 | 23580 | 23636 | 23691 | 23745 | 23798 | 23850 | 23901 | 23951 | 24000 | 24048 | 24095 | 24141 | 24186 |
| H-202 | 23466 | 23524 | 23581 | 23637 | 23692 | 23746 | 23799 | 23851 | 23902 | 23952 | 24001 | 24049 | 24096 | 24142 | 24187 |
| H-203 | 23467 | 23525 | 23582 | 23638 | 23693 | 23747 | 23800 | 23852 | 23903 | 23953 | 24002 | 24050 | 24097 | 24143 | 24188 |
| H-204 | 23468 | 23526 | 23583 | 23639 | 23694 | 23748 | 23801 | 23853 | 23904 | 23954 | 24003 | 24051 | 24098 | 24144 | 24189 |
| H-205 | 23469 | 23527 | 23584 | 23640 | 23695 | 23749 | 23802 | 23854 | 23905 | 23955 | 24004 | 24052 | 24099 | 24145 | 24190 |
| H-206 | 23470 | 23528 | 23585 | 23641 | 23696 | 23750 | 23803 | 23855 | 23906 | 23956 | 24005 | 24053 | 24100 | 24146 | 24191 |
| H-207 | 23471 | 23529 | 23586 | 23642 | 23697 | 23751 | 23804 | 23856 | 23907 | 23957 | 24006 | 24054 | 24101 | 24147 | 24192 |
| H-208 | 23472 | 23530 | 23587 | 23643 | 23698 | 23752 | 23805 | 23857 | 23908 | 23958 | 24007 | 24055 | 24102 | 24148 | 24193 |
| H-209 | 23473 | 23531 | 23588 | 23644 | 23699 | 23753 | 23806 | 23858 | 23909 | 23959 | 24008 | 24056 | 24103 | 24149 | 24194 |
| H-210 | 23474 | 23532 | 23589 | 23645 | 23700 | 23754 | 23807 | 23859 | 23910 | 23960 | 24009 | 24057 | 24104 | 24150 | 24195 |
| H-211 | 23475 | 23533 | 23590 | 23646 | 23701 | 23755 | 23808 | 23860 | 23911 | 23961 | 24010 | 24058 | 24105 | 24151 | 24196 |
| H-212 | 23476 | 23534 | 23591 | 23647 | 23702 | 23756 | 23809 | 23861 | 23912 | 23962 | 24011 | 24059 | 24106 | 24152 | 24197 |
| H-213 | 23477 | 23535 | 23592 | 23648 | 23703 | 23757 | 23810 | 23862 | 23913 | 23963 | 24012 | 24060 | 24107 | 24153 | 24198 |
| H-214 | 23478 | 23536 | 23593 | 23649 | 23704 | 23758 | 23811 | 23863 | 23914 | 23964 | 24013 | 24061 | 24108 | 24154 | 24199 |
| H-215 | 23479 | 23537 | 23594 | 23650 | 23705 | 23759 | 23812 | 23864 | 23915 | 23965 | 24014 | 24062 | 24109 | 24155 | 24200 |

(continued)

| | H-166 | H-167 | H-168 | H-169 | H-170 | H-171 | H-172 | H-173 | H-174 | H-175 | H-176 | H-177 | H-178 | H-179 | H-180 |
|---|---|---|---|---|---|---|---|---|---|---|---|---|---|---|---|
| H-216 | 23480 | 23538 | 23595 | 23651 | 23706 | 23760 | 23813 | 23865 | 23916 | 23966 | 24015 | 24063 | 24110 | 24156 | 24201 |
| H-217 | 23481 | 23539 | 23596 | 23652 | 23707 | 23761 | 23814 | 23866 | 23917 | 23967 | 24016 | 24064 | 24111 | 24157 | 24202 |
| H-218 | 23482 | 23540 | 23597 | 23653 | 23708 | 23762 | 23815 | 23867 | 23918 | 23968 | 24017 | 24065 | 24112 | 24158 | 24203 |
| H-219 | 23483 | 23541 | 23598 | 23654 | 23709 | 23763 | 23816 | 23868 | 23919 | 23969 | 24018 | 24066 | 24113 | 24159 | 24204 |
| H-220 | 23484 | 23542 | 23599 | 23655 | 23710 | 23764 | 23817 | 23869 | 23920 | 23970 | 24019 | 24067 | 24114 | 24160 | 24205 |

Table 37

| | H-181 | H-182 | H-183 | H-184 | H-185 | H-186 | H-187 | H-188 | H-189 | H-190 | H-191 | H-192 | H-193 | H-194 | H-195 |
|---|---|---|---|---|---|---|---|---|---|---|---|---|---|---|---|
| H-166 | 23445 | 23446 | 23447 | 23448 | 23449 | 23450 | 23451 | 23452 | 23453 | 23454 | 23455 | 23456 | 23457 | 23458 | 23459 |
| H-167 | 23503 | 23504 | 23505 | 23506 | 23507 | 23508 | 23509 | 23510 | 23511 | 23512 | 23513 | 23514 | 23515 | 23516 | 23517 |
| H-168 | 23560 | 23561 | 23562 | 23563 | 23564 | 23565 | 23566 | 23567 | 23568 | 23569 | 23570 | 23571 | 23572 | 23573 | 23574 |
| H-169 | 23616 | 23617 | 23618 | 23619 | 23620 | 23621 | 23622 | 23623 | 23624 | 23625 | 23626 | 23627 | 23628 | 23629 | 23630 |
| H-170 | 23671 | 23672 | 23673 | 23674 | 23675 | 23676 | 23677 | 23678 | 23679 | 23680 | 23681 | 23682 | 23683 | 23684 | 23685 |
| H-171 | 23725 | 23726 | 23727 | 23728 | 23729 | 23730 | 23731 | 23732 | 23733 | 23734 | 23735 | 23736 | 23737 | 23738 | 23739 |
| H-172 | 23778 | 23779 | 23780 | 23781 | 23782 | 23783 | 23784 | 23785 | 23786 | 23787 | 23788 | 23789 | 23790 | 23791 | 23792 |
| H-173 | 23830 | 23831 | 23832 | 23833 | 23834 | 23835 | 23836 | 23837 | 23838 | 23839 | 23840 | 23841 | 23842 | 23843 | 23844 |
| H-174 | 23881 | 23882 | 23883 | 23884 | 23885 | 23886 | 23887 | 23888 | 23889 | 23890 | 23891 | 23892 | 23893 | 23894 | 23895 |
| H-175 | 23931 | 23932 | 23933 | 23934 | 23935 | 23936 | 23937 | 23938 | 23939 | 23940 | 23941 | 23942 | 23943 | 23944 | 23945 |
| H-176 | 23980 | 23981 | 23982 | 23983 | 23984 | 23985 | 23986 | 23987 | 23988 | 23989 | 23990 | 23991 | 23992 | 23993 | 23994 |
| H-177 | 24028 | 24029 | 24030 | 24031 | 24032 | 24033 | 24034 | 24035 | 24036 | 24037 | 24038 | 24039 | 24040 | 24041 | 24042 |
| H-178 | 24075 | 24076 | 24077 | 24078 | 24079 | 24080 | 24081 | 24082 | 24083 | 24084 | 24085 | 24086 | 24087 | 24088 | 24089 |
| H-179 | 24121 | 24122 | 24123 | 24124 | 24125 | 24126 | 24127 | 24128 | 24129 | 24130 | 24131 | 24132 | 24133 | 24134 | 24135 |
| H-180 | 24166 | 24167 | 24168 | 24169 | 24170 | 24171 | 24172 | 24173 | 24174 | 24175 | 24176 | 24177 | 24178 | 24179 | 24180 |
| H-181 | - | 24211 | 24212 | 24213 | 24214 | 24215 | 24216 | 24217 | 24218 | 24219 | 24220 | 24221 | 24222 | 24223 | 24224 |
| H-182 | 24211 | - | 24255 | 24256 | 24257 | 24258 | 24259 | 24260 | 24261 | 24262 | 24263 | 24264 | 24265 | 24266 | 24267 |
| H-183 | 24212 | 24255 | - | 24298 | 24299 | 24300 | 24301 | 24302 | 24303 | 24304 | 24305 | 24306 | 24307 | 24308 | 24309 |
| H-184 | 24213 | 24256 | 24298 | - | 24340 | 24341 | 24342 | 24343 | 24344 | 24345 | 24346 | 24347 | 24348 | 24349 | 24350 |
| H-185 | 24214 | 24257 | 24299 | 24340 | - | 24381 | 24382 | 24383 | 24384 | 24385 | 24386 | 24387 | 24388 | 24389 | 24390 |
| H-186 | 24215 | 24258 | 24300 | 24341 | 24381 | - | 24421 | 24422 | 24423 | 24424 | 24425 | 24426 | 24427 | 24428 | 24429 |
| H-187 | 24216 | 24259 | 24301 | 24342 | 24382 | 24421 | - | 24460 | 24461 | 24462 | 24463 | 24464 | 24465 | 24466 | 24467 |
| H-188 | 24217 | 24260 | 24302 | 24343 | 24383 | 24422 | 24460 | - | 24498 | 24499 | 24500 | 24501 | 24502 | 24503 | 24504 |
| H-189 | 24218 | 24261 | 24303 | 24344 | 24384 | 24423 | 24461 | 24498 | - | 24535 | 24536 | 24537 | 24538 | 24539 | 24540 |
| H-190 | 24219 | 24262 | 24304 | 24345 | 24385 | 24424 | 24462 | 24499 | 24535 | - | 24571 | 24572 | 24573 | 24574 | 24575 |

(continued)

| | H-181 | H-182 | H-183 | H-184 | H-185 | H-186 | H-187 | H-188 | H-189 | H-190 | H-191 | H-192 | H-193 | H-194 | H-195 |
|---|---|---|---|---|---|---|---|---|---|---|---|---|---|---|---|
| H-191 | 24220 | 24263 | 24305 | 24346 | 24386 | 24425 | 24463 | 24500 | 24536 | 24571 | - | 24606 | 24607 | 24608 | 24609 |
| H-192 | 24221 | 24264 | 24306 | 24347 | 24387 | 24426 | 24464 | 24501 | 24537 | 24572 ' | 24606 | - | 24640 | 24641 | 24642 |
| H-193 | 24222 | 24265 | 24307 | 24348 | 24388 | 24427 | 24465 | 24502 | 24538 | 24573 | 24607 | 24640 | - | 24673 | 24674 |
| H-194 | 24223 | 24266 | 24308 | 24349 | 24389 | 24428 | 24466 | 24503 | 24539 | 24574 | 24608 | 24641 | 24673 | - | 24705 |
| H-195 | 24224 | 24267 | 24309 | 24350 | 24390 | 24429 | 24467 | 24504 | 24540 | 24575 | 24609 | 24642 | 24674 | 24705 | - |
| H-196 | 24225 | 24268 | 24310 | 24351 | 24391 | 24430 | 24468 | 24505 | 24541 | 24576 | 24610 | 24643 | 24675 | 24706 | 24736 |
| H-197 | 24226 | 24269 | 24311 | 24352 | 24392 | 24431 | 24469 | 24506 | 24542 | 24577 | 24611 | 24644 | 24676 | 24707 | 24737 |
| H-198 | 24227 | 24270 | 24312 | 24353 | 24393 | 24432 | 24470 | 24507 | 24543 | 24578 | 24612 | 24645 | 24677 | 24708 | 24738 |
| H-199 | 24228 | 24271 | 24313 | 24354 | 24394 | 24433 | 24471 | 24508 | 24544 | 24579 | 24613 | 24646 | 24678 | 24709 | 24739 |
| H-200 | 24229 | 24272 | 24314 | 24355 | 24395 | 24434 | 24472 | 24509 | 24545 | 24580 | 24614 | 24647 | 24679 | 24710 | 24740 |
| H-201 | 24230 | 24273 | 24315 | 24356 | 24396 | 24435 | 24473 | 24510 | 24546 | 24581 | 24615 | 24648 | 24680 | 24711 | 24741 |
| H-202 | 24231 | 24274 | 24316 | 24357 | 24397 | 24436 | 24474 | 24511 | 24547 | 24582 | 24616 | 24649 | 24681 | 24712 | 24742 |
| H-203 | 24232 | 24275 | 24317 | 24358 | 24398 | 24437 | 24475 | 24512 | 24548 | 24583 | 24617 | 24650 | 24682 | 24713 | 24743 |
| H-204 | 24233 | 24276 | 24318 | 24359 | 24399 | 24438 | 24476 | 24513 | 24549 | 24584 | 24618 | 24651 | 24683 | 24714 | 24744 |
| H-205 | 24234 | 24277 | 24319 | 24360 | 24400 | 24439 | 24477 | 24514 | 24550 | 24585 | 24619 | 24652 | 24684 | 24715 | 24745 |
| H-206 | 24235 | 24278 | 24320 | 24361 | 24401 | 24440 | 24478 | 24515 | 24551 | 24586 | 24620 | 24653 | 24685 | 24716 | 24746 |
| H-207 | 24236 | 24279 | 24321 | 24362 | 24402 | 24441 | 24479 | 24516 | 24552 | 24587 | 24621 | 24654 | 24686 | 24717 | 24747 |
| H-208 | 24237 | 24280 | 24322 | 24363 | 24403 | 24442 | 24480 | 24517 | 24553 | 24588 | 24622 | 24655 | 24687 | 24718 | 24748 |
| H-209 | 24238 | 24281 | 24323 | 24364 | 24404 | 24443 | 24481 | 24518 | 24554 | 24589 | 24623 | 24656 | 24688 | 24719 | 24749 |
| H-210 | 24239 | 24282 | 24324 | 24365 | 24405 | 24444 | 24482 | 24519 | 24555 | 24590 | 24624 | 24657 | 24689 | 24720 | 24750 |
| H-211 | 24240 | 24283 | 24325 | 24366 | 24406 | 24445 | 24483 | 24520 | 24556 | 24591 | 24625 | 24658 | 24690 | 24721 | 24751 |
| H-212 | 24241 | 24284 | 24326 | 24367 | 24407 | 24446 | 24484 | 24521 | 24557 | 24592 | 24626 | 24659 | 24691 | 24722 | 24752 |
| H-213 | 24242 | 24285 | 24327 | 24368 | 24408 | 24447 | 24485 | 24522 | 24558 | 24593 | 24627 | 24660 | 24692 | 24723 | 24753 |
| H-214 | 24243 | 24286 | 24328 | 24369 | 24409 | 24448 | 24486 | 24523 | 24559 | 24594 | 24628 | 24661 | 24693 | 24724 | 24754 |
| H-215 | 24244 | 24287 | 24329 | 24370 | 24410 | 24449 | 24487 | 24524 | 24560 | 24595 | 24629 | 24662 | 24694 | 24725 | 24755 |

(continued)

| | H-181 | H-182 | H-183 | H-184 | H-185 | H-186 | H-187 | H-188 | H-189 | H-190 | H-191 | H-192 | H-193 | H-194 | H-195 |
|---|---|---|---|---|---|---|---|---|---|---|---|---|---|---|---|
| H-216 | 24245 | 24288 | 24330 | 24371 | 24411 | 24450 | 24488 | 24525 | 24561 | 24596 | 24630 | 24663 | 24695 | 24726 | 24756 |
| H-217 | 24246 | 24289 | 24331 | 24372 | 24412 | 24451 | 24489 | 24526 | 24562 | 24597 | 24631 | 24664 | 24696 | 24727 | 24757 |
| H-218 | 24247 | 24290 | 24332 | 24373 | 24413 | 24452 | 24490 | 24527 | 24563 | 24598 | 24632 | 24665 | 24697 | 24728 | 24758 |
| H-219 | 24248 | 24291 | 24333 | 24374 | 24414 | 24453 | 24491 | 24528 | 24564 | 24599 | 24633 | 24666 | 24698 | 24729 | 24759 |
| H-220 | 24249 | 24292 | 24334 | 24375 | 24415 | 24454 | 24492 | 24529 | 24565 | 24600 | 24634 | 24667 | 24699 | 24730 | 24760 |

Table 38

| | H-196 | H-197 | H-198 | H-199 | H-200 | H-201 | H-202 | H-203 | H-204 | H-205 | H-206 | H-207 | H-208 | H-209 | H-210 |
|---|---|---|---|---|---|---|---|---|---|---|---|---|---|---|---|
| H-166 | 23460 | 23461 | 23462 | 23463 | 23464 | 23465 | 23466 | 23467 | 23468 | 23469 | 23470 | 23471 | 23472 | 23473 | 23474 |
| H-167 | 23518 | 23519 | 23520 | 23521 | 23522 | 23523 | 23524 | 23525 | 23526 | 23527 | 23528 | 23529 | 23530 | 23531 | 23532 |
| H-168 | 23575 | 23576 | 23577 | 23578 | 23579 | 23580 | 23581 | 23582 | 23583 | 23584 | 23585 | 23586 | 23587 | 23588 | 23589 |
| H-169 | 23631 | 23632 | 23633 | 23634 | 23635 | 23636 | 23637 | 23638 | 23639 | 23640 | 23641 | 23642 | 23643 | 23644 | 23645 |
| H-170 | 23686 | 23687 | 23688 | 23689 | 23690 | 23691 | 23692 | 23693 | 23694 | 23695 | 23696 | 23697 | 23698 | 23699 | 23700 |
| H-171 | 23740 | 23741 | 23742 | 23743 | 23744 | 23745 | 23746 | 23747 | 23748 | 23749 | 23750 | 23751 | 23752 | 23753 | 23754 |
| H-172 | 23793 | 23794 | 23795 | 23796 | 23797 | 23798 | 23799 | 23800 | 23801 | 23802 | 23803 | 23804 | 23805 | 23806 | 23807 |
| H-173 | 23845 | 23846 | 23847 | 23848 | 23849 | 23850 | 23851 | 23852 | 23853 | 23854 | 23855 | 23856 | 23857 | 23858 | 23859 |
| H-174 | 23896 | 23897 | 23898 | 23899 | 23900 | 23901 | 23902 | 23903 | 23904 | 23905 | 23906 | 23907 | 23908 | 23909 | 23910 |
| H-175 | 23946 | 23947 | 23948 | 23949 | 23950 | 23951 | 23952 | 23953 | 23954 | 23955 | 23956 | 23957 | 23958 | 23959 | 23960 |
| H-176 | 23995 | 23996 | 23997 | 23998 | 23999 | 24000 | 24001 | 24002 | 24003 | 24004 | 24005 | 24006 | 24007 | 24008 | 24009 |
| H-177 | 24043 | 24044 | 24045 | 24046 | 24047 | 24048 | 24049 | 24050 | 24051 | 24052 | 24053 | 24054 | 24055 | 24056 | 24057 |
| H-178 | 24090 | 24091 | 24092 | 24093 | 24094 | 24095 | 24096 | 24097 | 24098 | 24099 | 24100 | 24101 | 24102 | 24103 | 24104 |
| H-179 | 24136 | 24137 | 24138 | 24139 | 24140 | 24141 | 24142 | 24143 | 24144 | 24145 | 24146 | 24147 | 24148 | 24149 | 24150 |
| H-180 | 24181 | 24182 | 24183 | 24184 | 24185 | 24186 | 24187 | 24188 | 24189 | 24190 | 24191 | 24192 | 24193 | 24194 | 24195 |
| H-181 | 24225 | 24226 | 24227 | 24228 | 24229 | 24230 | 24231 | 24232 | 24233 | 24234 | 24235 | 24236 | 24237 | 24238 | 24239 |
| H-182 | 24268 | 24269 | 24270 | 24271 | 24272 | 24273 | 24274 | 24275 | 24276 | 24277 | 24278 | 24279 | 24280 | 24281 | 24282 |
| H-183 | 24310 | 24311 | 24312 | 24313 | 24314 | 24315 | 24316 | 24317 | 24318 | 24319 | 24320 | 24321 | 24322 | 24323 | 24324 |
| H-184 | 24351 | 24352 | 24353 | 24354 | 24355 | 24356 | 24357 | 24358 | 24359 | 24360 | 24361 | 24362 | 24363 | 24364 | 24365 |
| H-185 | 24391 | 24392 | 24393 | 24394 | 24395 | 24396 | 24397 | 24398 | 24399 | 24400 | 24401 | 24402 | 24403 | 24404 | 24405 |
| H-186 | 24430 | 24431 | 24432 | 24433 | 24434 | 24435 | 24436 | 24437 | 24438 | 24439 | 24440 | 24441 | 24442 | 24443 | 24444 |
| H-187 | 24468 | 24469 | 24470 | 24471 | 24472 | 24473 | 24474 | 24475 | 24476 | 24477 | 24478 | 24479 | 24480 | 24481 | 24482 |
| H-188 | 24505 | 24506 | 24507 | 24508 | 24509 | 24510 | 24511 | 24512 | 24513 | 24514 | 24515 | 24516 | 24517 | 24518 | 24519 |
| H-189 | 24541 | 24542 | 24543 | 24544 | 24545 | 24546 | 24547 | 24548 | 24549 | 24550 | 24551 | 24552 | 24553 | 24554 | 24555 |
| H-190 | 24576 | 24577 | 24578 | 24579 | 24580 | 24581 | 24582 | 24583 | 24584 | 24585 | 24586 | 24587 | 24588 | 24589 | 24590 |

(continued)

| | H-196 | H-197 | H-198 | H-199 | H-200 | H-201 | H-202 | H-203 | H-204 | H-205 | H-206 | H-207 | H-208 | H-209 | H-210 |
|---|---|---|---|---|---|---|---|---|---|---|---|---|---|---|---|
| H-191 | 24610 | 24611 | 24612 | 24613 | 24614 | 24615 | 24616 | 24617 | 24618 | 24619 | 24620 | 24621 | 24622 | 24623 | 24624 |
| H-192 | 24643 | 24644 | 24645 | 24646 | 24647 | 24648 | 24649 | 24650 | 24651 | 24652 | 24653 | 24654 | 24655 | 24656 | 24657 |
| H-193 | 24675 | 24676 | 24677 | 24678 | 24679 | 24680 | 24681 | 24682 | 24683 | 24684 | 24685 | 24686 | 24687 | 24688 | 24689 |
| H-194 | 24706 | 24707 | 24708 | 24709 | 24710 | 24711 | 24712 | 24713 | 24714 | 24715 | 24716 | 24717 | 24718 | 24719 | 24720 |
| H-195 | 24736 | 24737 | 24738 | 24739 | 24740 | 24741 | 24742 | 24743 | 24744 | 24745 | 24746 | 24747 | 24748 | 24749 | 24750 |
| H-196 | - | 24766 | 24767 | 24768 | 24769 | 24770 | 24771 | 24772 | 24773 | 24774 | 24775 | 24776 | 24777 | 24778 | 24779 |
| H-197 | 24766 | - | 24795 | 24796 | 24797 | 24798 | 24799 | 24800 | 24801 | 24802 | 24803 | 24804 | 24805 | 24806 | 24807 |
| H-198 | 24767 | 24795 | - | 24823 | 24824 | 24825 | 24826 | 24827 | 24828 | 24829 | 24830 | 24831 | 24832 | 24833 | 24834 |
| H-199 | 24768 | 24796 | 24823 | - | 24850 | 24851 | 24852 | 24853 | 24854 | 24855 | 24856 | 24857 | 24858 | 24859 | 24860 |
| H-200 | 24769 | 24797 | 24824 | 24850 | - | 24876 | 24877 | 24878 | 24879 | 24880 | 24881 | 24882 | 24883 | 24884 | 24885 |
| H-201 | 24770 | 24798 | 24825 | 24851 | 24876 | - | 24901 | 24902 | 24903 | 24904 | 24905 | 24906 | 24907 | 24908 | 24909 |
| H-202 | 24771 | 24799 | 24826 | 24852 | 24877 | 24901 | - | 24925 | 24926 | 24927 | 24928 | 24929 | 24930 | 24931 | 24932 |
| H-203 | 24772 | 24800 | 24827 | 24853 | 24878 | 24902 | 24925 | - | 24948 | 24949 | 24950 | 24951 | 24952 | 24953 | 24954 |
| H-204 | 24773 | 24801 | 24828 | 24854 | 24879 | 24903 | 24926 | 24948 | - | 24970 | 24971 | 24972 | 24973 | 24974 | 24975 |
| H-205 | 24774 | 24802 | 24829 | 24855 | 24880 | 24904 | 24927 | 24949 | 24970 | - | 24991 | 24992 | 24993 | 24994 | 24995 |
| H-206 | 24775 | 24803 | 24830 | 24856 | 24881 | 24905 | 24928 | 24950 | 24971 | 24991 | - | 25011 | 25012 | 25013 | 25014 |
| H-207 | 24776 | 24804 | 24831 | 24857 | 24882 | 24906 | 24929 | 24951 | 24972 | 24992 | 25011 | - | 25030 | 25031 | 25032 |
| H-208 | 24777 | 24805 | 24832 | 24858 | 24883 | 24907 | 24930 | 24952 | 24973 | 24993 | 25012 | 25030 | - | 25048 | 25049 |
| H-209 | 24778 | 24806 | 24833 | 24859 | 24884 | 24908 | 24931 | 24953 | 24974 | 24994 | 25013 | 25031 | 25048 | - | 25065 |
| H-210 | 24779 | 24807 | 24834 | 24860 | 24885 | 24909 | 24932 | 24954 | 24975 | 24995 | 25014 | 25032 | 25049 | 25065 | - |
| H-211 | 24780 | 24808 | 24835 | 24861 | 24886 | 24910 | 24933 | 24955 | 24976 | 24996 | 25015 | 25033 | 25050 | 25066 | 25081 |
| H-212 | 24781 | 24809 | 24836 | 24862 | 24887 | 24911 | 24934 | 24956 | 24977 | 24997 | 25016 | 25034 | 25051 | 25067 | 25082 |
| H-213 | 24782 | 24810 | 24837 | 24863 | 24888 | 24912 | 24935 | 24957 | 24978 | 24998 | 25017 | 25035 | 25052 | 25068 | 25083 |
| H-214 | 24783 | 24811 | 24838 | 24864 | 24889 | 24913 | 24936 | 24958 | 24979 | 24999 | 25018 | 25036 | 25053 | 25069 | 25084 |
| H-215 | 24784 | 24812 | 24839 | 24865 | 24890 | 24914 | 24937 | 24959 | 24980 | 25000 | 25019 | 25037 | 25054 | 25070 | 25085 |

(continued)

| | H-196 | H-197 | H-198 | H-199 | H-200 | H-201 | H-202 | H-203 | H-204 | H-205 | H-206 | H-207 | H-208 | H-209 | H-210 |
|---|---|---|---|---|---|---|---|---|---|---|---|---|---|---|---|
| H-216 | 24785 | 24813 | 24840 | 24866 | 24891 | 24915 | 24938 | 24960 | 24981 | 25001 | 25020 | 25038 | 25055 | 25071 | 25086 |
| H-217 | 24786 | 24814 | 24841 | 24867 | 24892 | 24916 | 24939 | 24961 | 24982 | 25002 | 25021 | 25039 | 25056 | 25072 | 25087 |
| H-218 | 24787 | 24815 | 24842 | 24868 | 24893 | 24917 | 24940 | 24962 | 24983 | 25003 | 25022 | 25040 | 25057 | 25073 | 25088 |
| H-219 | 24788 | 24816 | 24843 | 24869 | 24894 | 24918 | 24941 | 24963 | 24984 | 25004 | 25023 | 25041 | 25058 | 25074 | 25089 |
| H-220 | 24789 | 24817 | 24844 | 24870 | 24895 | 24919 | 24942 | 24964 | 24985 | 25005 | 25024 | 25042 | 25059 | 25075 | 25090 |

Table 39

| | H-211 | H-212 | H-213 | H-214 | H-215 | H-216 | H-217 | H-218 | H-219 | H-220 | H-221 | H-222 | H-223 | H-224 | H-225 |
|---|---|---|---|---|---|---|---|---|---|---|---|---|---|---|---|
| H-166 | 23475 | 23476 | 23477 | 23478 | 23479 | 23480 | 23481 | 23482 | 23483 | 23484 | 23485 | 23486 | 23487 | 23488 | 23489 |
| H-167 | 23533 | 23534 | 23535 | 23536 | 23537 | 23538 | 23539 | 23540 | 23541 | 23542 | 23543 | 23544 | 23545 | 23546 | 23547 |
| H-168 | 23590 | 23591 | 23592 | 23593 | 23594 | 23595 | 23596 | 23597 | 23598 | 23599 | 23600 | 23601 | 23602 | 23603 | 23604 |
| H-169 | 23646 | 23647 | 23648 | 23649 | 23650 | 23651 | 23652 | 23653 | 23654 | 23655 | 23656 | 23657 | 23658 | 23659 | 23660 |
| H-170 | 23701 | 23702 | 23703 | 23704 | 23705 | 23706 | 23707 | 23708 | 23709 | 23710 | 23711 | 23712 | 23713 | 23714 | 23715 |
| H-171 | 23755 | 23756 | 23757 | 23758 | 23759 | 23760 | 23761 | 23762 | 23763 | 23764 | 23765 | 23766 | 23767 | 23768 | 23769 |
| H-172 | 23808 | 23809 | 23810 | 23811 | 23812 | 23813 | 23814 | 23815 | 23816 | 23817 | 23818 | 23819 | 23820 | 23821 | 23822 |
| H-173 | 23860 | 23861 | 23862 | 23863 | 23864 | 23865 | 23866 | 23867 | 23868 | 23869 | 23870 | 23871 | 23872 | 23873 | 23874 |
| H-174 | 23911 | 23912 | 23913 | 23914 | 23915 | 23916 | 23917 | 23918 | 23919 | 23920 | 23921 | 23922 | 23923 | 23924 | 23925 |
| H-175 | 23961 | 23962 | 23963 | 23964 | 23965 | 23966 | 23967 | 23968 | 23969 | 23970 | 23971 | 23972 | 23973 | 23974 | 23975 |
| H-176 | 24010 | 24011 | 24012 | 24013 | 24014 | 24015 | 24016 | 24017 | 24018 | 24019 | 24020 | 24021 | 24022 | 24023 | 24024 |
| H-177 | 24058 | 24059 | 24060 | 24061 | 24062 | 24063 | 24064 | 24065 | 24066 | 24067 | 24068 | 24069 | 24070 | 24071 | 24072 |
| H-178 | 24105 | 24106 | 24107 | 24108 | 24109 | 24110 | 24111 | 24112 | 24113 | 24114 | 24115 | 24116 | 24117 | 24118 | 24119 |
| H-179 | 24151 | 24152 | 24153 | 24154 | 24155 | 24156 | 24157 | 24158 | 24159 | 24160 | 24161 | 24162 | 24163 | 24164 | 24165 |
| H-180 | 24196 | 24197 | 24198 | 24199 | 24200 | 24201 | 24202 | 24203 | 24204 | 24205 | 24206 | 24207 | 24208 | 24209 | 24210 |
| H-181 | 24240 | 24241 | 24242 | 24243 | 24244 | 24245 | 24246 | 24247 | 24248 | 24249 | 24250 | 24251 | 24252 | 24253 | 24254 |
| H-182 | 24283 | 24284 | 24285 | 24286 | 24287 | 24288 | 24289 | 24290 | 24291 | 24292 | 24293 | 24294 | 24295 | 24296 | 24297 |
| H-183 | 24325 | 24326 | 24327 | 24328 | 24329 | 24330 | 24331 | 24332 | 24333 | 24334 | 24335 | 24336 | 24337 | 24338 | 24339 |
| H-184 | 24366 | 24367 | 24368 | 24369 | 24370 | 24371 | 24372 | 24373 | 24374 | 24375 | 24376 | 24377 | 24378 | 24379 | 24380 |
| H-185 | 24406 | 24407 | 24408 | 24409 | 24410 | 24411 | 24412 | 24413 | 24414 | 24415 | 24416 | 24417 | 24418 | 24419 | 24420 |
| H-186 | 24445 | 24446 | 24447 | 24448 | 24449 | 24450 | 24451 | 24452 | 24453 | 24454 | 24455 | 24456 | 24457 | 24458 | 24459 |
| H-187 | 24483 | 24484 | 24485 | 24486 | 24487 | 24488 | 24489 | 24490 | 24491 | 24492 | 24493 | 24494 | 24495 | 24496 | 24497 |
| H-188 | 24520 | 24521 | 24522 | 24523 | 24524 | 24525 | 24526 | 24527 | 24528 | 24529 | 24530 | 24531 | 24532 | 24533 | 24534 |
| H-189 | 24556 | 24557 | 24558 | 24559 | 24560 | 24561 | 24562 | 24563 | 24564 | 24565 | 24566 | 24567 | 24568 | 24569 | 24570 |
| H-190 | 24591 | 24592 | 24593 | 24594 | 24595 | 24596 | 24597 | 24598 | 24599 | 24600 | 24601 | 24602 | 24603 | 24604 | 24605 |

(continued)

| | H-211 | H-212 | H-213 | H-214 | H-215 | H-216 | H-217 | H-218 | H-219 | H-220 | H-221 | H-222 | H-223 | H-224 | H-225 |
|---|---|---|---|---|---|---|---|---|---|---|---|---|---|---|---|
| H-191 | 24625 | 24626 | 24627 | 24628 | 24629 | 24630 | 24631 | 24632 | 24633 | 24634 | 24635 | 24636 | 24637 | 24638 | 24639 |
| H-192 | 24658 | 24659 | 24660 | 24661 | 24662 | 24663 | 24664 | 24665 | 24666 | 24667 | 24668 | 24669 | 24670 | 24671 | 24672 |
| H-193 | 24690 | 24691 | 24692 | 24693 | 24694 | 24695 | 24696 | 24697 | 24698 | 24699 | 24700 | 24701 | 24702 | 24703 | 24704 |
| H-194 | 24721 | 24722 | 24723 | 24724 | 24725 | 24726 | 24727 | 24728 | 24729 | 24730 | 24731 | 24732 | 24733 | 24734 | 24735 |
| H-195 | 24751 | 24752 | 24753 | 24754 | 24755 | 24756 | 24757 | 24758 | 24759 | 24760 | 24761 | 24762 | 24763 | 24764 | 24765 |
| H-196 | 24780 | 24781 | 24782 | 24783 | 24784 | 24785 | 24786 | 24787 | 24788 | 24789 | 24790 | 24791 | 24792 | 24793 | 24794 |
| H-197 | 24808 | 24809 | 24810 | 24811 | 24812 | 24813 | 24814 | 24815 | 24816 | 24817 | 24818 | 24819 | 24820 | 24821 | 24822 |
| H-198 | 24835 | 24836 | 24837 | 24838 | 24839 | 24840 | 24841 | 24842 | 24843 | 24844 | 24845 | 24846 | 24847 | 24848 | 24849 |
| H-199 | 24861 | 24862 | 24863 | 24864 | 24865 | 24866 | 24867 | 24868 | 24869 | 24870 | 24871 | 24872 | 24873 | 24874 | 24875 |
| H-200 | 24886 | 24887 | 24888 | 24889 | 24890 | 24891 | 24892 | 24893 | 24894 | 24895 | 24896 | 24897 | 24898 | 24899 | 24900 |
| H-201 | 24910 | 24911 | 24912 | 24913 | 24914 | 24915 | 24916 | 24917 | 24918 | 24919 | 24920 | 24921 | 24922 | 24923 | 24924 |
| H-202 | 24933 | 24934 | 24935 | 24936 | 24937 | 24938 | 24939 | 24940 | 24941 | 24942 | 24943 | 24944 | 24945 | 24946 | 24947 |
| H-203 | 24955 | 24956 | 24957 | 24958 | 24959 | 24960 | 24961 | 24962 | 24963 | 24964 | 24965 | 24966 | 24967 | 24968 | 24969 |
| H-204 | 24976 | 24977 | 24978 | 24979 | 24980 | 24981 | 24982 | 24983 | 24984 | 24985 | 24986 | 24987 | 24988 | 24989 | 24990 |
| H-205 | 24996 | 24997 | 24998 | 24999 | 25000 | 25001 | 25002 | 25003 | 25004 | 25005 | 25006 | 25007 | 25008 | 25009 | 25010 |
| H-206 | 25015 | 25016 | 25017 | 25018 | 25019 | 25020 | 25021 | 25022 | 25023 | 25024 | 25025 | 25026 | 25027 | 25028 | 25029 |
| H-207 | 25033 | 25034 | 25035 | 25036 | 25037 | 25038 | 25039 | 25040 | 25041 | 25042 | 25043 | 25044 | 25045 | 25046 | 25047 |
| H-208 | 25050 | 25051 | 25052 | 25053 | 25054 | 25055 | 25056 | 25057 | 25058 | 25059 | 25060 | 25061 | 25062 | 25063 | 25064 |
| H-209 | 25066 | 25067 | 25068 | 25069 | 25070 | 25071 | 25072 | 25073 | 25074 | 25075 | 25076 | 25077 | 25078 | 25079 | 25080 |
| H-210 | 25081 | 25082 | 25083 | 25084 | 25085 | 25086 | 25087 | 25088 | 25089 | 25090 | 25091 | 25092 | 25093 | 25094 | 25095 |
| H-211 | - | 25096 | 25097 | 25098 | 25099 | 25100 | 25101 | 25102 | 25103 | 25104 | 25105 | 25106 | 25107 | 25108 | 25109 |
| H-212 | 25096 | - | 25110 | 25111 | 25112 | 25113 | 25114 | 25115 | 25116 | 25117 | 25118 | 25119 | 25120 | 25121 | 25122 |
| H-213 | 25097 | 25110 | - | 25123 | 25124 | 25125 | 25126 | 25127 | 25128 | 25129 | 25130 | 25131 | 25132 | 25133 | 25134 |
| H-214 | 25098 | 25111 | 25123 | - | 25135 | 25136 | 25137 | 25138 | 25139 | 25140 | 25141 | 25142 | 25143 | 25144 | 25145 |
| H-215 | 25099 | 25112 | 25124 | 25135 | - | 25146 | 25147 | 25148 | 25149 | 25150 | 25151 | 25152 | 25153 | 25154 | 25155 |

(continued)

| | H-211 | H-212 | H-213 | H-214 | H-215 | H-216 | H-217 | H-218 | H-219 | H-220 | H-221 | H-222 | H-223 | H-224 | H-225 |
|---|---|---|---|---|---|---|---|---|---|---|---|---|---|---|---|
| H-216 | 25100 | 25113 | 25125 | 25136 | 25146 | - | 25156 | 25157 | 25158 | 25159 | 25160 | 25161 | 25162 | 25163 | 25164 |
| H-217 | 25101 | 25114 | 25126 | 25137 | 25147 | 25156 | - | 25165 | 25166 | 25167 | 25168 | 25169 | 25170 | 25171 | 25172 |
| H-218 | 25102 | 25115 | 25127 | 25138 | 25148 | 25157 | 25165 | - | 25173 | 25174 | 25175 | 25176 | 25177 | 25178 | 25179 |
| H-219 | 25103 | 25116 | 25128 | 25139 | 25149 | 25158 | 25166 | 25173 | - | 25180 | 25181 | 25182 | 25183 | 25184 | 25185 |
| H-220 | 25104 | 25117 | 25129 | 25140 | 25150 | 25159 | 25167 | 25174 | 25180 | - | 25186 | 25187 | 25188 | 25189 | 25190 |

Table 40

| | H-211 | H-212 | H-213 | H-214 | H-215 | H-216 | H-217 | H-218 | H-219 | H-220 | H-221 | H-222 | H-223 | H-224 | H-225 |
|---|---|---|---|---|---|---|---|---|---|---|---|---|---|---|---|
| H-221 | 25105 | 25118 | 25130 | 25141 | 25151 | 25160 | 25168 | 25175 | 25181 | 25186 | - | 25191 | 25192 | 25193 | 25194 |
| H-222 | 25106 | 25119 | 25131 | 25142 | 25152 | 25161 | 25169 | 25176 | 25182 | 25187 | 25191 | - | 25195 | 25196 | 25197 |
| H-223 | 25107 | 25120 | 25132 | 25143 | 25153 | 25162 | 25170 | 25177 | 25183 | 25188 | 25192 | 25195 | - | 25198 | 25199 |
| H-224 | 25108 | 25121 | 25133 | 25144 | 25154 | 25163 | 25171 | 25178 | 25184 | 25189 | 25193 | 25196 | 25198 | - | 25200 |
| H-225 | 25109 | 25122 | 25134 | 25145 | 25155 | 25164 | 25172 | 25179 | 25185 | 25190 | 25194 | 25197 | 25199 | 25200 | - |

## Second Exemplary Embodiment

### Organic Electroluminescence Device

An organic EL device according to a second exemplary embodiment of the invention will be described.

An organic EL device according to the second exemplary embodiment includes an anode, a cathode, and an organic layer between the anode and the cathode. The organic layer includes at least one layer formed of an organic compound. Alternatively, the organic layer is provided by laminating a plurality of layers each formed of an organic compound. The organic layer may further contain an inorganic compound. The organic layer of the organic EL device according to the present exemplary embodiment contains the mixture according to the first exemplary embodiment.

The organic EL device according to the present exemplary embodiment is preferably, for instance, an organic EL device according to the following first or second aspect.

### Organic EL Device According to First Aspect

The organic EL device according to the first aspect includes an anode, a cathode, and an organic layer disposed between the anode and the cathode and containing the mixture according to the first exemplary embodiment in one and the same layer.

Containing in one and the same layer means that when the organic EL device includes a plurality of organic layers, the mixture according to the first exemplary embodiment is contained in the same single layer among the plurality of organic layers. For instance, the case where a first organic layer contains a first compound and a second organic layer that is in contact with the first organic layer in a direct manner or via another organic layer contains a second compound does not fall under the case of containing in one and the same layer because the first and second compounds forming the mixture are not contained in the same single layer.

When the organic EL device according to the first aspect contains the mixture according to the first aspect, the second compound is preferably a compound where $L_{21}$ is a substituted or unsubstituted phenylene group and $Ar_{21}$ is a substituted or unsubstituted naphthyl group.

When the organic EL device according to the first aspect contains the mixture according to the first aspect, the second compound is preferably the compound represented by the formula (21).

### Organic EL Device According to Second Aspect

The organic EL device according to the second aspect includes an anode, a cathode, and an organic layer disposed between the anode and the cathode and formed by depositing the mixture according to the first exemplary embodiment from one and the same vapor-deposition source.

The vapor-deposition source is, for instance, a crucible capable of accommodating the mixture according to the first exemplary embodiment.

Fig. 1 schematically shows an exemplary arrangement of the organic EL device of the first exemplary embodiment.

An organic EL device 1 includes a light-transmissive substrate 2, an anode 3, a cathode 4, and an organic layer 10 provided between the anode 3 and the cathode 4. The organic layer 10 includes a hole injecting layer 6, a hole transporting layer 7, an emitting layer 5, an electron transporting layer 8, and an electron injecting layer 9, which are sequentially laminated on the anode 3.

The invention is by no means limited to an arrangement of the organic EL device shown in Fig. 1.

An arrangement of the organic EL device according to the present exemplary embodiment will be further described below. It should be noted that the reference numerals will be sometimes omitted below.

### Emitting Layer

In the organic EL device of the present exemplary embodiment, at least one of the organic layer(s) is the emitting layer. For instance, the organic layer may be a single emitting layer or may further include at least one layer usable for the organic EL device. Examples of the layer usable in the organic EL device, which are not particularly limited, include at least one layer selected from the group consisting of a hole injecting layer, hole transporting layer, electron injecting layer, electron transporting layer, and blocking layer.

The organic EL device of the present exemplary embodiment preferably contains the mixture according to the first exemplary embodiment in one and the same emitting layer.

Guest Material of Emitting Layer

The emitting layer, which is a layer containing a highly luminescent substance, can contain various materials. Examples of the highly luminescent substance includes a fluorescent compound emitting fluorescence or a phosphorescent compound emitting phosphorescence. The fluorescent compound is a compound emittable from a singlet state. The phosphorescent compound is a compound emittable from a triplet state.

The guest material is occasionally referred to as a dopant material, emitter or luminescent material.

Examples of a blue fluorescent material usable for the emitting layer include a pyrene derivative, styrylamine derivative, chrysene derivative, fluoranthene derivative, fluorene derivative, diamine derivative, and triarylamine derivative. Specific examples include N,N'-bis[4-(9H-carbazole-9-yl)phenyl]-N,N'-diphenylstilbene-4,4'-diamine (abbreviation: YGA2S), 4-(9H-carbazole-9-yl)-4'-(10-phenyl-9-anthryl)triphenylamine (abbreviation: YGAPA), and 4-(10-phenyl-9-anthryl)-4'-(9-phenyl-9H-carbazole-3-yl)triphenylamine (abbreviation: PCBAPA).

Examples of a green fluorescent material usable for the emitting layer include an aromatic amine derivative. Specific examples thereof include N-(9,10-diphenyl-2-anthryl)-N,9-diphenyl-9H-carbazole-3-amine (abbreviation: 2PCAPA), N-[9,10-bis(1,1'-biphenyl-2-yl)-2-anthryl]-N,9-diphenyl-9H-carbazole-3-amine (abbreviation: 2PCABPhA), N-(9,10-diphenyl-2-anthryl)-N,N',N'-triphenyl-1,4-phenylenediamine (abbreviation: 2DPAPA), N-[9,10-bis(1,1'-biphenyl-2-yl)-2-anthryl]-N,N',N'-triphenyl-1,4-phenylenediamine (abbreviation: 2DPABPhA), N-[9,10-bis(1,1'-biphenyl-2-yl)]-N-[4-(9H-carbazole-9-yl)phenyl]-N-phenylanthracene-2-amine (abbreviation: 2YGABPhA), and N,N,9-triphenylanthracene-9-amine (abbreviation: DPhAPhA).

Examples of a red fluorescent material usable for the emitting layer include a tetracene derivative and a diamine derivative. Specific examples thereof include N,N,N',N'-tetrakis(4-methylphenyl)tetracene-5,11-diamine (abbreviation: p-mPhTD), and 7,14-diphenyl-N,N,N',N'-tetrakis(4-methylphenyl)acenaphtho[1,2-a]fluoranthene-3,10-diamine (abbreviation: p-mPhAFD).

Examples of a blue phosphorescent material usable for the emitting layer include metal complexes such as an iridium complex, osmium complex and platinum complex. Specific examples thereof include bis[2-(4',6'-difluorophenyl)pyridinato-N,C2']iridium(III)tetrakis(1-pyrazolyl)borate (abbreviation: FIr6), bis[2-(4',6'-difluorophenyl)pyridinato-N,C2']iridium(III)picolinate (abbreviation: FIrpic), bis[2-(3',5'bistrifluoromethylphenyl)pyridinato-N,C2']iridium(III)picolinate (abbreviation: $Ir(CF_3ppy)_2(pic)$), and bis[2-(4',6'-difluorophenyl)pyridinato-N,C2']iridium(III)acetylacetonato (abbreviation: FIracac).

Examples of a green phosphorescent material usable for the emitting layer include an iridium complex. Specific examples thereof include tris(2-phenylpyridinato-N,C2')iridium(III) (abbreviation: $Ir(ppy)_3$), bis(2-phenylpyridinato-N,C2')iridium(III)acetylacetonato (abbreviation: $Ir(ppy)_2(acac)$), bis(1,2-diphenyl-1H-benzimidazolato)iridium(III)acetylacetonato (abbreviation: $Ir(pbi)_2(acac)$), and bis(benzo[h]quinolinato)iridium(III)acetylacetonato (abbreviation: $Ir(bzq)_2(acac)$).

Examples of a red phosphorescent material usable for the emitting layer include metal complexes such as an iridium complex, platinum complex, terbium complex, and europium complex. Specific examples thereof include organic metal complexes such as bis[2-(2'-benzo[4,5-α]thienyl)pyridinato-N,C3']iridium(III)acetylacetonato (abbreviation: $Ir(btp)_2(acac)$), bis(1-phenylisoquinolinato-N,C2')iridium(III)acetylacetonato (abbreviation: $Ir(piq)_2(acac)$), (acetylacetonato)bis[2,3-bis(4-fluorophenyl)quinolinato]iridium(III) (abbreviation:$Ir(Fdpq)_2(acac)$), and 2,3,7,8,12,13,17,18-octaethyl-21H,23H-porphyrinplatinum(II) (abbreviation: PtOEP).

Moreover, since a rare-earth metal complex, examples of which include tris(acetylacetonato)(monophenanthroline)terbium(III) (abbreviation: $Tb(acac)_3(Phen)$), tris(1,3-diphenyl-1,3-propanedionatodionato)(monophenanthroline)europium(III) (abbreviation: $Eu(DBM)_3(Phen)$), and tris[1-(2-thenoyl)-3,3,3-trifluoroacetonato](monophenanthroline)europium(III) (abbreviation: $Eu(TTA)_3(Phen)$), emits light from rare-earth metal ions (electron transition between different multiplicities), the rare-earth metal complex is usable as a phosphorescent compound.

Host Material of Emitting Layer

The emitting layer may include the above-described highly luminescent substance (guest material) dispersed in another substance (host material). The host material is occasionally referred to as a matrix material. The substance for dispersing the highly luminescent substance may be various substances, preferably a substance having higher Lowest Unoccupied Molecular Orbital (LUMO level) and lower Highest Occupied Molecular Orbital (HOMO level) than the highly luminescent substance.

The substance (host material) for dispersing the highly luminescent substance may be 1) a metal complex such as an aluminum complex, a beryllium complex, or a zinc complex, 2) a heterocyclic compound such as an oxadiazole derivative, a benzimidazole derivative, or a phenanthroline derivative, 4) a fused aromatic compound such as a carbazole derivative, an anthracene derivative, a phenanthrene derivative, a pyrene derivative, or a chrysene derivative, or 3) an aromatic amine compound such as a triarylamine derivative or a fused polycyclic aromatic amine derivative. Specific

examples include: metal complexes such as tris(8-quinolinolato)aluminum(III) (abbreviation: Alq), tris(4-methyl-8-quinolinolato)aluminum(III) (abbreviation: $Almq_3$), bis(10-hydroxybenzo[h]quinolinato)beryllium(II) (abbreviation: $BeBq_2$), bis(2-methyl-8-quinolinolato)(4-phenylphenolato)aluminum(III) (abbreviation: BAlq), bis(8-quinolinolato)zinc(II) (abbreviation: Znq), bis[2-(2-benzoxazolyl)phenolato]zinc(II) (abbreviation: ZnPBO), and bis[2-(2-benzothiazolyl)phenolato]zinc(II) (abbreviation: ZnBTZ); a heterocyclic compound such as 2-(4-biphenylyl)-5-(4-tert-butylphenyl)-1,3,4-oxadiazole (abbreviation: PBD), 1,3-bis[5-(p-tert-butylphenyl)-1,3,4-oxadiazole-2-yl]benzene (abbreviation: OXD-7), 3-(4-biphenylyl)-4-phenyl-5-(4-tert-butylphenyl)-1,2,4-triazole (abbreviation: TAZ), 2,2',2"-(1,3,5-benzenetriyl)tris(1-phenyl-1H-benzimidazole) (abbreviation: TPBI), bathophenanthroline (abbreviation: BPhen), bathocuproine (abbreviation: BCP); a fused aromatic compound such as 9-[4-(10-phenyl-9-anthryl)phenyl]-9H-carbazole (abbreviation: CzPA), 3,6-diphenyl-9-[4-(10-phenyl-9-anthryl)phenyl]-9H-carbazole (abbreviation: DPCzPA), 9,10-bis(3,5-diphenylphenyl)anthracene (abbreviation: DPPA), 9,10-di(2-naphthyl)anthracene (abbreviation: DNA), 2-tert-butyl-9,10-di(2-naphthyl)anthracene (abbreviation: t-BuDNA), 9,9'-bianthryl (abbreviation: BANT), 9,9'-(stilbene-3,3'-diyl)diphenanthrene (abbreviation: DPNS), 9,9'-(stilbene-4,4'-diyl)diphenanthrene (abbreviation: DPNS2), 3,3',3"-(benzene-1,3,5-triyl)tripyrene (abbreviation: TPB3), 9,10-diphenylanthracene (abbreviation: DPAnth), 6,12-dimethoxy-5,11-diphenylchrysene; and an aromatic amine compound such as N,N-diphenyl-9-[4-(10-phenyl-9-anthryl)phenyl]-9H-carbazole-3-amine (abbreviation: CzA1PA), 4-(10-phenyl-9-anthryl)triphenylamine (abbreviation: DPhPA), N,9-diphenyl-N-[4-(10-phenyl-9-anthryl)phenyl]-9H-carbazole-3-amine (abbreviation: PCAPA), N,9-diphenyl-N-{4-[4-(10-phenyl-9-anthryl)phenyl]phenyl}-9H-carbazole-3-amine (abbreviation: PCAPBA), N-(9,10-diphenyl-2-anthryl)-N,9-diphenyl-9H-carbazole-3-amine (abbreviation: 2PCAPA), NPB (or $\alpha$-NPD), TPD, DFLDPBi, and BSPB. Moreover, the substance (host material) for dispersing the highly luminescent substance (guest material) can be used in plural.

Specifically, examples of the metal complex include tris(8-quinolinolato)aluminum (III) (abbreviation: Alq), tris(4-methyl-8-quinolinolato)aluminum(III) (abbreviation: $Almq_3$), bis(10-hydroxybenzo[h]quinolinato)beryllium(II) (abbreviation: $BeBq_2$), bis(2-methyl-8-quinolinolato)(4-phenylphenolato)aluminum(III) (abbreviation: BAlq), bis(8-quinolinolato)zinc(II) (abbreviation: Znq), bis[2-(2-benzoxazolyl)phenolato]zinc(II) (abbreviation: ZnPBO), and bis[2-(2-benzothiazolyl)phenolato]zinc(II) (abbreviation: ZnBTZ).

Examples of the heterocyclic compound include 2-(4-biphenylyl)-5-(4-tert-butylphenyl)-1,3,4-oxadiazole (abbreviation: PBD), 1,3-bis[5-(p-tert-butylphenyl)-1,3,4-oxadiazol-2-yl]benzene (abbreviation: OXD-7), 3-(4-biphenylyl)-4-phenyl-5-(4-tert-butylphenyl)-1,2,4-triazole (abbreviation: TAZ), 2,2',2"-(1,3,5-benzenetriyl)tris(1-phenyl-1H-benzimidazole) (abbreviation: TPBI), bathophenanthroline (abbreviation: BPhen), and bathocuproine (abbreviation: BCP).

Examples of the fused aromatic compound include 9-[4-(10-phenyl-9-anthryl)phenyl]-9H-carbazole (abbreviation: CzPA), 3,6-diphenyl-9-[4-(10-phenyl-9-anthryl)phenyl]-9H-carbazole (abbreviation: DPCzPA), 9,10-bis(3,5-diphenylphenyl)anthracene (abbreviation: DPPA), 9,10-di(2-naphthyl)anthracene (abbreviation: DNA), 2-tert-butyl-9,10-di(2-naphthyl)anthracene (abbreviation: t-BuDNA), 9,9'-bianthryl (abbreviation: BANT), 9,9'-(stilbene-3,3'-diyl)diphenanthrene (abbreviation: DPNS), 9,9'-(stilbene-4,4'-diyl)diphenanthrene (abbreviation: DPNS2), 3,3',3"-(benzene-1,3,5-triyl)tripyrene (abbreviation: TPB3), 9,10-diphenylanthracene (abbreviation: DPAnth), and 6,12-dimethoxy-5,11-diphenylchrysene.

Examples of the aromatic amine compound include N,N-diphenyl-9-[4-(10-phenyl-9-anthryl)phenyl]-9H-carbazole-3-amine (abbreviation: CzA1PA), 4-(10-phenyl-9-anthryl)triphenylamine (abbreviation: DPhPA), N,9-diphenyl-N-[4-(10-phenyl-9-anthryl)phenyl]-9H-carbazole-3-amine (abbreviation: PCAPA), N,9-diphenyl-N-{4-[4-(10-phenyl-9-anthryl)phenyl]phenyl}-9H-carbazole-3-amine (abbreviation: PCAPBA), N-(9,10-diphenyl-2-anthryl)-N,9-diphenyl-9H-carbazole-3-amine (abbreviation: 2PCAPA), NPB (or $\alpha$-NPD), TPD, DFLDPBi, and BSPB.

Herein, the "host material" refers to, for instance, a material that accounts for "50 mass% or more of the layer." Therefore, the emitting layer contains the host material, for instance, in an amount of 50 mass% or more of the total mass of the emitting layer. When the organic EL device includes a plurality of emitting layers, for instance, the plurality of emitting layers each contain the host material in an amount of 50 mass% or more of the total mass of each emitting layer. For instance, the "host material" may account for 60 mass% or more of the emitting layer, 70 mass% or more of the emitting layer, 80 mass% or more of the emitting layer, 90 mass% or more of the emitting layer, or 95 mass% or more of the emitting layer. For instance, the "host material" may be contained in an amount of 99 mass% or less of the emitting layer.

When the emitting layer contains a host material and a dopant material, the upper limit of the total content ratio of the host material and the dopant material is 100 mass%.

When the organic EL device according to the present exemplary embodiment contains the mixture according to the first exemplary embodiment in one and the same emitting layer, at least one of the first compound or the second compound is preferably a host material, and both the first compound and the second compound are preferably host materials. When the emitting layer contains a plurality of compounds as host materials, the total amount of the plurality of compounds serving as host materials is "50 mass% or more of the layer".

## Substrate

The substrate is used as a support for the organic EL device. For instance, glass, quartz, plastics and the like are usable for the substrate. A flexible substrate is also usable. The flexible substrate is a bendable substrate, which is exemplified by a plastic substrate. Examples of the material for the plastic substrate include polycarbonate, polyarylate, polyethersulfone, polypropylene, polyester, polyvinyl fluoride, polyvinyl chloride, polyimide, and polyethylene naphthalate. Moreover, an inorganic vapor deposition film is also usable.

## Anode

Metal, an alloy, an electrically conductive compound, a mixture thereof, or the like having a large work function (specifically, 4.0 eV or more) is preferably used as the anode formed on the substrate. Specific examples of the material include ITO (Indium Tin Oxide), indium oxide-tin oxide containing silicon or silicon oxide, indium oxide-zinc oxide, indium oxide containing tungsten oxide and zinc oxide, and graphene. In addition, gold (Au), platinum (Pt), nickel (Ni), tungsten (W), chrome (Cr), molybdenum (Mo), iron (Fe), cobalt (Co), copper (Cu), palladium (Pd), titanium (Ti), and nitrides of a metal material (e.g., titanium nitride) are usable.

The material is typically formed into a film by a sputtering method. For instance, the indium oxide-zinc oxide can be formed into a film by the sputtering method using a target in which zinc oxide in a range from 1 mass% to 10 mass% is added to indium oxide. Moreover, for instance, the indium oxide containing tungsten oxide and zinc oxide can be formed by the sputtering method using a target in which tungsten oxide in a range from 0.5 mass% to 5 mass% and zinc oxide in a range from 0.1 mass% to 1 mass% are added to indium oxide. In addition, the anode may be formed by a vacuum deposition method, a coating method, an inkjet method, a spin coating method or the like.

Among the organic layers formed on the anode, since the hole injecting layer adjacent to the anode is formed of a composite material into which holes are easily injectable irrespective of the work function of the anode, a material usable as an electrode material (e.g., metal, an alloy, an electroconductive compound, a mixture thereof, and the elements belonging to the group 1 or 2 of the periodic table) is also usable for the anode.

A material having a small work function such as elements belonging to Groups 1 and 2 in the periodic table of the elements, specifically, an alkali metal such as lithium (Li) and cesium (Cs), an alkaline earth metal such as magnesium (Mg), calcium (Ca) and strontium (Sr), alloys (e.g., MgAg and AlLi) including the alkali metal or the alkaline earth metal, a rare earth metal such as europium (Eu) and ytterbium (Yb), alloys including the rare earth metal are also usable for the anode. It should be noted that the vacuum deposition method and the sputtering method are usable for forming the anode using the alkali metal, alkaline earth metal and the alloy thereof. Further, when a silver paste is used for the anode, the coating method and the inkjet method are usable.

## Cathode

It is preferable to use metal, an alloy, an electroconductive compound, a mixture thereof, or the like having a small work function (specifically, 3.8 eV or less) for the cathode. Examples of the material for the cathode include elements belonging to Groups 1 and 2 in the periodic table of the elements, specifically, the alkali metal such as lithium (Li) and cesium (Cs), the alkaline earth metal such as magnesium (Mg), calcium (Ca) and strontium (Sr), alloys (e.g., MgAg and AlLi) including the alkali metal or the alkaline earth metal, the rare earth metal such as europium (Eu) and ytterbium (Yb), and alloys including the rare earth metal.

It should be noted that the vacuum deposition method and the sputtering method are usable for forming the cathode using the alkali metal, alkaline earth metal and the alloy thereof. Further, when a silver paste is used for the cathode, the coating method and the inkjet method are usable.

By providing the electron injecting layer, various conductive materials such as Al, Ag, ITO, graphene, and indium oxide-tin oxide containing silicon or silicon oxide may be used for forming the cathode regardless of the work function. The conductive materials can be formed into a film using the sputtering method, inkjet method, spin coating method and the like.

## Hole Injecting Layer

The hole injecting layer may be any layer containing a highly hole injectable substance. Examples of the highly hole injectable substance include molybdenum oxide, titanium oxide, vanadium oxide, rhenium oxide, ruthenium oxide, chrome oxide, zirconium oxide, hafnium oxide, tantalum oxide, silver oxide, tungsten oxide, and manganese oxide.

When the hole injecting layer in the organic EL device contains a plurality of compounds, a mass of each of the compounds can be determined using Time-of-Flight Secondary Ion Mass Spectrometry (TOF-SIMS).

With respect to each of the compounds contained in the hole injecting layer, a signal intensity of molecular ions

by TOF-SIMS is measured in a film of an elementary substance, and the hole injecting layer in the organic EL device is exposed with a sputtering gun to be compared with the signal intensity of molecular ions by TOF-SIMS, whereby a mass ratio can be calculated.

In addition, the examples of the highly hole-injectable substance further include: an aromatic amine compound, which is a low-molecule organic compound, such as 4,4',4"-tris(N,N-diphenylamino)triphenylamine (abbreviation: TDATA), 4,4',4"-tris[N-(3-methylphenyl)-N-phenylamino]triphenylamine (abbreviation: MTDATA), 4,4'-bis[N-(4-diphenylaminophenyl)-N-phenylamino]biphenyl (abbreviation: DPAB), 4,4'-bis(N-f4-[N'-(3-methylphenyl)-N'-phenylamino]phenyl}-N-phenylamino)biphenyl (abbreviation: DNTPD), 1,3,5-tris[N-(4-diphenylaminophenyl)-N-phenylamino]benzene (abbreviation: DPA3B), 3-[N-(9-phenylcarbazole-3-yl)-N-phenylamino]-9-phenylcarbazole (abbreviation: PCzPCA1), 3,6-bis[N-(9-phenylcarbazole-3-yl)-N-phenylamino]-9-phenylcarbazole (abbreviation: PCzPCA2), and 3-[N-(1-naphthyl)-N-(9-phenylcarbazole-3-yl)amino]-9-phenylcarbazole (abbreviation: PCzPCN1); and dipyrazino[2,3-f:20,30-h]quinoxaline-2,3,6,7,10,11-hexacarbonitrile (HAT-CN).

In addition, a high polymer compound (e.g., oligomer, dendrimer and polymer) is usable as the highly hole-injectable substance. Examples of the high-molecule compound include poly(N-vinylcarbazole) (abbreviation: PVK), poly(4-vinyltriphenylamine) (abbreviation: PVTPA), poly[N-(4-{N'-[4-(4-diphenylamino)phenyl]phenyl-N'-phenylamino}phenyl)methacrylamide] (abbreviation: PTPDMA), and poly[N,N'-bis(4-butylphenyl)-N,N'-bis(phenyl)benzidine] (abbreviation: Poly-TPD). Moreover, an acid-added high polymer compound such as poly(3,4-ethylenedioxythiophene)/poly(styrene sulfonic acid) (PEDOT/PSS) and polyaniline/poly(styrene sulfonic acid) (PAni/PSS) are also usable.

Hole Transporting Layer

The hole transporting layer is any layer containing a highly hole-transporting substance. An aromatic amine compound, carbazole derivative, anthracene derivative and the like are usable for the hole transporting layer. Specific examples of a material for the hole transporting layer include an aromatic amine compound such as 4,4'-bis[N-(1-naphthyl)-N-phenylamino]biphenyl (abbreviation: NPB), N,N'-bis(3-methylphenyl)-N,N'-diphenyl-[1,1'-biphenyl]-4,4'-diamine (abbreviation: TPD), 4-phenyl-4'-(9-phenylfluorene-9-yl)triphenylamine (abbreviation: BAFLP), 4,4'-bis[N-(9,9-dimethylfluorene-2-yl)-N-phenylamino]biphenyl (abbreviation: DFLDPBi), 4,4',4"-tris(N,N-diphenylamino)triphenylamine (abbreviation: TDATA), 4,4',4"-tris[N-(3-methylphenyl)-N-phenylamino]triphenylamine (abbreviation: MTDATA), and 4,4'-bis[N-(spiro-9,9'-bifluorene-2-yl)-N-phenylamino]biphenyl (abbreviation: BSPB). The above-described substances mostly have a hole mobility of $10^{-6}$ $cm^2/(V\cdot s)$ or more.

For the hole transporting layer, a carbazole derivative such as CBP, 9-[4-(N-carbazolyl)]phenyl-10-phenylanthracene (CzPA), and 9-phenyl-3-[4-(10-phenyl-9-anthryl)phenyl]-9H-carbazole (PCzPA) and an anthracene derivative such as t-BuDNA, DNA, and DPAnth may be used. A high polymer compound such as poly(N-vinylcarbazole) (abbreviation: PVK) and poly(4-vinyltriphenylamine) (abbreviation: PVTPA) is also usable.

However, in addition to the above substances, any substance exhibiting a higher hole transportability than an electron transportability may be used. It should be noted that the layer containing the substance exhibiting a high hole transportability may be not only a single layer but also a laminate of two or more layers formed of the above substance(s).

Electron Transporting Layer

The electron transporting layer is a layer containing a highly electron-transporting substance. For the electron transporting layer, 1) a metal complex such as an aluminum complex, beryllium complex, and zinc complex, 2) a hetero aromatic compound such as imidazole derivative, benzimidazole derivative, azine derivative, carbazole derivative, and phenanthroline derivative, and 3) a high polymer compound are usable. Specifically, as a low-molecule organic compound, a metal complex such as Alq, tris(4-methyl-8-quinolinato)aluminum (abbreviation: $Almq_3$), bis(10-hydroxybenzo[h]quinolinato)beryllium (abbreviation: $BeBq_2$), BAlq, Znq, ZnPBO and ZnBTZ is usable. In addition to the metal complex, a heteroaromatic compound such as 2-(4-biphenylyl)-5-(4-tert-butylphenyl)-1,3,4-oxadiazole (abbreviation: PBD), 1,3-bis[5-(ptert-butylphenyl)-1,3,4-oxadiazole-2-yl]benzene (abbreviation: OXD-7), 3-(4-tert-butylphenyl)-4-phenyl-5-(4-biphenylyl)-1,2,4-triazole (abbreviation: TAZ), 3-(4-tert-butylphenyl)-4-(4-ethylphenyl)-5-(4-biphenylyl)-1,2,4-triazole (abbreviation: p-EtTAZ), bathophenanthroline (abbreviation: BPhen), bathocuproine (abbreviation: BCP), and 4,4'-bis(5-methylbenzoxazole-2-yl)stilbene (abbreviation: BzOs) is usable. In the exemplary embodiment, a benzimidazole compound is preferably usable. The above-described substances mostly have an electron mobility of $10^{-6}$ $cm^2/Vs$ or more. It should be noted that any substance other than the above substance may be used for the electron transporting layer as long as the substance exhibits a higher electron transportability than the hole transportability. The electron transporting layer may be provided in the form of a single layer or a laminate of two or more layers of the above substance(s).

Further, a high polymer compound is usable for the electron transporting layer. For instance, poly[(9,9-dihexylfluorene-2,7-diyl)-co-(pyridine-3,5-diyl)] (abbreviation: PF-Py), poly[(9,9-dioctylfluorene-2,7-diyl)-co-(2,2'-bipyridine-6,6'-diyl)] (abbreviation: PF-BPy) and the like are usable.

Electron Injecting Layer

The electron injecting layer is a layer containing a highly electron-injectable substance. Examples of a material for the electron injecting layer include an alkali metal, alkaline earth metal and a compound thereof, examples of which include lithium (Li), cesium (Cs), calcium (Ca), lithium fluoride (LiF), cesium fluoride (CsF), calcium fluoride ($CaF_2$), and lithium oxide (LiOx). In addition, the alkali metal, alkaline earth metal or the compound thereof may be added to the substance exhibiting the electron transportability in use. Specifically, for instance, magnesium (Mg) added to Alq may be used. In this case, the electrons can be more efficiently injected from the cathode.

Alternatively, the electron injecting layer may be provided by a composite material in a form of a mixture of the organic compound and the electron donor. Such a composite material exhibits excellent electron injectability and electron transportability since electrons are generated in the organic compound by the electron donor. In this case, the organic compound is preferably a material excellent in transporting the generated electrons. Specifically, the above examples (e.g., the metal complex and the hetero aromatic compound) of the substance forming the electron transporting layer are usable. As the electron donor, any substance exhibiting electron donating property to the organic compound is usable. Specifically, the electron donor is preferably alkali metal, alkaline earth metal and rare earth metal such as lithium, cesium, magnesium, calcium, erbium and ytterbium. The electron donor is also preferably alkali metal oxide and alkaline earth metal oxide such as lithium oxide, calcium oxide, and barium oxide. Moreover, a Lewis base such as magnesium oxide is usable. Further, the organic compound such as tetrathiafulvalene (abbreviation: TTF) is usable.

Layer Formation Method

Among the layers of the organic EL device of the present exemplary embodiment, the organic layer formed using the mixture according to the first exemplary embodiment is formed by a dry film-forming method such as a vacuum deposition method, a sputtering method, a plasma method, or an ion-plating method.

A method of forming layers other than the first organic layer, which is not limited except as described above, may be the dry film-forming method described above or a wet film-forming method such as spin coating, dipping, flow coating and ink jet printing.

A method for manufacturing the organic EL device of the present exemplary embodiment preferably includes: for instance, preparing the mixture according to the first exemplary embodiment by mixing the first compound and the second compound described in the first exemplary embodiment; introducing the mixture into one and the same vapor-deposition source; and heating the vapor-deposition source to form the mixture into a film on a substrate. In the forming the mixture according to the first exemplary embodiment into a film on a substrate, the film is formed directly on the substrate, or the film is formed on, for instance, another organic layer preliminarily formed on the substrate.

Film Thickness

A film thickness of each of the organic layers of the organic EL device in the exemplary embodiment is not limited unless otherwise specified in the above. In general, the thickness preferably ranges from several nanometers to 1 μm because excessively small film thickness is likely to cause defects (e.g. pin holes) and excessively large thickness leads to the necessity of applying high voltage and consequent reduction in efficiency.

According to the present exemplary embodiment, the organic EL device can be manufactured with improved efficiency because the mixture according to the first exemplary embodiment, which is capable of inhibiting formation of a bulky adhering film, is used. In addition, the organic EL device according to the present exemplary embodiment can maintain device performance comparable to that of an organic EL device including an organic layer formed using the first compound alone.

Third Exemplary Embodiment

Electronic Device

An electronic device according to a third exemplary embodiment is installed with any one of the organic EL devices according to the above exemplary embodiment. Examples of the electronic device include a display device and a light-emitting unit. Examples of the display device include a display component (e.g., an organic EL panel module), TV, mobile phone, tablet and personal computer. Examples of the light-emitting unit include an illuminator and a vehicle light.

Modification of Embodiment(s)

The scope of the invention is not limited by the above-described exemplary embodiments but includes any modification and improvement as long as such modification and improvement are compatible with the invention.

For instance, the mixture according to the above exemplary embodiment may further contain a compound in addition to the first compound and the second compound.

For instance, the emitting layer is not limited to a single layer, but may be provided by laminating a plurality of emitting layers. When the organic EL device has a plurality of organic layers, it is only required to satisfy the conditions described in the second exemplary embodiment while at least one of the organic layers contains the first compound and the second compound.

When the organic EL device includes a plurality of emitting layers, these emitting layers may be mutually adjacently provided, or may form a so-called tandem organic EL device, in which a plurality of emitting units are layered via an intermediate layer.

For instance, a blocking layer may be provided adjacent to at least one of a side of the emitting layer close to the anode or a side of the emitting layer close to the cathode. The blocking layer is preferably provided in contact with the emitting layer to block at least any of holes, electrons, excitons or combinations thereof.

For instance, when the blocking layer is provided in contact with the side of the emitting layer close to the cathode, the blocking layer permits transport of electrons and blocks holes from reaching a layer provided closer to the cathode (e.g., the electron transporting layer) beyond the blocking layer. When the organic EL device includes the electron transporting layer, the blocking layer is preferably interposed between the emitting layer and the electron transporting layer.

When the blocking layer is provided in contact with the side of the emitting layer close to the anode, the blocking layer permits transport of holes and blocks electrons from reaching a layer provided closer to the anode (e.g., the hole transporting layer) beyond the blocking layer. When the organic EL device includes the hole transporting layer, the blocking layer is preferably interposed between the emitting layer and the hole transporting layer.

Alternatively, the blocking layer may be provided adjacent to the emitting layer so that excitation energy does not leak out from the emitting layer toward neighboring layer(s). The blocking layer blocks excitons generated in the emitting layer from being transferred to a layer(s) (e.g., the electron transporting layer and the hole transporting layer) closer to the electrode(s) beyond the blocking layer.

The emitting layer is preferably bonded with the blocking layer.

Specific structure, shape and the like of the components in the invention may be designed in any manner as long as an object of the invention can be achieved.

Examples

Example(s) of the invention will be described below. However, the invention is not limited to Example(s).

Compounds

The structures of the first compounds used to produce mixtures according to Examples 1 to 5, 11A, 12A, and 13A and organic EL devices according to Examples 6 to 13 are shown below.

[Formula 56]

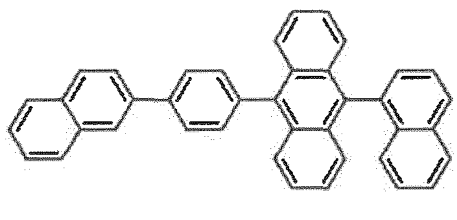

BH-A

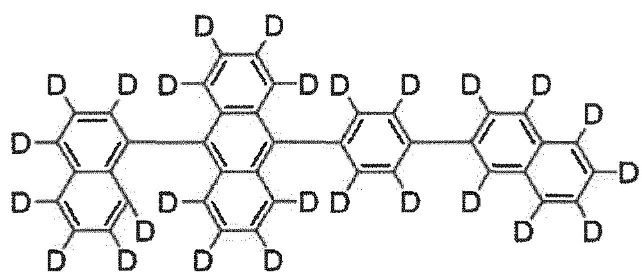

BH-D

The structures of the second compounds used to produce the mixtures according to Examples 1 to 5, 11A, 12A, and 13A and the organic EL devices according to Examples 6 to 13 are shown below.

[Formula 57]

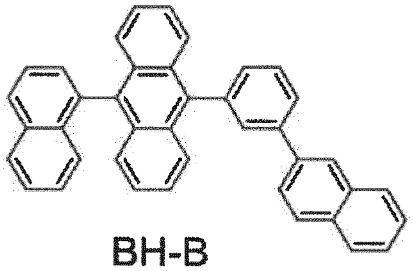

BH-B

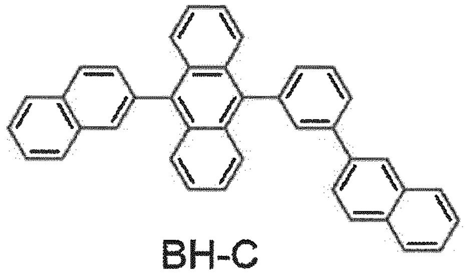

BH-C

[Formula 58]

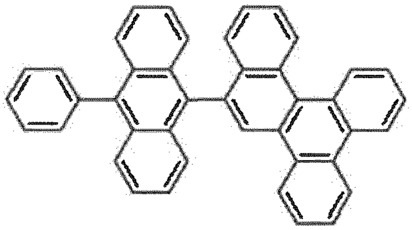

BH-E

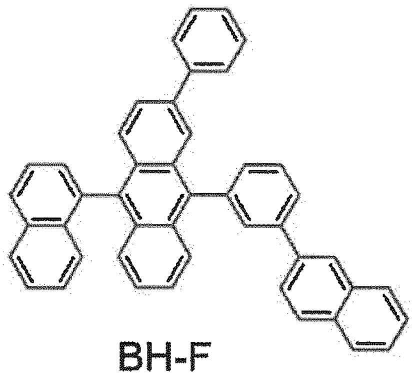

BH-F

The structure of a compound used for a mixture according to Reference Example 1 is shown below.

[Formula 59]

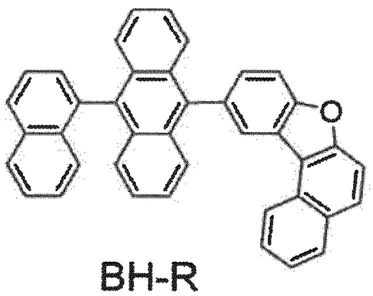

BH-R

The structures of other compounds used to produce the organic EL devices according to Examples 6 to 13 and Comparative Examples 3 and 4 are shown below.

[Formula 60]

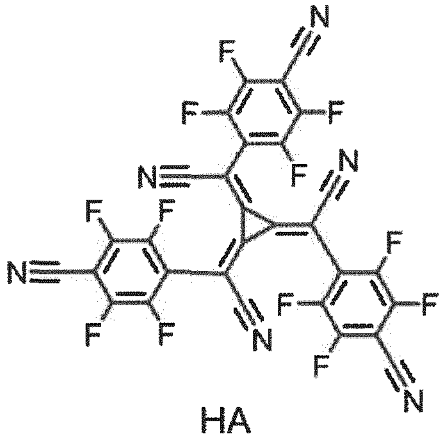

HA

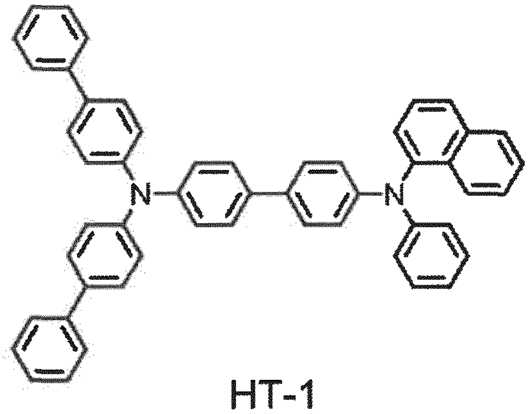

HT-1

[Formula 61]

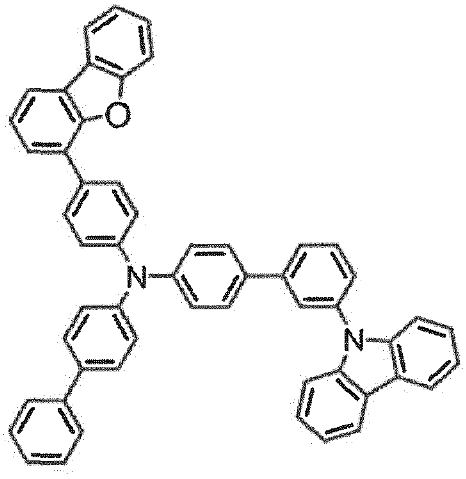

HT-2

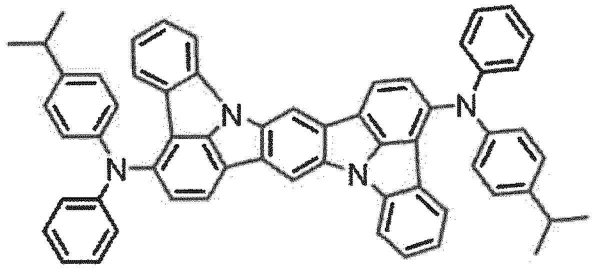

BD-1

[Formula 62]

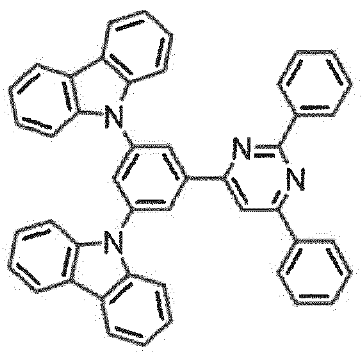

ET-1

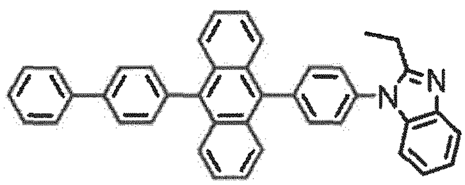

ET-2

Formation of Organic Layer and Cross-Sectional SEM Observation

Example 1

Formation of Single Layer of Material

A mixture according Example 1 was used for forming an organic layer as follows.

First, 198 mg of Compound BH-A serving as the first compound and 2 mg of Compound BH-B serving as the second compound were mixed to prepare the mixture according to Example 1. The mixture according to Example 1 satisfied the above numerical formula (Numerical Formula 1): $(M_1/M_T) \times 100 = 99$ mass%.

Next, a glass substrate with a UV-washed surface was provided as a base material.

Next, 200 mg of the mixture according to Example 1 was put in a crucible.

The mixture in Example 1 was formed into a film on a to-be-cleaned surface of the base material using a vacuum deposition apparatus.

A cross section of the formed organic layer was observed using SEM (scanning electron microscope).

Fig. 2A shows a cross-sectional SEM image (magnification of 100 times) of the organic layer formed using the mixture according to Example 1. Fig. 2B shows a cross-sectional SEM image (magnification of 500 times) of the organic layer.

SEM Observation

The cross section of the above-manufactured organic layer was observed with Scanning Electron Microscope (SEM) (model No.: SU8220 manufactured by Hitachi High Technologies, accelerating voltage for observation: 1kV).

Examples 2 and 3

The mixtures according to Examples 2 and 3 were each prepared in the same manner as in Example 1 except that the mass $M_1$ of the first compound and the mass $M_2$ of the second compound were changed as shown in Table 41. The mixtures of Examples 2 and 3 both satisfied the above numerical formula (Numerical Formula 1).

Using each prepared mixture, an organic layer was formed with a vacuum deposition apparatus under the same film-formation conditions as in Example 1.

Fig. 3A shows a cross-sectional SEM image (magnification of 100 times) of the organic layer formed using the mixture according to Example 2. Fig. 3B shows a cross-sectional SEM image (magnification of 500 times) of the organic layer.

Fig. 4A shows a cross-sectional SEM image (magnification of 100 times) of the organic layer formed using the mixture according to Example 3. Fig. 4B shows a cross-sectional SEM image (magnification of 500 times) of the organic layer.

Examples 4 and 5

The mixtures according to Examples 4 and 5 were each prepared in the same manner as in Example 1 except that the second compound was changed to Compound BH-C shown in Table 41, and the mass $M_1$ of the first compound and the mass $M_2$ of the second compound were changed as shown in Table 41. The mixtures of Examples 4 and 5 both satisfied the above numerical formula (Numerical Formula 1).

Using each prepared mixture, an organic layer was formed with a vacuum deposition apparatus under the same film-formation conditions as in Example 1.

Fig. 5A shows a cross-sectional SEM image (magnification of 100 times) of the organic layer formed using the mixture according to Example 4. Fig. 5B shows a cross-sectional SEM image (magnification of 500 times) of the organic layer.

Fig. 6A shows a cross-sectional SEM image (magnification of 100 times) of the organic layer formed using the mixture according to Example 5. Fig. 6B shows a cross-sectional SEM image (magnification of 500 times) of the organic layer.

Example 11A

The mixture according to Example 11A prepared in the same manner as in Example 1 except that the first compound was changed to Compound BH-D shown in Table 41, the second compound was changed to Compound BH-C shown in Table 41, and the mass $M_1$ of the first compound and the mass $M_2$ of the second compound were

changed as shown in Table 41. The mixture according to Example 11A satisfied the above numerical formula (Numerical Formula 1).

Example 12A

The mixture according to Example 12A was prepared in the same manner as in Example 1 except that the second compound was changed to Compound BH-E shown in Table 41 and the mass $M_1$ of the first compound and the mass $M_2$ of the second compound were changed as shown in Table 41. The mixture according to Example 12A satisfied the above numerical formula (Numerical Formula 1).

Example 13A

The mixture according to Example 13A was prepared in the same manner as in Example 1 except that the second compound was changed to Compound BH-F shown in Table 41 and the mass $M_1$ of the first compound and the mass $M_2$ of the second compound were changed as shown in Table 41. The mixture according to Example 13A satisfied the above numerical formula (Numerical Formula 1).

Reference Example 1

The mixture according to Reference Example 1 was prepared in the same manner as in Example 1 except that the second compound was changed to Compound BH-R. The mixture according to Reference Example 1 satisfied the above numerical formula (Numerical Formula 1).

Using each of the mixtures prepared in Example 11A, 12A, and 13A and Reference Example 1, an organic layer was formed with a vacuum deposition apparatus under the same film-formation conditions as in Example 1. A cross section of the formed organic layer was observed.

Comparative Example 1

As a sample according to Comparative Example 1, not a mixture but a sample containing Compound BH-A alone was provided. Using the sample according to Comparative Example 1, an organic layer was formed with a vacuum deposition apparatus under the same film-formation conditions as in Example 1. Fig. 7A shows a cross-sectional SEM image (magnification of 100 times) of the organic layer formed using the sample according to Comparative Example 1, and Fig. 7B shows a cross-sectional SEM image (magnification of 500 times) of the organic layer.

Comparative Example 2

As a sample according to Comparative Example 2, not a mixture but a sample containing Compound BH-C alone was provided. Using the sample according to Comparative Example 2, an organic layer was formed with a vacuum deposition apparatus under the same film-formation conditions as in Example 1. Fig. 8A shows a cross-sectional SEM image (magnification of 100 times) of the organic layer formed using the sample according to Comparative Example 2, and Fig. 8B shows a cross-sectional SEM image (magnification of 500 times) of the organic layer.

In the organic layer formed using the sample according to Comparative Example 1, as a result of film formation using the single material of Compound BH-A, bulky crystals grew on the base material as shown in the cross-sectional SEM image of Comparative Example 1. In contrast to Comparative Example 1, when the mixtures according to Examples 1 to 5 were used to form films, it was found that dense and non-bulky organic layers were formed as shown in the cross-sectional SEM images of Examples 1 to 5. When the mixtures according to Example 11A, 12A, and 13A and Reference Example 1 were used to form films, it was found that dense and non-bulky organic layers were formed.

Manufacture of Organic Electroluminescence Device

Organic Electroluminescence devices were manufactured and evaluated as follows.

Example 6

A glass substrate (size: 25 mm × 75 mm × 1.1 mm thick, manufactured by Geomatec Co., Ltd.) having an ITO transparent electrode (anode) was ultrasonic-cleaned in isopropyl alcohol for five minutes, and then UV/ozone-cleaned for one minute. A film of ITO was 130 nm thick.

The washed glass substrate having a transparent electrode line was mounted to a substrate holder of a vacuum

deposition apparatus, and Compound HT-1 and Compound HA were co-deposited first on a surface on which the transparent electrode line was formed so as to cover the transparent electrode, thereby forming a hole injecting layer having a thickness of 10 nm. In the hole injecting layer, the concentration of Compound HT-1 was 97 mass%, and the concentration of Compound HA was 3 mass%.

Next, Compound HT-1 was vapor-deposited on the hole injecting layer to form a first hole transporting layer having a thickness of 80 nm.

Next, Compound HT-2 was vapor-deposited on the first hole transporting layer to form a second hole transporting layer having a thickness of 10 nm.

Next, the mixture according to Example 1 (mixture of Compound BH-A and Compound BH-B) and Compound BD-1 were co-deposited on the second hole transporting layer to form an emitting layer having a thickness of 20 nm. In the emitting layer, the total concentration of Compound BH-A and Compound BH-B was 99 mass%, and the concentration of Compound BD-1 was 1 mass%.

Next, Compound ET-1 was vapor-deposited on the emitting layer to form a first electron transporting layer having a thickness of 10 nm.

Next, Compound ET-2 was vapor-deposited on the first electron transporting layer to form a second electron transporting layer having a thickness of 20 nm.

Next, lithium fluoride (LiF) was vapor-deposited on the second electron transporting layer to form an electron injecting layer having a thickness of 1 nm.

Then, metal aluminum (Al) was vapor-deposited on the electron injecting layer to form a metal Al cathode having a thickness of 80 nm.

In the above manner, a bottom emission organic EL device was prepared.

The device arrangement of the organic EL device of Example 6 can be roughly shown as follows.

ITO(130) / HT-1 :HA(10,97%:3%) / HT-1(80) / HT-2(10) / BH-A,BH-B:BD-1(20,99%:1%) / ET-1(10) / ET-2(20) / LiF(1) / Al(80)

Numerals in parentheses represent a film thickness (unit: nm).

Likewise, numerals expressed in percentage in parentheses, for instance, HT-1:HA (10, 97%:3%) indicate that the ratio (mass%) between Compound HT-1 and Compound HA in the hole injecting layer is HT-1:HA = 97 mass%:3 mass%. Numerals expressed in percentage in BH-A, BH-B:BD-1 (20, 99%:1%) indicate that the ratio (mass%) between the total of Compound BH-A and Compound BH-B and Compound BD-1 in the emitting layer is (BH-A and BH-B):BD-1 = 99 mass%:1 mass%. Similar notations apply to the description below.

Examples 7 to 13

The organic EL devices according to Examples 7 to 13 were each manufactured in the same manner as the organic EL device according to Example 6 except that the mixture used to form an emitting layer was changed to a mixture shown in Table 41.

Comparative Examples 3 and 4

The organic EL device according to Comparative Examples 3 and 4 were each manufactured in the same manner as the organic EL device according to Example 6 except that the mixture used to form an emitting layer was changed to a mixture shown in Table 41.

Evaluation of Organic EL Devices

The following evaluations were performed on the organic EL devices manufactured in Examples 6 to 13 and Comparative Examples 3 and 4. The evaluation results are shown in Table 41.

External Quantum Efficiency EQE

Voltage was applied on the organic EL devices so that a current density was 10 mA/cm$^2$, where spectral radiance spectrum was measured by a spectroradiometer (CS-2000 manufactured by Konica Minolta, Inc.). The external quantum efficiency EQE (unit: %) was calculated based on the obtained spectral-radiance spectra, assuming that the spectra was provided under a Lambertian radiation.

Lifetime (LT95)

Voltage was applied on the devices so that a current density was 50 mA/cm$^2$, and the time (unit: h) elapsed

before the luminance intensity was reduced to 95% of the initial luminance intensity was measured using a spectroradiometer (CS-200 manufactured by Konica Minolta, Inc.).

Herein, the time elapsed before the luminance intensity was reduced to 95% of the initial luminance intensity is occasionally referred to as "Lifetime (LT95)."

Blockage

Blockage was evaluated according to the following criteria on the basis of the results of measurement in a state where the single layer was formed on the glass substrate in Formation of Organic Layer and Cross-Sectional SEM Observation above.

A: A dense and non-bulky thick film was observed in a SEM image.
B: A slightly bulky thick film was observed in a SEM image.
C: A bulky thick film was observed in a SEM image.
D: A very bulky thick film was observed in a SEM image.

Table 41

| | | First compound | | | Second compound | | | Evaluation | | |
|---|---|---|---|---|---|---|---|---|---|---|
| Device No. | Mixture No. | Type | Mass [mmg] | $(M_1/M_T) \times 100$ [mass%] | Type | Mass [mmg] | $(M_2/M_T) \times 100$ [mass%] | EQE [%] | LT95 [hr] | Blockage |
| Example 6 | Example 1 | BH-A | 198 | 99 | BH-B | 2 | 1 | 10.5 | 150 | C |
| Example 7 | Example 2 | BH-A | 190 | 95 | BH-B | 10 | 5 | 10.5 | 150 | B |
| Example 8 | Example 3 | BH-A | 150 | 75 | BH-B | 50 | 25 | 10.5 | 150 | A |
| Example 9 | Example 4 | BH-A | 170 | 85 | BH-C | 30 | 15 | 10.5 | 150 | A |
| Example 10 | Example 5 | BH-A | 150 | 75 | BH-C | 50 | 25 | 10.5 | 150 | A |
| Example 11 | Example 11A | BH-D | 150 | 75 | BH-C | 50 | 25 | 10.5 | 250 | A |
| Example 12 | Example 12A | BH-A | 150 | 75 | BH-E | 50 | 25 | 10.5 | 150 | A |
| Example 13 | Example 13A | BH-A | 150 | 75 | BH-F | 50 | 25 | 10.5 | 150 | A |
| Comparative Example 3 | Comparative Example 1 | BH-A | 200 | 100 | - | - | - | 10.5 | 150 | D |
| Comparative Example 4 | Comparative Example 2 | - | - | - | BH-C | 200 | 100 | 9.5 | 150 | A |

The organic EL devices according to Examples 6 to 13, in each of which a mixture obtained by adding a second compound to a first compound was used to form an emitting layer, exhibited device performance comparable to those of the organic EL devices according to Comparative Example 3 and Comparative Example 4.

Taking into account the verification results in Examples 1 to 5, 11A, 12A, and 13A above, it has been found that when an organic layer is formed through dry film-forming using a mixture containing the first compound and the second compound according to the above exemplary embodiment, the formation of a bulky adhering film can be inhibited, and an organic EL device can be manufactured without causing a decrease in manufacturing efficiency or a significant degradation in device performance.

EXPLANATION OF CODES

1 ...organic EL device, 2...substrate, 3...anode, 4...cathode, 5...emitting layer, 6...hole injecting layer, 7...hole transporting layer, 8...electron transporting layer, 9...electron injecting layer.

## Claims

**1.** A mixture comprising:

a first compound; and a second compound, wherein
the first compound is represented by a formula (10) below,
the second compound is represented by a formula (20) below, and
the first compound and the second compound have structures different from each other,

[Formula 1]

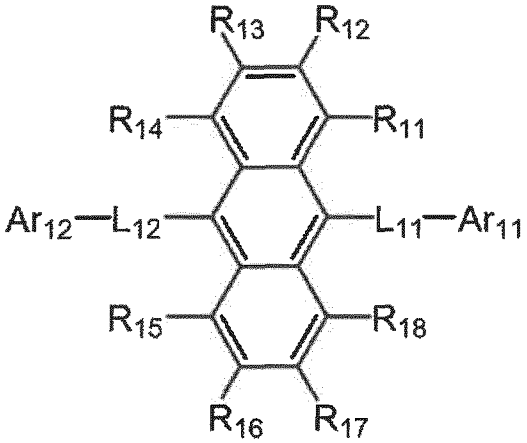

(10)

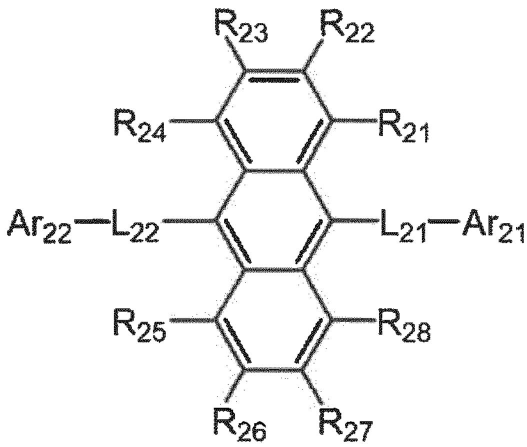

(20)

where:

$L_{12}$ is a substituted or unsubstituted arylene group having 6 to 50 ring carbon atoms, or a substituted or unsubstituted divalent heterocyclic group having 5 to 50 ring atoms;
$Ar_{12}$ is a substituted or unsubstituted aryl group having 6 to 50 ring carbon atoms;
$L_{11}$, $L_{21}$, and $L_{22}$ are each independently a single bond, a substituted or unsubstituted arylene group having 6 to 50 ring carbon atoms, or a substituted or unsubstituted divalent heterocyclic group having 5 to 50 ring atoms;
$Ar_{11}$, $Ar_{21}$, and $Ar_{22}$ are each independently a substituted or unsubstituted aryl group having 6 to 50 ring carbon atoms; and
$R_{11}$ to $R_{18}$ and $R_{21}$ to $R_{28}$ are each independently a hydrogen atom, a substituted or unsubstituted alkyl group having 1 to 50 carbon atoms, a substituted or unsubstituted haloalkyl group having 1 to 50 carbon atoms, a substituted or unsubstituted alkenyl group having 2 to 50 carbon atoms, a substituted or unsubstituted alkynyl group having 2 to 50 carbon atoms, a substituted or unsubstituted cycloalkyl group having

3 to 50 ring carbon atoms, a group represented by -Si($R_{901}$)($R_{902}$)($R_{903}$), a group represented by -O-($R_{904}$), a group represented by -S-($R_{905}$), a group represented by -N($R_{906}$)($R_{907}$), a substituted or unsubstituted aralkyl group having 7 to 50 carbon atoms, a group represented by -C(=O)$R_{801}$, a group represented by -COOR$_{802}$, a halogen atom, a cyano group, a nitro group, a substituted or unsubstituted aryl group having 6 to 50 ring carbon atoms, or a substituted or unsubstituted heterocyclic group having 5 to 50 ring atoms; and in the first compound and the second compound, $R_{901}$, $R_{902}$, $R_{903}$, $R_{904}$, $R_{905}$, $R_{906}$, $R_{907}$, $R_{801}$, and $R_{802}$ are each independently a hydrogen atom, a substituted or unsubstituted alkyl group having 1 to 50 carbon atoms, a substituted or unsubstituted cycloalkyl group having 3 to 50 ring carbon atoms, a substituted or unsubstituted aryl group having 6 to 50 ring carbon atoms, or a substituted or unsubstituted heterocyclic group having 5 to 50 ring atoms;
when a plurality of $R_{901}$ are present, the plurality of $R_{901}$ are mutually the same or different;
when a plurality of $R_{902}$ are present, the plurality of $R_{902}$ are mutually the same or different;
when a plurality of $R_{903}$ are present, the plurality of $R_{903}$ are mutually the same or different;
when a plurality of $R_{904}$ are present, the plurality of $R_{904}$ are mutually the same or different;
when a plurality of $R_{905}$ are present, the plurality of $R_{905}$ are mutually the same or different;
when a plurality of $R_{906}$ are present, the plurality of $R_{906}$ are mutually the same or different;
when a plurality of $R_{907}$ are present, the plurality of $R_{907}$ are mutually the same or different;
when a plurality of $R_{801}$ are present, the plurality of $R_{801}$ are mutually the same or different; and
when a plurality of $R_{802}$ are present, the plurality of $R_{802}$ are mutually the same or different.

2. The mixture according to claim 1, wherein
$L_{12}$ is a substituted or unsubstituted arylene group having 6 to 50 ring carbon atoms.

3. The mixture according to claim 1 or 2, wherein
the first compound is represented by a formula (11) below:

[Formula 2]

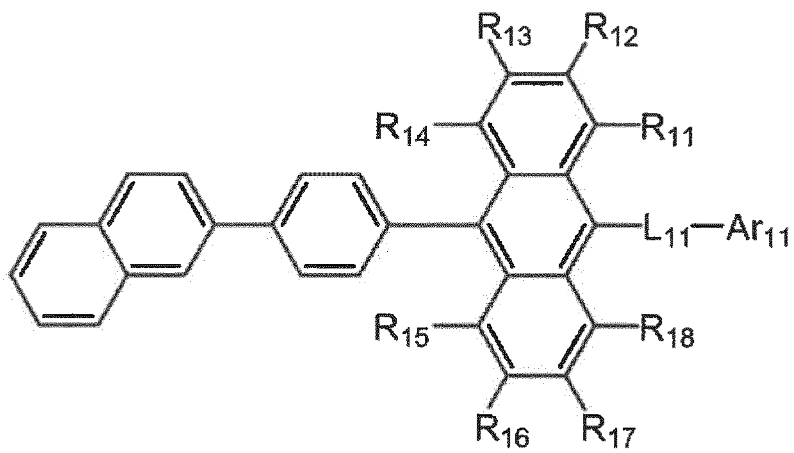

(11)

where: $R_{11}$ to $R_{18}$, $L_{11}$, and $Ar_{11}$ represent the same as $R_{11}$ to $R_{18}$, $L_{11}$, and $Ar_{11}$, respectively, in the formula (10).

4. The mixture according to any one of claims 1 to 3, wherein
$L_{11}$ is a single bond or a substituted or unsubstituted arylene group having 6 to 50 ring carbon atoms.

5. The mixture according to any one of claims 1 to 4, wherein
$Ar_{11}$ is a substituted or unsubstituted aryl group having 6 to 18 ring carbon atoms.

6. The mixture according to any one of claims 1 to 5, wherein
$R_{11}$ to $R_{18}$ are each independently a hydrogen atom, a substituted or unsubstituted alkyl group having 1 to 50 carbon atoms, a substituted or unsubstituted cycloalkyl group having 3 to 50 ring carbon atoms, or a group represented by -Si($R_{901}$)($R_{902}$)($R_{903}$).

7. The mixture according to any one of claims 1 to 6, wherein $R_{11}$ to $R_{18}$ are each a hydrogen atom.

8. The mixture according to any one of claims 1 to 7, wherein $R_{21}$ to $R_{28}$ are each independently a hydrogen atom, a substituted or unsubstituted haloalkyl group having 1 to 50 carbon atoms, a substituted or unsubstituted alkenyl group having 2 to 50 carbon atoms, a substituted or unsubstituted alkynyl group having 2 to 50 carbon atoms, a substituted or unsubstituted cycloalkyl group having 3 to 50 ring carbon atoms, a group represented by $-Si(R_{901})(R_{902})(R_{903})$, a group represented by $-O-(R_{904})$, a group represented by $-S-(R_{905})$, a group represented by $-N(R_{906})(R_{907})$, a substituted or unsubstituted aralkyl group having 7 to 50 carbon atoms, a group represented by $-C(=O)R_{801}$, a group represented by $-COOR_{802}$, a halogen atom, a cyano group, a nitro group, a substituted or unsubstituted aryl group having 6 to 50 ring carbon atoms, or a substituted or unsubstituted heterocyclic group having 5 to 50 ring atoms.

9. The mixture according to any one of claims 1 to 8, wherein $R_{21}$ to $R_{28}$ are each a hydrogen atom.

10. The mixture according to any one of claims 1 to 9, wherein

$L_{21}$ and $L_{22}$ are each independently a single bond, or a substituted or unsubstituted arylene group having 6 to 50 ring carbon atoms; and
$Ar_{21}$ and $Ar_{22}$ are each independently a substituted or unsubstituted aryl group having 6 to 18 ring carbon atoms.

11. The mixture according to any one of claims 1 to 10, wherein in the mixture, a total mass $M_T$ of the first compound and the second compound and a mass $M_1$ of the first compound satisfy a relationship of a numerical formula (Numerical Formula 1) below,

$$50 \leq (M_1/M_T) \times 100 < 100 \qquad \text{(Numerical Formula 1).}$$

12. The mixture according to any one of claims 1 to 11, wherein

$L_{21}$ is a substituted or unsubstituted phenylene group; and
$Ar_{21}$ is a substituted or unsubstituted naphthyl group.

13. The mixture according to any one of claims 1 to 12, wherein the second compound is represented by a formula (21) below,

[Formula 3]

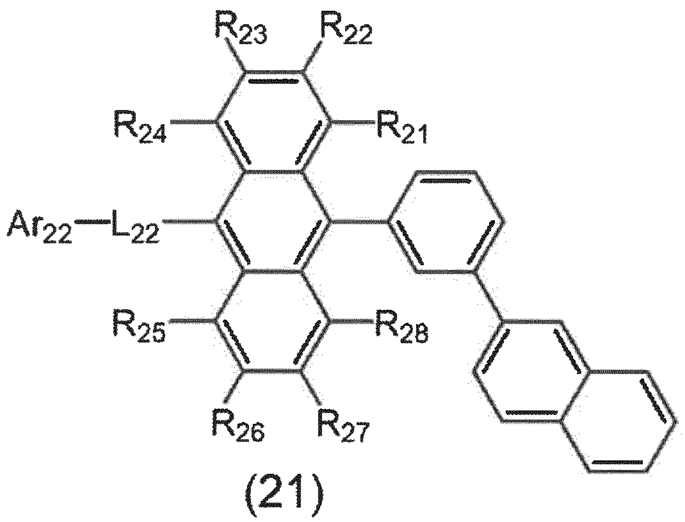

(21)

where: $R_{21}$ to $R_{28}$, $L_{22}$, and $Ar_{22}$ represent the same as $R_{21}$ to $R_{28}$, $L_{22}$, and $Ar_{22}$, respectively, in the formula (20).

**14.** A mixture comprising:

a first compound; and a second compound, wherein
the first compound is represented by a formula (20) below,
the second compound is represented by a formula (30) below, and
the first compound and the second compound have structures different from each other,

[Formula 4]

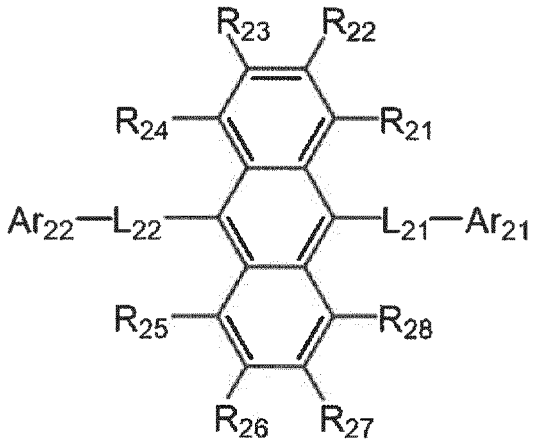

(20)

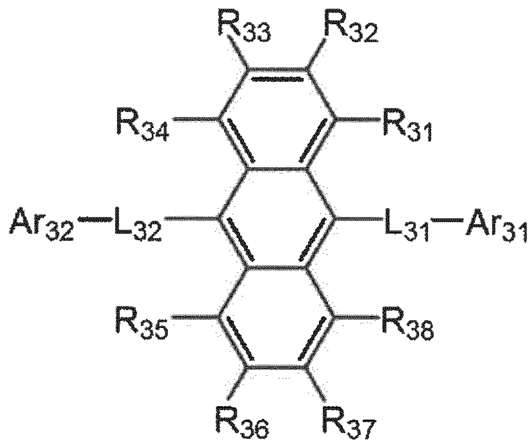

(30)

where:

$L_{21}$, $L_{22}$, $L_{31}$, and $L_{32}$ are each independently a single bond, a substituted or unsubstituted arylene group having 6 to 50 ring carbon atoms, or a substituted or unsubstituted divalent heterocyclic group having 5 to 50 ring atoms;
$Ar_{21}$, $Ar_{22}$, $Ar_{31}$, and $Ar_{32}$ are each independently a substituted or unsubstituted aryl group having 6 to 50 ring carbon atoms;
$R_{21}$ to $R_{28}$ and $R_{31}$ to $R_{38}$ are each independently a hydrogen atom, a substituted or unsubstituted alkyl group having 1 to 50 carbon atoms, a substituted or unsubstituted haloalkyl group having 1 to 50 carbon atoms, a substituted or unsubstituted alkenyl group having 2 to 50 carbon atoms, a substituted or unsubstituted alkynyl group having 2 to 50 carbon atoms, a substituted or unsubstituted cycloalkyl group having 3 to 50 ring carbon atoms, a group represented by $-Si(R_{901})(R_{902})(R_{903})$, a group represented by $-O-(R_{904})$, a group represented by $-S-(R_{905})$, a group represented by $-N(R_{906})(R_{907})$, a substituted or unsubstituted aralkyl group having 7 to 50 carbon atoms, a group represented by $-C(=O)R_{801}$, a group represented by $-COOR_{802}$, a halogen atom, a cyano group, a nitro group, a substituted or unsubstituted aryl group having 6 to 50 ring carbon atoms, or a substituted or unsubstituted heterocyclic group having 5 to 50 ring atoms; and $R_{22}$, $R_{23}$, $R_{26}$, $R_{27}$, $R_{32}$, $R_{33}$, $R_{36}$, and $R_{37}$ are not substituted or unsubstituted alkyl groups having 1 to 50 carbon atoms;
in the first compound and the second compound, $R_{901}$, $R_{902}$, $R_{903}$, $R_{904}$, $R_{905}$, $R_{906}$, $R_{907}$, $R_{801}$, and $R_{802}$ are each independently a hydrogen atom, a substituted or unsubstituted alkyl group having 1 to 50 carbon atoms, a substituted or unsubstituted cycloalkyl group having 3 to 50 ring carbon atoms, a substituted or unsubstituted aryl group having 6 to 50 ring carbon atoms, or a substituted or unsubstituted heterocyclic group having 5 to 50 ring atoms;
when a plurality of $R_{901}$ are present, the plurality of $R_{901}$ are mutually the same or different;
when a plurality of $R_{902}$ are present, the plurality of $R_{902}$ are mutually the same or different;
when a plurality of $R_{903}$ are present, the plurality of $R_{903}$ are mutually the same or different;
when a plurality of $R_{904}$ are present, the plurality of $R_{904}$ are mutually the same or different;
when a plurality of $R_{905}$ are present, the plurality of $R_{905}$ are mutually the same or different;
when a plurality of $R_{906}$ are present, the plurality of $R_{906}$ are mutually the same or different;

when a plurality of $R_{907}$ are present, the plurality of $R_{907}$ are mutually the same or different;
when a plurality of $R_{801}$ are present, the plurality of $R_{801}$ are mutually the same or different; and
when a plurality of $R_{802}$ are present, the plurality of $R_{802}$ are mutually the same or different.

**15.** The mixture according to claim 14, wherein
$R_{31}$ to $R_{38}$ are each a hydrogen atom.

**16.** The mixture according to claim 14 or 15, wherein
$L_{31}$ and $L_{32}$ are each independently a single bond, or a substituted or unsubstituted arylene group having 6 to 50 ring carbon atoms.

**17.** The mixture according to any one of claims 14 to 16, wherein
$L_{31}$ is a substituted or unsubstituted phenylene group, and $Ar_{31}$ is a substituted or unsubstituted naphthyl group.

**18.** The mixture according to any one of claims 14 to 17, wherein
the second compound is represented by a formula (31) below,

[Formula 5]

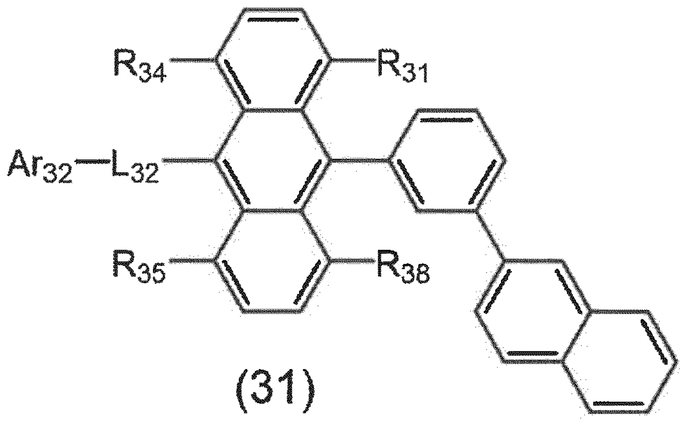

(31)

where: $R_{31}$, $R_{34}$, $R_{35}$, $R_{38}$, $L_{32}$, and $Ar_{32}$ represent the same as $R_{31}$, $R_{34}$, $R_{35}$, $R_{38}$, $L_{32}$, and $Ar_{32}$, respectively, in the formula (30).

**19.** The mixture according to any one of claims 14 to 18, wherein
in the mixture, a total mass $M_T$ of the first compound and the second compound and a mass $M_1$ of the first compound satisfy a relationship of a numerical formula (Numerical Formula 1) below,

$$50 \leq (M_1/M_T) \times 100 < 100 \quad \text{(Numerical Formula 1).}$$

**20.** A mixture comprising:

a first compound; and a second compound, wherein
the first compound is represented by a formula (20) below,
the second compound is represented by a formula (40) below,
the first compound and the second compound having structures different from each other; and
in the mixture, a total mass $M_T$ of the first compound and the second compound and a mass $M_1$ of the first compound satisfy a relationship of a numerical formula (Numerical Formula 2) below,

$$50 < (M_1/M_T) \times 100 < 100 \quad \text{(Numerical Formula 2)}$$

[Formula 6]

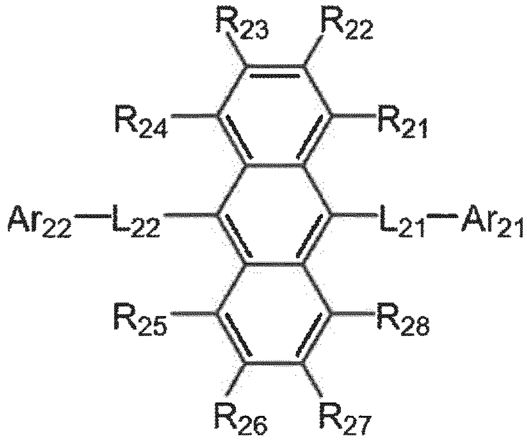

(20)

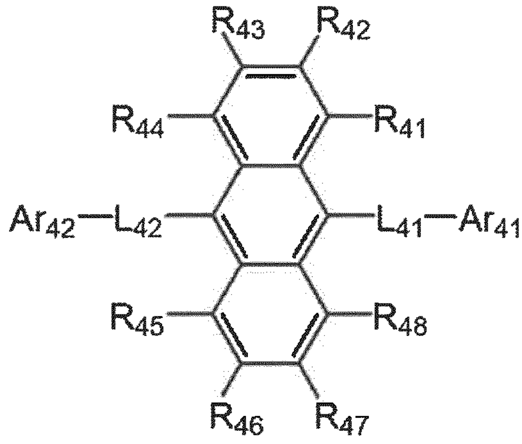

(40)

where:

$L_{21}$, $L_{22}$, $L_{41}$, and $L_{42}$ are each independently a single bond, a substituted or unsubstituted arylene group having 6 to 50 ring carbon atoms, or a substituted or unsubstituted divalent heterocyclic group having 5 to 50 ring atoms;
$Ar_{21}$, $Ar_{22}$, $Ar_{41}$, and $Ar_{42}$ are each independently a substituted or unsubstituted aryl group having 6 to 50 ring carbon atoms;
$R_{21}$ to $R_{28}$ and $R_{41}$ to $R_{48}$ are each independently a hydrogen atom, a substituted or unsubstituted alkyl group having 1 to 50 carbon atoms, a substituted or unsubstituted haloalkyl group having 1 to 50 carbon atoms, a substituted or unsubstituted alkenyl group having 2 to 50 carbon atoms, a substituted or unsubstituted alkynyl group having 2 to 50 carbon atoms, a substituted or unsubstituted cycloalkyl group having 3 to 50 ring carbon atoms, a group represented by $-Si(R_{901})(R_{902})(R_{903})$, a group represented by $-O-(R_{904})$, a group represented by $-S-(R_{905})$, a group represented by $-N(R_{906})(R_{907})$, a substituted or unsubstituted aralkyl group having 7 to 50 carbon atoms, a group represented by $-C(=O)R_{801}$, a group represented by $-COOR_{802}$, a halogen atom, a cyano group, a nitro group, a substituted or unsubstituted aryl group having 6 to 50 ring carbon atoms, or a substituted or unsubstituted heterocyclic group having 5 to 50 ring atoms; and
in the first compound and the second compound, $R_{901}$, $R_{902}$, $R_{903}$, $R_{904}$, $R_{905}$, $R_{906}$, $R_{907}$, $R_{801}$, and $R_{802}$ are each independently a hydrogen atom, a substituted or unsubstituted alkyl group having 1 to 50 carbon atoms, a substituted or unsubstituted cycloalkyl group having 3 to 50 ring carbon atoms, a substituted or unsubstituted aryl group having 6 to 50 ring carbon atoms, or a substituted or unsubstituted heterocyclic group having 5 to 50 ring atoms;
when a plurality of $R_{901}$ are present, the plurality of $R_{901}$ are mutually the same or different;
when a plurality of $R_{902}$ are present, the plurality of $R_{902}$ are mutually the same or different;
when a plurality of $R_{903}$ are present, the plurality of $R_{903}$ are mutually the same or different;
when a plurality of $R_{904}$ are present, the plurality of $R_{904}$ are mutually the same or different;
when a plurality of $R_{905}$ are present, the plurality of $R_{905}$ are mutually the same or different;
when a plurality of $R_{906}$ are present, the plurality of $R_{906}$ are mutually the same or different;
when a plurality of $R_{907}$ are present, the plurality of $R_{907}$ are mutually the same or different;
when a plurality of $R_{801}$ are present, the plurality of $R_{801}$ are mutually the same or different; and
when a plurality of $R_{802}$ are present, the plurality of $R_{802}$ are mutually the same or different.

**21.** The mixture according to claim 20, wherein
$R_{41}$ to $R_{48}$ are each a hydrogen atom.

**22.** The mixture according to claim 20 or 21, wherein

$L_{41}$ and $L_{42}$ are each independently a single bond, or a substituted or unsubstituted arylene group having 6 to 50 ring carbon atoms; and
$Ar_{41}$ and $Ar_{42}$ are each independently a substituted or unsubstituted aryl group having 6 to 18 ring carbon atoms.

**23.** The mixture according to any one of claims 20 to 22, wherein

$L_{41}$ is a substituted or unsubstituted phenylene group; and
$Ar_{41}$ is a substituted or unsubstituted naphthyl group.

**24.** The mixture according to any one of claims 20 to 23, wherein the second compound is represented by a formula (41) below,

[Formula 7]

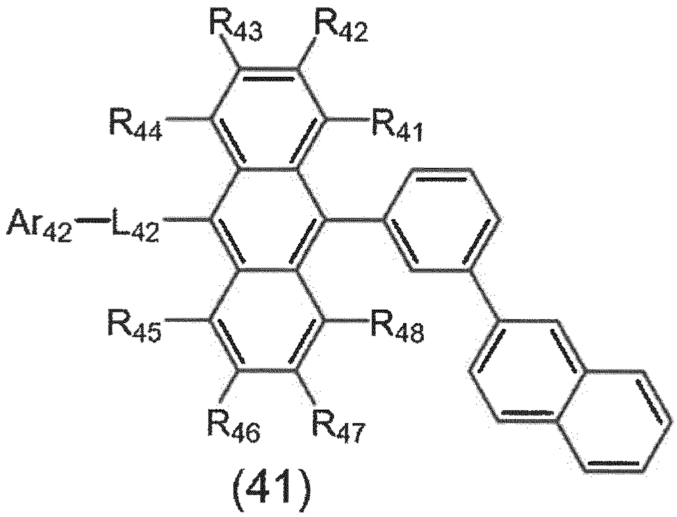

(41)

where: $R_{41}$ to $R_{48}$, $L_{42}$, and $Ar_{42}$ represent the same as $R_{41}$ to $R_{48}$, $L_{42}$, and $Ar_{42}$, respectively, in the formula (40).

**25.** The mixture according to any one of claims 14 to 24, wherein

$L_{22}$ is a substituted or unsubstituted arylene group having 6 to 50 ring carbon atoms; and
$Ar_{22}$ is a substituted or unsubstituted aryl group having 6 to 18 ring carbon atoms.

**26.** The mixture according to any one of claims 14 to 25, wherein the first compound is represented by a formula (22) below,

[Formula 8]

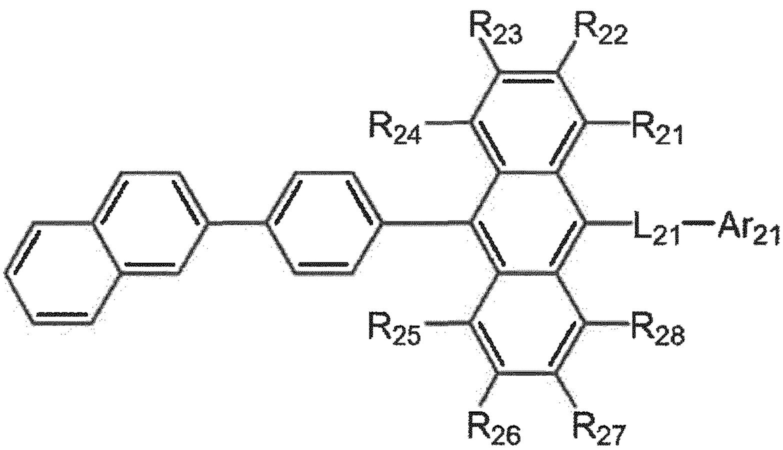

(22)

where: $R_{21}$ to $R_{28}$, $L_{21}$, and $Ar_{21}$ represent the same as $R_{21}$ to $R_{28}$, $L_{21}$, and $Ar_{21}$, respectively, in the formula (20).

27. The mixture according to any one of claims 14 to 26, wherein
$L_{21}$ is a single bond or a substituted or unsubstituted arylene group having 6 to 50 ring carbon atoms.

28. The mixture according to any one of claims 14 to 27, wherein
$Ar_{21}$ is a substituted or unsubstituted aryl group having 6 to 18 ring carbon atoms.

29. The mixture according to any one of claims 14 to 28, wherein
$R_{21}$ to $R_{28}$ are each independently a hydrogen atom, a substituted or unsubstituted alkyl group having 1 to 50 carbon atoms, a substituted or unsubstituted cycloalkyl group having 3 to 50 ring carbon atoms, or a group represented by $-Si(R_{901})(R_{902})(R_{903})$.

30. The mixture according to any one of claims 14 to 28, wherein
$R_{21}$ to $R_{28}$ are each independently a hydrogen atom, a substituted or unsubstituted haloalkyl group having 1 to 50 carbon atoms, a substituted or unsubstituted alkenyl group having 2 to 50 carbon atoms, a substituted or unsubstituted alkynyl group having 2 to 50 carbon atoms, a substituted or unsubstituted cycloalkyl group having 3 to 50 ring carbon atoms, a group represented by $-Si(R_{901})(R_{902})(R_{903})$, a group represented by $-O-(R_{904})$, a group represented by $-S-(R_{905})$, a group represented by $-N(R_{906})(R_{907})$, a substituted or unsubstituted aralkyl group having 7 to 50 carbon atoms, a group represented by $-C(=O)R_{801}$, a group represented by $-COOR_{802}$, a halogen atom, a cyano group, a nitro group, a substituted or unsubstituted aryl group having 6 to 50 ring carbon atoms, or a substituted or unsubstituted heterocyclic group having 5 to 50 ring atoms.

31. The mixture according to any one of claims 14 to 30, wherein
$R_{21}$ to $R_{28}$ are each a hydrogen atom.

32. The mixture according to any one of claims 1 to 31, wherein
in the mixture, the total mass $M_T$ of the first compound and the second compound and the mass $M_1$ of the first compound satisfy a relationship of a numerical formula (Numerical Formula 3) below,

$$60 \leq (M_1/M_T) \times 100 < 100 \qquad \text{(Numerical Formula 3).}$$

33. The mixture according to any one of claims 1 to 32, wherein
in the first compound and the second compound, the groups described as "substituted or unsubstituted" are each an "unsubstituted" group.

34. The mixture according to any one of claims 1 to 33, wherein
the mixture is neither a film nor a layer.

35. An organic electroluminescence device comprising:

an anode;
a cathode; and
an organic layer disposed between the anode and the cathode and containing the mixture according to claim 12 or 13 in one and the same layer.

36. An organic electroluminescence device comprising:

an anode;
a cathode; and
an organic layer disposed between the anode and the cathode and formed by depositing the mixture according to any one of claims 1 to 34 from one and the same vapor-deposition source.

37. An electronic device comprising the organic electroluminescence device according to claim 35 or 36.

38. A method for manufacturing an organic electroluminescence device, comprising:

preparing the mixture according to any one of claims 1 to 34 by mixing the first compound and the second compound;

introducing the mixture into one and the same vapor-deposition source; and heating the vapor-deposition source to form the mixture into a film on a substrate.

FIG. 1

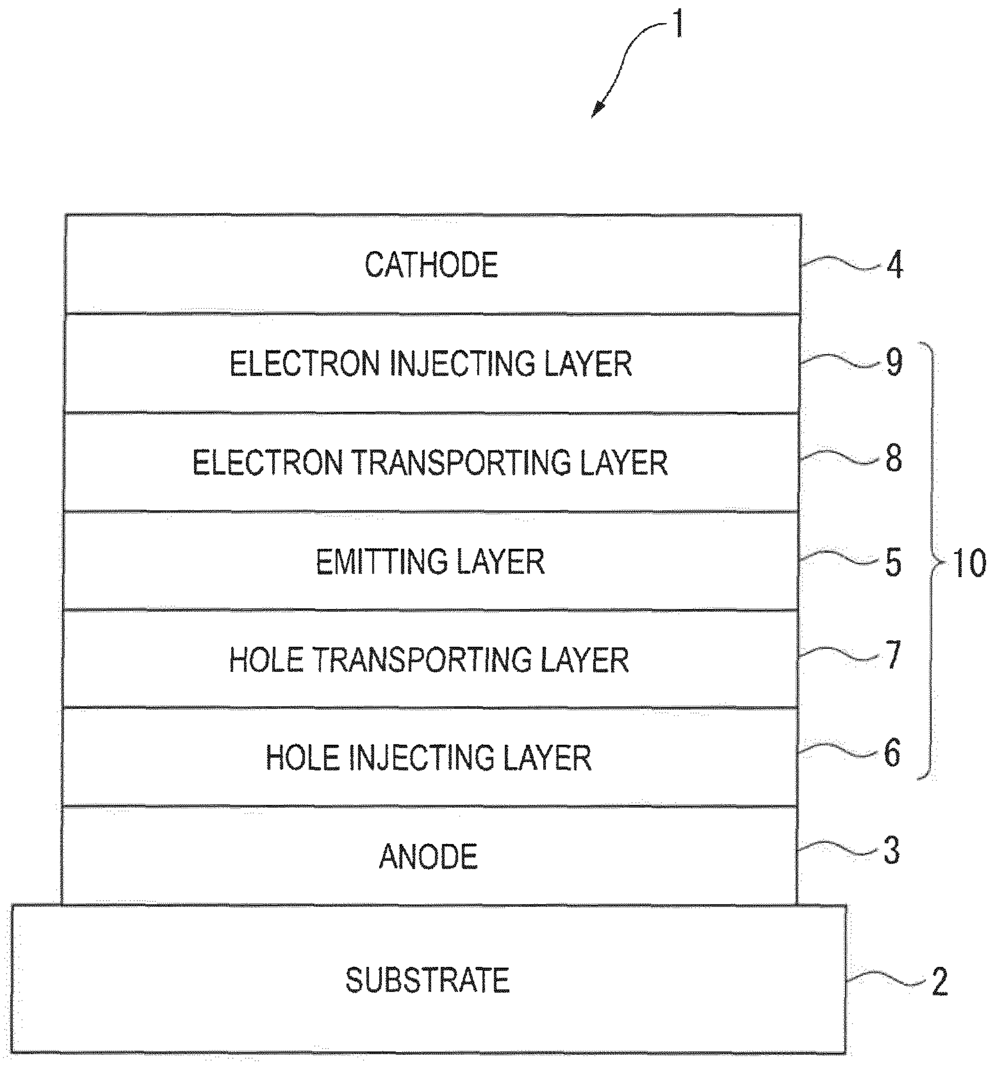
1
CATHODE
4
ELECTRON INJECTING LAYER
9
ELECTRON TRANSPORTING LAYER
8
EMITTING LAYER
5
10
HOLE TRANSPORTING LAYER
7
HOLE INJECTING LAYER
6
ANODE
3
SUBSTRATE
2

FIG.2A

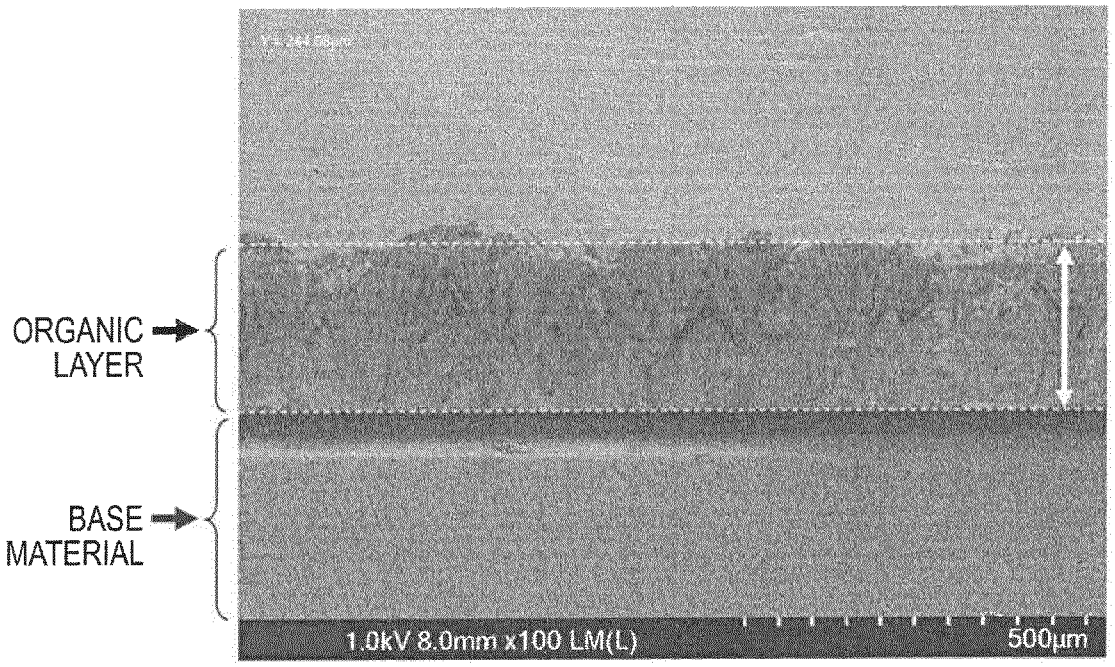
ORGANIC LAYER
BASE MATERIAL
1.0kV 8.0mm x100 LM(L)
500µm

FIG.2B

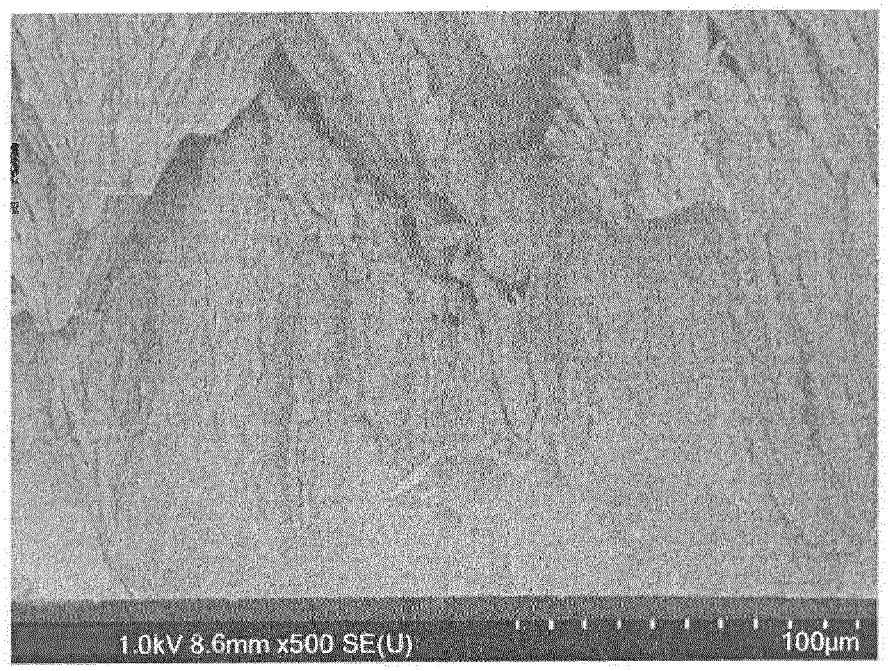
1.0kV 8.6mm x500 SE(U)
100µm

FIG.3A

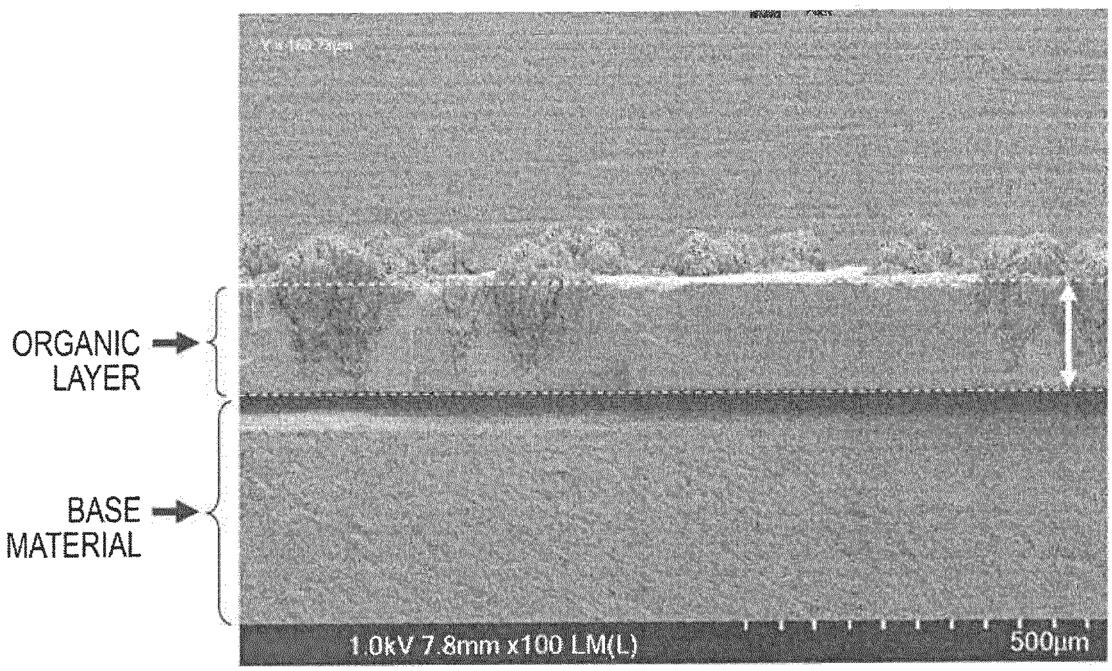
ORGANIC LAYER
BASE MATERIAL
1.0kV 7.8mm x100 LM(L)
500µm

FIG.3B

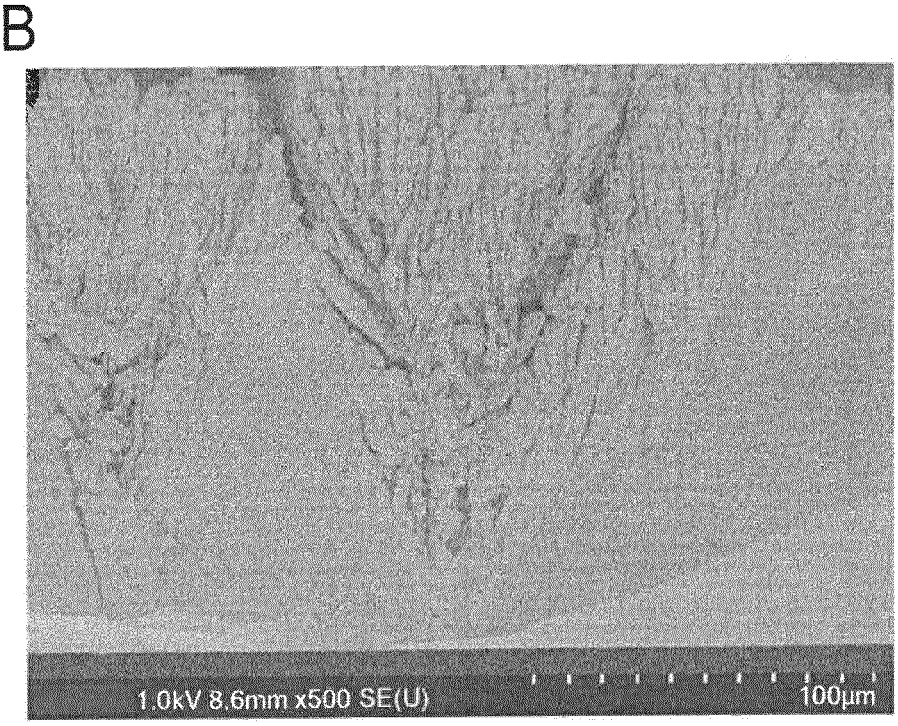
1.0kV 8.6mm x500 SE(U)
100µm

FIG.4A

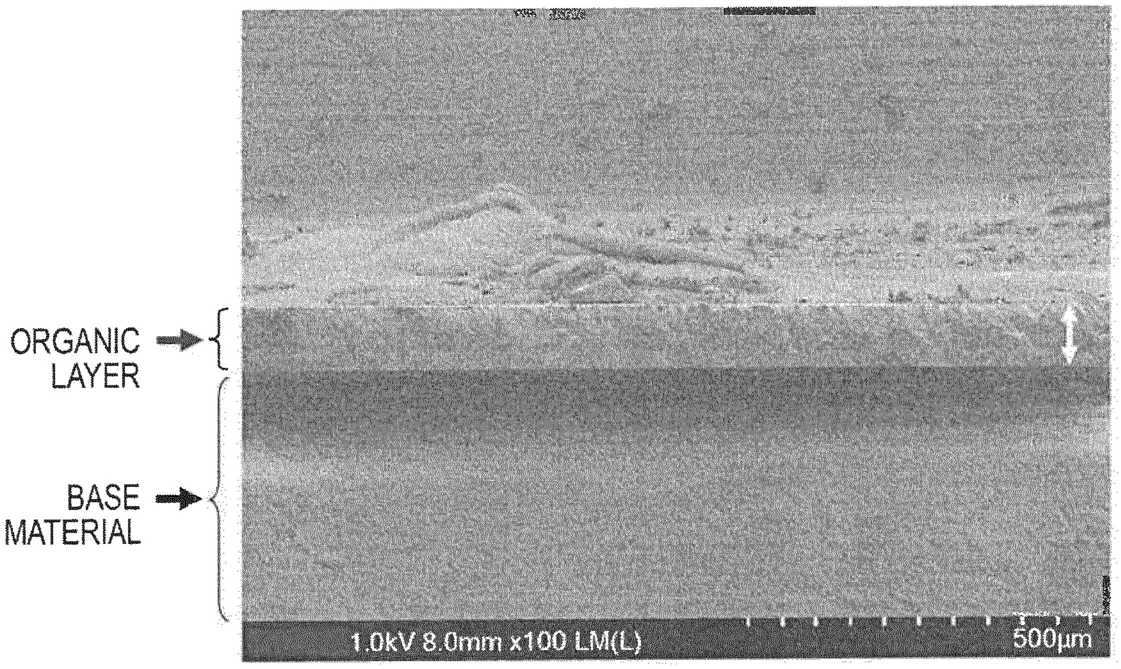
ORGANIC LAYER
BASE MATERIAL
1.0kV 8.0mm x100 LM(L)
500µm

FIG.4B

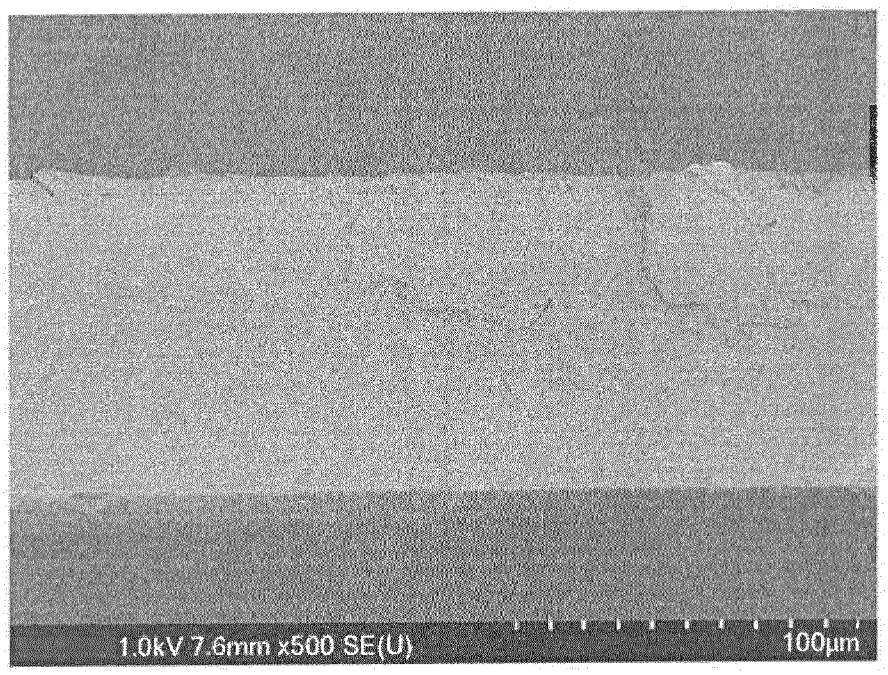
1.0kV 7.6mm x500 SE(U)
100µm

FIG.5A

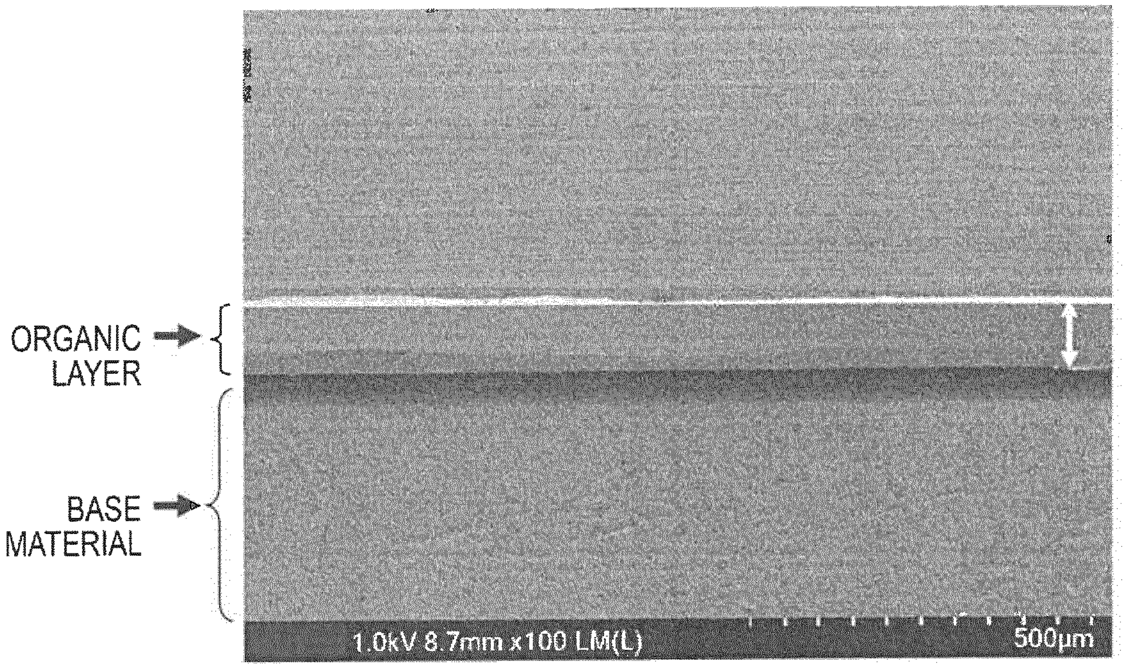
ORGANIC LAYER
BASE MATERIAL
1.0kV 8.7mm x100 LM(L)
500μm

FIG.5B

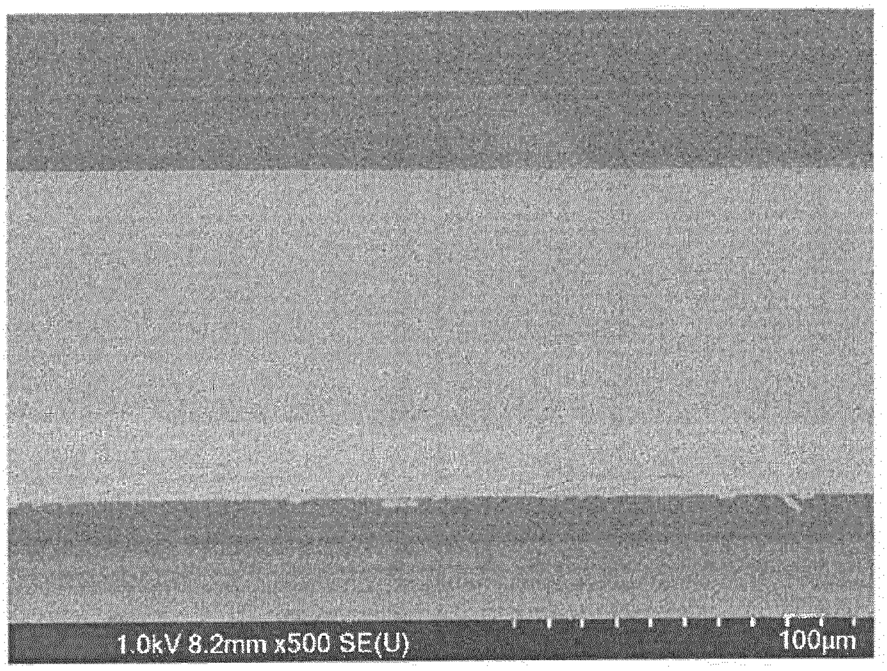
1.0kV 8.2mm x500 SE(U)
100μm

FIG.6A

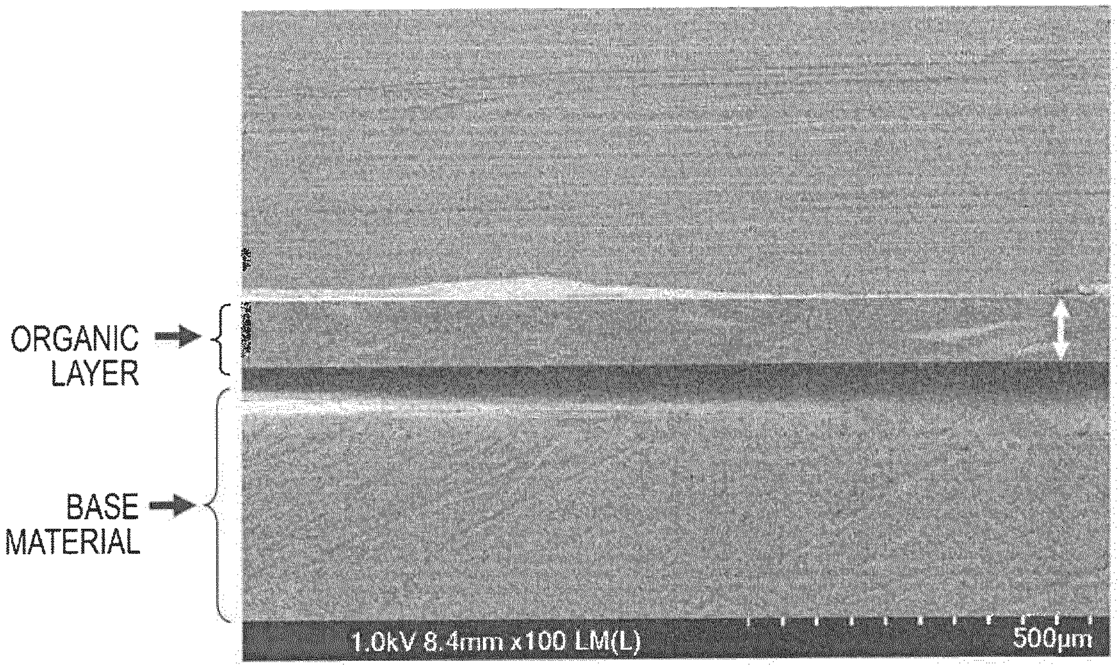
ORGANIC LAYER
BASE MATERIAL
1.0kV 8.4mm x100 LM(L)
500µm

FIG.6B

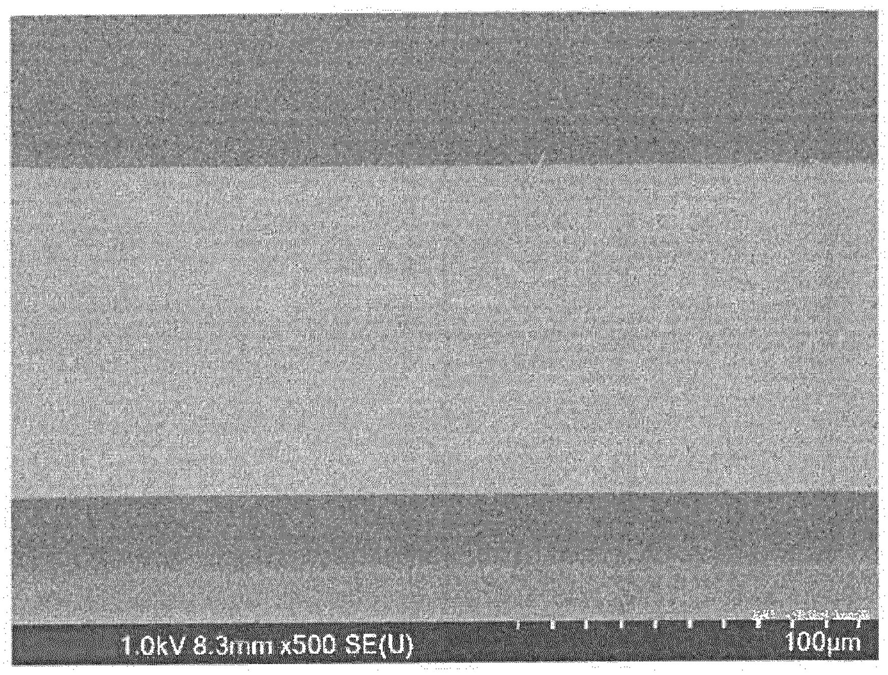
1.0kV 8.3mm x500 SE(U)
100µm

FIG.7A

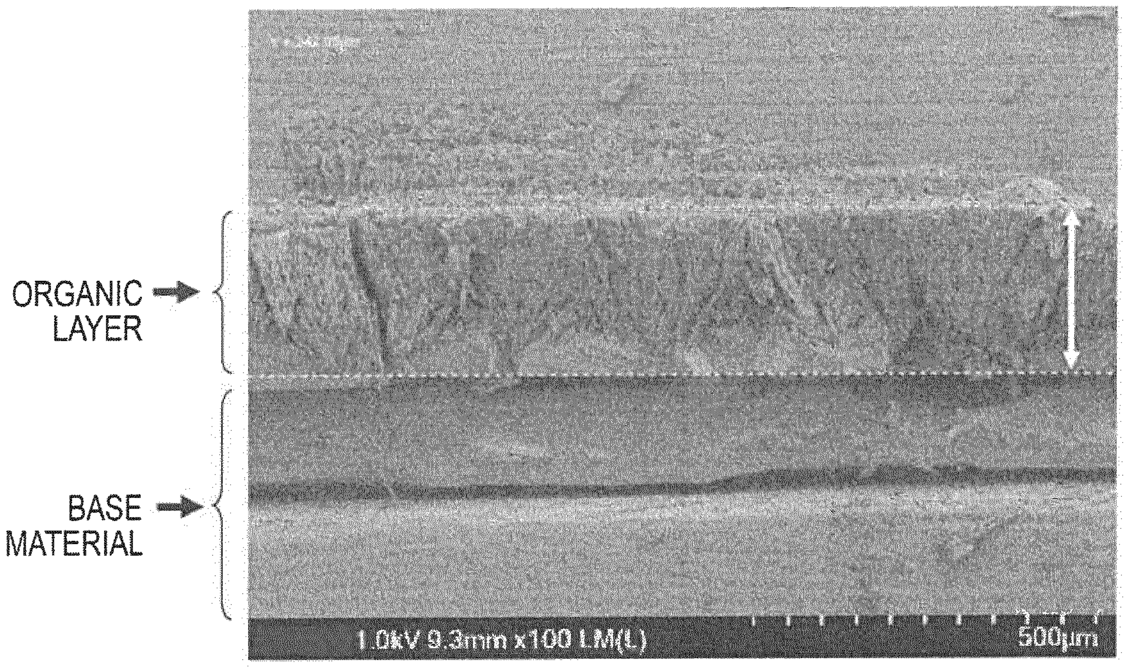
ORGANIC LAYER
BASE MATERIAL
1.0kV 9.3mm x100 LM(L)
500μm

FIG.7B

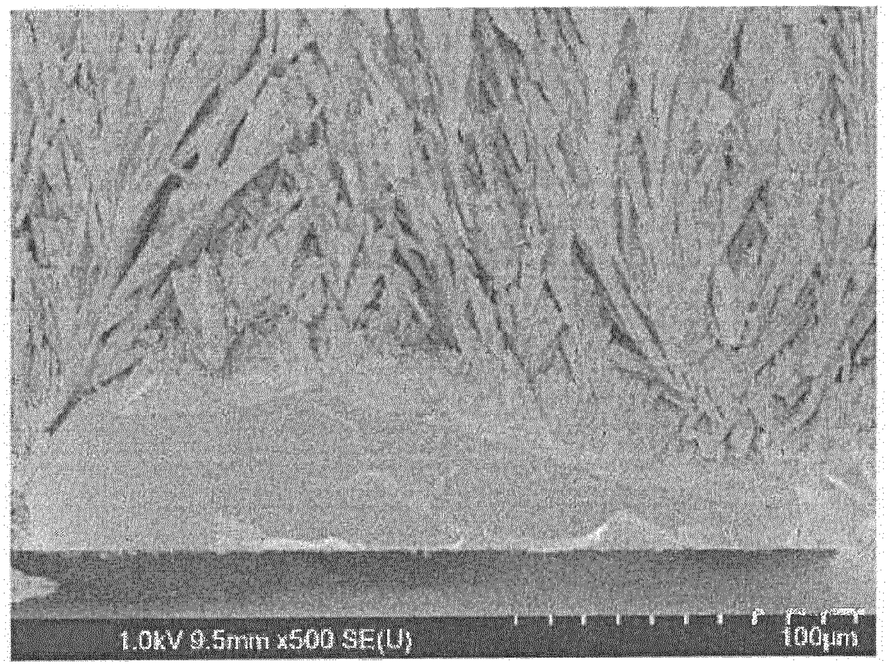
1.0kV 9.5mm x500 SE(U)
100μm

FIG.8A

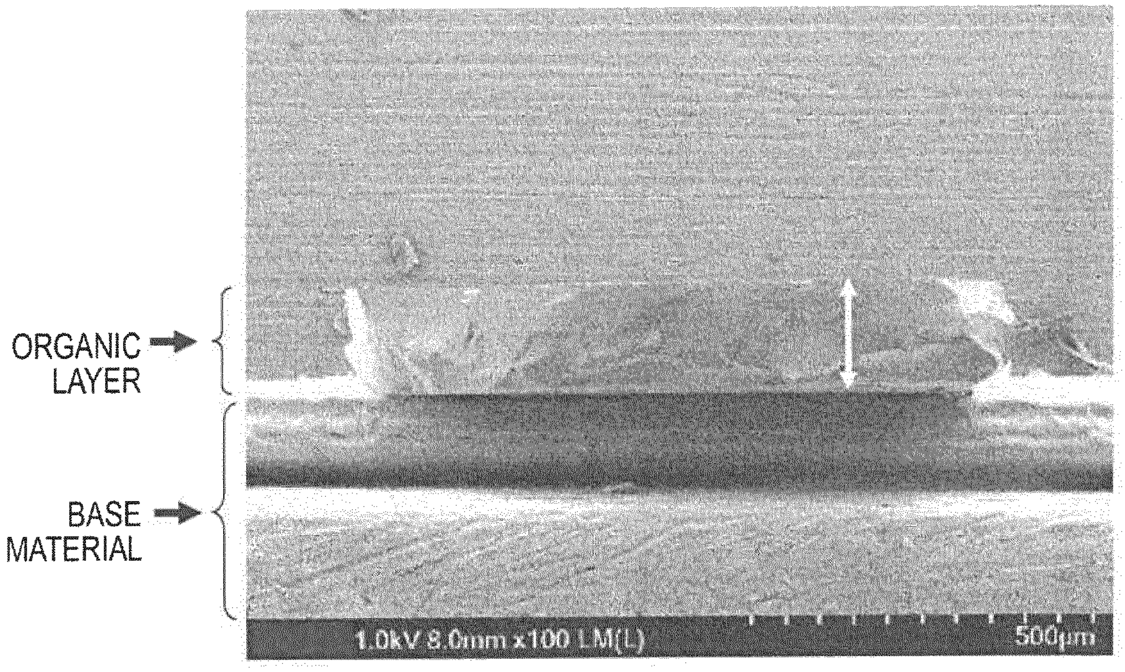
ORGANIC LAYER
BASE MATERIAL
1.0kV 8.0mm x100 LM(L)
500μm

FIG.8B

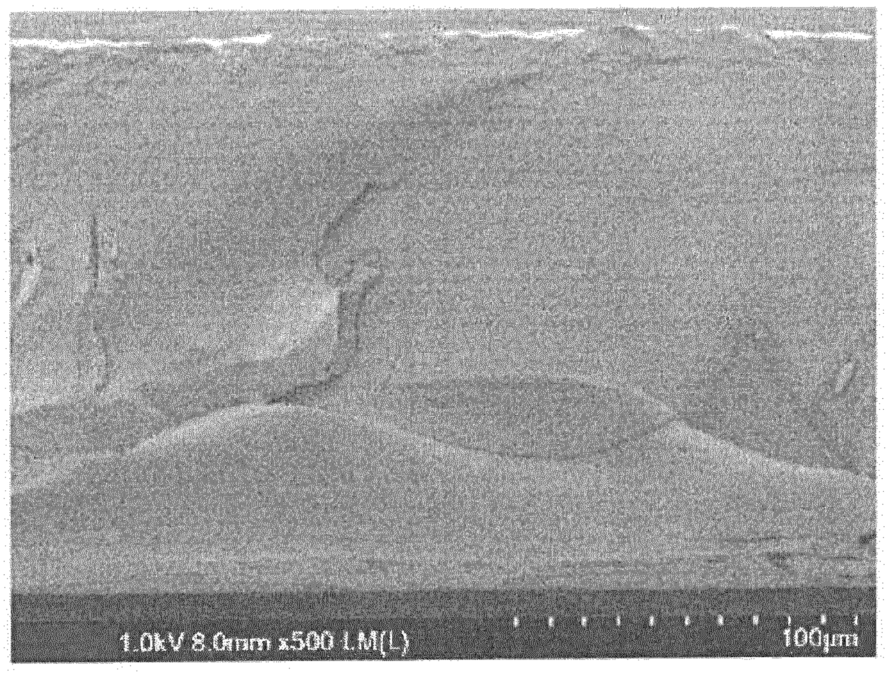
1.0kV 8.0mm x500 LM(L)
100μm

## INTERNATIONAL SEARCH REPORT

International application No.
PCT/JP2021/020449

A. CLASSIFICATION OF SUBJECT MATTER
C09K 11/06(2006.01)i; C23C 14/12(2006.01)i; C23C 14/24(2006.01)i; H05B 33/10(2006.01)i; H01L 51/50(2006.01)i
FI: H05B33/10; H05B33/14 B; C09K11/06 610; C23C14/12; C23C14/24 E
According to International Patent Classification (IPC) or to both national classification and IPC

B. FIELDS SEARCHED
Minimum documentation searched (classification system followed by classification symbols)
C09K11/06; C23C14/12; C23C14/24; H05B33/10; H01L51/50

Documentation searched other than minimum documentation to the extent that such documents are included in the fields searched

| | |
|---|---|
| Published examined utility model applications of Japan | 1922-1996 |
| Published unexamined utility model applications of Japan | 1971-2021 |
| Registered utility model specifications of Japan | 1996-2021 |
| Published registered utility model applications of Japan | 1994-2021 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| X<br>A | WO 2018/101491 A2 (IDEMITSU KOSAN CO., LTD.) 07 June 2018 (2018-06-07) paragraphs [0001], [0065], [0067], [0069] | 14, 16, 19-20, 22, 27-28, 30, 32-38<br>1-13, 15, 17-18, 21, 23-26, 29, 31 |
| X<br>A | WO 2009/081776 A1 (IDEMITSU KOSAN CO., LTD.) 02 July 2009 (2009-07-02) paragraphs [0115], [0126]-[0127], [0129] | 14, 16, 19-20, 22, 27-28, 30, 32-38<br>1-13, 15, 17-18, 21, 23-26, 29, 31 |
| A | KR 2014-0037826 A (TORAY INDUSTRIES, INC.) 27 March 2014 (2014-03-27) paragraphs [0103], [0123] | 1-38 |

☒ Further documents are listed in the continuation of Box C. ☒ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| 08 July 2021 (08.07.2021) | 27 July 2021 (27.07.2021) |

| Name and mailing address of the ISA/ | Authorized officer |
|---|---|
| Japan Patent Office<br>3-4-3, Kasumigaseki, Chiyoda-ku,<br>Tokyo 100-8915, Japan | Telephone No. |

Form PCT/ISA/210 (second sheet) (January 2015)

**INTERNATIONAL SEARCH REPORT**

International application No.
PCT/JP2021/020449

C (Continuation). DOCUMENTS CONSIDERED TO BE RELEVANT

| Category* | Citation of document, with indication, where appropriate, of the relevant passages | Relevant to claim No. |
|---|---|---|
| A | US 2017/0200899 A1 (SAMSUNG DISPLAY CO., LTD.) 13 July 2017 (2017-07-13) paragraphs [0010], [0046], [0368], [0371], [0372] | 1-38 |
| A | JP 2012-238577 A (CANON INC.) 06 December 2012 (2012-12-06) paragraphs [0037]-[0039] | 1-38 |

Form PCT/ISA/210 (continuation of second sheet) (January 2015)

**INTERNATIONAL SEARCH REPORT**
Information on patent family members

International application No.
PCT/JP2021/020449

| Patent Documents referred in the Report | Publication Date | Patent Family | Publication Date |
|---|---|---|---|
| WO 2018/101491 A2 | 07 Jun. 2018 | (Family: none) | |
| WO 2009/081776 A1 | 02 Jul. 2009 | US 2011/0297918 A1 paragraphs [0152]-[0154], [0162], [0164] | |
| KR 2014-0037826 A | 27 Mar. 2014 | TW 201308710 A | |
| US 2017/0200899 A1 | 13 Jul. 2017 | EP 3193384 A<br>KR 10-2017-0085183 A<br>CN 107068912 A | |
| JP 2012-238577 A | 06 Dec. 2012 | US 2012/0274239 A1 paragraphs [0049]-[0051]<br>CN 102760844 A | |

Form PCT/ISA/210 (patent family annex) (January 2015)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- JP 2002025770 A